(19) Europäisches Patentamt
European Patent Office
Office européen des brevets

(11) EP 4 199 132 A1

(12) **EUROPEAN PATENT APPLICATION**

(43) Date of publication:
**21.06.2023 Bulletin 2023/25**

(21) Application number: **21215929.7**

(22) Date of filing: **20.12.2021**

(51) International Patent Classification (IPC):
***H01L 51/54*** *(2006.01)*

(52) Cooperative Patent Classification (CPC):
**H10K 85/60;** H10K 50/19

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Novaled GmbH**
**01099 Dresden (DE)**

(72) Inventors:
- **Nüllen, Max Peter**
**01099 Dresden (DE)**
- **Schulze, Benjamin**
**01099 Dresden (DE)**
- **Wudarczyk, Jakob Jacek**
**01099 Dresden (DE)**
- **Runge, Steffen**
**01099 Dresden (DE)**
- **Rosenow, Thomas**
**01099 Dresden (DE)**
- **Roaschik, Peter**
**01099 Dresden (DE)**

(74) Representative: **Michalski Hüttermann & Partner Patentanwälte mbB**
**Kaistraße 16A**
**40221 Düsseldorf (DE)**

(54) **CHARGE GENERATION LAYER COMPRISING A COMPOUND OF FORMULA (I), ORGANIC ELECTRONIC DEVICE AND DISPLAY DEVICE COMPRISING THE CHARGE GENERATION LAYER AS WELL AS COMPOUNDS OF FORMULA (I)**

(57) The present invention relates to a charge generation layer comprising a compound of formula (I). The invention further relates to organic electronic devices and display devices comprising the charge generation layer as well as compounds of formula (I).

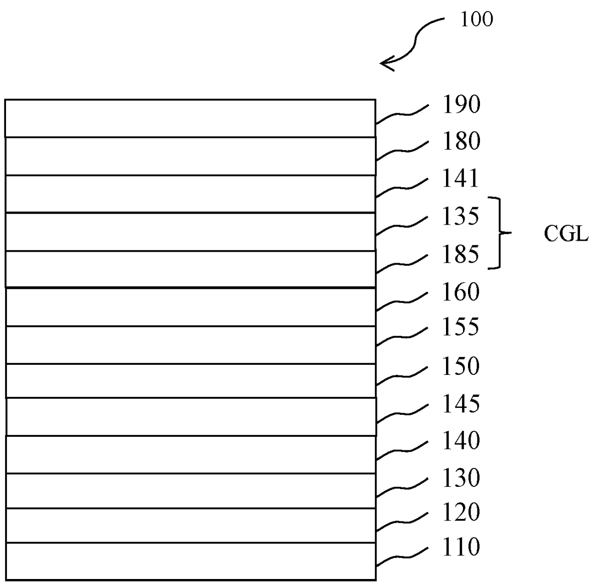


**Fig. 1**

EP 4 199 132 A1

## Description

### Technical Field

The present invention relates to a charge generation layer comprising a compound of formula (I). The invention further relates to organic electronic devices and display devices comprising the charge generation layer as well as compounds of formula (I).

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layer, and among them, may be affected by characteristics of compounds of formula (I) which are also contained in the semiconductor layer.

There remains a need to improve performance of organic semiconductor materials, semiconductor layers, as well as organic electronic devices thereof, in particular to achieve improved brightness or lifetime or reducing the current density, and improving the characteristics of the compounds comprised therein.

### DISCLOSURE

An aspect of the present invention provides a charge generation layer comprising a first charge generation layer and a second charge generation layer, wherein the first charge generation layer comprises a compound of formula (I)

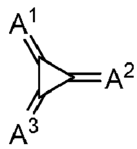

(I),

wherein in formula (I)

- $A^1$ is independently selected from a group of formula (II)

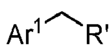

(II),

wherein $Ar^1$ is independently selected from substituted or unsubstituted $C_6$ to $C_{36}$ aryl and substituted or unsubstituted $C_2$ to $C_{36}$ heteroaryl; wherein for the case that $Ar^1$ is substituted, one or more of the substituents are independently selected from the group consisting of an electron-withdrawing group, F, CN, partially fluorinated alkyl, perfluorinated alkyl, and $-NO_2$;

- $A^2$ and $A^3$ are independently selected from a group of formula (III)

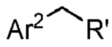

(III),

wherein $Ar^2$ is independently selected from substituted or unsubstituted $C_6$ to $C_{36}$ aryl and substituted or unsubstituted $C_2$ to $C_{36}$ heteroaryl; wherein for the case that $Ar^2$ is substituted, one or more of the substituents are independently selected from the group consisting of an electron-withdrawing group, F, CN, partially fluorinated alkyl, perfluorinated alkyl, and $-NO_2$;

- and wherein each R' is independently selected from substituted or unsubstituted $C_6$ to $C_{18}$ aryl, $C_3$ to $C_{18}$ heteroaryl, electron-withdrawing group, partially fluorinated $C_1$ to $C_8$ alkyl, perfluorinated $C_1$ to $C_8$ alkyl, halogen, F or CN;

wherein the compound of formula (I) has an absorption maximum $\lambda_{max}$ at ≤ 459 nm when measured in DCM at a concentration of $10^{-5}$ to $10^{-4}$ mol/L at 20 °C, an absorption maximum $\lambda_{max}$ at ≤ 494 nm when calculated with the program package TURBOMOLE V6.5 (TURBOMOLE GmbH, Litzenhardtstrasse 19, 76135 Karlsruhe, Germany) by TDDFT using the hybrid functional PBEO with adef2-SVP basis set in the gas phase and including the first 30 singlet transitions from optimized geometry using the hybrid functional B3LYP with a 6-31G* basis set in the gas phase, and/or an integral of ≤ 50 a.u. × nm in an UV-Vis Spectrum in the range of 400 to 650 nm, when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a6-31G* basis set in the gas phase;
wherein the first charge generation layer comprises an organic hole transport compound and wherein the second charge generation layer comprises an organic electron transport compound and a metal dopant.

It should be noted that throughout the application and the claims any $A^n$, $Ar^n$, $B^n$, $R^n$ etc. always refer to the same moieties, unless otherwise noted.

In the present specification, when a definition is not otherwise provided, "substituted" refers to one substituted with a deuterium, $C_1$ to $C_{12}$ alkyl and $C_1$ to $C_{12}$ alkoxy.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a $C_1$ to $C_{12}$ alkyl group. More specifically, the alkyl group may be a $C_1$ to $C_{10}$ alkyl group or a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common $sp^2$-hybridized carbon atoms,

The term "electron-withdrawing group" refers to a chemical group in a molecule, which can draw electrons

away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated $C_1$ to $C_{12}$ alkyl, partially fluorinated or perfluorinated alkoxy, partially fluorinated or perfluorinated $C_1$ to $C_6$ alkoxy.

In the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of', "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

According to the invention, the feature of having an absorption maximum $\lambda_{max}$ at $\leq$ 459 nm when measured in DCM at a concentration of $10^{-5}$ to $10^{-4}$ mol/L at 20 °C should be understood to mean that the compound has at least one absorption maximum at below or equal to the given wavelength. Particularly, this refers to an absorption maximum in the range as measured by an UV-Vis spectrophotometer, particularly in the range of 248 nm to 1000 nm. Preferably, the compound has its maximum absorption at below or equal to the given wavelength. In other words, this means that the compound does not have an absorption maximum at above the given wavelength.

According to the invention, the feature of having an absorption maximum $\lambda_{max}$ at $\leq$ 494 nm when calculated with the program package TURBOMOLE V6.5 (TURBOMOLE GmbH, Litzenhardtstrasse 19, 76135 Karlsruhe, Germany) by TDDFT using PBEO with a def2-SVP basis set in the gas phase and including the first 30 singlet transitions from optimized geometry using the hybrid functional B3LYP with a 6-31G* basis set in the gas phase, should be understood to mean that the compound has at least one absorption maximum at below or equal to the given wavelength. Particularly, this refers to an absorption maximum in the range as measured by an UV-Vis spectrophotometer, particularly in the range of 300 nm to 650 nm, especially in the range of 350 to 650 nm. Preferably, the compound has its maximum absorption at below or equal to the given wavelength. In other words, this means that the compound does not have an absorption maximum at above the given wavelength.

DCM is dichloromethane.

According to the invention, the feature of having an integral of $\leq$ 50 a.u. $\times$ nm in an UV-Vis Spectrum in the range of 400 to 650 nm, when calculated bwith the program package TURBOMOLE V6.5 (TURBOMOLE GmbH, Litzenhardtstrasse 19, 76135 Karlsruhe, Germany) by TDDFT using PBEO with a def2-SVP basis set in the gas phase and including the first 30 singlet transitions from optimized geometry using hybrid functional B3LYP with a 6-31G* basis set in the gas phase means that for a calculated UV-Vis spectrum the quantitative area of the absorption in the given range is below or equal the given value.

## Advantageous Effects

Surprisingly, it was found that the charge generation layer according to the invention solves the problem underlying the present invention by enabling devices in various aspects superior over the organic electronic devices known in the art, in particular with respect improved brightness or lifetime or reducing the current density, and improving the characteristics of the compounds comprised therein.

According to one embodiment of the present invention, the organic hole transport compound is not a metal complex and/or a metal organic compound, preferably the organic hole transport compound does not comprise any metal atom.

According to one embodiment of the present invention, the organic electron transport compound is not a metal complex and/or a metal organic compound, preferably the organic electron transport compound does not comprise any metal atom.

According to one embodiment of the present invention, the charge generation layer is not a charge generation layer selected from the group consisting of:

a) a charge generation layer, wherein the first charge generation layer comprises 10.1 vol% of a compound of formula (I) wherein $A^1$, $A^2$ and $A^3$ are selected according to the following:

$A^1$

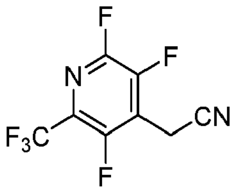

$A^2$

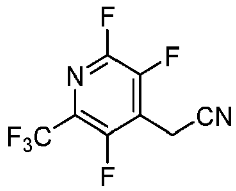

$A^3$

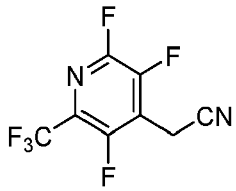

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

b) a charge generation layer, wherein the first charge generation layer comprises 9.8 vol% of a compound of formula (I) wherein $A^1$, $A^2$ and $A^3$ are selected according to the following:

$A^1$

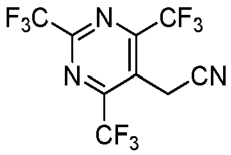

$A^2$

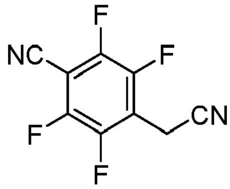

$A^3$

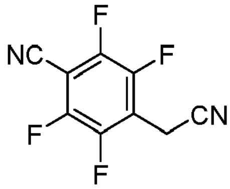

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm, and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

c) a charge generation layer, wherein the first charge generation layer comprises 12 vol% of a compound of formula (I) wherein $A^1$, $A^2$ and $A^3$ are selected according to the following:

$A^1$

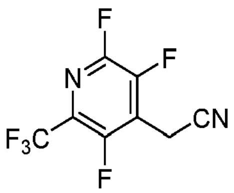

$A^2$

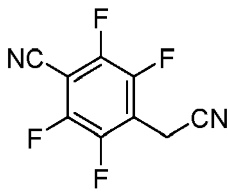

$A^3$

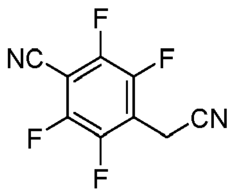

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

d) a charge generation layer, wherein the first charge generation layer comprises 9.6 vol% of a compound of formula

(I) wherein $A^1$, $A^2$ and $A^3$ are selected according to the following:

$A^1$

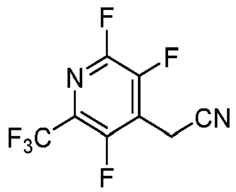

$A^2$

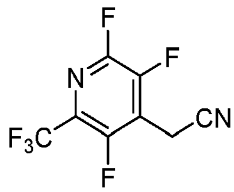

$A^3$

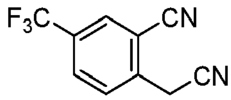

and N-([1,1'-biphenyl]-2-yl)-N-(9,9-dimethyl-9H-fluoren-2-yl)-9,9'-spirobi[fluoren]-2-amine, wherein the first charge generation layer has a thickness of 81 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

e) a charge generation layer, wherein the first charge generation layer comprises 10.1 vol% of a compound of formula (I) wherein $A^1$, $A^2$ and $A^3$ are selected according to the following:

$A^1$

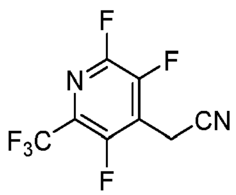

$A^2$

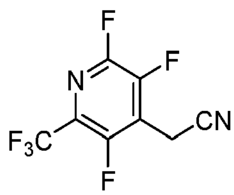

$A^3$

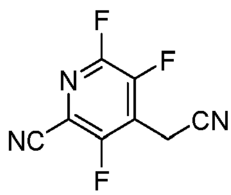

and N-([1,1'-biphenyl]-2-yl)-N-(9,9-dimethyl-9H-fluoren-2-yl)-9,9'-spirobi[fluoren]-2-amine, wherein the first charge generation layer has a thickness of 81 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

f) a charge generation layer, wherein the first charge generation layer comprises 9.9 vol% of a compound of formula (I) wherein $A^1$, $A^2$ and $A^3$ are selected according to the following:

$A^1$

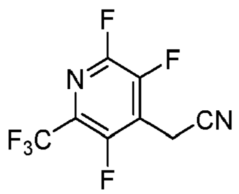

$A^2$

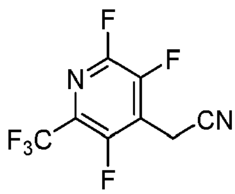

$A^3$

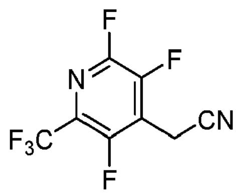

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

g) a charge generation layer, wherein the first charge generation layer comprises 10.8 vol% of a compound of formula (I) wherein $A^1$, $A^2$ and $A^3$ are selected according to the following:

A$^1$

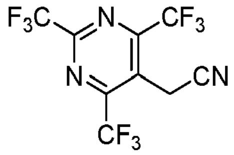

A$^2$

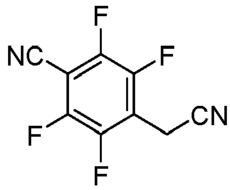

A$^3$

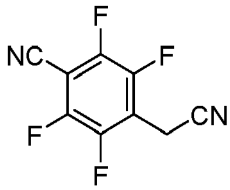

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

h) a charge generation layer, wherein the first charge generation layer comprises 11.8 vol% of a compound of formula (I) wherein $A^1$, $A^2$ and $A^3$ are selected according to the following:

A$^1$

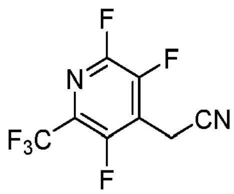

A$^2$

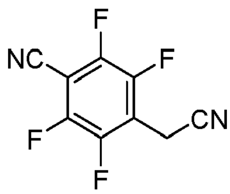

A$^3$

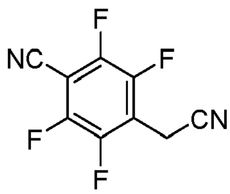

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

i) a charge generation layer, wherein the first charge generation layer comprises 9.9 vol% of a compound of formula (I) wherein $A^1$, $A^2$ and $A^3$ are selected according to the following:

A$^1$

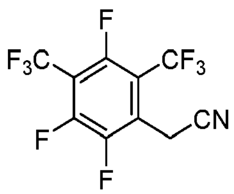

A$^2$

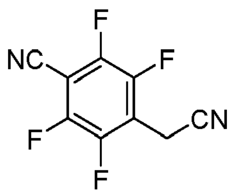

A$^3$

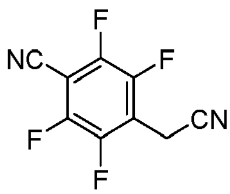

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

j) a charge generation layer, wherein the first charge generation layer comprises 10.3 vol% of a compound of formula (I) wherein $A^1$, $A^2$ and $A^3$ are selected according to the following:

$A^1$

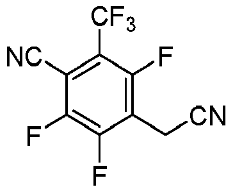

$A^2$

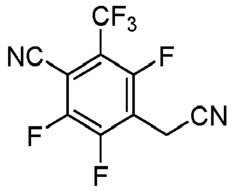

$A^3$

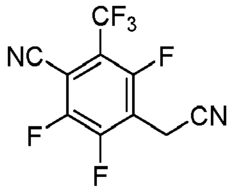

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm, and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

k) a charge generation layer, wherein the first charge generation layer comprises 10.3 vol% of a compound of formula (I) wherein $A^1$, $A^2$ and $A^3$ are selected according to the following:

$A^1$

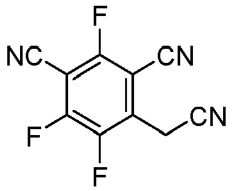

$A^2$

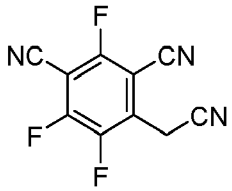

$A^3$

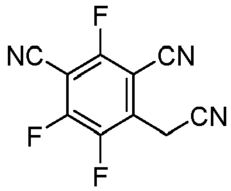

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

l) a charge generation layer, wherein the first charge generation layer comprises 5 vol% of a compound of formula (I) wherein $A^1$, $A^2$ and $A^3$ are selected according to the following:

$A^1$

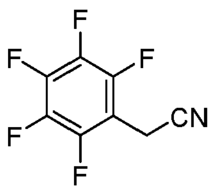

$A^2$

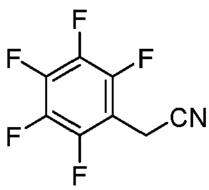

$A^3$

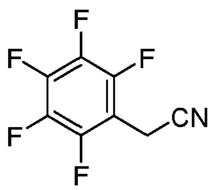

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

m) a charge generation layer, wherein the first charge generation layer comprises 5 vol% of a compound of formula (I) wherein $A^1$, $A^2$ and $A^3$ are selected according to the following:

$A^1$

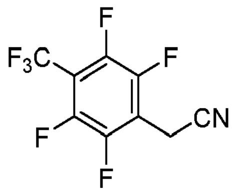

$A^2$

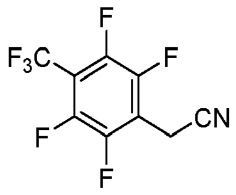

$A^3$

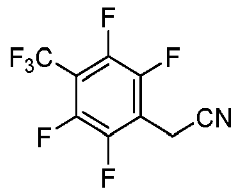

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

n) a charge generation layer, wherein the first charge generation layer comprises 5 vol% or 10 vol% of a compound of formula (I) wherein $A^1$, $A^2$ and $A^3$ are selected according to the following:

$A^1$

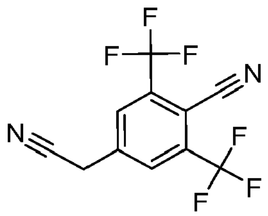

$A^2$

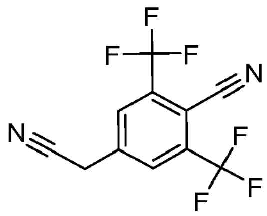

$A^3$

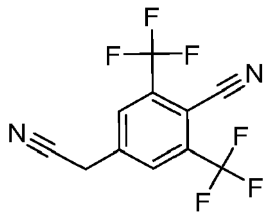

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

o) a charge generation layer, wherein the first charge generation layer comprises 5 vol% or 10 vol% of a compound of formula (I) wherein $A^1$, $A^2$ and $A^3$ are selected according to the following:

$A^1$

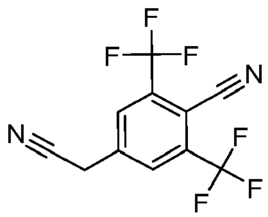

$A^2$

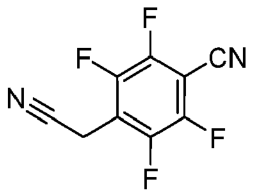

$A^3$

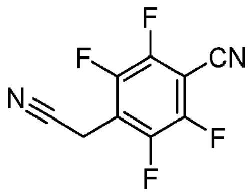

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

p) a charge generation layer, wherein the first charge generation layer comprises 10 vol% of a compound of formula (I) wherein $A^1$, $A^2$ and $A^3$ are selected according to the following:

$A^1$ $A^2$ $A^3$

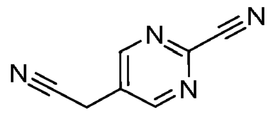 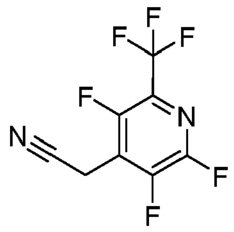 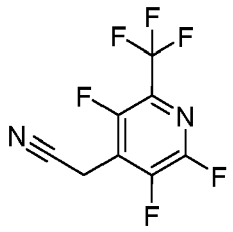

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

q) a charge generation layer, wherein the first charge generation layer comprises 10 vol% of a compound of formula (I) wherein $A^1$, $A^2$ and $A^3$ are selected according to the following:

$A^1$ $A^2$ $A^3$

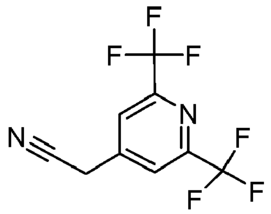 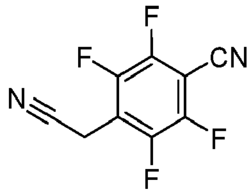 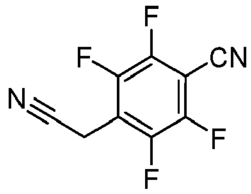

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

r) a charge generation layer, wherein the first charge generation layer comprises 10 vol% of a compound of formula (I) wherein $A^1$, $A^2$ and $A^3$ are selected according to the following:

$A^1$ $A^2$ $A^3$

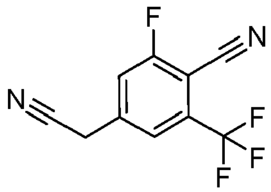 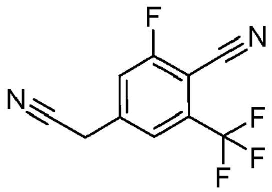 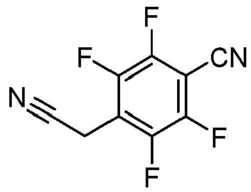

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

s) a charge generation layer, wherein the first charge generation layer comprises 10 wt% of a compound of formula (I) wherein $A^1$, $A^2$ and $A^3$ are selected according to the following:

$A^1$ $A^2$ $A^3$

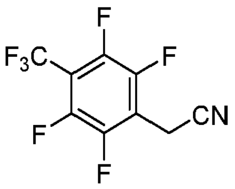 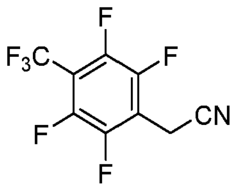 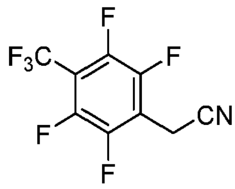

wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

t) a charge generation layer, wherein the first charge generation layer comprises 10 wt% of a compound of formula (I) wherein $A^1$, $A^2$ and $A^3$ are selected according to the following:

$A^1$ 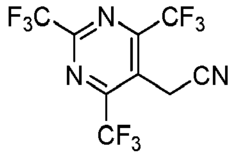 $A^2$ 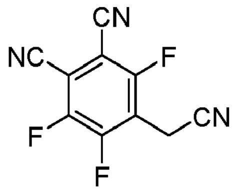 $A^3$ 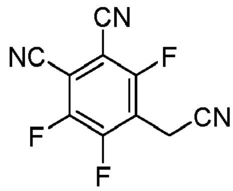

wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

u) a charge generation layer, wherein the first charge generation layer comprises 10 wt% of a compound of formula (I) wherein $A^1$, $A^2$ and $A^3$ are selected according to the following:

$A^1$ 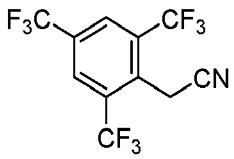 $A^2$ 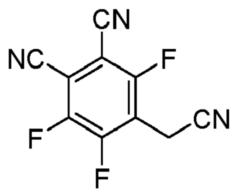 $A^3$ 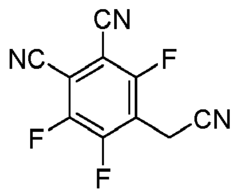

wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

v) a charge generation layer, wherein the first charge generation layer comprises 10 vol% or 10 wt% of a compound of formula (I) wherein $A^1$, $A^2$ and $A^3$ are selected according to the following:

$A^1$ 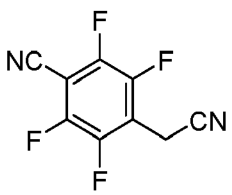 $A^2$ 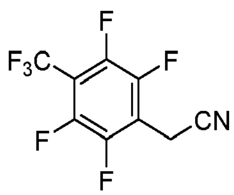 $A^3$ 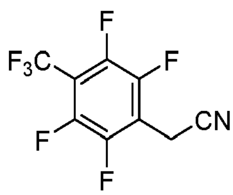

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm,
and the second charge generation layer contains 99 vol.-% 2,2'-(1,3-Phenylene)bis[9-phenyl-1,10-phenanthroline]

and 1 vol.-% Li, wherein the second charge generation layer has a thickness of 15 nm;

w) a charge generation layer, wherein the first charge generation layer comprises 10 vol% or 10 wt% of a compound of formula (I) wherein $A^1$, $A^2$ and $A^3$ are selected according to the following:

$A^1$

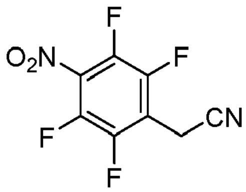

$A^2$

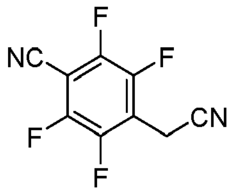

$A^3$

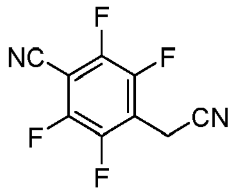

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 15 nm; and

x) a charge generation layer, wherein the first charge generation layer comprises 10 vol% or 10 wt% of a compound of formula (I) wherein $A^1$, $A^2$ and $A^3$ are selected according to the following:

$A^1$

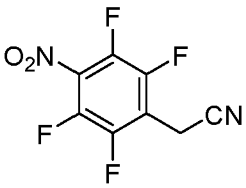

$A^2$

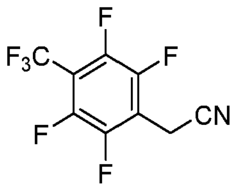

$A^3$

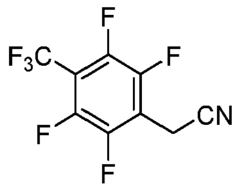

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 15 nm.

According to one embodiment of the present invention, the charge generation layer is not a charge generation layer selected from the group consisting of:

a) a charge generation layer, wherein the first charge generation layer comprises 10.1 vol% of a compound of formula (I) wherein $A^1$, $A^2$ and $A^3$ are selected according to the following:

$A^1$

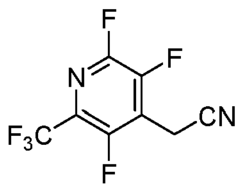

$A^2$

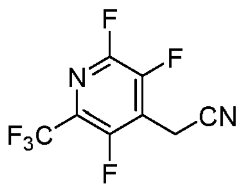

$A^3$

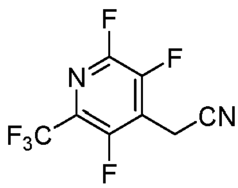

and N-([1,1'-biphenyl]-2-yl)-N-(9,9-dimethyl-9H-fluoren-2-yl)-9,9-diphenyl-9H-fluoren-2-amine,
and the second charge generation layer contains 99 vol.-% 2,2'-(1,3-Phenylene)bis[9-phenyl-1,10-phenanthroline] and 1 vol.-% Li;

b) a charge generation layer, wherein the first charge generation layer comprises 9.8 vol% of a compound of formula (I) wherein $A^1$, $A^2$ and $A^3$ are selected according to the following:

$A^1$ 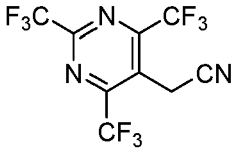 $A^2$ 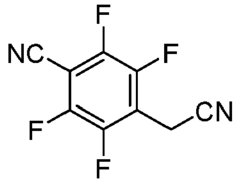 $A^3$ 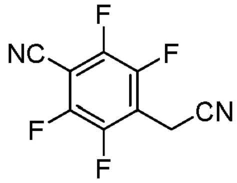

and N-([1,1'-biphenyl]-2-yl)-N-(9,9-dimethyl-9H-fluoren-2-yl)-9,9-diphenyl-9H-fluoren-2-amine, and the second charge generation layer contains 99 vol.-% 2,2'-(1,3-Phenylene)bis[9-phenyl-1,10-phenanthroline] and 1 vol.-% Li;

c) a charge generation layer, wherein the first charge generation layer comprises 12 vol% of a compound of formula (I) wherein $A^1$, $A^2$ and $A^3$ are selected according to the following:

$A^1$ 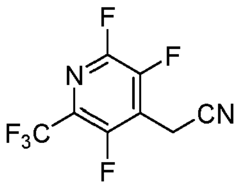 $A^2$ 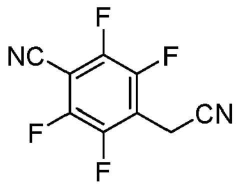 $A^3$ 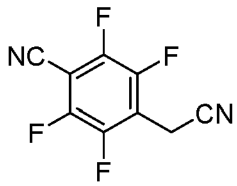

and N-([1,1'-biphenyl]-2-yl)-N-(9,9-dimethyl-9H-fluoren-2-yl)-9,9-diphenyl-9H-fluoren-2-amine, and the second charge generation layer contains 99 vol.-% 2,2'-(1,3-Phenylene)bis[9-phenyl-1,10-phenanthroline] and 1 vol.-% Li;

d) a charge generation layer, wherein the first charge generation layer comprises 9.6 vol% of a compound of formula (I) wherein $A^1$, $A^2$ and $A^3$ are selected according to the following:

$A^1$ 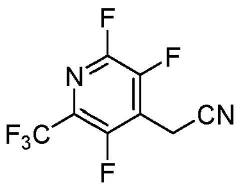 $A^2$ 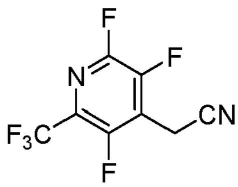 $A^3$ 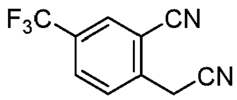

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and 1 vol.-% Li;

e) a charge generation layer, wherein the first charge generation layer comprises 10.1 vol% of a compound of formula (I) wherein $A^1$, $A^2$ and $A^3$ are selected according to the following:

$A^1$ 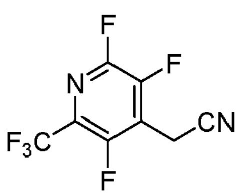 $A^2$ 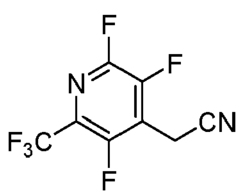 $A^3$ 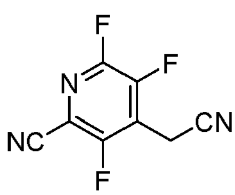

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and 1 vol.-% Li;

f) a charge generation layer, wherein the first charge generation layer comprises 9.9 vol% of a compound of formula (I) wherein $A^1$, $A^2$ and $A^3$ are selected according to the following:

$A^1$ 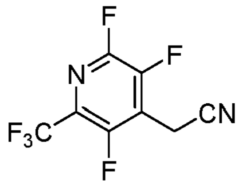 $A^2$ 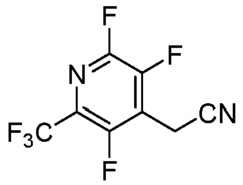 $A^3$ 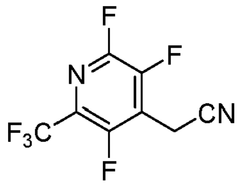

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and 1 vol.-% Li;

g) a charge generation layer, wherein the first charge generation layer comprises 10.8 vol% of a compound of formula (I) wherein $A^1$, $A^2$ and $A^3$ are selected according to the following:

$A^1$ 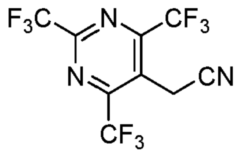 $A^2$ 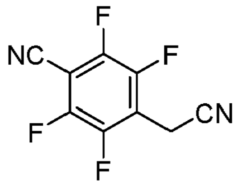 $A^3$ 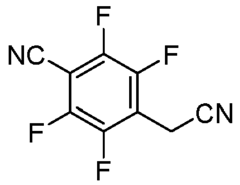

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and 1 vol.-% Li;

h) a charge generation layer, wherein the first charge generation layer comprises 11.8 vol% of a compound of formula (I) wherein $A^1$, $A^2$ and $A^3$ are selected according to the following:

$A^1$ 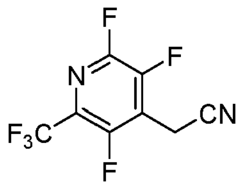 $A^2$ 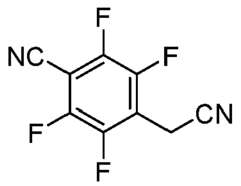 $A^3$ 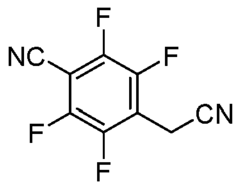

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and 1 vol.-% Li;

i) a charge generation layer, wherein the first charge generation layer comprises 9.9 vol% of a compound of formula (I) wherein $A^1$, $A^2$ and $A^3$ are selected according to the following:

A$^1$ 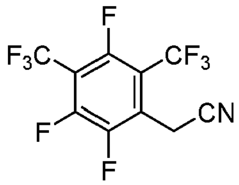 A$^2$ 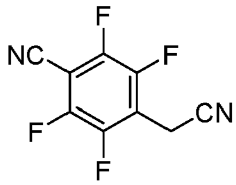 A$^3$ 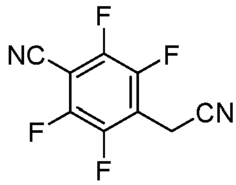

and N-([1,1'-biphenyl]-4-yl)-9,9-dimethyl-N-(4-(9-phenyl-9H-carbazol-3-yl)phenyl)-9H-fluoren-2-amine, and the second charge generation layer contains 99 vol.-% 2,2'-(1,3-Phenylene)bis[9-phenyl-1,10-phenanthroline] and 1 vol.-% Li;

j) a charge generation layer, wherein the first charge generation layer comprises 10.3 vol% of a compound of formula (I) wherein $A^1$, $A^2$ and $A^3$ are selected according to the following:

A$^1$ 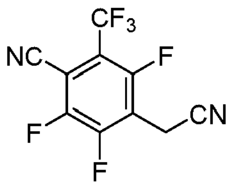 A$^2$ 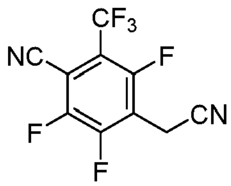 A$^3$ 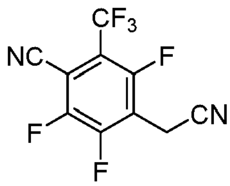

and N-([1,1'-biphenyl]-4-yl)-9,9-dimethyl-N-(4-(9-phenyl-9H-carbazol-3-yl)phenyl)-9H-fluoren-2-amine, and the second charge generation layer contains 99 vol.-% 2,2'-(1,3-Phenylene)bis[9-phenyl-1,10-phenanthroline] and 1 vol.-% Li;

k) a charge generation layer, wherein the first charge generation layer comprises 10.3 vol% of a compound of formula (I) wherein $A^1$, $A^2$ and $A^3$ are selected according to the following:

A$^1$ 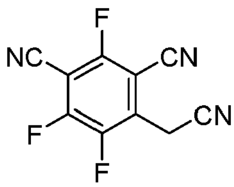 A$^2$ 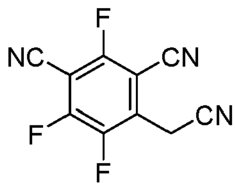 A$^3$ 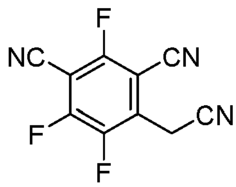

and N-([1,1'-biphenyl]-4-yl)-9,9-dimethyl-N-(4-(9-phenyl-9H-carbazol-3-yl)phenyl)-9H-fluoren-2-amine, and the second charge generation layer contains 99 vol.-% 2,2'-(1,3-Phenylene)bis[9-phenyl-1,10-phenanthroline] and 1 vol.-% Li;

l) a charge generation layer, wherein the first charge generation layer comprises 5 vol% of a compound of formula (I) wherein $A^1$, $A^2$ and $A^3$ are selected according to the following:

A$^1$ 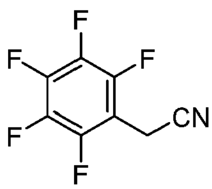 A$^2$ 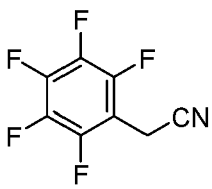 A$^3$ 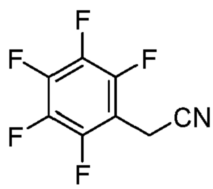

and N-([1,1'-biphenyl]-2-yl)-N-(9,9-dimethyl-9H-fluoren-2-yl)-9,9'-spirobi[fluoren]-4-amine,

and the second charge generation layer contains 99 vol.-% 2,2'-(1,3-Phenylene)bis[9-phenyl-1,10-phenanthroline] and 1 vol.-% or 3 vol.-% Li;

m) a charge generation layer, wherein the first charge generation layer comprises 5 vol% of a compound of formula (I) wherein $A^1$, $A^2$ and $A^3$ are selected according to the following:

$A^1$

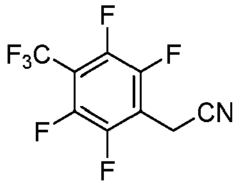

$A^2$

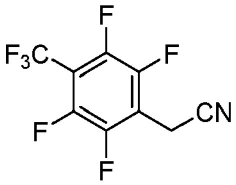

$A^3$

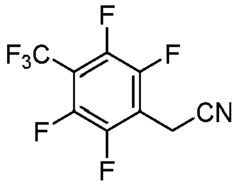

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and 1 vol.-% or 3 vol.-% Li;

n) a charge generation layer, wherein the first charge generation layer comprises 5 vol% or 10 vol% of a compound of formula (I) wherein $A^1$, $A^2$ and $A^3$ are selected according to the following:

$A^1$

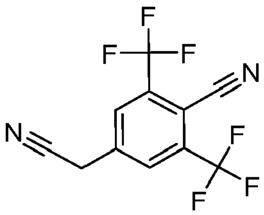

$A^2$

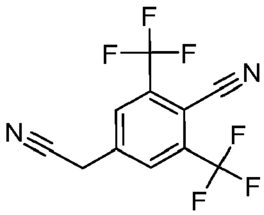

$A^3$

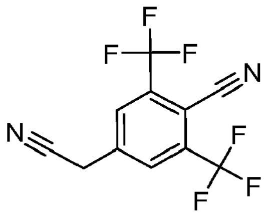

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and 1 vol.-% or 3 vol.-% Li;

o) a charge generation layer, wherein the first charge generation layer comprises 5 vol% or 10 vol% of a compound of formula (I) wherein $A^1$, $A^2$ and $A^3$ are selected according to the following:

$A^1$

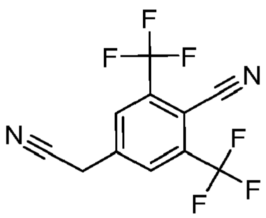

$A^2$

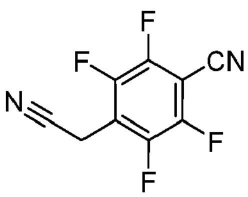

$A^3$

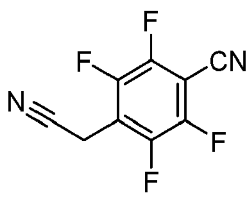

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and 1 vol.-% or 3 vol.-% Li;

p) a charge generation layer, wherein the first charge generation layer comprises 10 vol% of a compound of formula (I) wherein $A^1$, $A^2$ and $A^3$ are selected according to the following:

$A^1$ 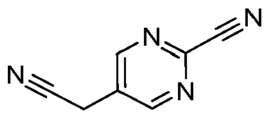 $A^2$ 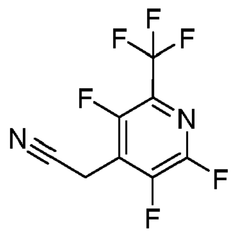 $A^3$ 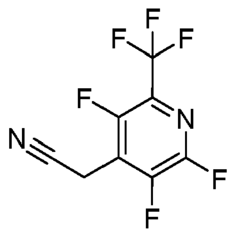

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and 1 vol.-% or 3 vol.-% Li;

q) a charge generation layer, wherein the first charge generation layer comprises 10 vol% of a compound of formula (I) wherein $A^1$, $A^2$ and $A^3$ are selected according to the following:

$A^1$ 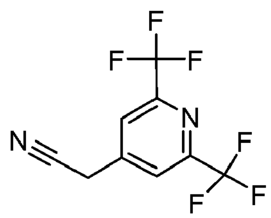 $A^2$ 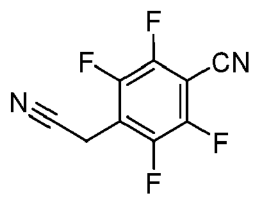 $A^3$ 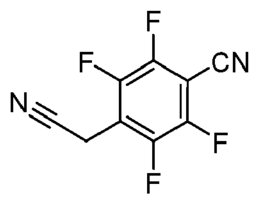

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and 1 vol.-% or 3 vol.-% Li;

r) a charge generation layer, wherein the first charge generation layer comprises 10 vol% of a compound of formula (I) wherein $A^1$, $A^2$ and $A^3$ are selected according to the following:

$A^1$ 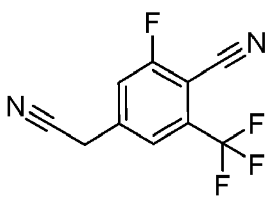 $A^2$ 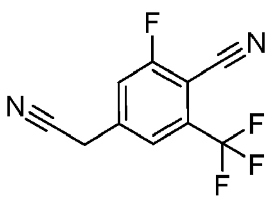 $A^3$ 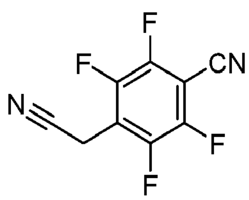

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and 1 vol.-% or 3 vol.-% Li;

s) a charge generation layer, wherein the first charge generation layer comprises 10 wt% of a compound of formula (I) wherein $A^1$, $A^2$ and $A^3$ are selected according to the following:

$A^1$ 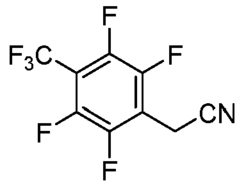 $A^2$ 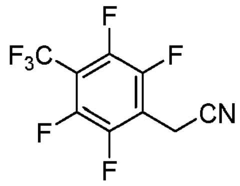 $A^3$ 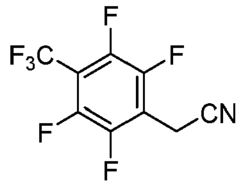

and the second charge generation layer contains 99 vol.-% 2,2'-(1,3-Phenylene)bis[9-phenyl-1,10-phenanthroline] and 1 vol.-% Li;

t) a charge generation layer, wherein the first charge generation layer comprises 10 wt% of a compound of formula (I) wherein $A^1$, $A^2$ and $A^3$ are selected according to the following:

$A^1$ 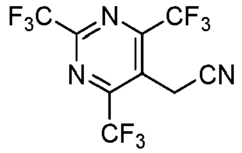 $A^2$ 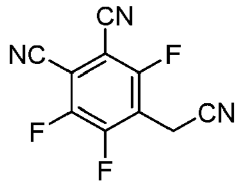 $A^3$ 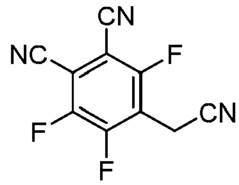

and the second charge generation layer contains 99 vol.-% 2,2'-(1,3-Phenylene)bis[9-phenyl-1,10-phenanthroline] and 1 vol.-% Li;

u) a charge generation layer, wherein the first charge generation layer comprises 10 wt% of a compound of formula (I) wherein $A^1$, $A^2$ and $A^3$ are selected according to the following:

$A^1$ 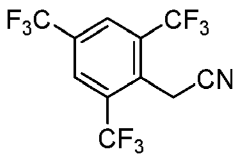 $A^2$ 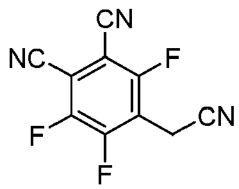 $A^3$ 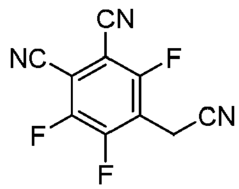

and the second charge generation layer contains 99 vol.-% 2,2'-(1,3-Phenylene)bis[9-phenyl-1,10-phenanthroline] and 1 vol.-% Li;

v) a charge generation layer, wherein the first charge generation layer comprises 10 vol% or 10 wt% of a compound of formula (I) wherein $A^1$, $A^2$ and $A^3$ are selected according to the following:

$A^1$ 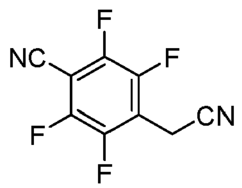 $A^2$ 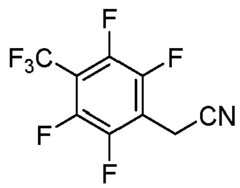 $A^3$ 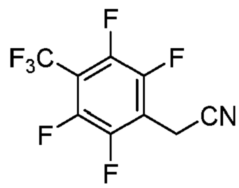

and N-([1,1'-biphenyl]-2-yl)-N-(9.9-dimethyl-9H-fluoren-2-yl)-9,9'spirobi[fluoren]-2-amine,
and the second charge generation layer contains 99 vol.-% 2,2'-(1,3-Phenylene)bis[9-phenyl-1,10-phenanthroline] and 1 vol.-% Li;

w) a charge generation layer, wherein the first charge generation layer comprises 10 vol% or 10 wt% of a compound of formula (I) wherein $A^1$, $A^2$ and $A^3$ are selected according to the following:

$A^1$

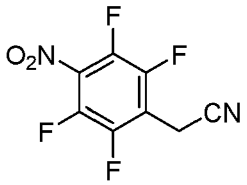

$A^2$

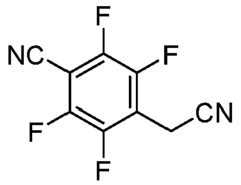

$A^3$

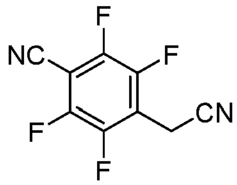

and N-([1,1’-biphenyl]-2-yl)-N-(9.9-dimethyl-9H-fluoren-2-yl)-9,9’spirobi[fluoren]-2-amine, and the second charge generation layer contains 99 vol.-% 2,2’-(1,3-Phenylene)bis[9-phenyl-1,10-phenanthroline] and 1 vol.-% Li; and

x) a charge generation layer, wherein the first charge generation layer comprises 10 vol% or 10 wt% of a compound of formula (I) wherein $A^1$, $A^2$ and $A^3$ are selected according to the following:

$A^1$

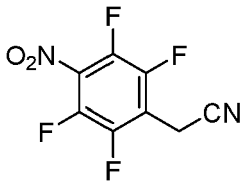

$A^2$

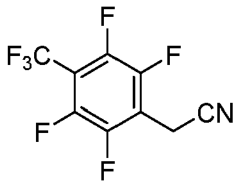

$A^3$

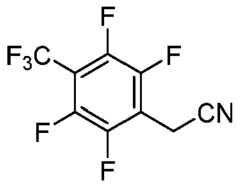

and N-([1,1’-biphenyl]-2-yl)-N-(9.9-dimethyl-9H-fluoren-2-yl)-9,9’spirobi[fluoren]-2-amine, and the second charge generation layer contains 99 vol.-% 2,2’-(1,3-Phenylene)bis[9-phenyl-1,10-phenanthroline] and 1 vol.-% Li.

According to one embodiment of the present invention, the charge generation layer is not a charge generation layer selected from the group consisting of:

a) a charge generation layer, wherein the first charge generation layer comprises 10.1 vol% of a compound of formula (I) wherein $A^1$, $A^2$ and $A^3$ are selected according to the following:

$A^1$

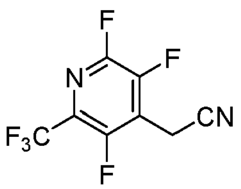

$A^2$

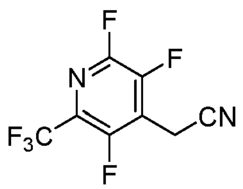

$A^3$

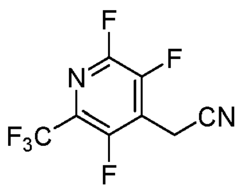

and N-([1,1’-biphenyl]-2-yl)-N-(9,9-dimethyl-9H-fluoren-2-yl)-9,9-diphenyl-9H-fluoren-2-amine, wherein the first charge generation layer has a thickness of 86 nm, and the second charge generation layer contains 99 vol.-% 2,2’-(1,3-Phenylene)bis[9-phenyl-1,10-phenanthroline] and as metal dopant Li, wherein the second charge generation layer has a thickness of 10 nm;

b) a charge generation layer, wherein the first charge generation layer comprises 9.8 vol% of a compound of formula (I) wherein $A^1$, $A^2$ and $A^3$ are selected according to the following:

$A^1$ $A^2$ $A^3$

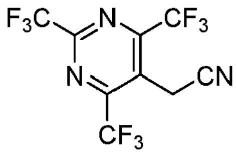 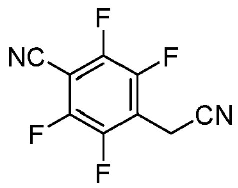 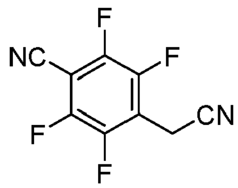

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

c) a charge generation layer, wherein the first charge generation layer comprises 12 vol% of a compound of formula (I) wherein $A^1$, $A^2$ and $A^3$ are selected according to the following:

$A^1$ 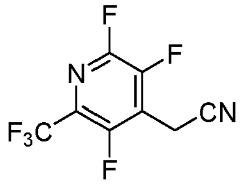 $A^2$ 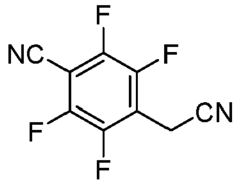 $A^3$ 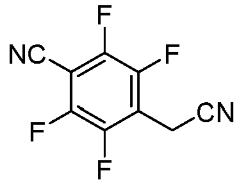

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

d) a charge generation layer, wherein the first charge generation layer comprises 9.6 vol% of a compound of formula (I) wherein $A^1$, $A^2$ and $A^3$ are selected according to the following:

$A^1$ 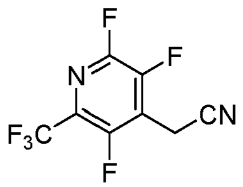 $A^2$ 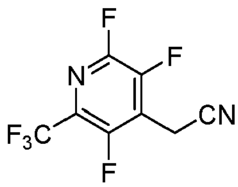 $A^3$ 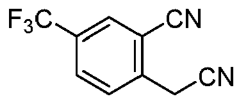

and N-([1,1'-biphenyl]-2-yl)-N-(9,9-dimethyl-9H-fluoren-2-yl)-9,9'-spirobi[fluoren]-2-amine, wherein the first charge generation layer has a thickness of 81 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

e) a charge generation layer, wherein the first charge generation layer comprises 10.1 vol% of a compound of formula (I) wherein $A^1$, $A^2$ and $A^3$ are selected according to the following:

$A^1$ 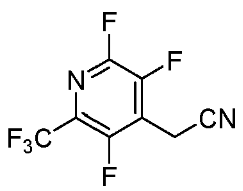 $A^2$ 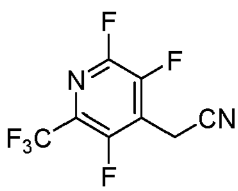 $A^3$ 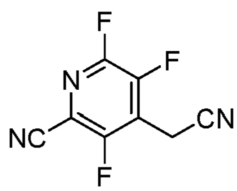

and N-([1,1'-biphenyl]-2-yl)-N-(9,9-dimethyl-9H-fluoren-2-yl)-9,9'-spirobi[fluoren]-2-amine, wherein the first charge generation layer has a thickness of 81 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

f) a charge generation layer, wherein the first charge generation layer comprises 9.9 vol% of a compound of formula (I) wherein $A^1$, $A^2$ and $A^3$ are selected according to the following:

$A^1$
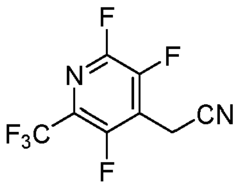
$A^2$
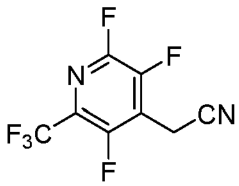
$A^3$
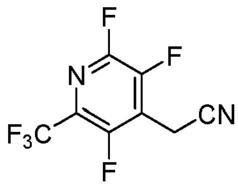

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

g) a charge generation layer, wherein the first charge generation layer comprises 10.8 vol% of a compound of formula (I) wherein $A^1$, $A^2$ and $A^3$ are selected according to the following:

$A^1$
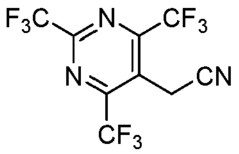
$A^2$
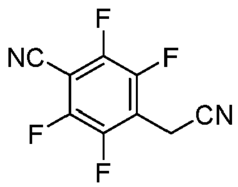
$A^3$
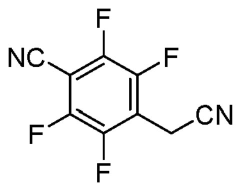

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

h) a charge generation layer, wherein the first charge generation layer comprises 11.8 vol% of a compound of formula (I) wherein $A^1$, $A^2$ and $A^3$ are selected according to the following:

$A^1$
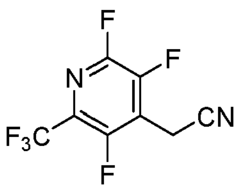
$A^2$
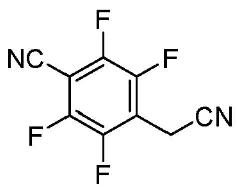
$A^3$
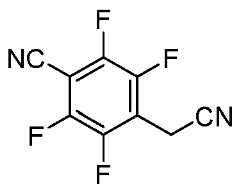

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

i) a charge generation layer, wherein the first charge generation layer comprises 9.9 vol% of a compound of formula (I) wherein $A^1$, $A^2$ and $A^3$ are selected according to the following:

A$^1$ 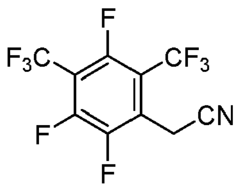 A$^2$ 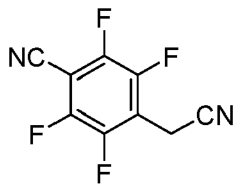 A$^3$ 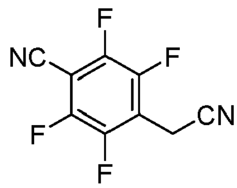

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm, and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

j) a charge generation layer, wherein the first charge generation layer comprises 10.3 vol% of a compound of formula (I) wherein $A^1$, $A^2$ and $A^3$ are selected according to the following:

A$^1$ 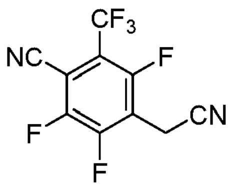 A$^2$ 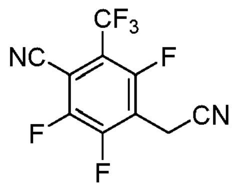 A$^3$ 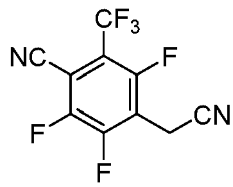

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm, and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

k) a charge generation layer, wherein the first charge generation layer comprises 10.3 vol% of a compound of formula (I) wherein $A^1$, $A^2$ and $A^3$ are selected according to the following:

A$^1$ 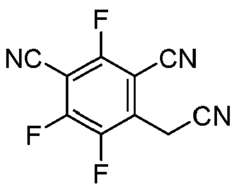 A$^2$ 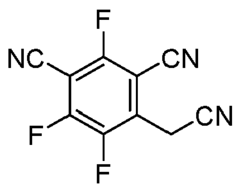 A$^3$ 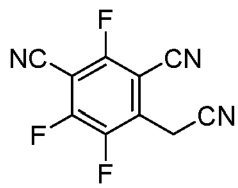

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm, and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

l) a charge generation layer, wherein the first charge generation layer comprises 5 vol% of a compound of formula (I) wherein $A^1$, $A^2$ and $A^3$ are selected according to the following:

$A^1$ 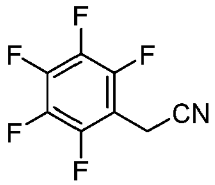 $A^2$ 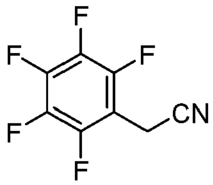 $A^3$ 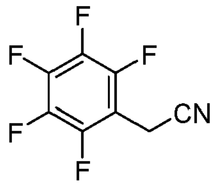

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

m) a charge generation layer, wherein the first charge generation layer comprises 5 vol% of a compound of formula (I) wherein $A^1$, $A^2$ and $A^3$ are selected according to the following:

$A^1$ 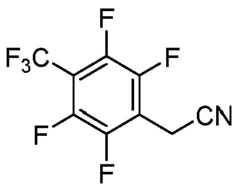 $A^2$ 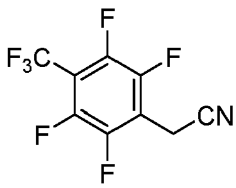 $A^3$ 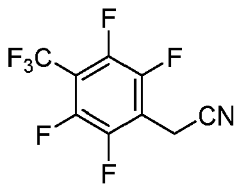

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

n) a charge generation layer, wherein the first charge generation layer comprises 5 vol% or 10 vol% of a compound of formula (I) wherein $A^1$, $A^2$ and $A^3$ are selected according to the following:

$A^1$ 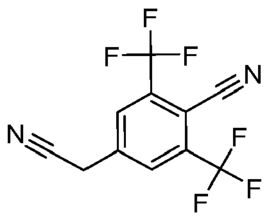 $A^2$ 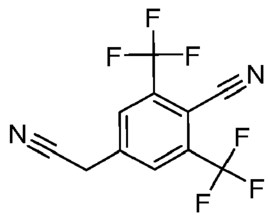 $A^3$ 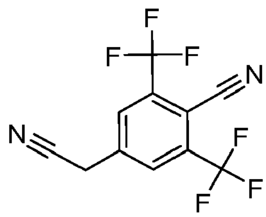

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

o) a charge generation layer, wherein the first charge generation layer comprises 5 vol% or 10 vol% of a compound of formula (I) wherein $A^1$, $A^2$ and $A^3$ are selected according to the following:

A$^1$

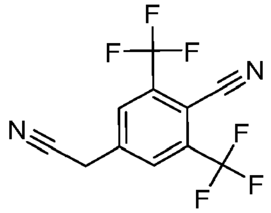

A$^2$

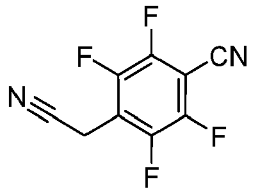

A$^3$

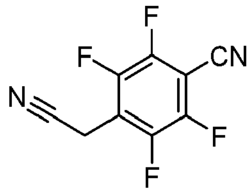

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

p) a charge generation layer, wherein the first charge generation layer comprises 10 vol% of a compound of formula (I) wherein A$^1$, A$^2$ and A$^3$ are selected according to the following:

A$^1$

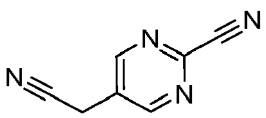

A$^2$

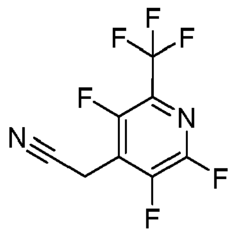

A$^3$

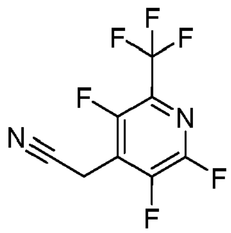

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

q) a charge generation layer, wherein the first charge generation layer comprises 10 vol% of a compound of formula (I) wherein A$^1$, A$^2$ and A$^3$ are selected according to the following:

A$^1$

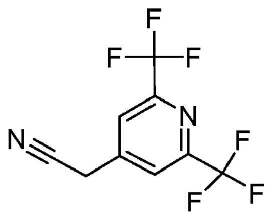

A$^2$

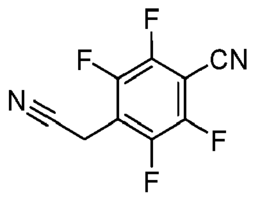

A$^3$

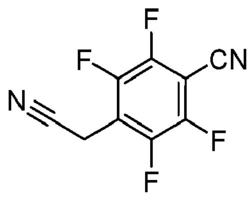

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

r) a charge generation layer, wherein the first charge generation layer comprises 10 vol% of a compound of formula (I) wherein A$^1$, A$^2$ and A$^3$ are selected according to the following:

$A^1$

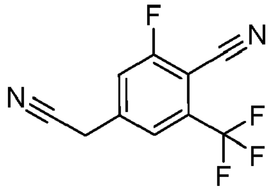

$A^2$

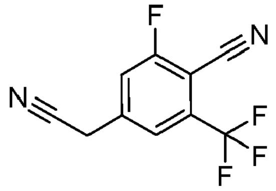

$A^3$

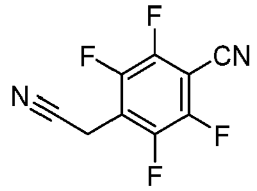

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

s) a charge generation layer, wherein the first charge generation layer comprises 10 wt% of a compound of formula (I) wherein $A^1$, $A^2$ and $A^3$ are selected according to the following:

$A^1$

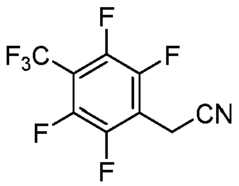

$A^2$

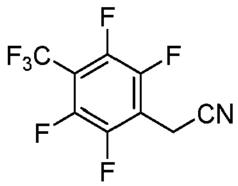

$A^3$

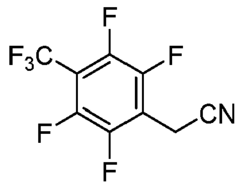

wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

t) a charge generation layer, wherein the first charge generation layer comprises 10 wt% of a compound of formula (I) wherein $A^1$, $A^2$ and $A^3$ are selected according to the following:

$A^1$

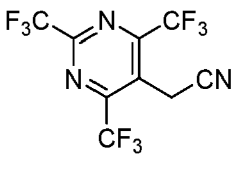

$A^2$

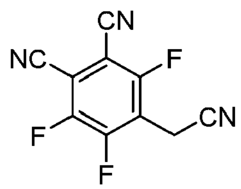

$A^3$

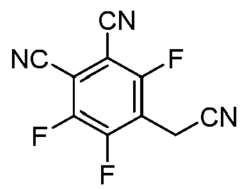

wherein the first charge generation layer has a thickness of 10 nm,
and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

u) a charge generation layer, wherein the first charge generation layer comprises 10 wt% of a compound of formula (I) wherein $A^1$, $A^2$ and $A^3$ are selected according to the following:

$A^1$

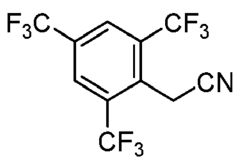

$A^2$

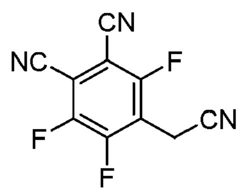

$A^3$

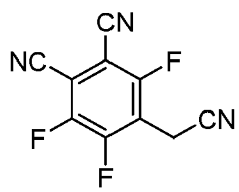

wherein the first charge generation layer has a thickness of 10 nm, and the second charge generation layer contains 99 vol.-% 2,2'-(1,3-Phenylene)bis[9-phenyl-1,10-phenanthroline] and as metal dopant Li, wherein the second charge generation layer has a thickness of 10 nm;

v) a charge generation layer, wherein the first charge generation layer comprises 10 vol% or 10 wt% of a compound of formula (I) wherein $A^1$, $A^2$ and $A^3$ are selected according to the following:

A$^1$

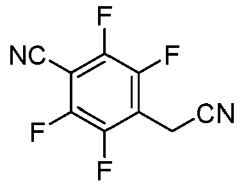

A$^2$

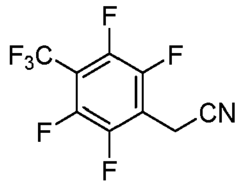

A$^3$

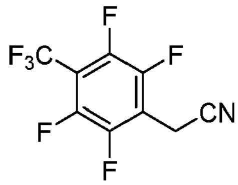

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm, and the second charge generation layer contains 99 vol.-% 2,2'-(1,3-Phenylene)bis[9-phenyl-1,10-phenanthroline] and as metal dopant Li, wherein the second charge generation layer has a thickness of 15 nm;

w) a charge generation layer, wherein the first charge generation layer comprises 10 vol% or 10 wt% of a compound of formula (I) wherein $A^1$, $A^2$ and $A^3$ are selected according to the following:

A$^1$

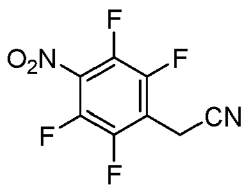

A$^2$

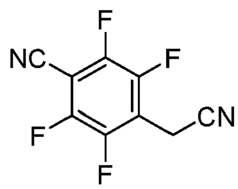

A$^3$

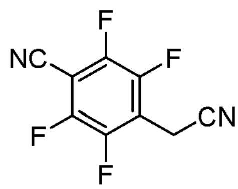

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm, and the second charge generation layer contains 99 vol.-% 2,2'-(1,3-Phenylene)bis[9-phenyl-1,10-phenanthroline] and as metal dopant Li, wherein the second charge generation layer has a thickness of 15 nm; and

x) a charge generation layer, wherein the first charge generation layer comprises 10 vol% or 10 wt% of a compound of formula (I) wherein $A^1$, $A^2$ and $A^3$ are selected according to the following:

A$^1$

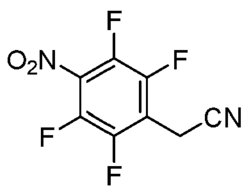

A$^2$

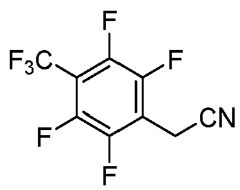

A$^3$

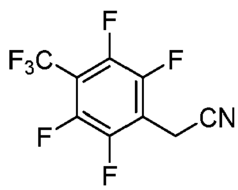

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm, and the second charge generation layer contains 99 vol.-% 2,2'-(1,3-Phenylene)bis[9-phenyl-1,10-phenanthroline] and as metal dopant Li, wherein the second charge generation layer has a thickness of 15 nm.

According to one embodiment of the present invention, the charge generation layer is not a charge generation layer selected from the group consisting of:

a) a charge generation layer, wherein the first charge generation layer comprises a compound of formula (I) wherein $A^1$, $A^2$ and $A^3$ are selected according to the following:

$A^1$

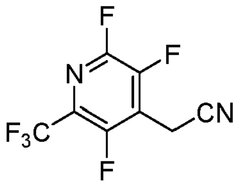

$A^2$

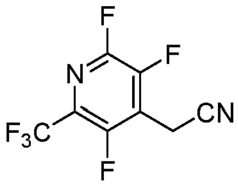

$A^3$

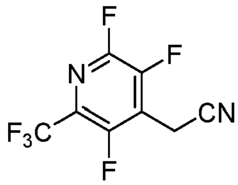

and N-([1,1'-biphenyl]-2-yl)-N-(9,9-dimethyl-9H-fluoren-2-yl)-9,9-diphenyl-9H-fluoren-2-amine, and the second charge generation layer contains 99 vol.-% 2,2'-(1,3-Phenylene)bis[9-phenyl-1,10-phenanthroline] and as metal dopant Li;

b) a charge generation layer, wherein the first charge generation layer comprises a compound of formula (I) wherein $A^1$, $A^2$ and $A^3$ are selected according to the following:

$A^1$

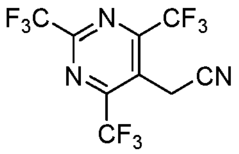

$A^2$

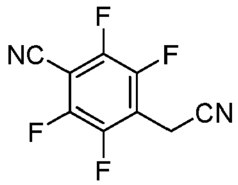

$A^3$

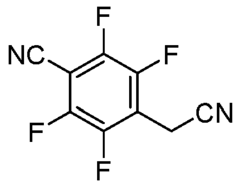

and N-([1,1'-biphenyl]-2-yl)-N-(9,9-dimethyl-9H-fluoren-2-yl)-9,9-diphenyl-9H-fluoren-2-amine, and the second charge generation layer contains 99 vol.-% 2,2'-(1,3-Phenylene)bis[9-phenyl-1,10-phenanthroline] and as metal dopant Li;

c) a charge generation layer, wherein the first charge generation layer comprises a compound of formula (I) wherein $A^1$, $A^2$ and $A^3$ are selected according to the following:

$A^1$

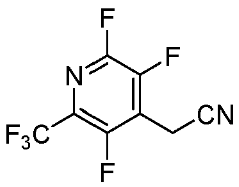

$A^2$

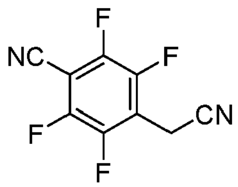

$A^3$

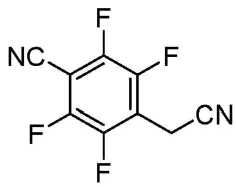

and N-([1,1'-biphenyl]-2-yl)-N-(9,9-dimethyl-9H-fluoren-2-yl)-9,9-diphenyl-9H-fluoren-2-amine, and the second charge generation layer contains 99 vol.-% 2,2'-(1,3-Phenylene)bis[9-phenyl-1,10-phenanthroline] and as metal dopant Li;

d) a charge generation layer, wherein the first charge generation layer comprises a compound of formula (I) wherein $A^1$, $A^2$ and $A^3$ are selected according to the following:

$A^1$

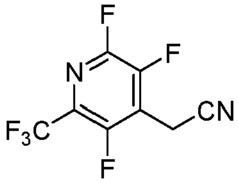

$A^2$

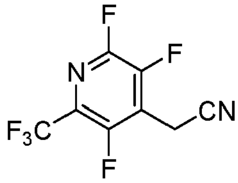

$A^3$

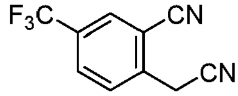

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and as metal dopant Li;

e) a charge generation layer, wherein the first charge generation layer comprises a compound of formula (I) wherein $A^1$, $A^2$ and $A^3$ are selected according to the following:

$A^1$

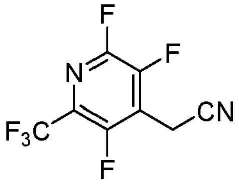

$A^2$

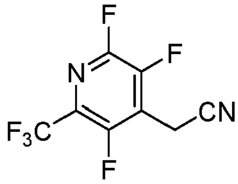

$A^3$

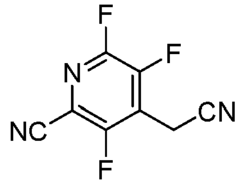

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and as metal dopant Li;

f) a charge generation layer, wherein the first charge generation layer comprises a compound of formula (I) wherein $A^1$, $A^2$ and $A^3$ are selected according to the following:

$A^1$

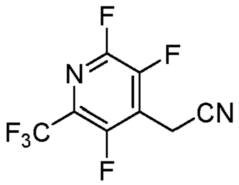

$A^2$

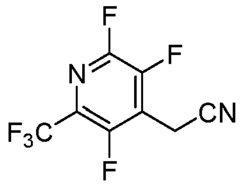

$A^3$

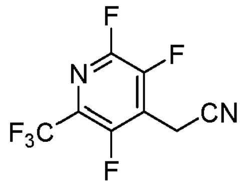

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and as metal dopant Li;

g) a charge generation layer, wherein the first charge generation layer comprises a compound of formula (I) wherein $A^1$, $A^2$ and $A^3$ are selected according to the following:

$A^1$

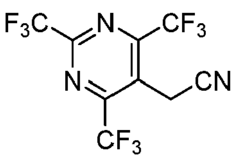

$A^2$

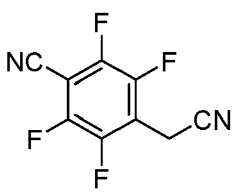

$A^3$

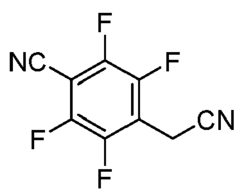

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and as metal dopant Li;

h) a charge generation layer, wherein the first charge generation layer comprises a compound of formula (I) wherein $A^1$, $A^2$ and $A^3$ are selected according to the following:

$A^1$

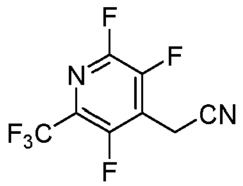

$A^2$

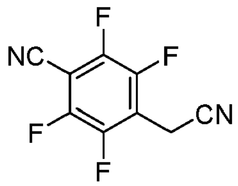

$A^3$

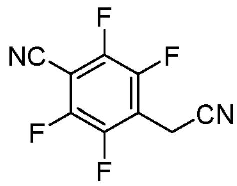

and N-([1,1'-biphenyl]-2-yl)-N-(9,9-dimethyl-9H-fluoren-2-yl)-9,9'-spirobi[fluoren]-2-amine, and the second charge generation layer contains 99 vol.-% 2,2'-(1,3-Phenylene)bis[9-phenyl-1,10-phenanthroline] and as metal dopant Li;

i) a charge generation layer, wherein the first charge generation layer comprises a compound of formula (I) wherein $A^1$, $A^2$ and $A^3$ are selected according to the following:

$A^1$

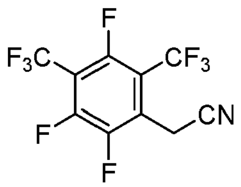

$A^2$

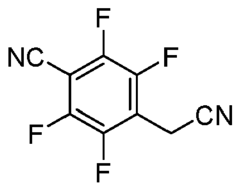

$A^3$

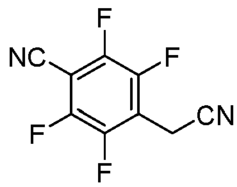

and N-([1,1'-biphenyl]-4-yl)-9,9-dimethyl-N-(4-(9-phenyl-9H-carbazol-3-yl)phenyl)-9H-fluoren-2-amine, and the second charge generation layer contains 99 vol.-% 2,2'-(1,3-Phenylene)bis[9-phenyl-1,10-phenanthroline] and as metal dopant Li;

j) a charge generation layer, wherein the first charge generation layer comprises a compound of formula (I) wherein $A^1$, $A^2$ and $A^3$ are selected according to the following:

$A^1$

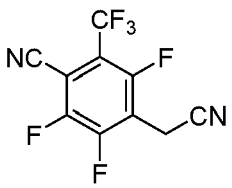

$A^2$

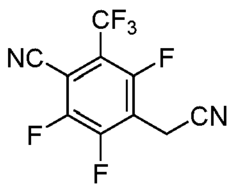

$A^3$

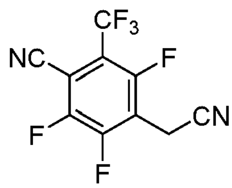

and N-([1,1'-biphenyl]-4-yl)-9,9-dimethyl-N-(4-(9-phenyl-9H-carbazol-3-yl)phenyl)-9H-fluoren-2-amine, and the second charge generation layer contains 99 vol.-% 2,2'-(1,3-Phenylene)bis[9-phenyl-1,10-phenanthroline] and as metal dopant Li;

k) a charge generation layer, wherein the first charge generation layer comprises a compound of formula (I) wherein $A^1$, $A^2$ and $A^3$ are selected according to the following:

A$^1$ A$^2$ A$^3$

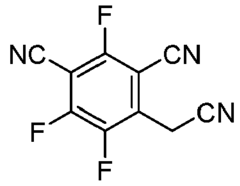 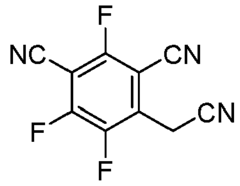 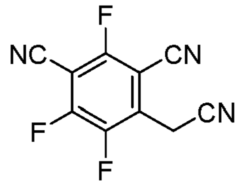

and N-([1,1'-biphenyl]-4-yl)-9,9-dimethyl-N-(4-(9-phenyl-9H-carbazol-3-yl)phenyl)-9H-fluoren-2-amine, and the second charge generation layer contains 99 vol.-% 2,2'-(1,3-Phenylene)bis[9-phenyl-1,10-phenanthroline] and as metal dopant Li;

l) a charge generation layer, wherein the first charge generation layer comprises a compound of formula (I) wherein A$^1$, A$^2$ and A$^3$ are selected according to the following:

A$^1$ A$^2$ A$^3$

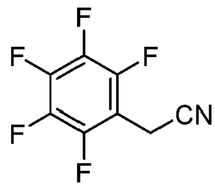 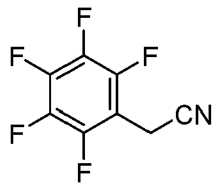 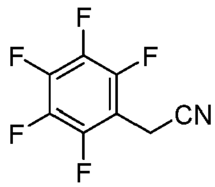

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and as metal dopant Li;

m) a charge generation layer, wherein the first charge generation layer comprises a compound of formula (I) wherein A$^1$, A$^2$ and A$^3$ are selected according to the following:

A$^1$ A$^2$ A$^3$

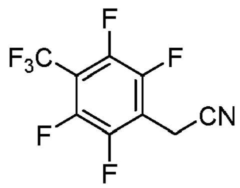 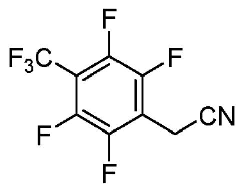 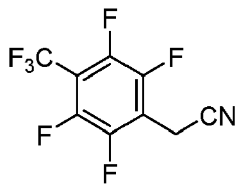

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and as metal dopant Li;

n) a charge generation layer, wherein the first charge generation layer comprises a compound of formula (I) wherein A$^1$, A$^2$ and A$^3$ are selected according to the following:

A$^1$ A$^2$ A$^3$

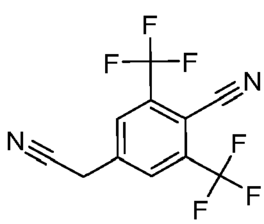 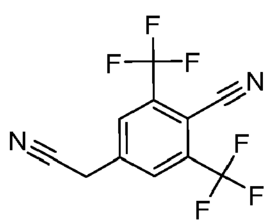 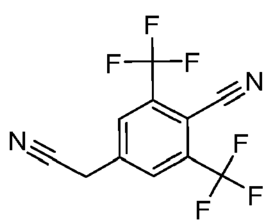

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and as metal dopant Li;

o) a charge generation layer, wherein the first charge generation layer comprises a compound of formula (I) wherein $A^1$, $A^2$ and $A^3$ are selected according to the following:

$A^1$

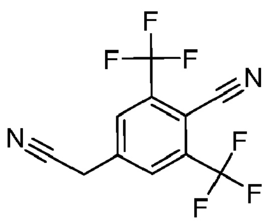

$A^2$

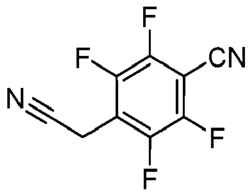

$A^3$

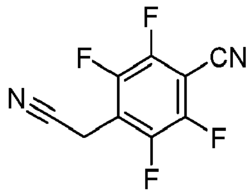

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and as metal dopant Li;

p) a charge generation layer, wherein the first charge generation layer comprises a compound of formula (I) wherein $A^1$, $A^2$ and $A^3$ are selected according to the following:

$A^1$

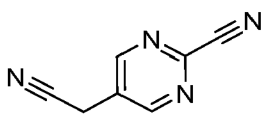

$A^2$

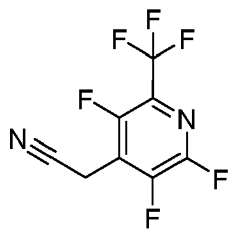

$A^3$

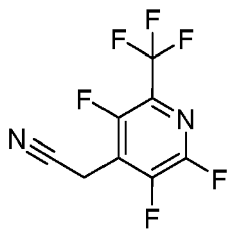

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and as metal dopant Li;

q) a charge generation layer, wherein the first charge generation layer comprises a compound of formula (I) wherein $A^1$, $A^2$ and $A^3$ are selected according to the following:

$A^1$

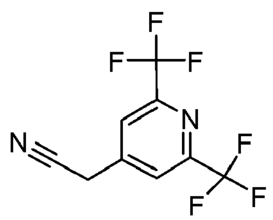

$A^2$

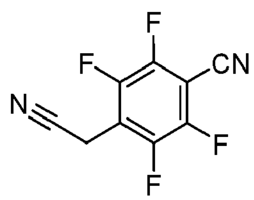

$A^3$

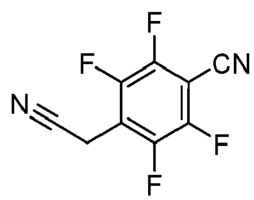

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and as metal dopant Li;

r) a charge generation layer, wherein the first charge generation layer comprises a compound of formula (I) wherein $A^1$, $A^2$ and $A^3$ are selected according to the following:

$A^1$

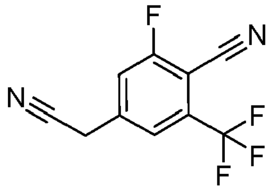

$A^2$

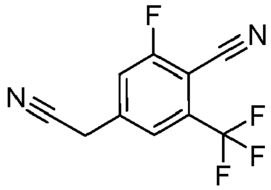

$A^3$

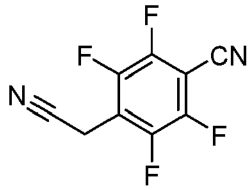

and N-([1,1'-biphenyl]-2-yl)-N-(9,9-dimethyl-9H-fluoren-2-yl)-9,9'-spirobi[fluoren]-4-amine, and the second charge generation layer contains 99 vol.-% 2,2'-(1,3-Phenylene)bis[9-phenyl-1,10-phenanthroline] and as metal dopant Li;

s) a charge generation layer, wherein the first charge generation layer comprises a compound of formula (I) wherein $A^1$, $A^2$ and $A^3$ are selected according to the following:

$A^1$

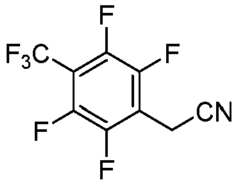

$A^2$

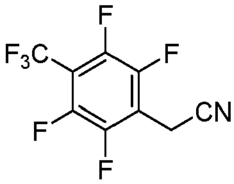

$A^3$

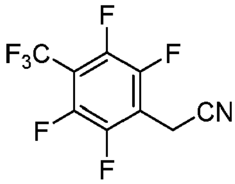

and the second charge generation layer contains 99 vol.-% 2,2'-(1,3-Phenylene)bis[9-phenyl-1,10-phenanthroline] and as metal dopant Li;

t) a charge generation layer, wherein the first charge generation layer comprises a compound of formula (I) wherein $A^1$, $A^2$ and $A^3$ are selected according to the following:

$A^1$

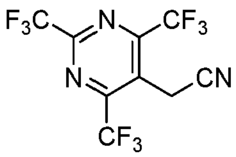

$A^2$

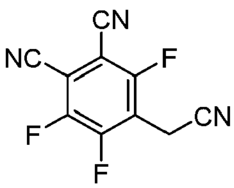

$A^3$

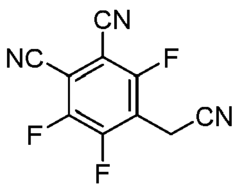

and the second charge generation layer contains 99 vol.-% 2,2'-(1,3-Phenylene)bis[9-phenyl-1,10-phenanthroline] and as metal dopant Li;

u) a charge generation layer, wherein the first charge generation layer comprises a compound of formula (I) wherein $A^1$, $A^2$ and $A^3$ are selected according to the following:

$A^1$

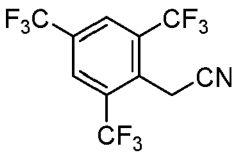

$A^2$

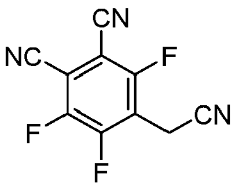

$A^3$

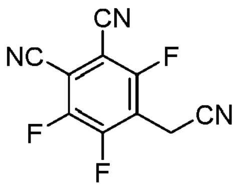

and the second charge generation layer contains 99 vol.-% 2,2'-(1,3-Phenylene)bis[9-phenyl-1,10-phenanthroline] and as metal dopant Li;

v) a charge generation layer, wherein the first charge generation layer comprises a compound of formula (I) wherein $A^1$, $A^2$ and $A^3$ are selected according to the following:

$A^1$

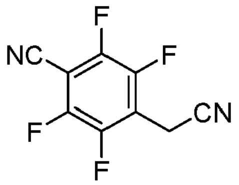

$A^2$

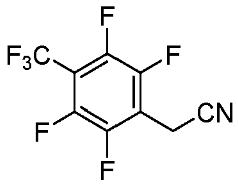

$A^3$

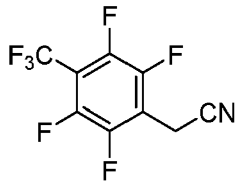

and N-([1,1'-biphenyl]-2-yl)-N-(9.9-dimethyl-9H-fluoren-2-yl)-9,9'spirobi[fluoren]-2-amine, and the second charge generation layer contains 99 vol.-% 2,2'-(1,3-Phenylene)bis[9-phenyl-1,10-phenanthroline] and as metal dopant Li;

w) a charge generation layer, wherein the first charge generation layer comprises a compound of formula (I) wherein $A^1$, $A^2$ and $A^3$ are selected according to the following:

$A^1$

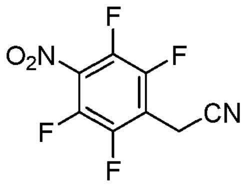

$A^2$

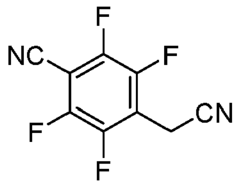

$A^3$

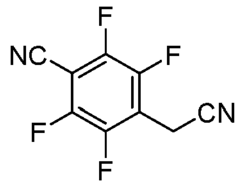

and N-([1,1'-biphenyl]-2-yl)-N-(9.9-dimethyl-9H-fluoren-2-yl)-9,9'spirobi[fluoren]-2-amine, and the second charge generation layer contains 99 vol.-% 2,2'-(1,3-Phenylene)bis[9-phenyl-1,10-phenanthroline] and as metal dopant Li; and

x) a charge generation layer, wherein the first charge generation layer comprises a compound of formula (I) wherein $A^1$, $A^2$ and $A^3$ are selected according to the following:

$A^1$

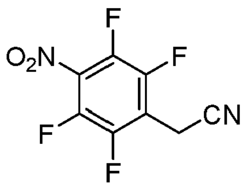

$A^2$

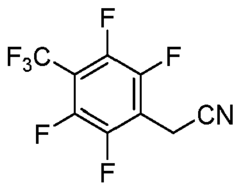

$A^3$

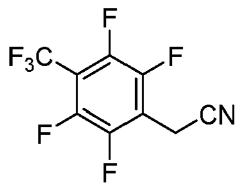

and N-([1,1'-biphenyl]-2-yl)-N-(9.9-dimethyl-9H-fluoren-2-yl)-9,9'spirobi[fluoren]-2-amine, and the second charge generation layer contains 99 vol.-% 2,2'-(1,3-Phenylene)bis[9-phenyl-1,10-phenanthroline] and as metal dopant Li.

According to one embodiment of the present invention, the charge generation layer is not a charge generation layer selected from the group consisting of:

a) a charge generation layer, wherein the first charge generation layer comprises a compound of formula (I) wherein $A^1$, $A^2$ and $A^3$ are selected according to the following:

A1
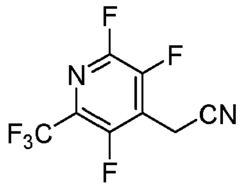
A2
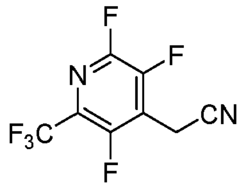
A3
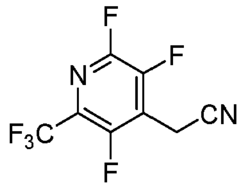
;

b) a charge generation layer, wherein the first charge generation layer comprises a compound of formula (I) wherein $A^1$, $A^2$ and $A^3$ are selected according to the following:

A1
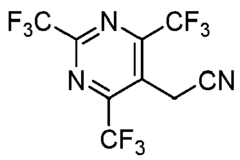
A2
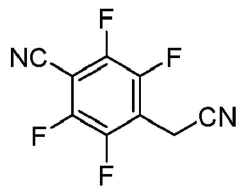
A3
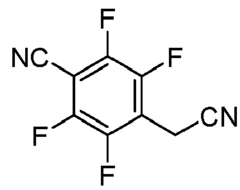
;

c) a charge generation layer, wherein the first charge generation layer a compound of formula (I) wherein $A^1$, $A^2$ and $A^3$ are selected according to the following:

A1
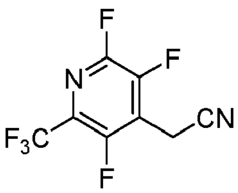
A2
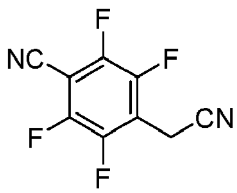
A3
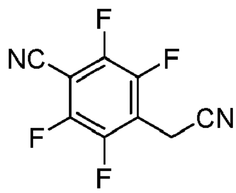
;

d) a charge generation layer, wherein the first charge generation layer comprises a compound of formula (I) wherein $A^1$, $A^2$ and $A^3$ are selected according to the following:

A1
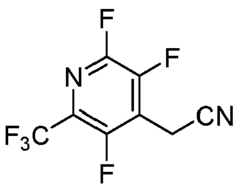
A2
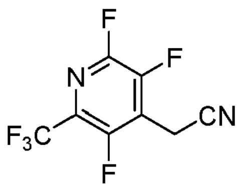
A3
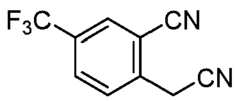
;

e) a charge generation layer, wherein the first charge generation layer comprises a compound of formula (I) wherein $A^1$, $A^2$ and $A^3$ are selected according to the following:

A1
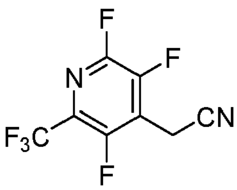
A2
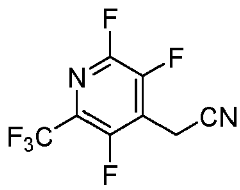
A3
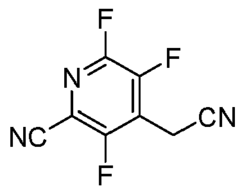
;

f) a charge generation layer, wherein the first charge generation layer comprises a compound of formula (I) wherein $A^1$, $A^2$ and $A^3$ are selected according to the following:

$A^1$

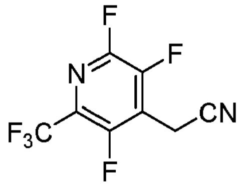

$A^2$

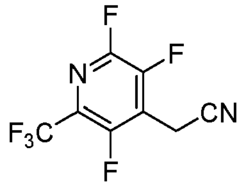

$A^3$

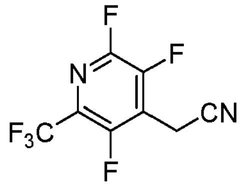

;

g) a charge generation layer, wherein the first charge generation layer comprises a compound of formula (I) wherein $A^1$, $A^2$ and $A^3$ are selected according to the following:

$A^1$

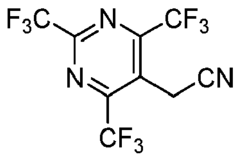

$A^2$

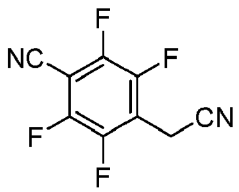

$A^3$

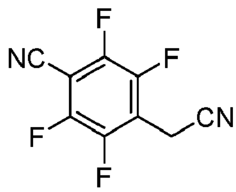

;

h) a charge generation layer, wherein the first charge generation layer comprises a compound of formula (I) wherein $A^1$, $A^2$ and $A^3$ are selected according to the following:

$A^1$

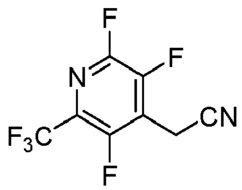

$A^2$

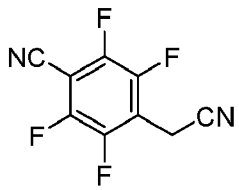

$A^3$

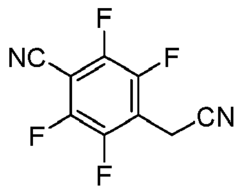

;

i) a charge generation layer, wherein the first charge generation layer comprises a compound of formula (I) wherein $A^1$, $A^2$ and $A^3$ are selected according to the following:

$A^1$

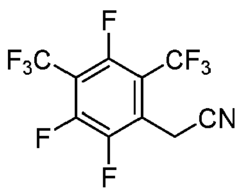

$A^2$

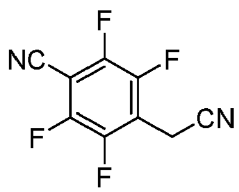

$A^3$

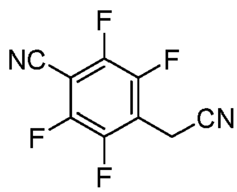

;

j) a charge generation layer, wherein the first charge generation layer comprises a compound of formula (I) wherein $A^1$, $A^2$ and $A^3$ are selected according to the following:

$A^1$ 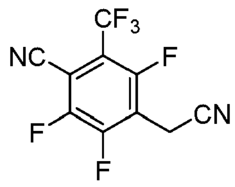 $A^2$ 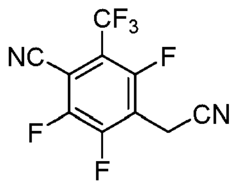 $A^3$ 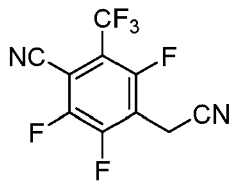 ;

k) a charge generation layer, wherein the first charge generation layer comprises a compound of formula (I) wherein $A^1$, $A^2$ and $A^3$ are selected according to the following:

$A^1$ 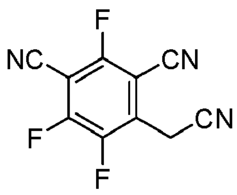 $A^2$ 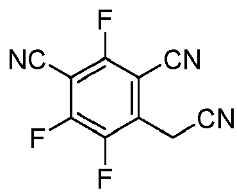 $A^3$ 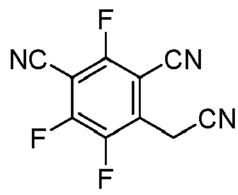 ;

l) a charge generation layer, wherein the first charge generation layer comprises a compound of formula (I) wherein $A^1$, $A^2$ and $A^3$ are selected according to the following:

$A^1$ 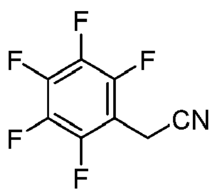 $A^2$ 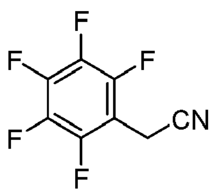 $A^3$ 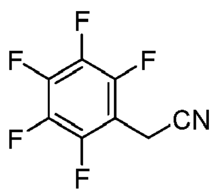 ;

m) a charge generation layer, wherein the first charge generation layer comprises a compound of formula (I) wherein $A^1$, $A^2$ and $A^3$ are selected according to the following:

$A^1$ 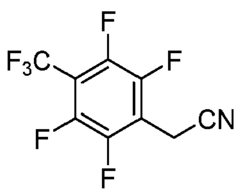 $A^2$ 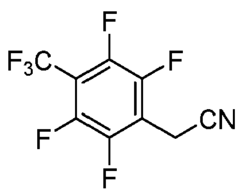 $A^3$ 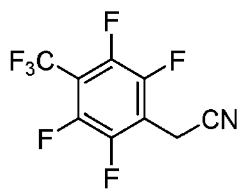 ;

n) a charge generation layer, wherein the first charge generation layer comprises a compound of formula (I) wherein $A^1$, $A^2$ and $A^3$ are selected according to the following:

$A^1$ 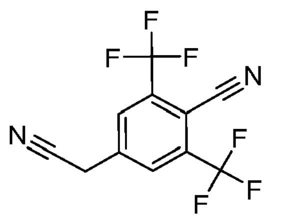 $A^2$ 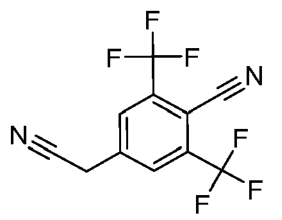 $A^3$ 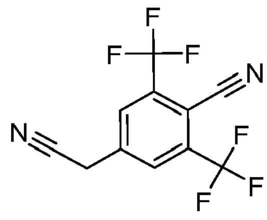 ;

o) a charge generation layer, wherein the first charge generation layer comprises a compound of formula (I) wherein $A^1$, $A^2$ and $A^3$ are selected according to the following:

$A^1$ 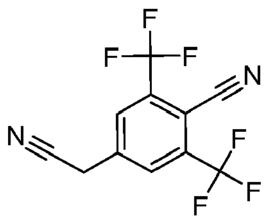 $A^2$ 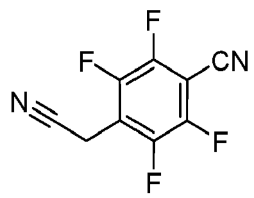 $A^3$ 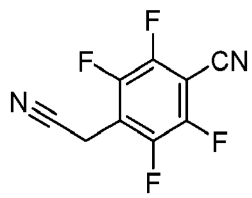 ;

p) a charge generation layer, wherein the first charge generation layer comprises a compound of formula (I) wherein $A^1$, $A^2$ and $A^3$ are selected according to the following:

$A^1$ 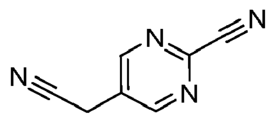 $A^2$ 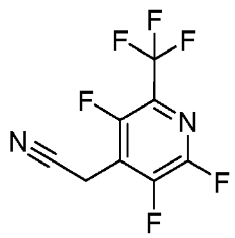 $A^3$ 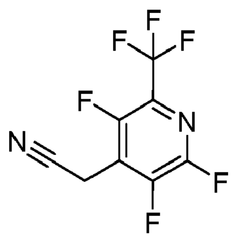 ;

q) a charge generation layer, wherein the first charge generation layer comprises a compound of formula (I) wherein $A^1$, $A^2$ and $A^3$ are selected according to the following:

$A^1$ 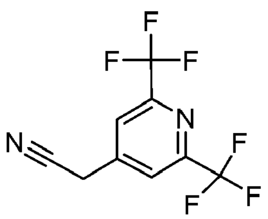 $A^2$ 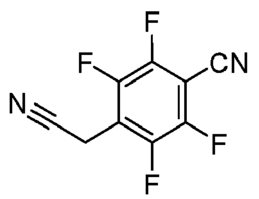 $A^3$ 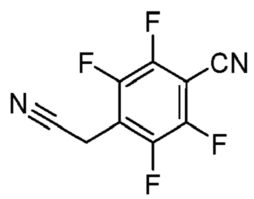 ;

r) a charge generation layer, wherein the first charge generation layer comprises a compound of formula (I) wherein $A^1$, $A^2$ and $A^3$ are selected according to the following:

$A^1$ 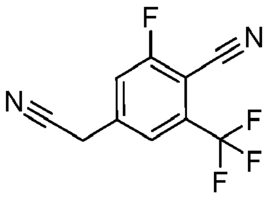 $A^2$ 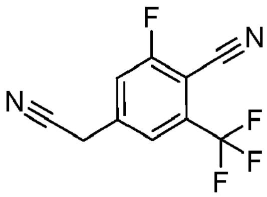 $A^3$ 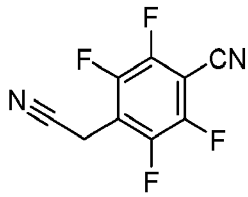 ;

s) a charge generation layer, wherein the first charge generation layer a compound of formula (I) wherein $A^1$, $A^2$ and $A^3$ are selected according to the following:

$A^1$ 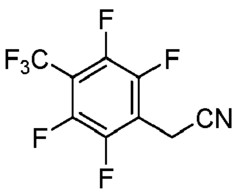 $A^2$ 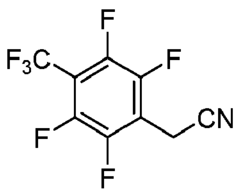 $A^3$ 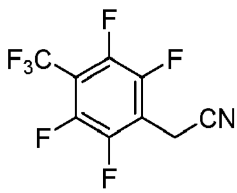 ;

t) a charge generation layer, wherein the first charge generation layer comprises a compound of formula (I) wherein $A^1$, $A^2$ and $A^3$ are selected according to the following:

$A^1$ 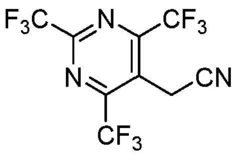 $A^2$ 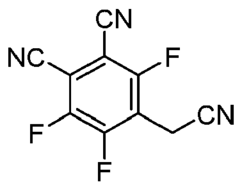 $A^3$ 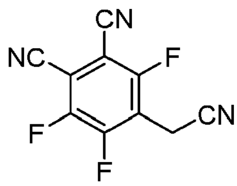 ;

u) a charge generation layer, wherein the first charge generation layer comprises a compound of formula (I) wherein $A^1$, $A^2$ and $A^3$ are selected according to the following:

$A^1$ 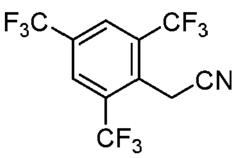 $A^2$ 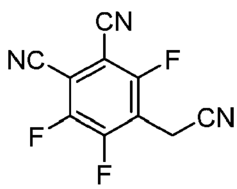 $A^3$ 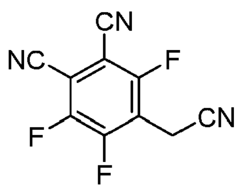 ;

v) a charge generation layer, wherein the first charge generation layer comprises a compound of formula (I) wherein $A^1$, $A^2$ and $A^3$ are selected according to the following:

$A^1$ 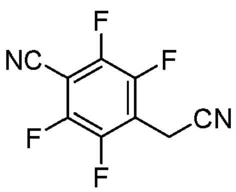 $A^2$ 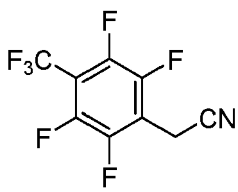 $A^3$ 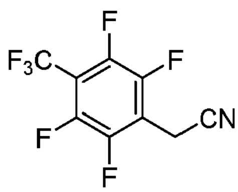 ;

w) a charge generation layer, wherein the first charge generation layer comprises a compound of formula (I) wherein $A^1$, $A^2$ and $A^3$ are selected according to the following:

$A^1$ $A^2$ $A^3$

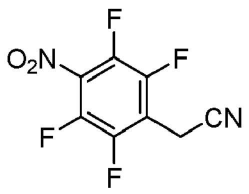
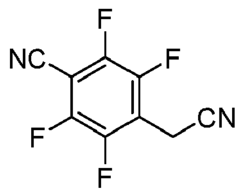
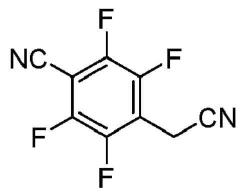
;

and

x) a charge generation layer, wherein the first charge generation layer comprises a compound of formula (I) wherein $A^1$, $A^2$ and $A^3$ are selected according to the following:

$A^1$ $A^2$ $A^3$

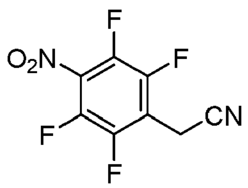
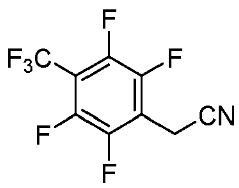
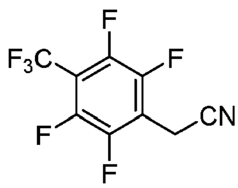
.

According to one embodiment of the present invention, the first charge generation layer is a p-type charge generation layer.

According to one embodiment of the present invention, the second charge generation layer is an n-type charge generation layer.

According to one embodiment of the present invention, the first charge generation layer is a p-type charge generation layer and the second charge generation layer is an n-type charge generation layer.

According to one embodiment of the present invention, the charge generation layer is not a charge generation layer according to any one of the aforementioned charge generation layers a) to x).

Metal dopant

According to one embodiment of the present invention, the metal dopant is selected from a metal with an electronegativity of ≤ 1.4 eV by Pauling scale or a metal alloy comprising a metal with an electronegativity of ≤ 1.4 eV by Pauling scale.

According to one embodiment of the present invention, the metal dopant is selected from a metal with an electronegativity of ≤ 1.35 eV by Pauling scale or a metal alloy comprising a metal with an electronegativity of ≤ 1.35 eV by Pauling scale.

According to one embodiment of the present invention, the metal dopant is a metal selected from the group consisting of Li, Na, K, Rb, Cs, Mg, Ca, Sr, Ba, Sm, Eu an Yb or a metal alloy comprising a metal selected from the group consisting of Li, Na, K, Rb, Cs, Mg, Ca, Sr, Ba, Sm, Eu and Yb.

According to one embodiment of the present invention, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.

According to one embodiment of the present invention, the metal dopant is a metal selected from the group consisting of Li, Mg and Yb or a metal alloy comprising a metal selected from the group consisting of Li, Mg and Yb.

According to one embodiment of the present invention, the metal dopant is a metal selected from the group consisting of Li and Yb or metal a alloy comprising a metal selected from the group consisting of Li, and Yb.

According to one embodiment of the present invention, the metal dopant is Yb or a metal alloy comprising a metal selected from the group consisting of Li and Yb.

According to one embodiment of the present invention, the metal dopant is Yb.

Organic hole transport compound

According to one embodiment of the present invention, the organic hole transport compound has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range of ≤ -4.4 eV to ≥ -5.2 eV, more preferably ≤ -4.5 eV to ≥ -5.1 eV, even more preferably ≤ -4.6 eV to ≥ -5.0 eV, most preferably ≤ -4.65 eV to ≥ -4.9 eV.

According to one embodiment of the present invention, the organic hole transport compound is present in the first charge generation layer in an amount of at least 0.1 wt% based on the total weight of the first charge generation layer, preferably at least 1 wt%, more preferably at least 5 wt%, more preferably at least 10 wt%, more preferably at least 20 wt%, more preferably at least 30 wt%, more preferably at least 40 wt%, more preferably at least 50 wt%, more preferably at least 60 wt%, more preferably at least 70 wt%, more preferably at least 80 wt%, and most preferably at least 90 wt%.

According to one embodiment of the present invention, the organic hole transport compound is a substantially covalent matrix compound.

Substantially covalent matrix compound

The semiconductor layer, and/or charge generation layer, may further comprises a substantially covalent matrix compound. The substantially covalent matrix compound may consists substantially from covalently bound C, H, O, N, S, which optionally comprise in addition covalently bound B, P, As and/or Se.

According to one embodiment the substantially covalent matrix compound may be selected from organic compounds consisting substantially from covalently bound C, H, O, N, S, which optionally comprise in addition covalently bound B, P, As and/or Se.

In one embodiment, the substantially covalent matrix compound lacks metal atoms and majority of its skeletal atoms may be selected from C, O, S, N. Alternatively, the substantially covalent matrix compound lacks metal atoms and majority of its skeletal atoms may be selected from C and N.

According to one embodiment of the present invention, the organic hole transport compound comprises at least 15 covalently bound atoms, preferably at least 20 covalently bound atoms, more preferably at least 25 covalently bound atoms, more preferably at least 30 covalently bound atoms, more preferably at least 35 covalently bound atoms, more preferably 40 covalently bound atoms, and more preferably 45 covalently bound atoms.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

Preferably, the substantially covalent matrix compound comprises at least one arylamine moiety, alternatively a diarylamine moiety, alternatively a triarylamine moiety.

Preferably, the substantially covalent matrix compound is free of metals and/or ionic bonds.

Compound of formula (IV) or a compound of formula (V)

According to another aspect of the present invention, the at least one matrix compound, also referred to as "substantially covalent matrix compound", may comprises at least one arylamine compound, diarylamine compound, triarylamine compound, a compound of formula (IV) or a compound of formula (V)

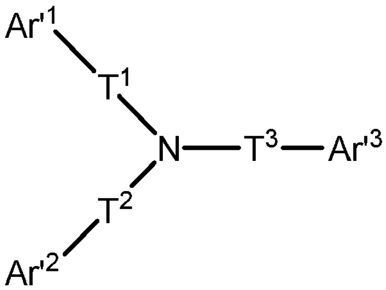
(IV),

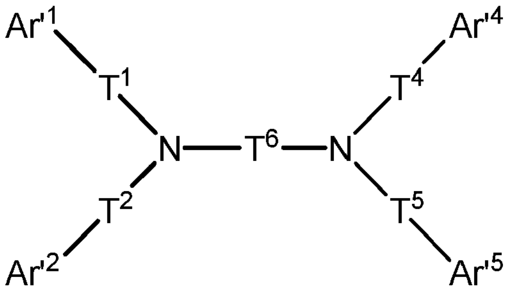
(V),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

$Ar'^1$, $Ar'^2$, $Ar'^3$, $Ar'^4$ and $Ar'^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar'^1$, $Ar'^2$, $Ar'^3$, $Ar'^4$ and $Ar'^5$ are selected the same or different from the group comprising H, D, F, $C(=O)R^2$, CN, $Si(R^2)_3$, $P(=O)(R^2)_2$, $OR^2$, $S(=O)R^2$, $S(=O)_2R^2$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle, wherein $R^2$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

According to an embodiment wherein $T^1$, $T^2$, $T^3$, $T^4$ and $T^5$ may be independently selected from a single bond, phenylene, biphenylene or terphenylene. According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond. According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene. According to an embodiment wherein $T^6$ may be biphenylene. According to an embodiment wherein $T^6$ may be terphenylene.

According to an embodiment wherein $Ar'^1$, $Ar'^2$, $Ar'^3$, $Ar'^4$ and $Ar'^5$ may be independently selected from D1 to D16:

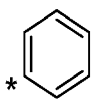 (D1), 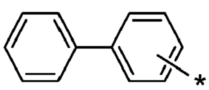 (D2), 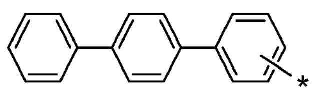 (D3), 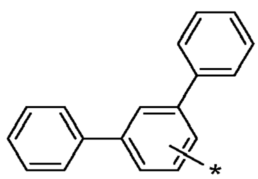 (D4),

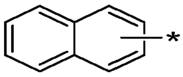 (D5), 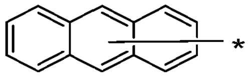 (D6), 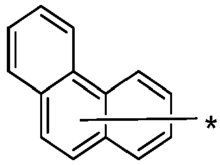 (D7), 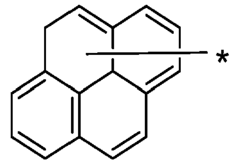 (D8),

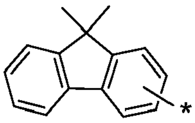 (D9), 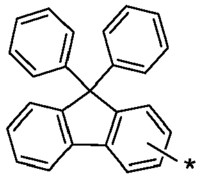 (D10), 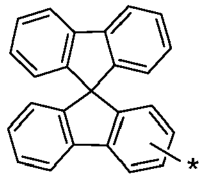 (D11),

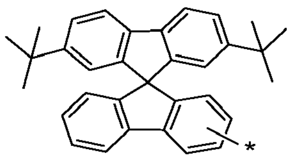 (D12), 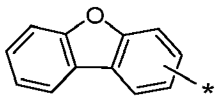 (D13), 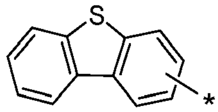 (D14),

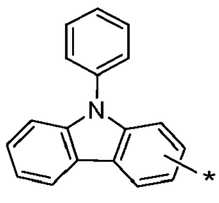 (D15), 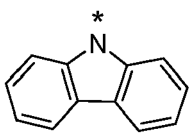 (D16),

wherein the asterisk "*" denotes the binding position.

According to an embodiment, wherein Ar'[1], Ar'[2], Ar'[3], Ar'[4] and Ar'[5] may be independently selected from D1 to D15; alternatively selected from D1 to D10 and D13 to D15.

According to an embodiment, wherein Ar'[1], Ar'[2], Ar'[3], Ar'[4] and Ar'[5] may be independently selected from the group consisting of D1, D2, D5, D7, D9, D10, D13 to D16.

The rate onset temperature may be in a range particularly suited to mass production, when Ar'[1], Ar'[2], Ar'[3], Ar'[4] and Ar'[5] are selected in this range.

According to one embodiment, the substantially covalent matrix compound comprises at least one naphthyl group, carbazole group, dibenzofuran group, dibenzothiophene group and/or substituted fluorenyl group, wherein the substituents are independently selected from methyl, phenyl or fluorenyl.

According to an embodiment of the invention, the matrix compound of formula (IV) or formula (V) are selected from F1 to F18:

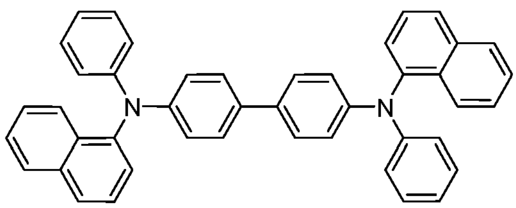 (F1), 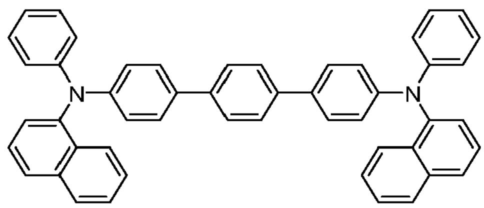 (F2),

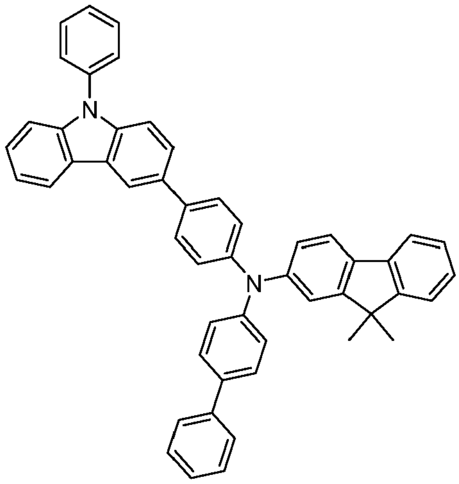
(F3),

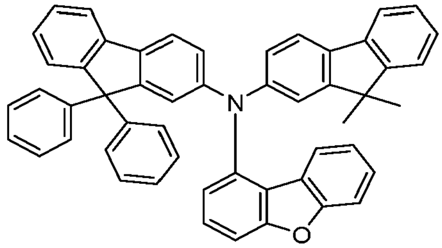
(F4),

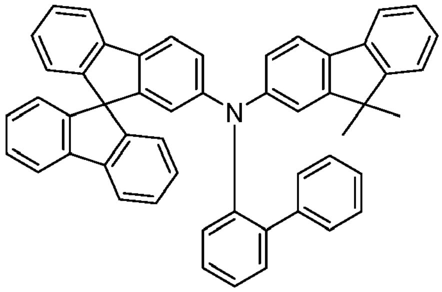
(F5),

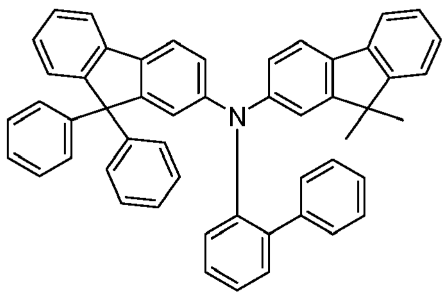
(F6),

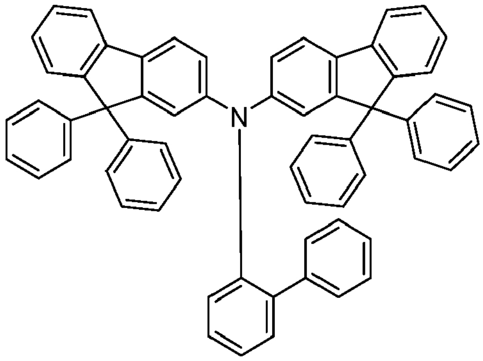
(F7),

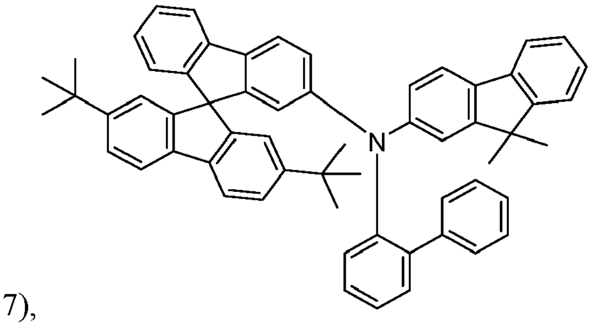
(F8),

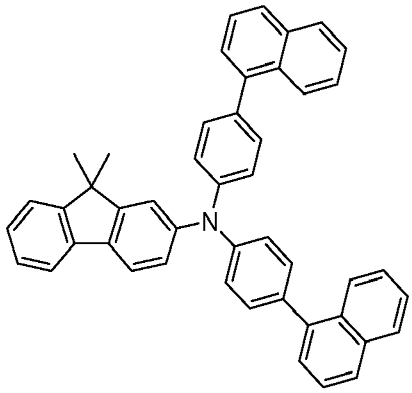
(F9),

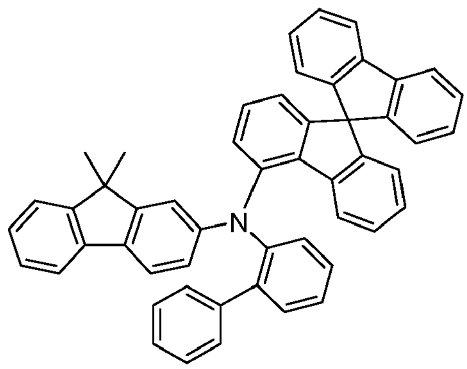
(F10),

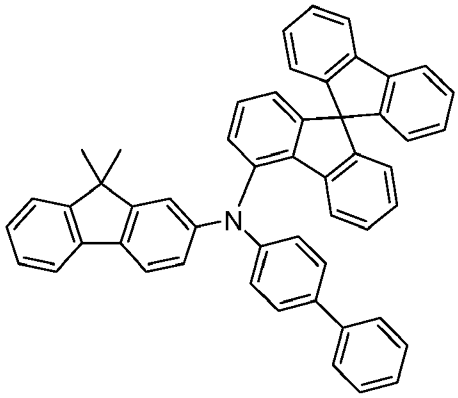 (F11), 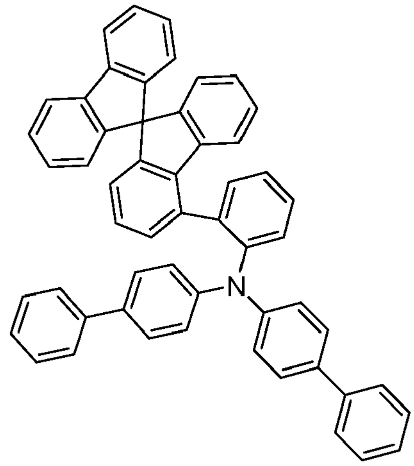 (F12),

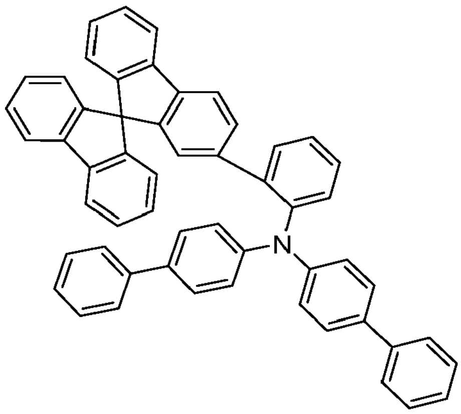 (F13), 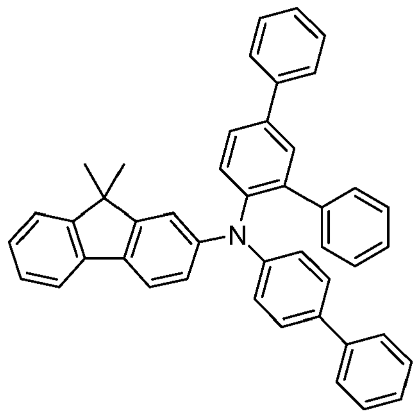 (F14),

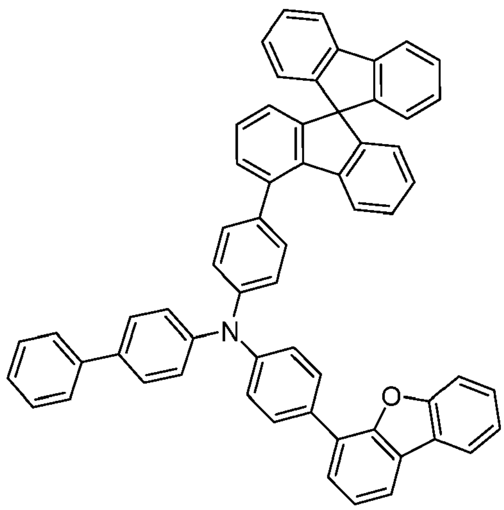 (F15), 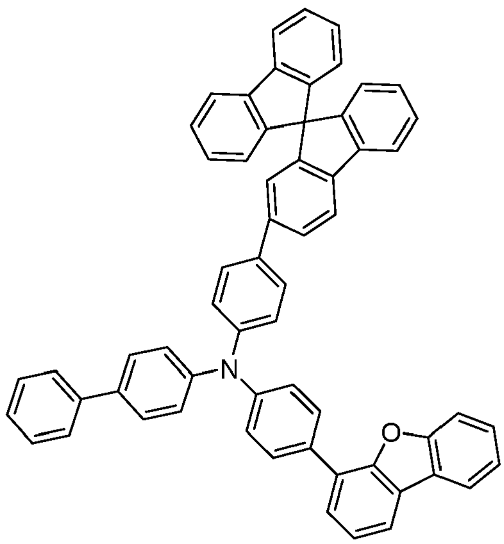 (F16);

and

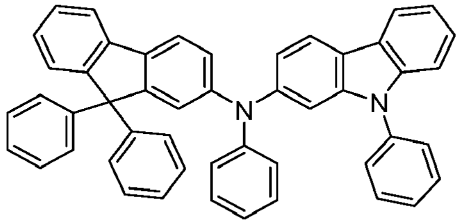

(F17).

Organic electron transport compound

According to one embodiment of the present invention, the organic electron transport compound is an organic substantially covalent electron transport compound.

According to one embodiment of the present invention, the organic electron transport compound lacks metal atoms and majority of its skeletal atoms may be selected from C, H, O, N, S, which optionally comprise in addition covalently bound B, P, As and/or Se.

The organic electron transport compound may consists substantially from covalently bound C, H, O, N, S, which optionally comprise in addition covalently bound B, P, As and/or Se.

According to an embodiment of the present invention, the organic electron transport compound preferably comprises at least one $C_2$ to $C_{24}$ N-heteroaryl or P=X group, with X being O, P, Se, with P=O especially preferred.

According to an embodiment of the present invention, the at least one $C_2$ to $C_{24}$ N-heteroaryl may be selected from a compound comprising at least one azine group, preferably at least two azine groups, also preferred three azine groups.

According to an embodiment of the present invention, the organic electron transport compound comprises at least one group selected from the list consisting of pyridine, pyrimidine, triazine, imidazole, benzimidazole, benzooxazole, quinone, benzoquinone, quinoxaline, benzoquinoxaline, acridine, phenanthroline, benzoacridine, dibenzoacridine.

According to one embodiment of the present invention, the organic electron transport compound comprises at least 15 covalently bound atoms, preferably at least 20 covalently bound atoms, more preferably at least 25 covalently bound atoms, and most preferably at least 30 covalently bound atoms.

According to one embodiment of the present invention, the organic substantially covalent electron transport compound comprises at least 15 covalently bound atoms, preferably at least 20 covalently bound atoms, more preferably at least 25 covalently bound atoms, and most preferably at least 30 covalently bound atoms.

According to one embodiment of the present invention, the organic electron transport compound may have a molecular weight Mw of $\geq$ 400 and $\leq$ 2000 g/mol, preferably a molecular weight Mw of $\geq$ 450 and $\leq$ 1500 g/mol, further preferred a molecular weight Mw of $\geq$ 500 and $\leq$ 1000 g/mol, further preferred a molecular weight Mw of $\geq$ 550 and $\leq$ 900 g/mol, in addition preferred a molecular weight Mw of $\geq$ 580 and $\leq$ 800 g/mol, also preferred a molecular weight Mw of $\geq$ 600 and $\leq$ 800 g/mol.

According to one embodiment of the present invention, the organic electron transport compound has a LUMO when calculated by DFT using B3LYP/6-31G* of < -1.75 eV. In particular, according to one embodiment of the present invention, the organic electron transport compound has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase of < -1.75 eV.

According to one embodiment of the present invention, the organic electron transport compound is present in the second charge generation layer in an amount of at least 0.1 wt% based on the total weight of the second charge generation layer, preferably at least 1 wt%, more preferably at least 5 wt%, more preferably at least 10 wt%, more preferably at least 20 wt%, more preferably at least 30 wt%, more preferably at least 40 wt%, more preferably at least 50 wt%, more preferably at least 60 wt%, more preferably at least 70 wt%, more preferably at least 80 wt%, more preferably at least 90 wt%, more preferably at least 95 wt%, more preferably at least 96 wt%, more preferably at least 97 wt%, and most preferably at least 98 wt%.

Compound of formula (I)

According to one embodiment of the present invention, $Ar^1$ is selected from $C_6$ to $C_{30}$ aryl and substituted or unsubstituted $C_2$ to $C_{30}$ heteroaryl.

According to one embodiment of the present invention, $Ar^1$ is selected from $C_6$ to $C_{24}$ aryl and substituted or unsubstituted $C_2$ to $C_{24}$ heteroaryl.

According to one embodiment of the present invention, $Ar^1$ is selected from $C_6$ to $C_{18}$ aryl and substituted or

unsubstituted $C_3$ to $C_{18}$ heteroaryl.

According to one embodiment of the present invention, $Ar^1$ is selected from $C_6$ to $C_{12}$ aryl and substituted or unsubstituted $C_3$ to $C_{12}$ heteroaryl.

According to one embodiment of the present invention, wherein for the case that $Ar^1$ is substituted, one or more of the substituents are independently selected from the group consisting of F, CN, partially fluorinated alkyl or perfluorinated $C_1$ to $C_8$ alkyl, in particular $CF_3$, and $-NO_2$.

According to one embodiment of the present invention, wherein for the case that $Ar^1$ is substituted, one or more of the substituents are independently selected from the group consisting of F, CN, and partially fluorinated alkyl or perfluorinated $C_1$ to $C_8$ alkyl, in particular $CF_3$.

According to one embodiment of the present invention, $Ar^2$ is selected from $C_6$ to $C_{30}$ aryl and substituted or unsubstituted $C_2$ to $C_{30}$ heteroaryl.

According to one embodiment of the present invention, $Ar^2$ is selected from $C_6$ to $C_{24}$ aryl and substituted or unsubstituted $C_2$ to $C_{24}$ heteroaryl.

According to one embodiment of the present invention, $Ar^2$ is selected from $C_6$ to $C_{18}$ aryl and substituted or unsubstituted $C_3$ to $C_{18}$ heteroaryl.

According to one embodiment of the present invention, $Ar^2$ is selected from $C_6$ to $C_{12}$ aryl and substituted or unsubstituted $C_3$ to $C_{12}$ heteroaryl.

According to one embodiment of the present invention, wherein for the case that $Ar^2$ is substituted, one or more of the substituents are independently selected from the group consisting of F, CN, partially fluorinated alkyl or perfluorinated $C_1$ to $C_8$ alkyl, in particular $CF_3$, and $-NO_2$.

According to one embodiment of the present invention, wherein for the case that $Ar^2$ is substituted, one or more of the substituents are independently selected from the group consisting of F, CN, and partially fluorinated alkyl or perfluorinated $C_1$ to $C_8$ alkyl, in particular $CF_3$.

According to one embodiment of the present invention, R' is independently selected from the group consisting of electron-withdrawing group, CN, halogen, F, partially fluorinated $C_1$ to $C_8$ alkyl, and perfluorinated $C_1$ to $C_8$ alkyl, in particular $CF_3$..

According to one embodiment of the present invention, R' is independently selected from the group consisting of CN, F, partially fluorinated $C_1$ to $C_8$ alkyl, and perfluorinated $C_1$ to $C_8$ alkyl, in particular $CF_3$.

According to one embodiment of the present invention, R' is independently selected from CN.

According to one embodiment of the present invention, formula (II) is selected from formula (VI)

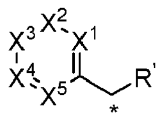

(VI)

wherein in formula (VI)

$X^1$ is selected from $CR^1$ or N;
$X^2$ is selected from $CR^2$ or N;
$X^3$ is selected from $CR^3$ or N;
$X^4$ is selected from $CR^4$ or N;
$X^5$ is selected from $CR^5$ or N;
$R^1$, $R^2$, $R^3$, $R^4$ and $R^5$ (if present) are independently selected from electron-withdrawing group, CN, partially fluorinated $C_1$ to $C_8$ alkyl, perfluorinated $C_1$ to $C_8$ alkyl, $-NO_2$, halogen, Cl, F, D or H, whereby when any of $R^1$, $R^2$, $R^3$, $R^4$ and $R^5$ is present, then the corresponding $X^1$, $X^2$, $X^3$, $X^4$ and $X^5$ is not N.

According to one embodiment of the present invention, $X^1$ is $CR^1$ and $R^1$ is selected from partially fluorinated $C_1$ to $C_8$ alkyl, perfluorinated $C_1$ to $C_8$ alkyl, CN, $-NO_2$, halogen, Cl, or F.

According to one embodiment of the present invention, $X^1$ is $CR^1$ and $R^1$ is selected from partially fluorinated $C_1$ to $C_8$ alkyl, perfluorinated $C_1$ to $C_8$ alkyl, or CN.

According to one embodiment of the present invention, $X^1$ is $CR^1$ and $R^1$ is selected from partially fluorinated $C_1$ to $C_8$ alkyl or perfluorinated $C_1$ to $C_8$ alkyl.

According to one embodiment of the present invention, $X^1$ is $CR^1$ and $R^1$ is selected from $CF_3$.

According to one embodiment of the present invention, $X^1$ is $CR^1$ and $X^5$ is $CR^5$ and $R^1$ and $R^5$ are independently

selected from partially fluorinated $C_1$ to $C_8$ alkyl, perfluorinated $C_1$ to $C_8$ alkyl, CN, $-NO_2$, halogen, Cl, or F.

According to one embodiment of the present invention, $X^1$ is $CR^1$ and $X^5$ is $CR^5$ and $R^1$ and $R^5$ are independently selected from partially fluorinated $C_1$ to $C_8$ alkyl, perfluorinated $C_1$ to $C_8$ alkyl, or CN.

According to one embodiment of the present invention, $X^1$ is $CR^1$ and $X^5$ is $CR^5$ and $R^1$ and $R^5$ are independently selected from partially fluorinated $C_1$ to $C_8$ alkyl or perfluorinated $C_1$ to $C_8$ alkyl.

According to one embodiment of the present invention, $X^1$ is $CR^1$ and $X^5$ is $CR^5$ and $R^1$ and $R^5$ are independently selected from $CF_3$.

According to one embodiment of the present invention, in formula (I)

- $A^1$ is independently selected from a group of formula (IIa)

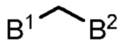

(IIa),

wherein $B^1$ is independently selected from substituted or unsubstituted $C_6$ to $C_{36}$ aryl and substituted or unsubstituted $C_2$ to $C_{36}$ heteroaryl;
wherein for the case that $B^1$ is substituted, one or more of the substituents are independently selected from the group consisting of an electron-withdrawing group, F, CN, partially fluorinated alkyl, perfluorinated alkyl, and $-NO_2$;

- $B^3$ is independently selected from a group of formula (IIIa)

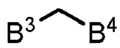

(IIIa),

wherein $B^3$ is independently selected from substituted or unsubstituted $C_6$ to $C_{36}$ aryl and substituted or unsubstituted $C_2$ to $C_{36}$ heteroaryl;
wherein for the case that $B^3$ is substituted, one or more of the substituents are independently selected from the group consisting of an electron-withdrawing group, F, CN, partially fluorinated alkyl, perfluorinated alkyl, and $-NO_2$;

- $B^5$ is independently selected from a group of formula (IIIb)

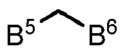

(IIIb),

wherein $B^5$ is independently selected from substituted or unsubstituted $C_6$ to $C_{36}$ aryl and substituted or unsubstituted $C_2$ to $C_{36}$ heteroaryl;
wherein for the case that $B^5$ is substituted, one or more of the substituents are independently selected from the group consisting of an electron-withdrawing group, F, CN, partially fluorinated alkyl, perfluorinated alkyl, and $-NO_2$;

- and wherein $B^2$, $B^4$, and $B^6$ each are independently selected from substituted or unsubstituted $C_6$ to $C_{18}$ aryl, $C_3$ to $C_{18}$ heteroaryl, electron-withdrawing group, partially fluorinated $C_1$ to $C_8$ alkyl, perfluorinated $C_1$ to $C_8$ alkyl, halogen, F or CN.

According to one embodiment of the present invention, in formula (I)

- $A^1$ is independently selected from a group of formula (IIa)

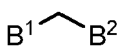

(IIa),

wherein $B^1$ is independently selected from substituted or unsubstituted $C_6$ to $C_{36}$ aryl and substituted or unsubstituted $C_2$ to $C_{36}$ heteroaryl;
wherein for the case that $B^1$ is substituted, one or more of the substituents are independently selected from the

group consisting of an electron-withdrawing group, F, CN, partially fluorinated alkyl, perfluorinated alkyl, and $-NO_2$;

- $B^3$ is independently selected from a group of formula (IIIa)

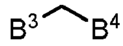

(IIIa),

wherein $B^3$ is independently selected from substituted or unsubstituted $C_6$ to $C_{36}$ aryl and substituted or unsubstituted $C_2$ to $C_{36}$ heteroaryl;
wherein for the case that $B^3$ is substituted, one or more of the substituents are independently selected from the group consisting of an electron-withdrawing group, F, CN, partially fluorinated alkyl, perfluorinated alkyl, and $-NO_2$;

- $B^5$ is independently selected from a group of formula (IIIb)

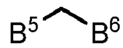

(IIIb),

wherein $B^5$ is independently selected from substituted or unsubstituted $C_6$ to $C_{36}$ aryl and substituted or unsubstituted $C_2$ to $C_{36}$ heteroaryl;
wherein for the case that $B^5$ is substituted, one or more of the substituents are independently selected from the group consisting of an electron-withdrawing group, F, CN, partially fluorinated alkyl, perfluorinated alkyl, and $-NO_2$;

- and wherein $B^2$, $B^4$, and $B^6$ each are independently selected from substituted or unsubstituted $C_6$ to $C_{18}$ aryl, $C_3$ to $C_{18}$ heteroaryl, electron-withdrawing group, partially fluorinated $C_1$ to $C_8$ alkyl, perfluorinated $C_1$ to $C_8$ alkyl, halogen, F or CN,
- wherein the resulting compound of formula (I) represented by one of the following compounds (Ia) to (Ie)

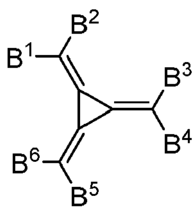

(Ia)

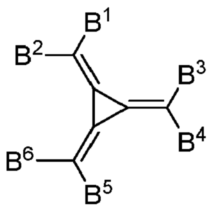

(Ib)

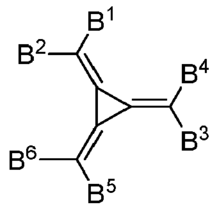

(Ic)

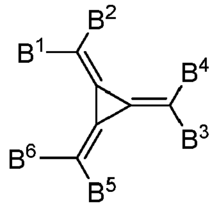

(Id)

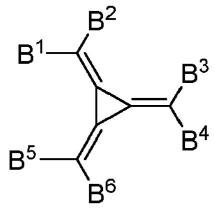

(Ie).

According to one embodiment of the present invention, the group of formula (IIa) is selected from the same preferred groups as the group according to formula (II). According to one embodiment of the present invention, the group of formula (IIa) is selected from the same preferred groups as the group according to formula (VI).

According to one embodiment of the present invention, the groups of formula (IIIa) and (IIIb) are independently selected from the same preferred groups as the group according to formula (III).

According to one embodiment of the present invention, the group of formula (IIa) is selected from the same preferred groups as the group according to formula (II) and the groups of formula (IIIa) and (IIIb) are independently selected from the same preferred groups as the group according to formula (III). Particularly, according to one embodiment of the present invention, the groups of formula (IIa), (IIIa), and (IIIb) are selected from preferred combinations of $A^1$, $A^2$, and $A^3$ according to the invention.

According to one embodiment of the present invention, the compound of formula (I) is represented by a compound of formula (Ia)

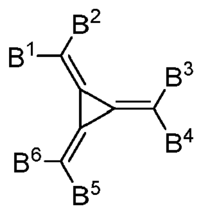

(Ia)

wherein $B^1$ is $Ar^1$, $B^3$ and $B^5$ are $Ar^2$ and $B^2$, $B^4$ and $B^6$ are R', as defined for formula (I).

According to one embodiment of the present invention, the compound of formula (I) is represented by a compound of formula (Ia)

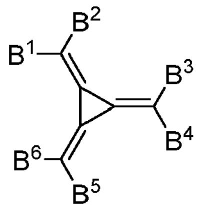

(Ia)

- wherein $B^1$ is $Ar^1$,

    wherein $Ar^1$ is independently selected from substituted or unsubstituted $C_6$ to $C_{36}$ aryl and substituted or unsubstituted $C_2$ to $C_{36}$ heteroaryl;
    wherein for the case that $Ar^1$ is substituted, one or more of the substituents are independently selected from the group consisting of an electron-withdrawing group, F, CN, partially fluorinated alkyl, perfluorinated alkyl, and $-NO_2$;

- $B^3$ and $B^5$ are $Ar^2$,

    wherein $Ar^2$ is independently selected from substituted or unsubstituted $C_6$ to $C_{36}$ aryl and substituted or unsubstituted $C_2$ to $C_{36}$ heteroaryl;
    wherein for the case that $Ar^2$ is substituted, one or more of the substituents are independently selected from the group consisting of an electron-withdrawing group, F, CN, partially fluorinated alkyl, perfluorinated alkyl, and $-NO_2$;

- and wherein $B^2$, $B^4$ and $B^6$ are R', and each R' is independently selected from substituted or unsubstituted $C_6$ to $C_{18}$ aryl, $C_3$ to $C_{18}$ heteroaryl, electron-withdrawing group, partially fluorinated $C_1$ to $C_8$ alkyl, perfluorinated $C_1$ to $C_8$ alkyl, halogen, F or CN.

According to one embodiment of the present invention, the compound of formula (I) is represented by a compound of formula (Ia)

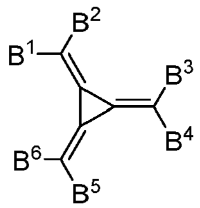

(Ia)

wherein $B^1$ is selected from formula (VIa)

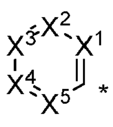

(VIa)

$B^3$ and $B^5$ are $Ar^2$ and $B^2$, $B^4$ and $B^6$ are R';
wherein in formula (VIa)

$X^1$ is selected from $CR^1$ or N;
$X^2$ is selected from $CR^2$ or N;
$X^3$ is selected from $CR^3$ or N;

$X^4$ is selected from $CR^4$ or N;
$X^5$ is selected from $CR^5$ or N;
$R^1$, $R^2$, $R^3$, $R^4$ and $R^5$ (if present) are independently selected from electron-withdrawing group, CN, partially fluorinated $C_1$ to $C_8$ alkyl, perfluorinated $C_1$ to $C_8$ alkyl, $-NO_2$, halogen, Cl, F, D or H, whereby when any of $R^1$, $R^2$, $R^3$, $R^4$ and $R^5$ is present, then the corresponding $X^1$, $X^2$, $X^3$, $X^4$ and $X^5$ is not N,
wherein formula (VIa) is linked to the methylene C-atom via the atom marked as "*".

According to one embodiment of the present invention, the the compound of formula (I) is represented by a compound of formula (Ia)

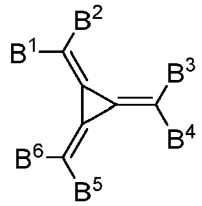

(Ia)

wherein $B^1$ is selected from formula (VIa)

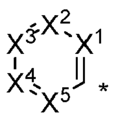

(VIa)

wherein in formula (Via)

$X^1$ is selected from $CR^1$ or N;
$X^2$ is selected from $CR^2$ or N;
$X^3$ is selected from $CR^3$ or N;
$X^4$ is selected from $CR^4$ or N;
$X^5$ is selected from $CR^5$ or N;
$R^1$, $R^2$, $R^3$, $R^4$ and $R^5$ (if present) are independently selected from electron-withdrawing group, CN, partially fluorinated $C_1$ to $C_8$ alkyl, perfluorinated $C_1$ to $C_8$ alkyl, $-NO_2$, halogen, Cl, F, D or H, whereby when any of $R^1$, $R^2$, $R^3$, $R^4$ and $R^5$ is present, then the corresponding $X^1$, $X^2$, $X^3$, $X^4$ and $X^5$ is not N,
wherein formula (VIa) is linked to the methylene C-atom via the atom marked as "*";
wherein $B^3$ and $B^5$ are independently selected from

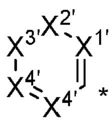

(VIb)

wherein in formula (xxxxxIII)
$X^{1'}$ is selected from $CR^{1'}$ or N;
$X^{2'}$ is selected from $CR^{2'}$ or N;
$X^{3'}$ is selected from $CR^{3'}$ or N;
$X^{4'}$ is selected from $CR^{4'}$ or N;
$X^{5'}$ is selected from $CR^{5'}$ or N;
$R^{1'}$, $R^{2'}$, $R^{3'}$, $R^{4'}$ and $R^{5'}$ (if present) are independently selected from electron-withdrawing group, CN, partially fluorinated $C_1$ to $C_8$ alkyl, perfluorinated $C_1$ to $C_8$ alkyl, $-NO_2$, halogen, Cl, F, D or H, whereby when any of $R^{1'}$, $R^{2'}$, $R^{3'}$, $R^{4'}$ and $R^{5'}$ is present, then the corresponding $X^{1'}$, $X^{2'}$, $X^{3'}$, $X^{4'}$ and $X^{5'}$ is not N,

wherein formula (VIb) is linked to the methylene C-atom via the atom marked as "*"; and wherein $B^2$, $B^4$ and $B^6$ are R'.

According to one embodiment, the first charge generation layer comprises a composition comprising as compound of formula (I) a compound of formula (Ia) and at least one compound of formula (Ib) to (Ie)

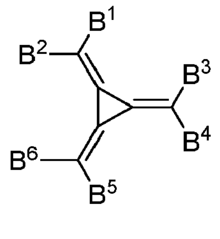

(Ib)

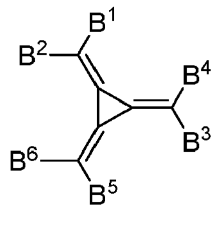

(Ic)

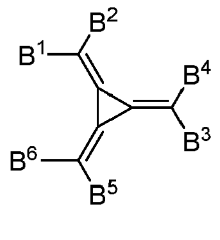

(Id)

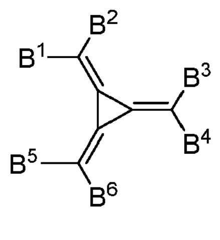

(Ie)

According to one embodiment of the present invention, the compound of formula (I) is selected from a compound of formula (VII)

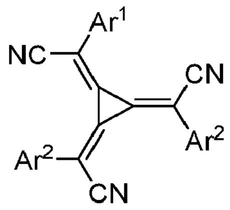

(VII),

wherein

- $Ar^1$ is independently selected from substituted $C_6$ to $C_{36}$ or unsubstituted $C_6$ to $C_{36}$ aryl and substituted or unsubstituted $C_2$ to $C_{36}$ heteroaryl;
  wherein for the case that $Ar^1$ is substituted, the one or more substituents are independently selected from an electron-withdrawing group, F, CN, partially fluorinated or perfluorinated alkyl, and $-NO_2$; and
- $Ar^2$ is independently selected from substituted or unsubstituted $C_6$ to $C_{36}$ aryl and substituted or unsubstituted $C_2$ to $C_{36}$ heteroaryl;
  wherein for the case that if $Ar^2$ is substituted, the one or more substituents are independently selected from an electron-withdrawing group, F, CN, partially fluorinated or perfluorinated alkyl, and $-NO_2$;

wherein the compound of formula (VII) has an absorption maximum $\lambda_{max}$ at ≤ 459 nm when measured in DCM at a concentration of $10^{-5}$ to $10^{-4}$ mol/L at 20 °C, an absorption maximum $\lambda_{max}$ at ≤ 494 nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYPwith a 6-31G* basis set in the gas phase, and/or an integral of ≤ 50 a.u. × nm in an UV-Vis Spectrum in the range of 400 to 650 nm, when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP/6-31G* basis set in the gas phase.

According to one embodiment of the invention, the compound of formula (I) is selected from a compound of formula (VIII)

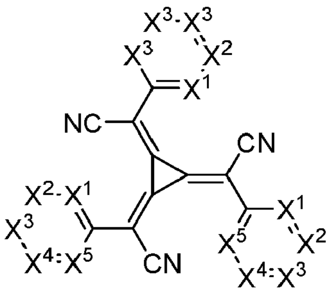

(VIII)

each $X^1$ is selected from $CR^1$ or N;
each $X^2$ is selected from $CR^2$ or N;
each $X^3$ is selected from $CR^3$ or N;
each $X^4$ is selected from $CR^4$ or N;
each $X^5$ is selected from $CR^5$ or N;
each $R^1$, $R^2$, $R^3$, $R^4$ and $R^5$ (if present) are independently selected from CN, partially fluorinated or perfluorinated $C_1$ to $C_8$ alkyl, $-NO_2$, halogen, Cl, F, D or H, whereby when any of $R^1$, $R^2$, $R^3$, $R^4$ and $R^5$ is present, then the corresponding $X^1$, $X^2$, $X^3$, $X^4$ and $X^5$ is not N;

wherein the compound of formula (VIII) has an absorption maximum $\lambda_{max}$ at ≤ 459 nm when measured in DCM at a concentration of $10^{-5}$ to $10^{-4}$ mol/L at 20 °C, an absorption maximum $\lambda_{max}$ at ≤ 494 nm when calculated with the program package TURBOMOLE V6.5 (TURBOMOLE GmbH, Litzenhardtstrasse 19, 76135 Karlsruhe, Germany) by TDDFT

using the hybrid functional PBEO with a def2-SVP basis set the gas phase and including the first 30 singlet transitions from optimized geometry using the hybrid functional B3LYP with a 6-31G* basis set in the gas phase, and/or an integral of ≤ 50 a.u. × nm in an UV-Vis Spectrum in the range of 400 to 650 nm, when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set he gas phase and including the first 30 singlet transitions optimized geometry using the hybrid functional B3LYP with a 6-31G* basis set in the gas phase.

According to one embodiment of the present invention, $X^1$ is $CR^1$ and $R^1$ is selected from partially fluorinated $C_1$ to $C_8$ alkyl, perfluorinated $C_1$ to $C_8$ alkyl, CN, $-NO_2$, halogen, Cl, or F.

According to one embodiment of the present invention, $X^1$ is $CR^1$ and $R^1$ is selected from partially fluorinated $C_1$ to $C_8$ alkyl, perfluorinated $C_1$ to $C_8$ alkyl, or CN.

According to one embodiment of the present invention, $X^1$ is $CR^1$ and $R^1$ is selected from partially fluorinated $C_1$ to $C_8$ alkyl or perfluorinated $C_1$ to $C_8$ alkyl.

According to one embodiment of the present invention, $X^1$ is $CR^1$ and $R^1$ is selected from $CF_3$.

According to one embodiment of the present invention, $X^1$ is $CR^1$ and $X^5$ is $CR^5$ and $R^1$ and $R^5$ are independently selected from partially fluorinated $C_1$ to $C_8$ alkyl, perfluorinated $C_1$ to $C_8$ alkyl, CN, $-NO_2$, halogen, Cl, or F.

According to one embodiment of the present invention, $X^1$ is $CR^1$ and $X^5$ is $CR^5$ and $R^1$ and $R^5$ are independently selected from partially fluorinated $C_1$ to $C_8$ alkyl, perfluorinated $C_1$ to $C_8$ alkyl, or CN.

According to one embodiment of the present invention, $X^1$ is $CR^1$ and $X^5$ is $CR^5$ and $R^1$ and $R^5$ are independently selected from partially fluorinated $C_1$ to $C_8$ alkyl or perfluorinated $C_1$ to $C_8$ alkyl.

According to one embodiment of the present invention, $X^1$ is $CR^1$ and $X^5$ is $CR^5$ and $R^1$ and $R^5$ are independently selected from $CF_3$.

According to one embodiment of the present invention, the compound of formula (I) has an absorption maximum $\lambda_{max}$ at ≤ 455 nm when measured in DCM at a concentration of $10^{-5}$ to $10^{-4}$ mol/L at 20 °C, preferably ≤ 450 nm, more preferably ≤ 445, more preferably ≤ 441 nm, and most preferably ≤ 440 nm.

According to one embodiment of the present invention, the compound of formula (I) has an absorption maximum $\lambda_{max}$ at ≤ 475 nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase, preferably ≤ 455 nm.

According to one embodiment of the present invention, the compound of formula (I) has an absorption maximum $\lambda_{max}$ at ≤ 475 nm, preferably at ≤ 455 nm.

According to one embodiment of the present invention, the compound of formula (I) has an integral of ≤ 49 a.u. × nm in an UV-Vis Spectrum in the range of 400 to 650 nm, when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase, preferably ≤48 a.u. x nm, more preferably ≤47 a.u. x nm, more preferably ≤46 a.u. x nm, more preferably ≤45 a.u. x nm, more preferably ≤44 a.u. x nm, more preferably ≤43 a.u. x nm, and most preferably ≤42 a.u. x nm.

According to one embodiment of the present invention, the compound of formula (I) has an absorption maximum $\lambda_{max}$(absorption) at ≤ 455 nm when measured in DCM at a concentration of $10^{-5}$ to $10^{-4}$ mol/L at 20 °C, and an integral of ≤50 a.u. x nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase.According to one embodiment of the present invention, the compound of formula (I) has an absorption maximum $\lambda_{max}$ at ≤ 450 nm when measured in DCM at a concentration of $10^{-5}$ to $10^{-4}$ mol/L at 20 °C, and an integral of ≤46 a.u. x nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase.

According to one embodiment of the present invention, the compound of formula (I) has an absorption maximum $\lambda_{max}$ at ≤ 445 nm when measured in DCM at a concentration of $10^{-5}$ to $10^{-4}$ mol/L at 20 °C, and an integral of ≤45 a.u. x nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase.

According to one embodiment of the present invention, the compound of formula (I) has an absorption maximum $\lambda_{max}$ at ≤ 441 when measured in DCM at a concentration of $10^{-5}$ to $10^{-4}$ mol/L at 20 °C, and an integral of ≤ 45 a.u. x nm when calculated with the program package TURBOMOLE V6.5 (TURBOMOLE GmbH, Litzenhardtstrasse 19, 76135

Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase.

According to one embodiment of the present invention the compound of formula (I) has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range from ≥ -5.7 eV to ≤ -4.7 eV, preferably ≥-5.6 eV to ≤ -4.7 eV, more preferably ≥ -5.55 eV to ≤ -4.75 eV, more preferably ≥ -5.50 eV to ≤-4.80 eV, and most preferably ≥ -5.45 eV to ≤ -4.85 eV.

According to one embodiment of the present invention, the compound of formula (I) has an absorption maximum $\lambda_{max}$ at ≤ 455 nm when measured in DCM at a concentration of $10^{-5}$ to $10^{-4}$ mol/L at 20 °C and an integral of ≤ 50 a.u. x nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase and the compound of formula (I) has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range from ≥ -5.45 and ≤ -4.85 eV.

According to one embodiment of the present invention, the compound of formula (I) has an absorption maximum $\lambda_{max}$ at ≤ 450 nm when measured in DCM at a concentration of $10^{-5}$ to $10^{-4}$ mol/L at 20 °C and an integral of ≤ 46 a.u. x nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase and the compound of formula (I) has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range from ≥ -5.45 and ≤ -4.85 eV.

According to one embodiment of the present invention, the compound of formula (I) has an absorption maximum $\lambda_{max}$ at ≤ 445 nm when measured in DCM at a concentration of $10^{-5}$ to $10^{-4}$ mol/L at 20 °C and an integral of ≤ 45 a.u. x nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase and the compound of formula (I) has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range from ≥ -5.45 and ≤ -4.85 eV.

According to one embodiment of the present invention, the compound of formula (I) has an absorption maximum $\lambda_{max}$ at ≤ 441 when measured in DCM at a concentration of $10^{-5}$ to $10^{-4}$ mol/L at 20 °C and an integral of ≤ 45 a.u. x nm when calculated with the program package TURBOMOLE V6.5 (TURBOMOLE GmbH, Litzenhardtstrasse 19, 76135 Karlsruhe, Germany) by TDDFT using the hybrid functional PBEO with a def2-SVP basis set in the gas phase and including the first 30 singlet transitions from optimized geometry using the hybrid functional B3LYP with a 6-31G* basis set in the gas phase and the compound of formula (I) has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range from ≥ -5.45 and ≤ -4.85 eV.

According to one embodiment of the present invention, the group of formula (II) or formula (IIa) is selected from one of the following formulae:

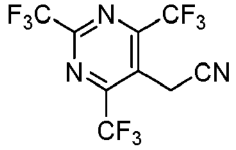 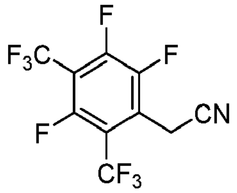 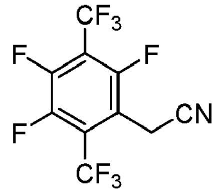 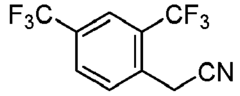

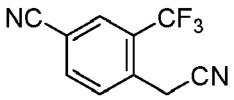
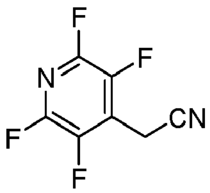
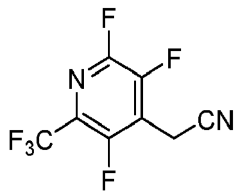
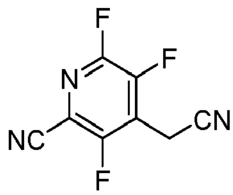

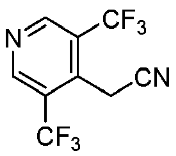
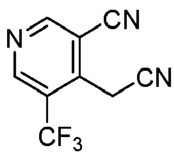
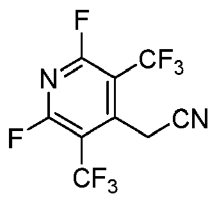
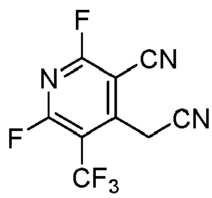

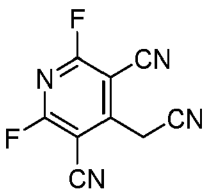
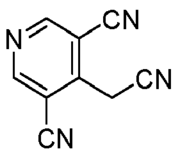
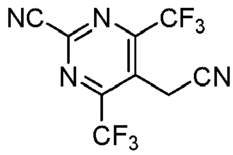
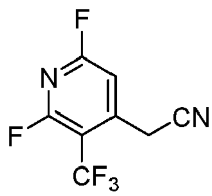

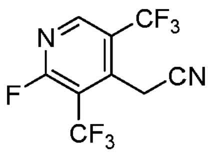
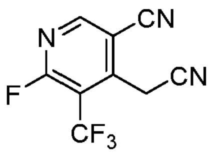
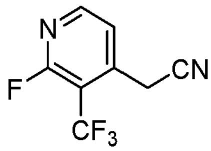
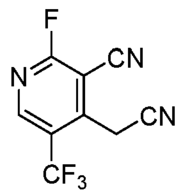

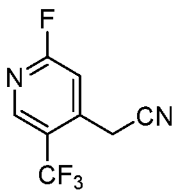
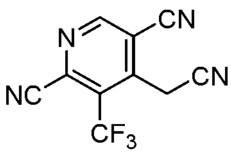
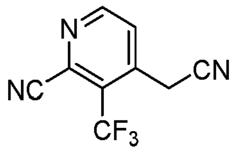
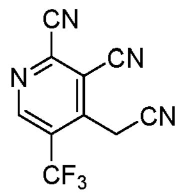

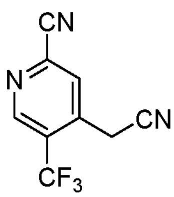
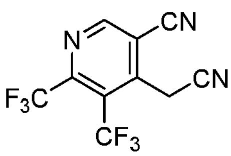
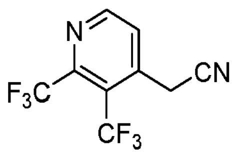
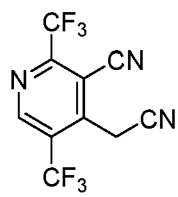

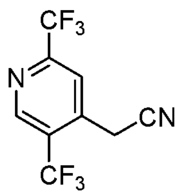
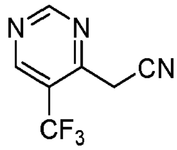
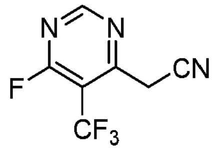
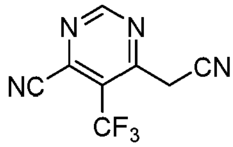

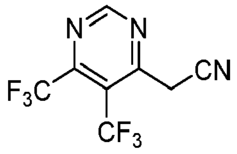 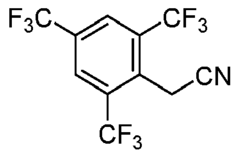 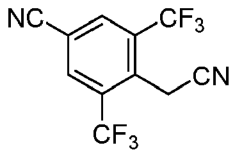 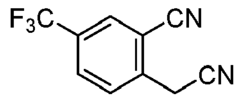

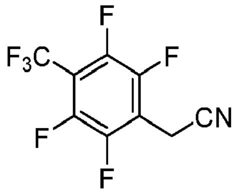 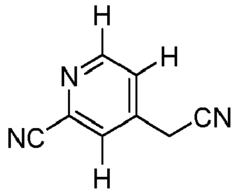 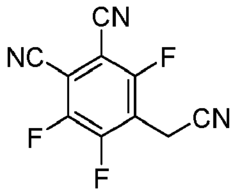 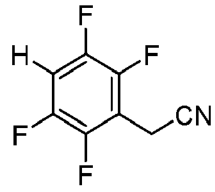

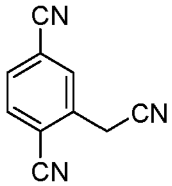 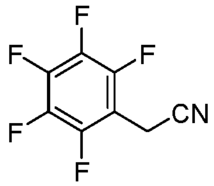 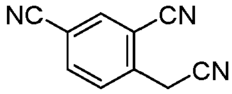 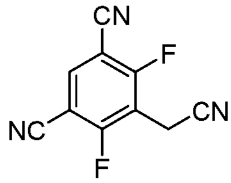

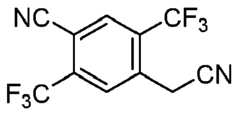 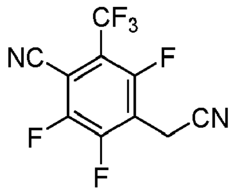 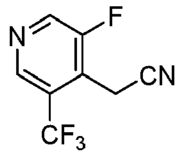 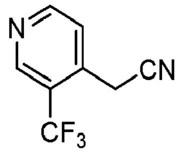

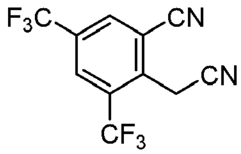 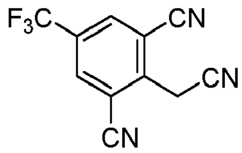 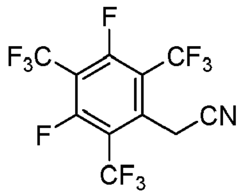 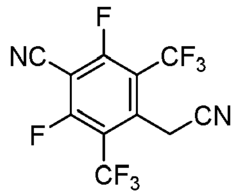

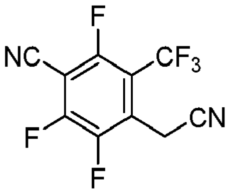 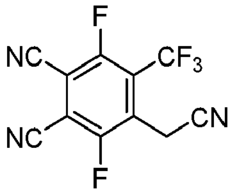 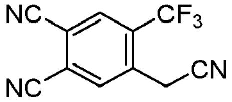 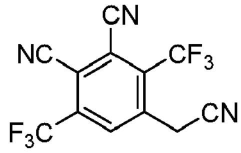

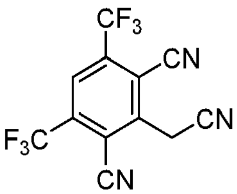 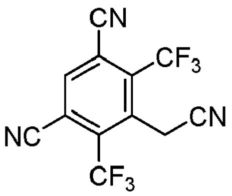 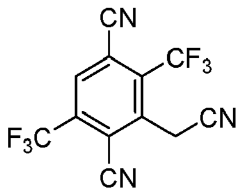 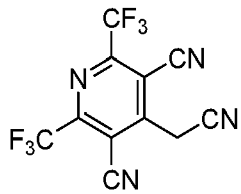

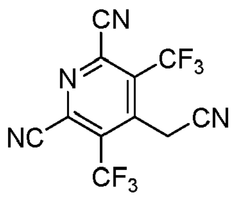 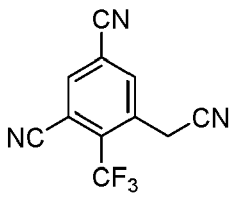 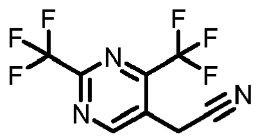 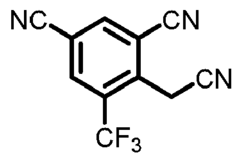

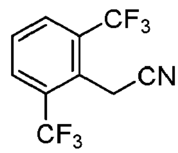.

According to one embodiment of the present invention, the group of formula (II) or formula (IIa) is selected from one of the following formulae:

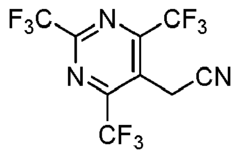 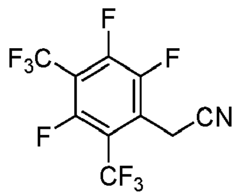 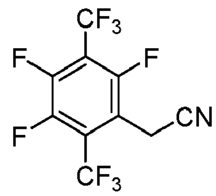 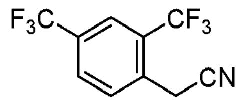

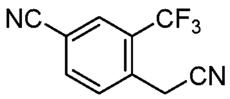 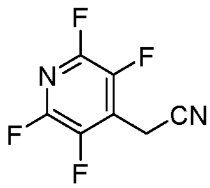 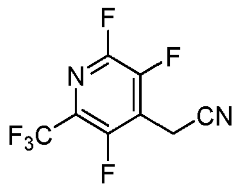 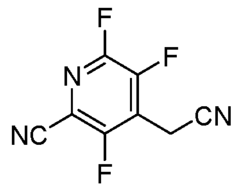

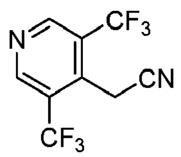 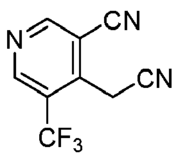 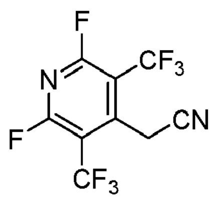 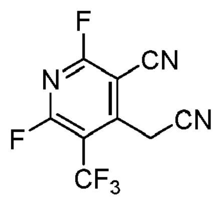

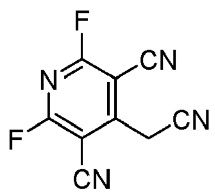 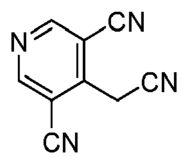 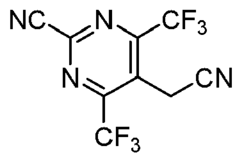 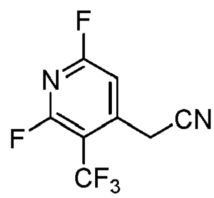

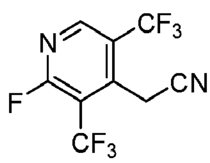 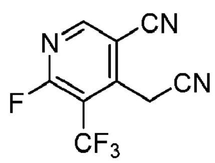 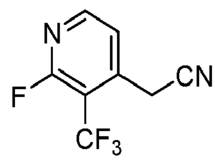 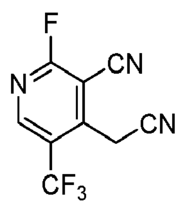

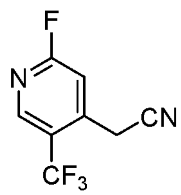
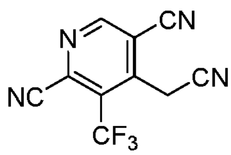
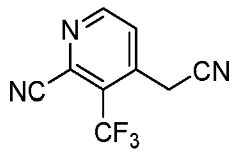
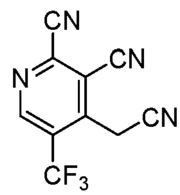

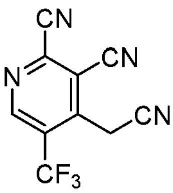
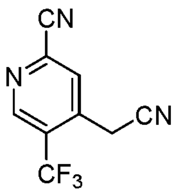
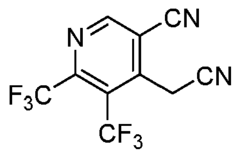
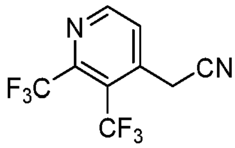

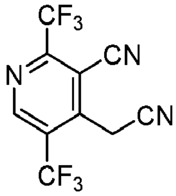
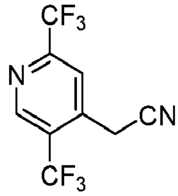
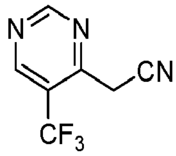
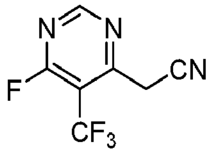

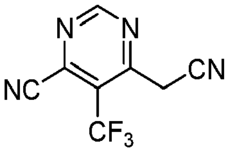
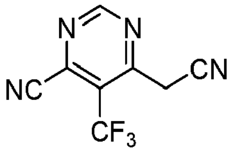
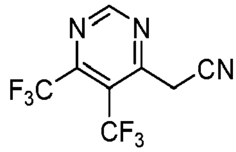
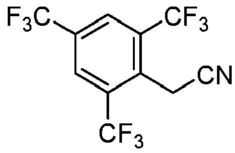

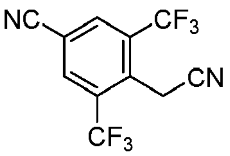
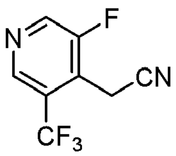
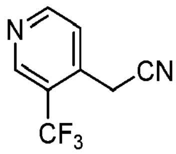
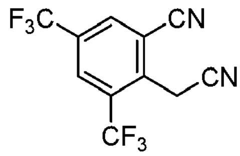

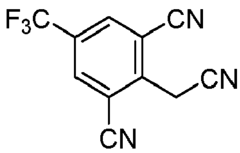
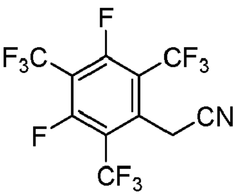
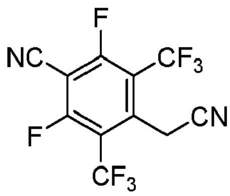
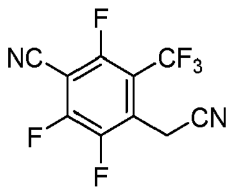

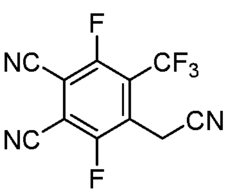
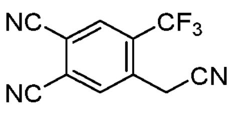
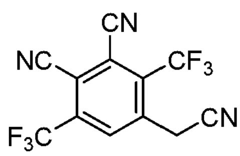
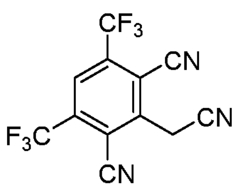

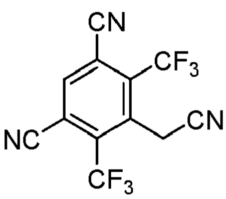
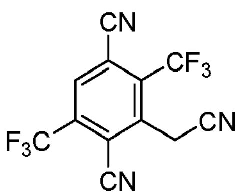
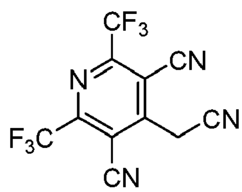
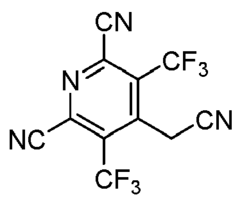

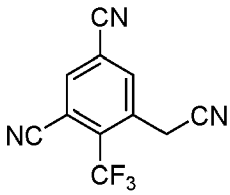 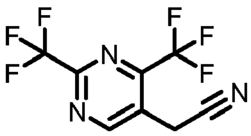 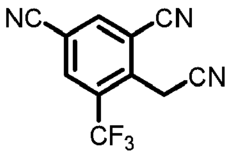 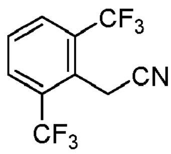 .

According to one embodiment of the present invention, the group of formula (II) or formula (IIa) is selected from one of the following formulae:

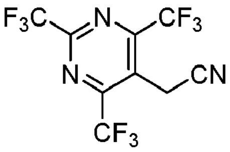 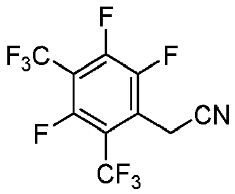 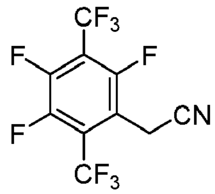 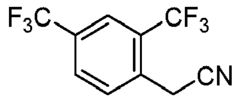

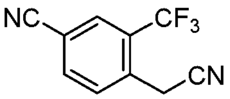 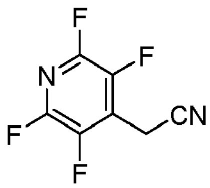 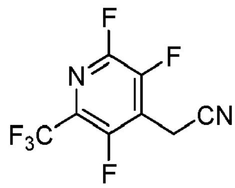 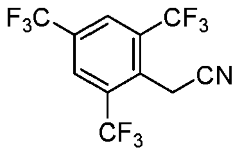

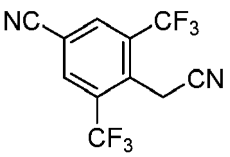 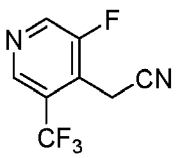 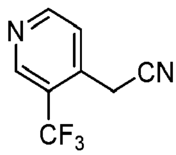 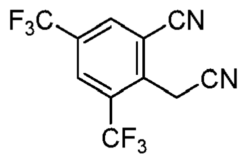

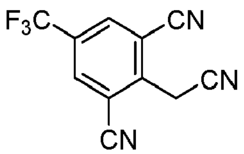 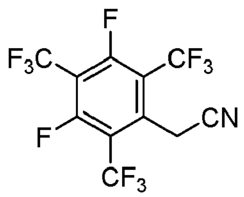 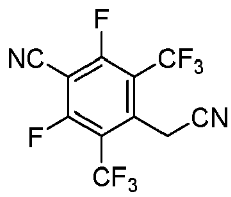 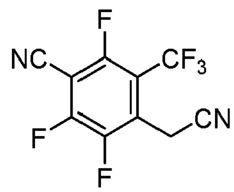

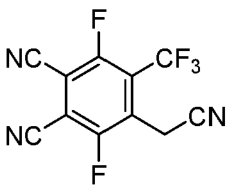 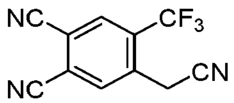 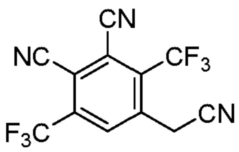 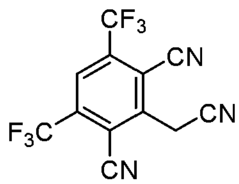

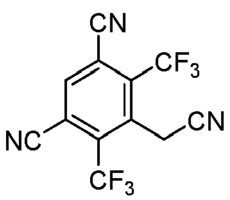 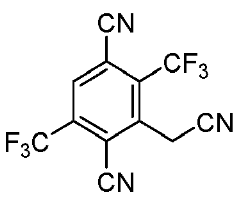 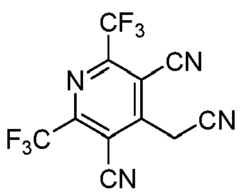 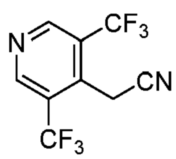

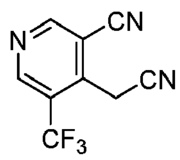
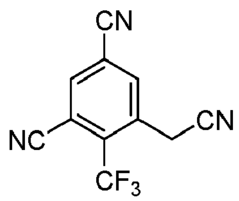
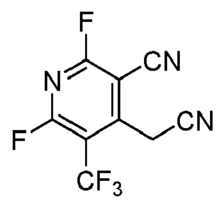
.

According to one embodiment of the present invention, the group of formula (III) or independently formula (IIIa) and formula (IIIb) is selected from one of the following formulae:

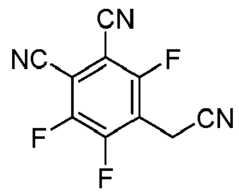
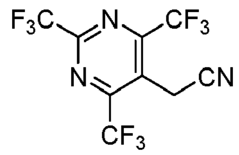
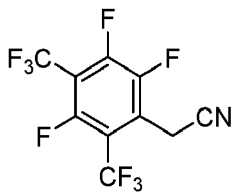
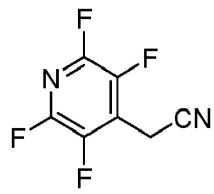

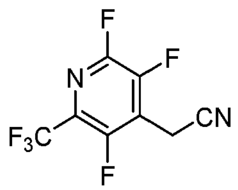
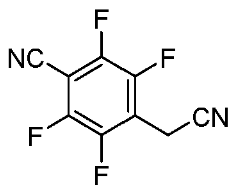
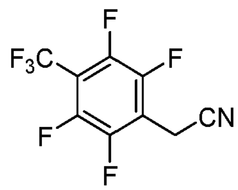
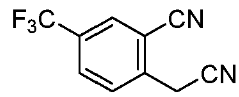

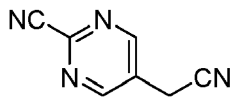
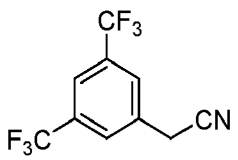
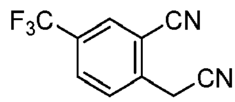
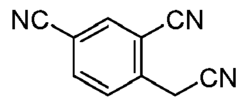

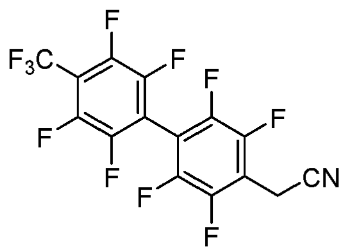
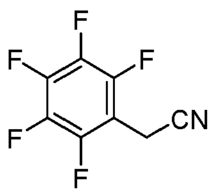
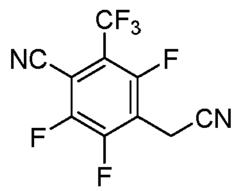

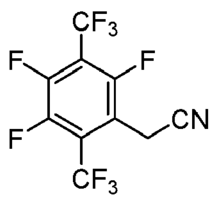
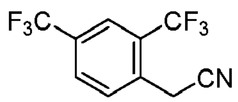
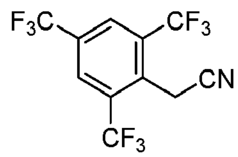
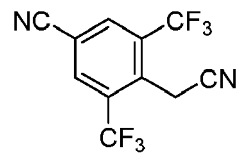

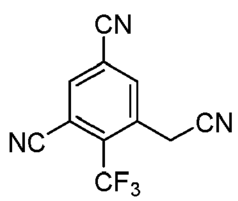
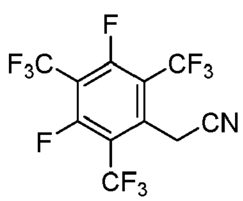
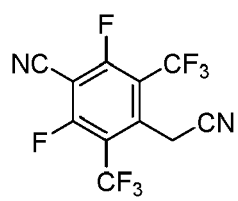
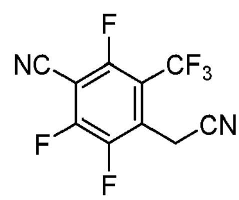

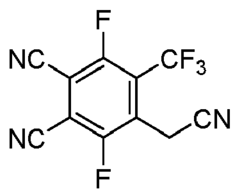 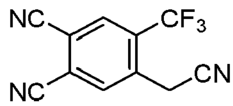 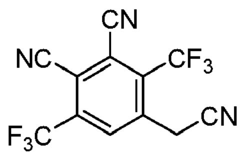 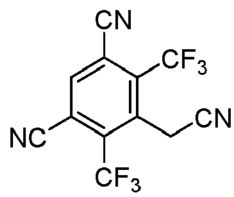

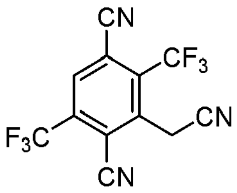 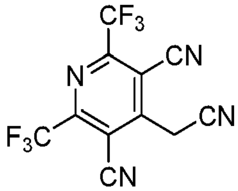 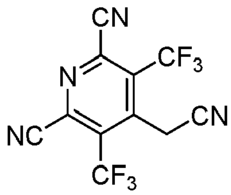 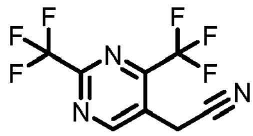

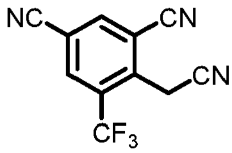 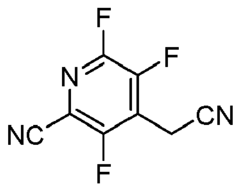 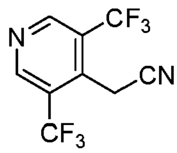 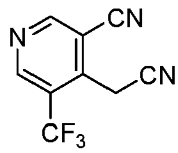

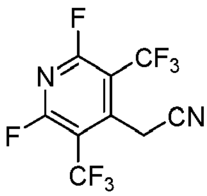 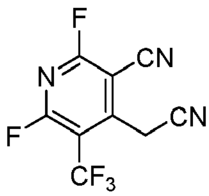 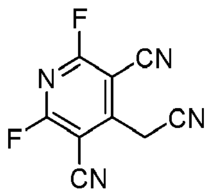 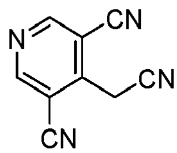

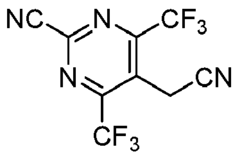 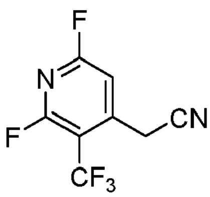 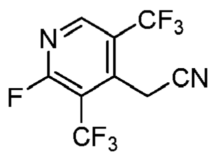 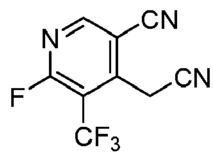

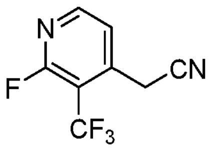 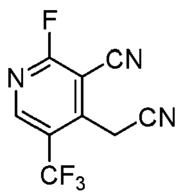 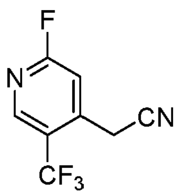 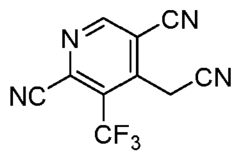

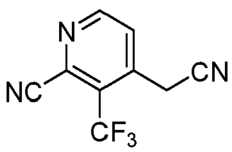 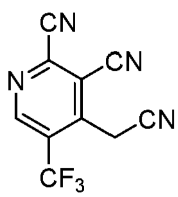 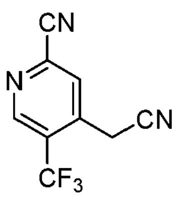 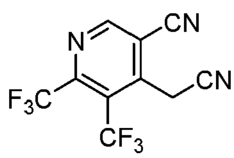

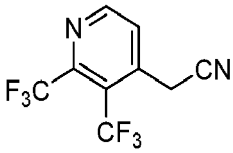
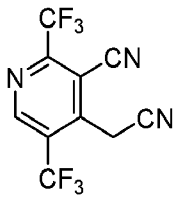
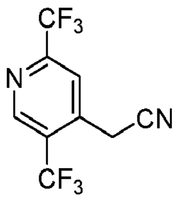
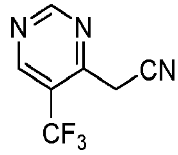

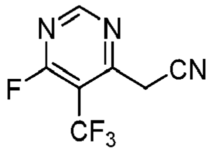
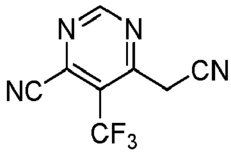
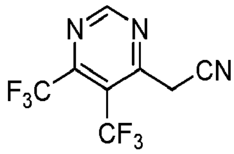
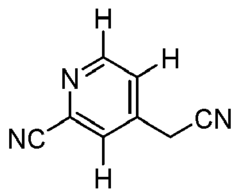

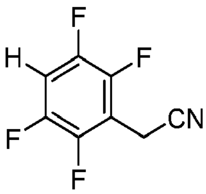
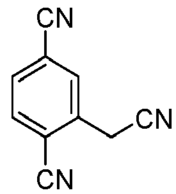
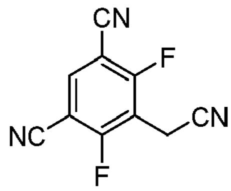
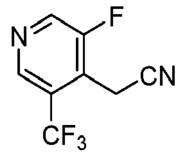

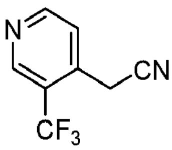
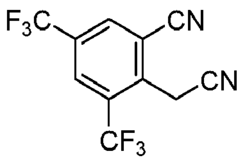
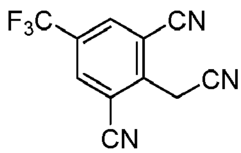
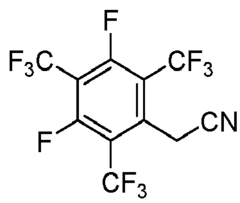

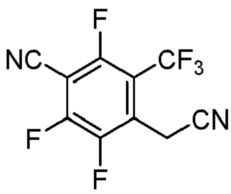
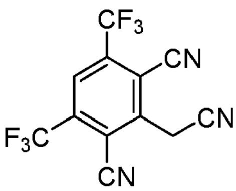

According to one embodiment of the present invention, the group of formula (III) or independently formula (IIIa) and formula (IIIb) is selected from one of the following formulae:

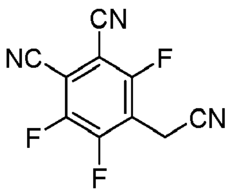
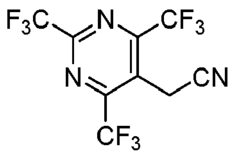
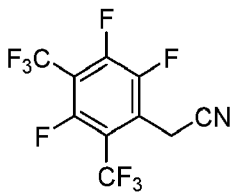
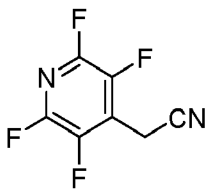

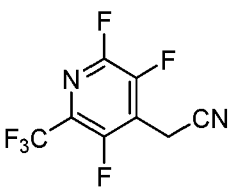
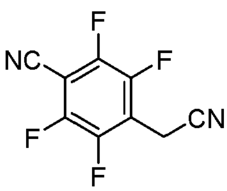
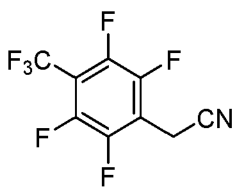
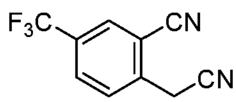

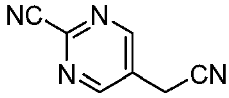 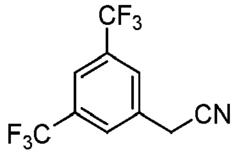 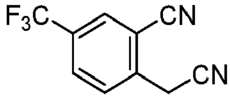 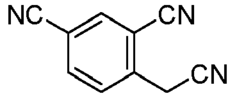

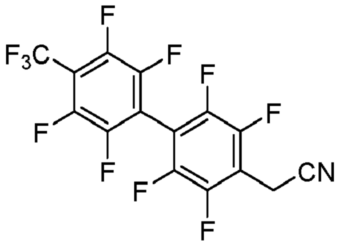 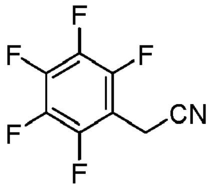 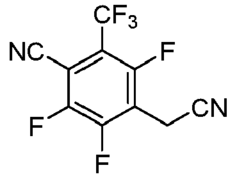

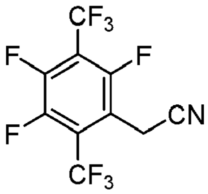 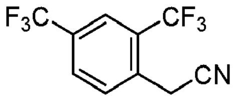 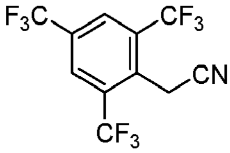 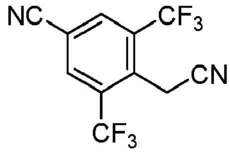

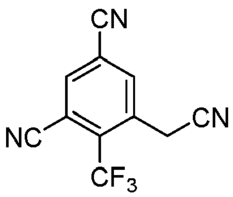 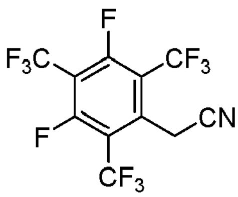 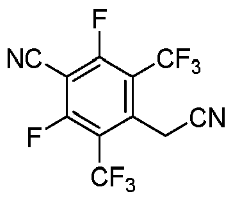 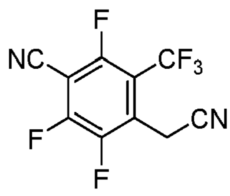

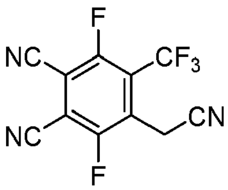 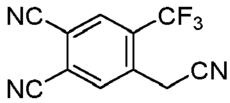 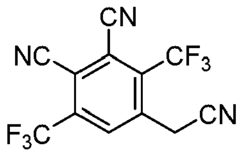 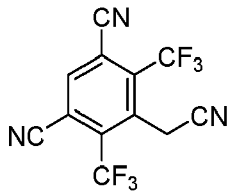

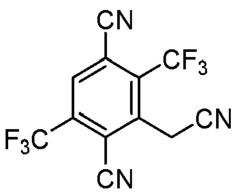 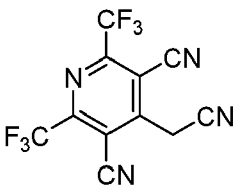 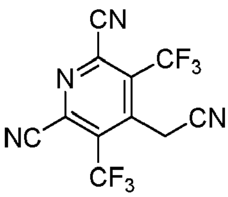 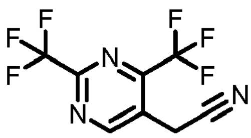

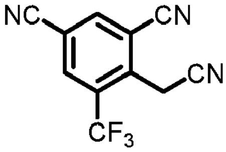 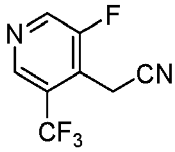 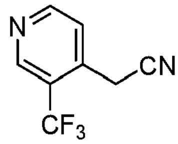 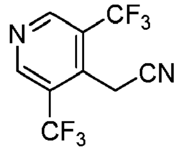

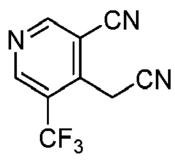 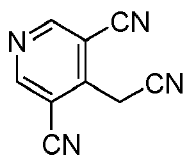 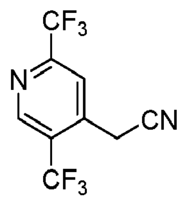 .

According to one embodiment of the present invention, the group of formula (III) or independently formula (IIIa) and formula (IIIb) is selected from one of the following formulae:

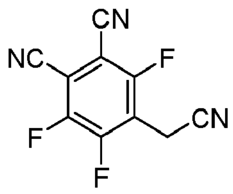 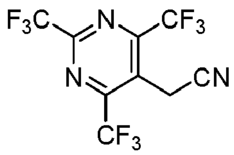 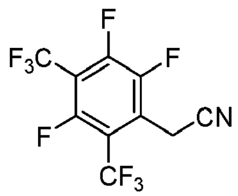 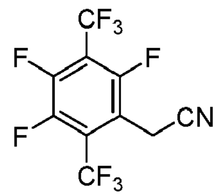

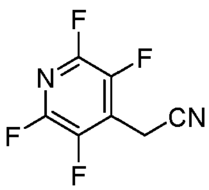 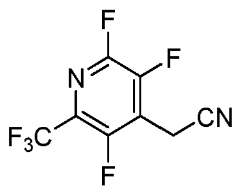 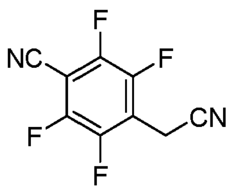 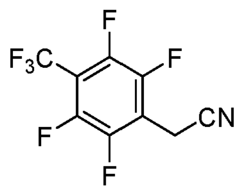

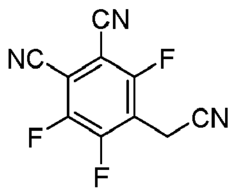 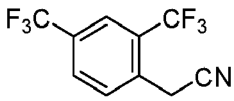 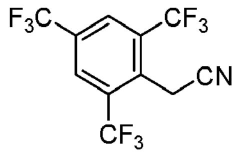 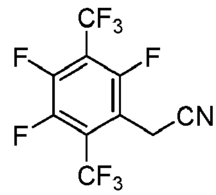

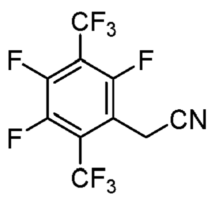 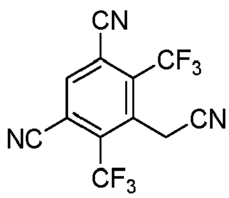 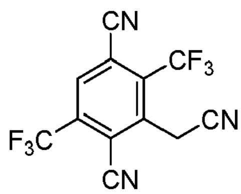 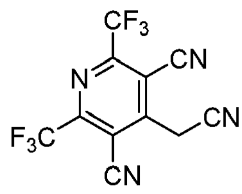

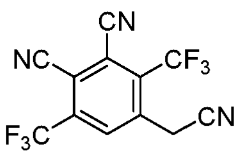 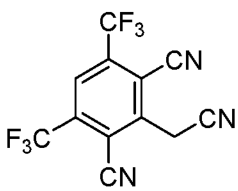 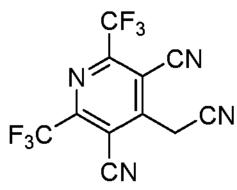 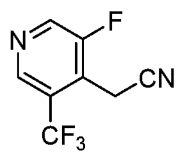

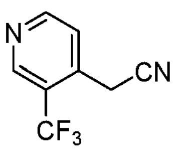 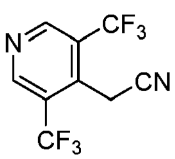 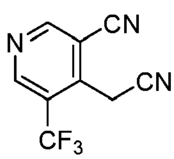 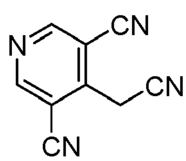

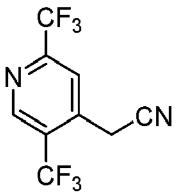 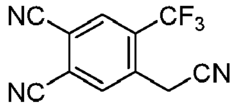 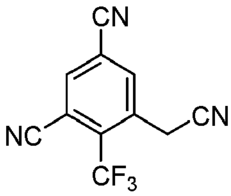 .

According to one embodiment of the present invention, the compound of formula (I) is selected from the compounds A1 to A79, wherein $A^1$, $A^2$ and $A^3$ of the compound of formula (I) are selected according to the following formulae:

| | $A^1$ | $A^2$ | $A^3$ |
|---|---|---|---|
| A1 | 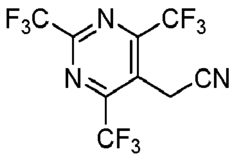 | 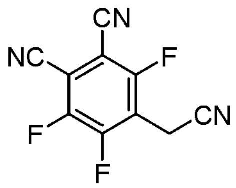 | 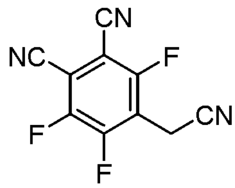 |
| A2 | 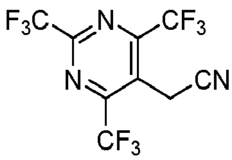 | 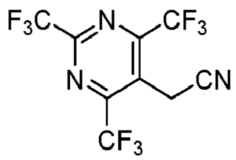 | 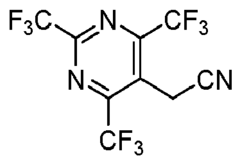 |
| A3 | 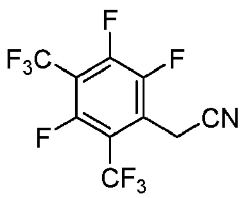 | 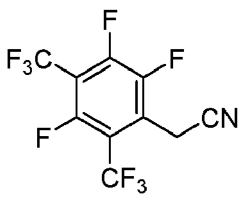 | 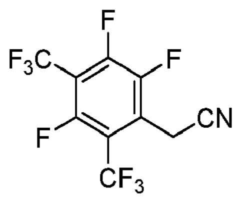 |
| A4 | 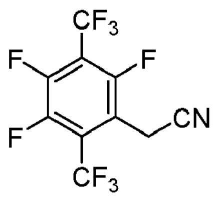 | 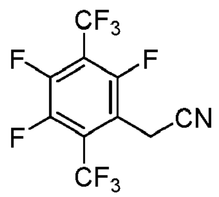 | 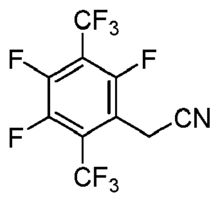 |
| A5 | 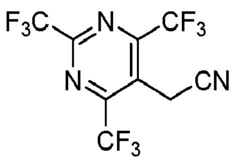 | 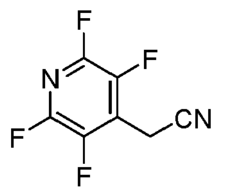 | 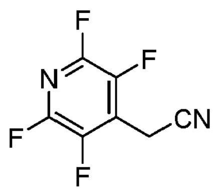 |
| A6 | 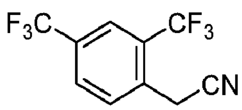 | 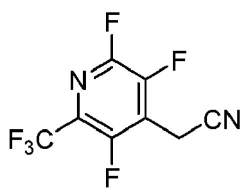 | 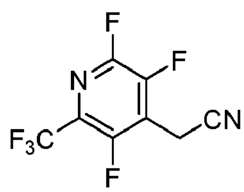 |

(continued)

| | $A^1$ | $A^2$ | $A^3$ |
|---|---|---|---|
| A7 | 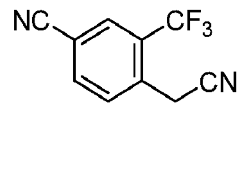 | 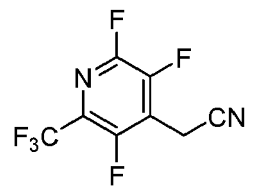 | 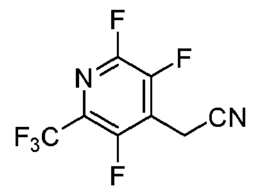 |
| A8 | 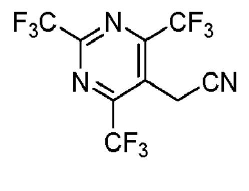 | 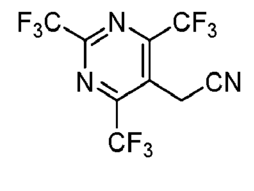 | 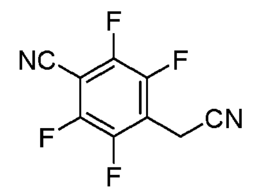 |
| A9 | 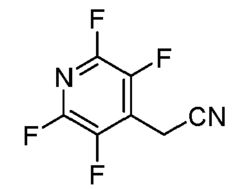 | 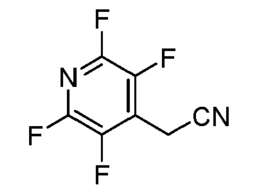 | 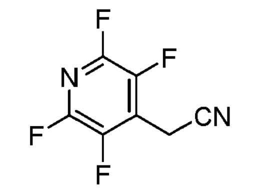 |
| A10 | 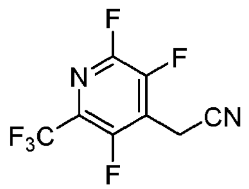 | 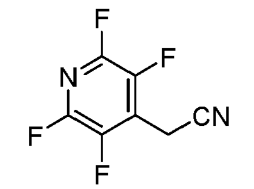 | 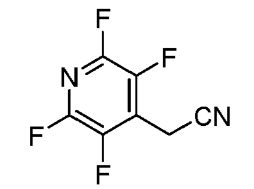 |
| A11 | 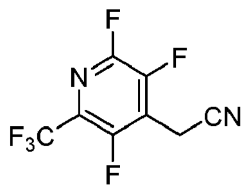 | 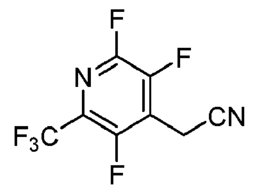 | 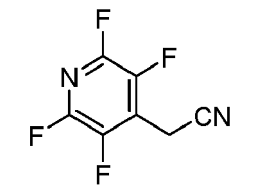 |
| A12 | 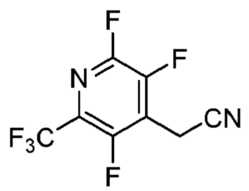 | 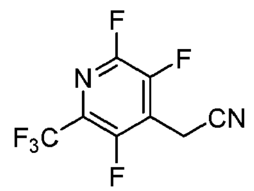 | 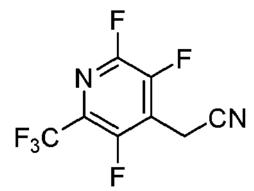 |
| A13 | 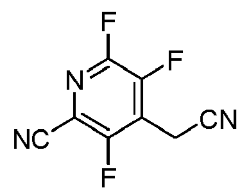 | 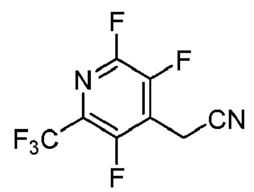 | 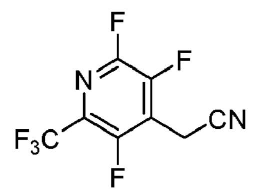 |
| A14 | 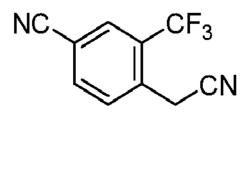 | 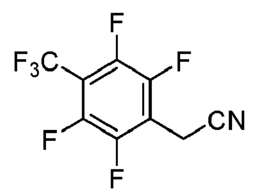 | 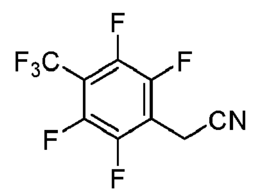 |

(continued)

| | $A^1$ | $A^2$ | $A^3$ |
|---|---|---|---|
| A15 | 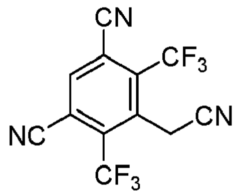 | 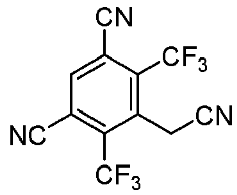 | 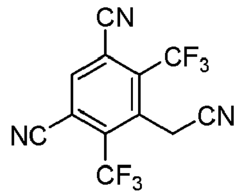 |
| A16 | 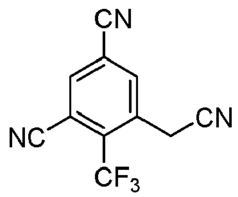 | 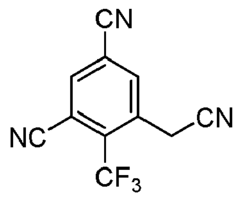 | 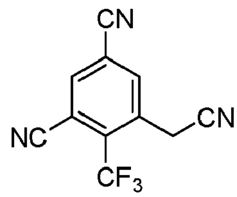 |
| A17 | 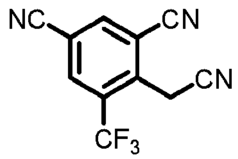 | 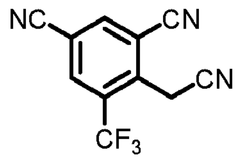 | 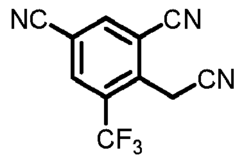 |
| A18 | 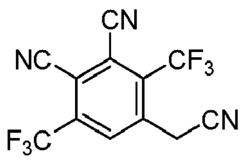 | 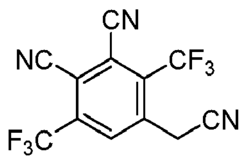 | 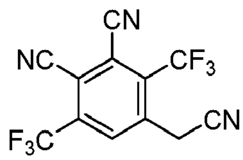 |
| A19 | 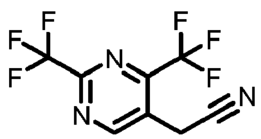 | 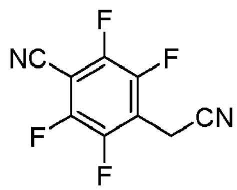 | 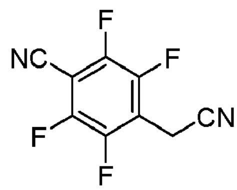 |
| A20 | 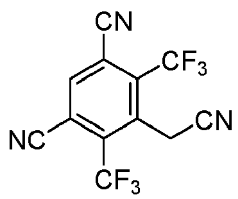 | 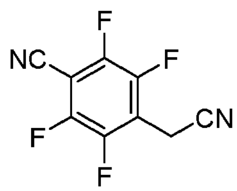 | 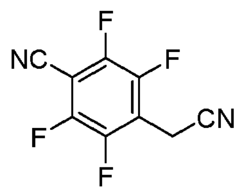 |
| A21 | 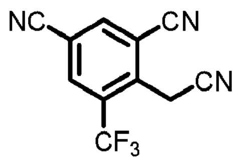 | 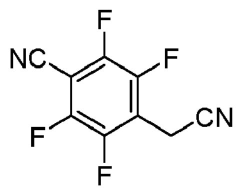 | 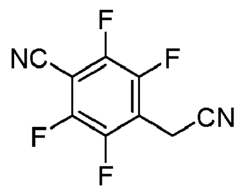 |
| A22 | 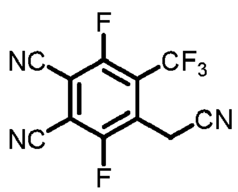 | 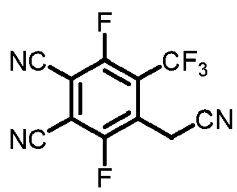 | 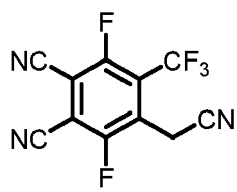 |

(continued)

| | $A^1$ | $A^2$ | $A^3$ |
|---|---|---|---|
| A23 | 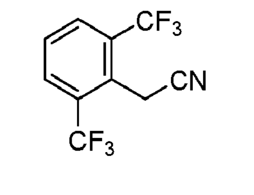 | 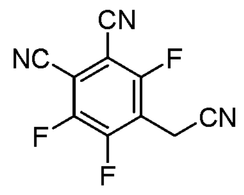 | 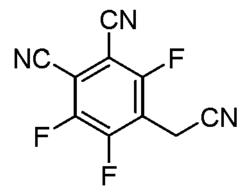 |
| A24 | 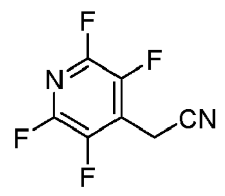 | 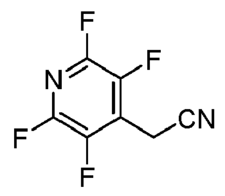 | 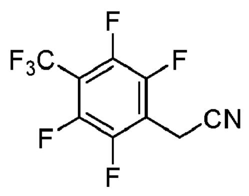 |
| A25 | 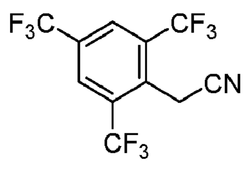 | 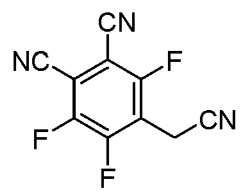 | 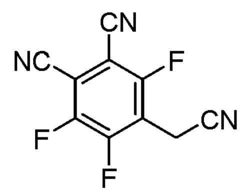 |
| A26 | 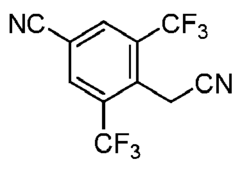 | 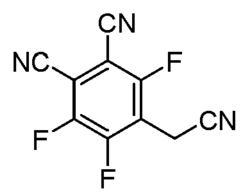 | 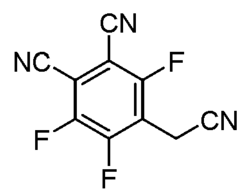 |
| A27 | 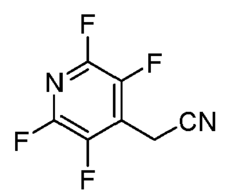 | 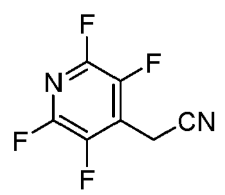 | 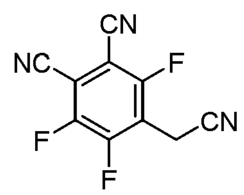 |
| A28 | 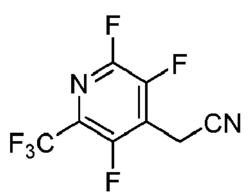 | 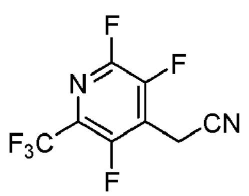 | 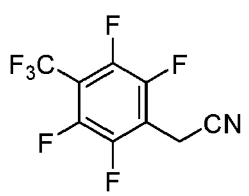 |
| A29 | 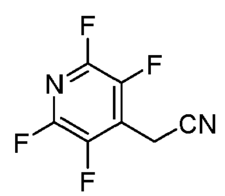 | 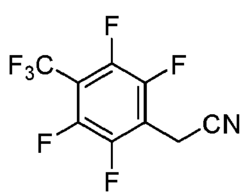 | 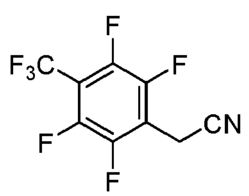 |
| A30 | 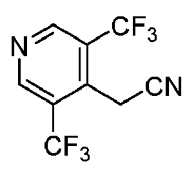 | 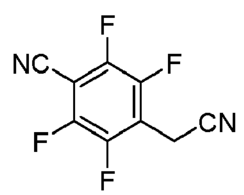 | 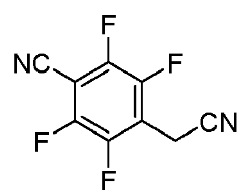 |

(continued)

| | $A^1$ | $A^2$ | $A^3$ |
|---|---|---|---|
| A31 | 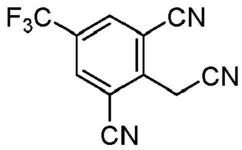 | 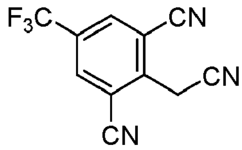 | 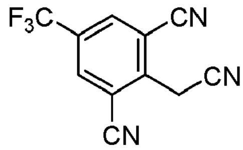 |
| A32 | 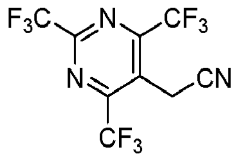 | 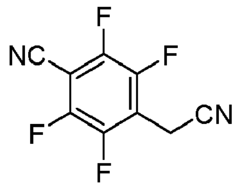 | 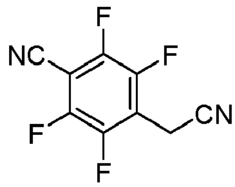 |
| A33 | 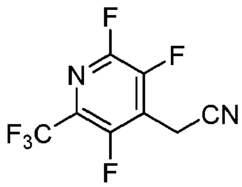 | 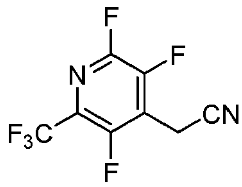 | 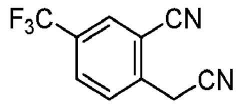 |
| A34 | 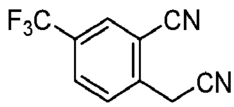 | 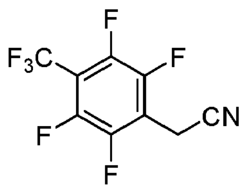 | 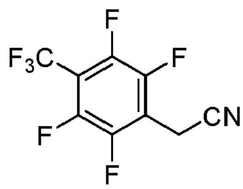 |
| A35 | 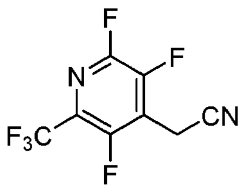 | 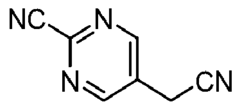 | 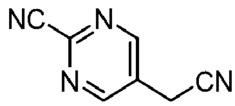 |
| A36 | 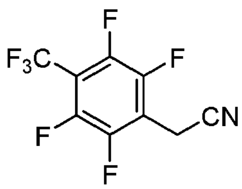 | 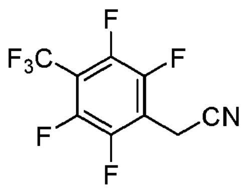 | 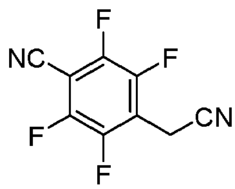 |
| A37 | 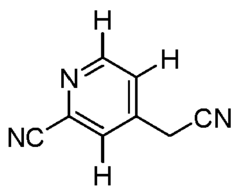 | 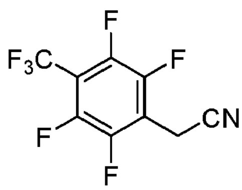 | 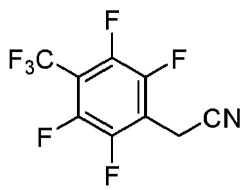 |
| A38 | 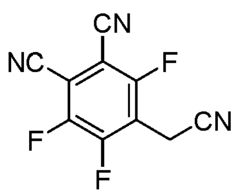 | 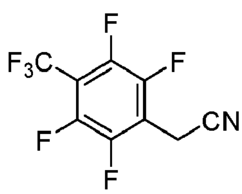 | 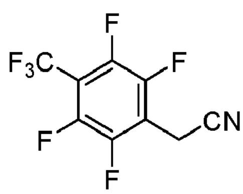 |

(continued)

| | $A^1$ | $A^2$ | $A^3$ |
|---|---|---|---|
| A39 | 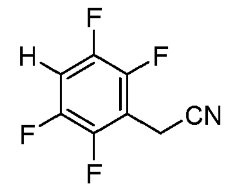 | 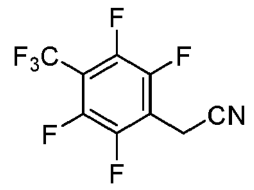 | 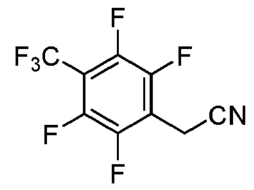 |
| A40 | 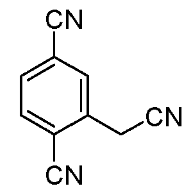 | 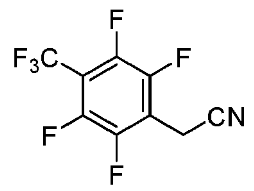 | 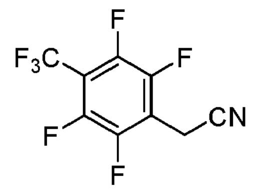 |
| A41 | 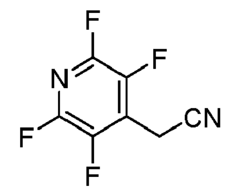 | 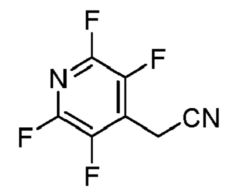 | 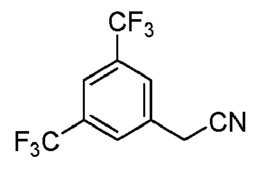 |
| A42 | 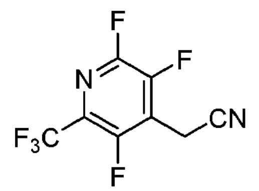 | 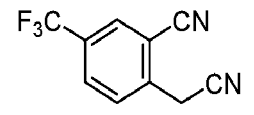 | 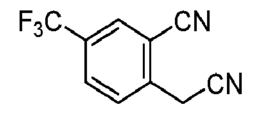 |
| A43 | 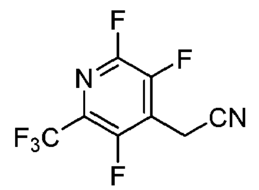 | 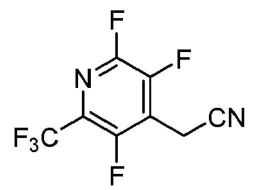 | 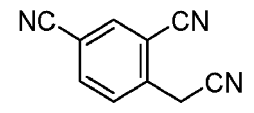 |
| A44 | 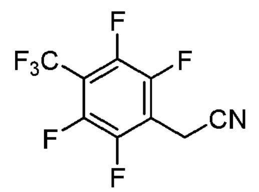 | 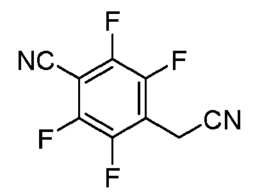 | 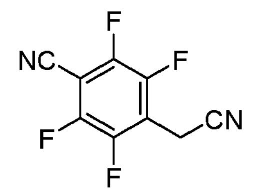 |
| A45 | 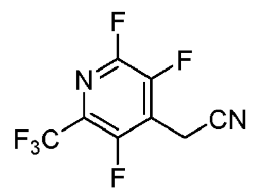 | 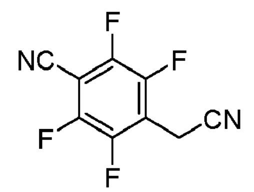 | 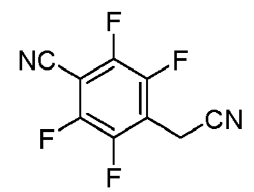 |
| A46 | 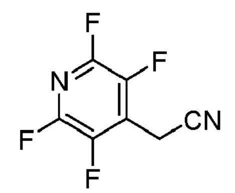 | 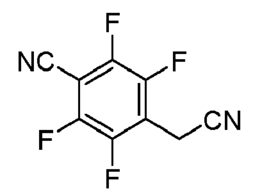 | 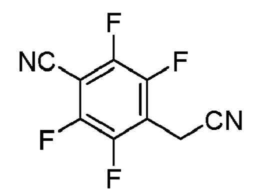 |

(continued)

| | $A^1$ | $A^2$ | $A^3$ |
|---|---|---|---|
| A47 | 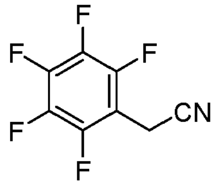 | 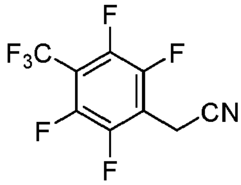 | 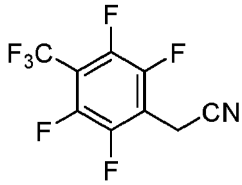 |
| A48 | 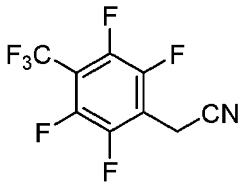 | 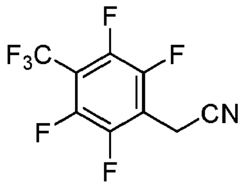 | 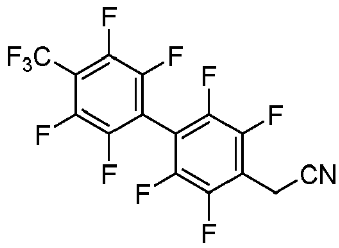 |
| A49 | 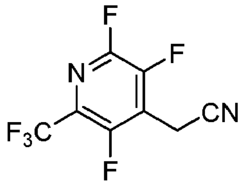 | 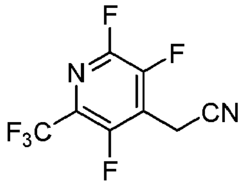 | 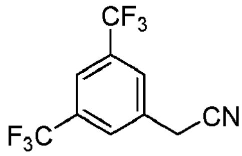 |
| A50 | 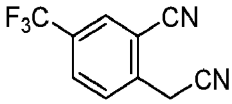 | 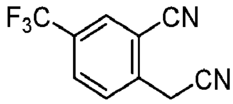 | 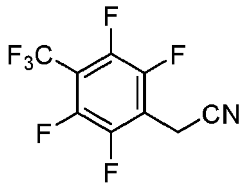 |
| A51 | 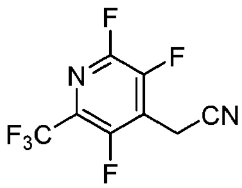 | 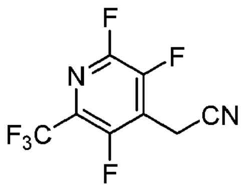 | 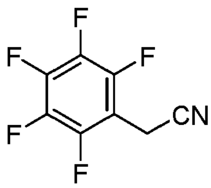 |
| A52 | 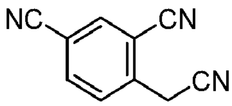 | 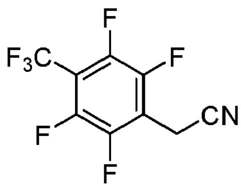 | 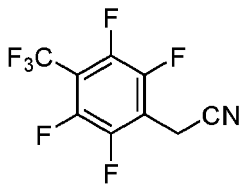 |
| A53 | 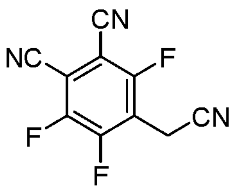 | 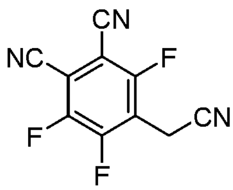 | 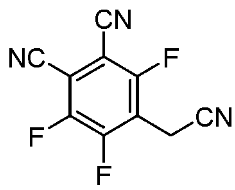 |

(continued)

| | $A^1$ | $A^2$ | $A^3$ |
|---|---|---|---|
| A54 | 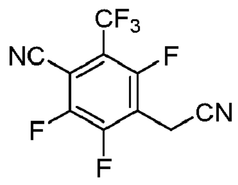 | 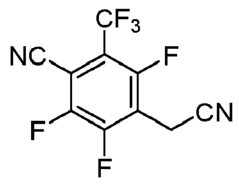 | 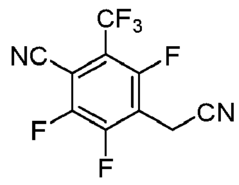 |
| A55 | 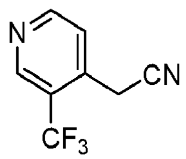 | 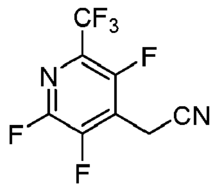 | 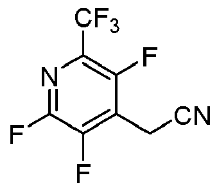 |
| A56 | 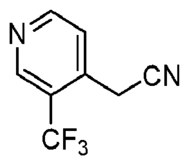 | 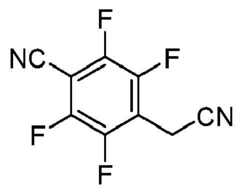 | 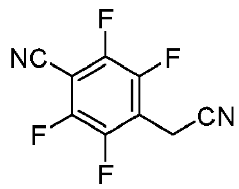 |
| A57 | 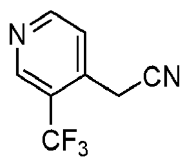 | 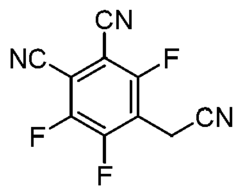 | 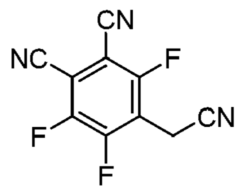 |
| A58 | 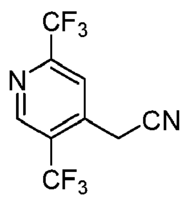 | 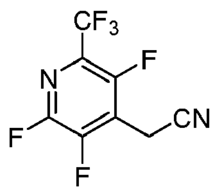 | 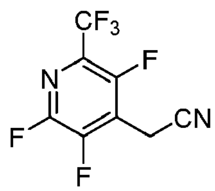 |
| A59 | 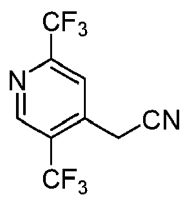 | 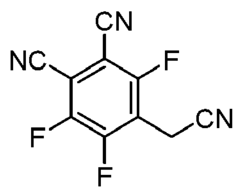 | 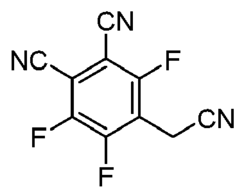 |
| A60 | 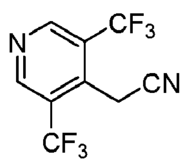 | 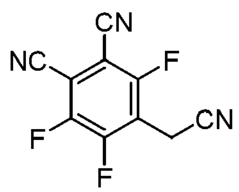 | 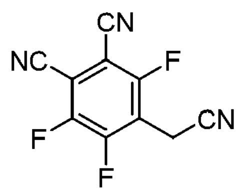 |
| A61 | 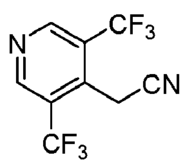 | 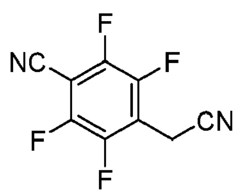 | 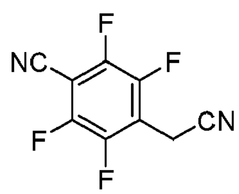 |

(continued)

| | $A^1$ | $A^2$ | $A^3$ |
|---|---|---|---|
| A62 | 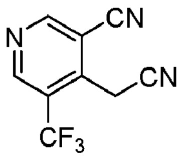 | 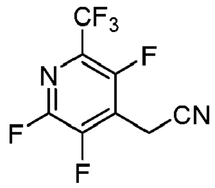 | 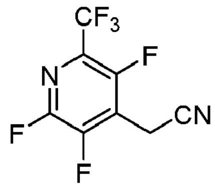 |
| A63 | 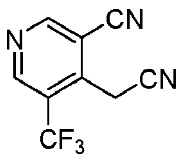 | 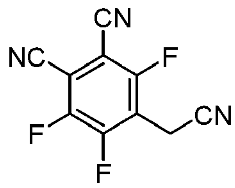 | 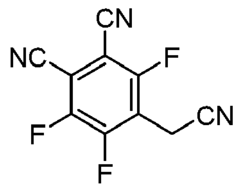 |
| A64 | 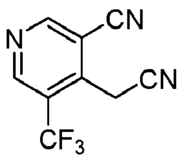 | 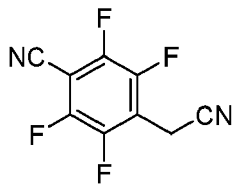 | 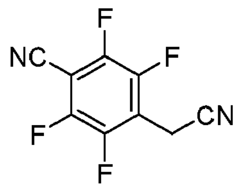 |
| A65 | 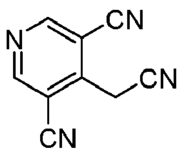 | 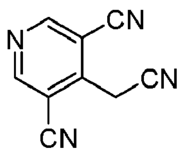 | 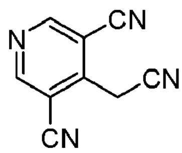 |
| A66 | 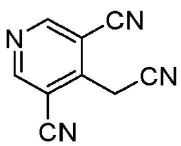 | 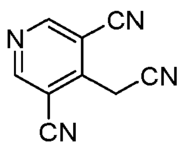 | 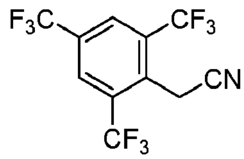 |
| A67 | 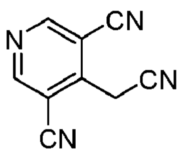 | 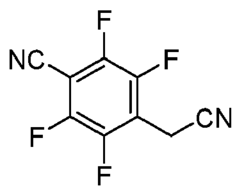 | 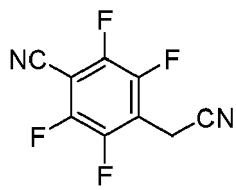 |
| A68 | 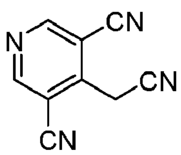 | 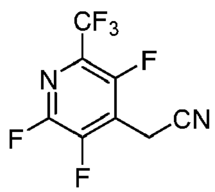 | 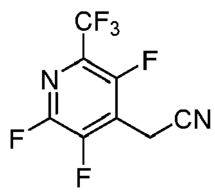 |
| A69 | 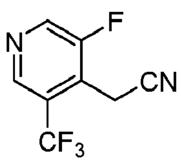 | 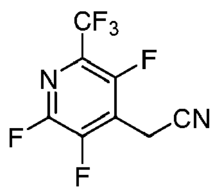 | 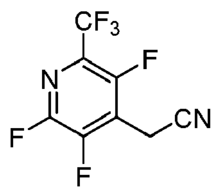 |

(continued)

| | $A^1$ | $A^2$ | $A^3$ |
|---|---|---|---|
| A70 | 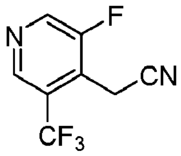 | 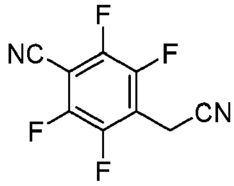 | 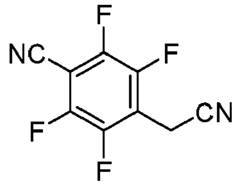 |
| A71 | 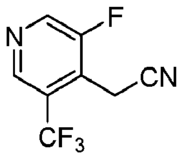 | 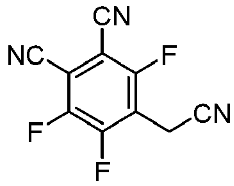 | 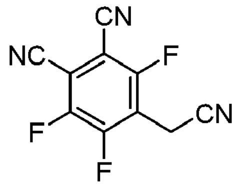 |
| A72 | 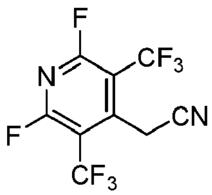 | 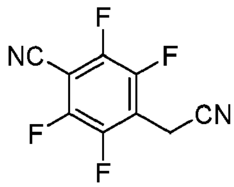 | 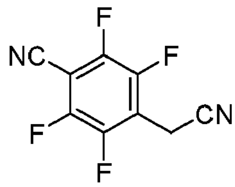 |
| A73 | 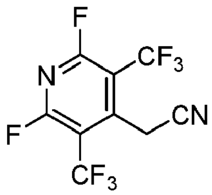 | 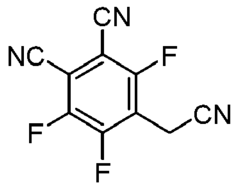 | 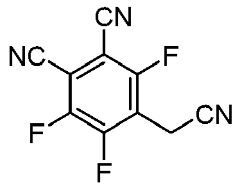 |
| A74 | 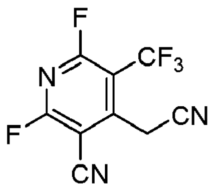 | 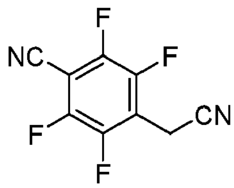 | 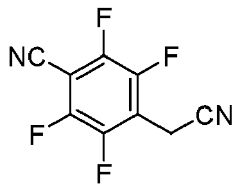 |
| A75 | 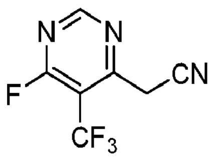 | 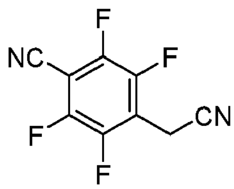 | 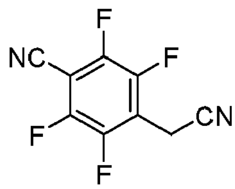 |
| A76 | 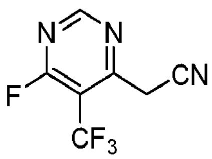 | 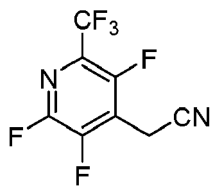 | 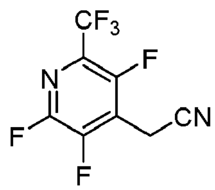 |
| A77 | 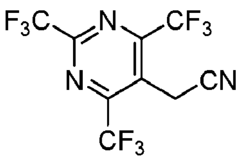 | 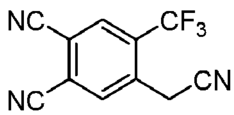 | 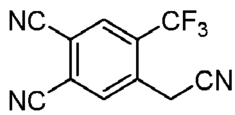 |

(continued)

| | $A^1$ | $A^2$ | $A^3$ |
|---|---|---|---|
| A78 | 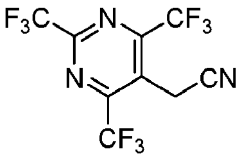 | 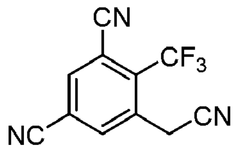 | 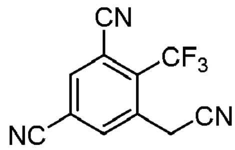 |
| A79 | 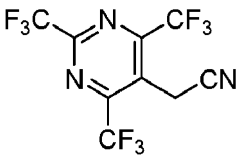 | 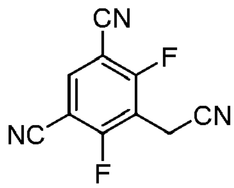 | 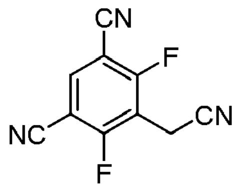 |

According to one embodiment of the present invention, the compound of formula (I) is selected from the compounds A1 to A29, A57, A59, A60, A61, A64, A70 to A72, A77 and A78, wherein $A^1$, $A^2$ and $A^3$ of the compound of formula (I) are selected according to the following formulae:

| | $A^1$ | $A^2$ | $A^3$ |
|---|---|---|---|
| A1 | 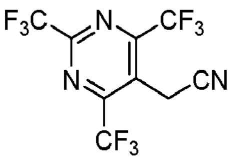 | 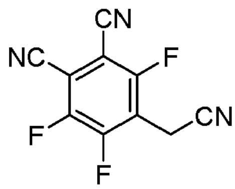 | 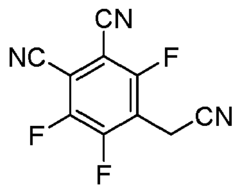 |
| A2 | 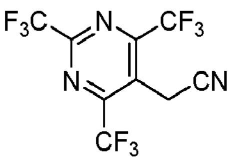 | 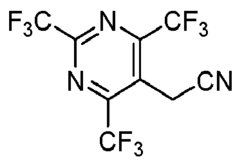 | 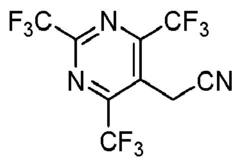 |
| A3 | 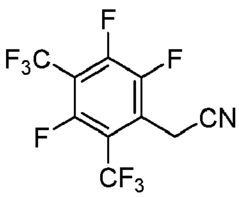 | 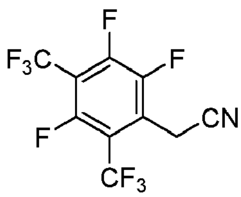 | 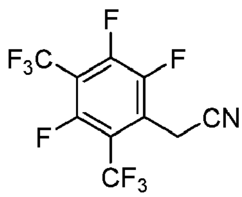 |
| A4 | 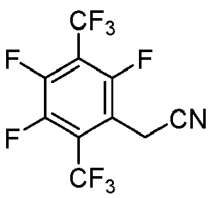 | 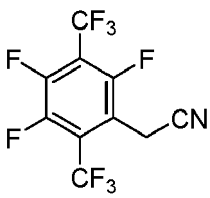 | 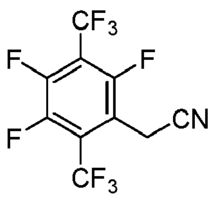 |
| A5 | 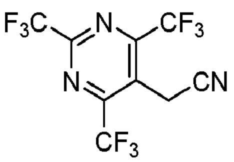 | 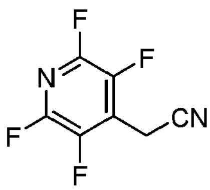 | 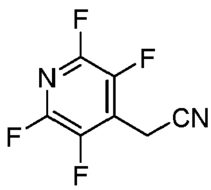 |

(continued)

| | $A^1$ | $A^2$ | $A^3$ |
|---|---|---|---|
| A6 | 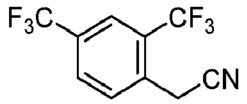 | 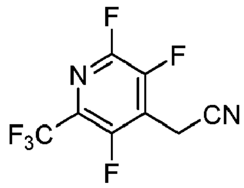 | 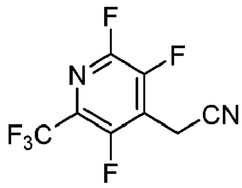 |
| A7 | 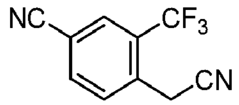 | 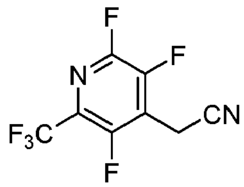 | 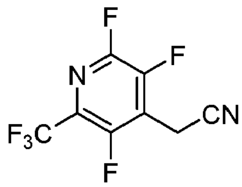 |
| A8 | 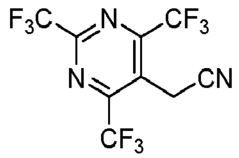 | 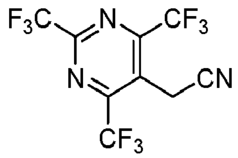 | 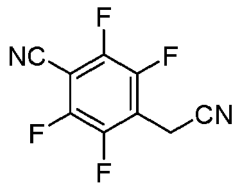 |
| A9 | 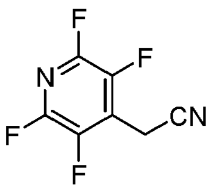 | 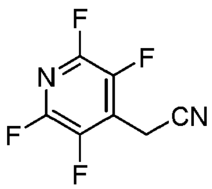 | 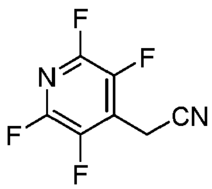 |
| A10 | 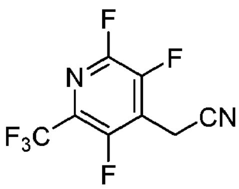 | 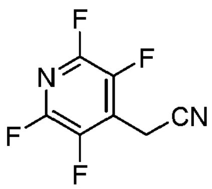 | 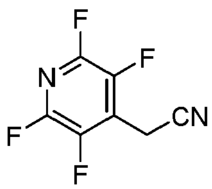 |
| A11 | 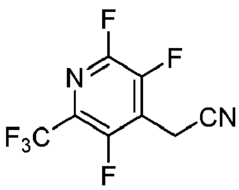 | 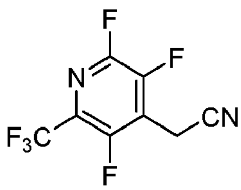 | 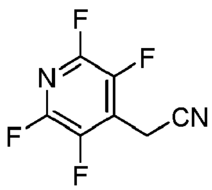 |
| A12 | 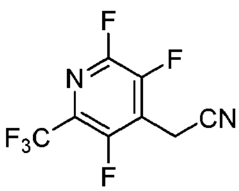 | 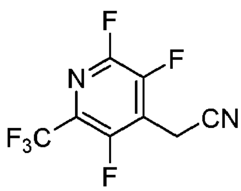 | 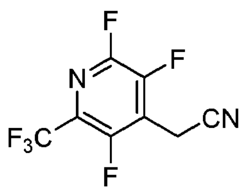 |
| A13 | 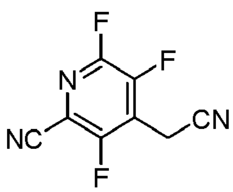 | 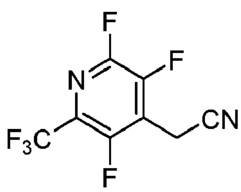 | 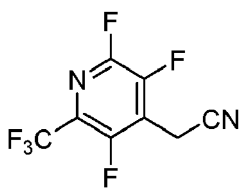 |

(continued)

| | A1 | A2 | A3 |
|---|---|---|---|
| A14 | 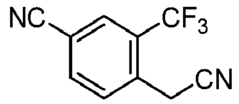 | 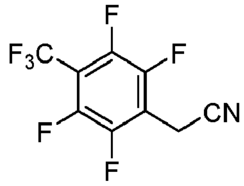 | 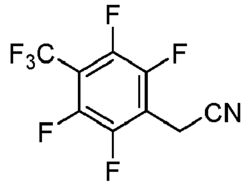 |
| A15 | 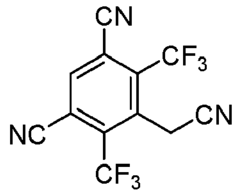 | 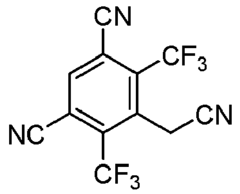 | 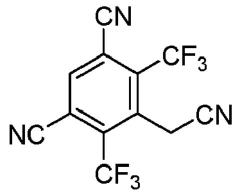 |
| A16 | 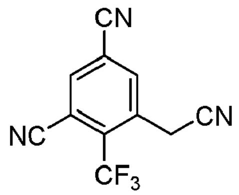 | 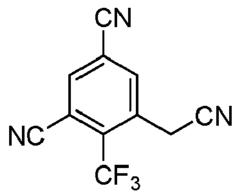 | 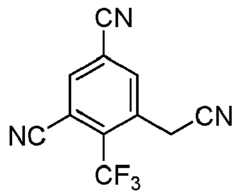 |
| A17 | 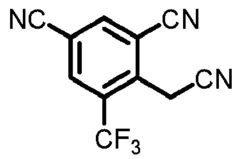 | 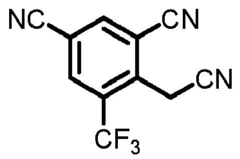 | 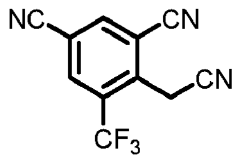 |
| A18 | 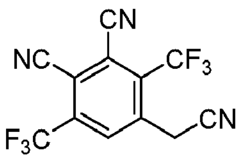 | 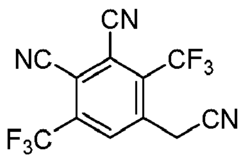 | 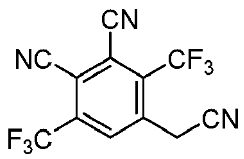 |
| A19 | 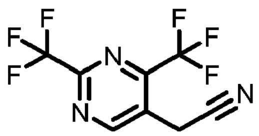 | 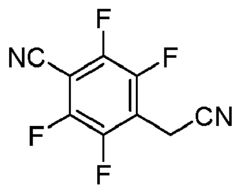 | 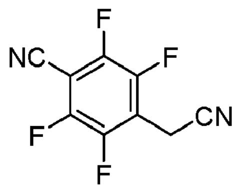 |
| A20 | 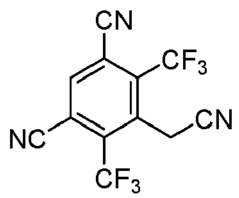 | 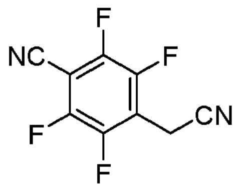 | 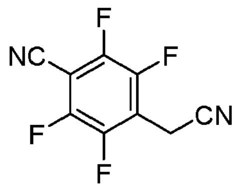 |
| A21 | 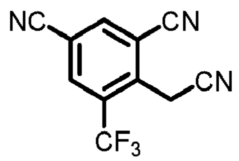 | 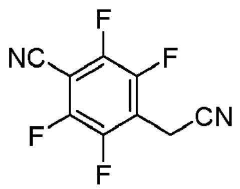 | 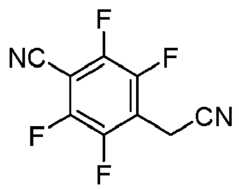 |

(continued)

| | $A^1$ | $A^2$ | $A^3$ |
|---|---|---|---|
| A22 | 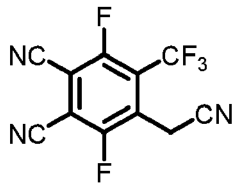 | 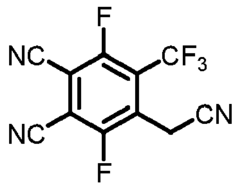 | 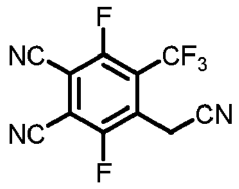 |
| A23 | 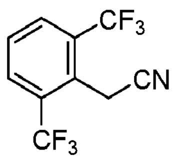 | 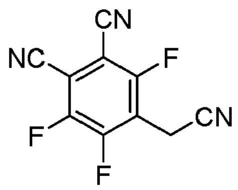 | 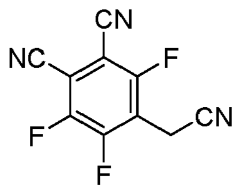 |
| A24 | 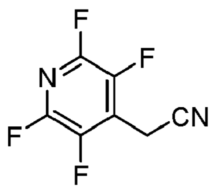 | 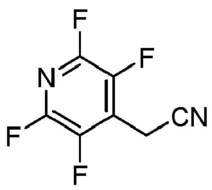 | 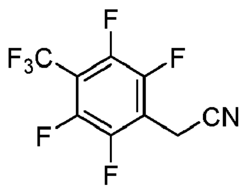 |
| A25 | 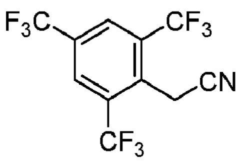 | 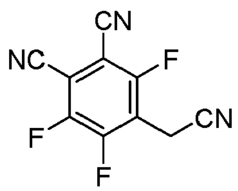 | 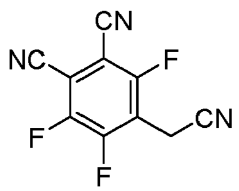 |
| A26 | 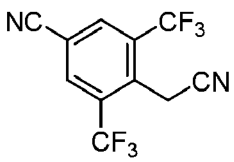 | 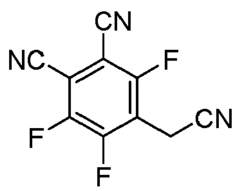 | 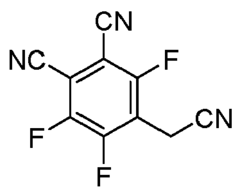 |
| A27 | 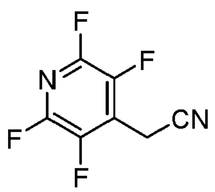 | 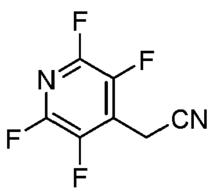 | 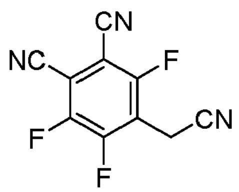 |
| A28 | 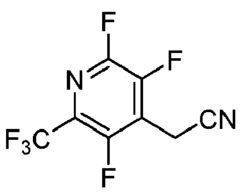 | 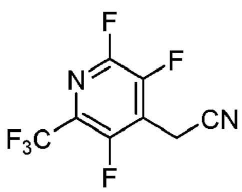 | 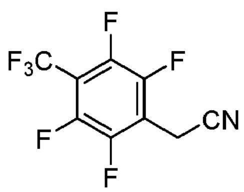 |
| A29 | 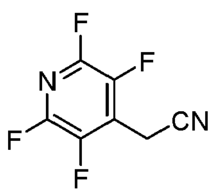 | 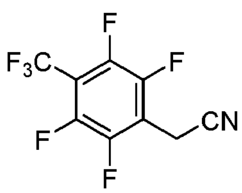 | 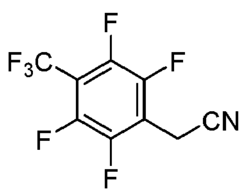 |

(continued)

| | $A^1$ | $A^2$ | $A^3$ |
|---|---|---|---|
| A57 | 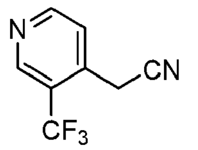 | 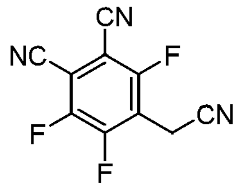 | 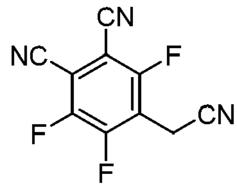 |
| A59 | 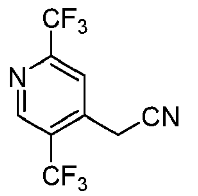 | 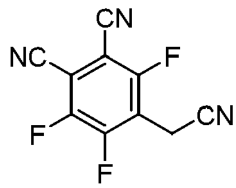 | 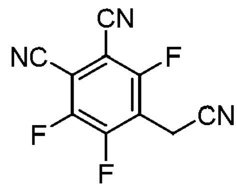 |
| A60 | 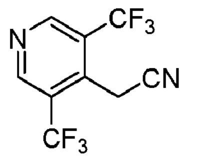 | 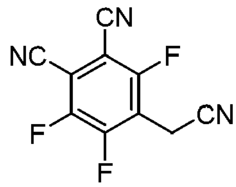 | 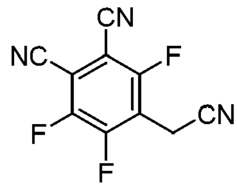 |
| A61 | 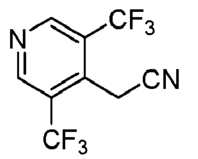 | 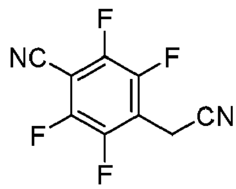 | 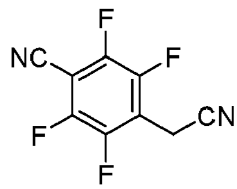 |
| A64 | 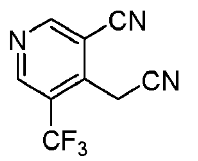 | 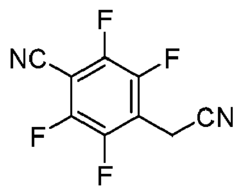 | 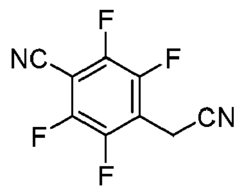 |
| A70 | 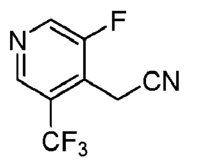 | 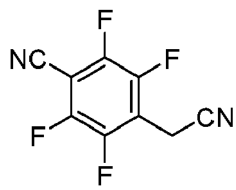 | 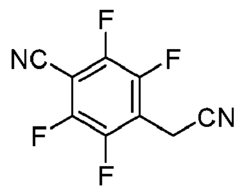 |
| A71 | 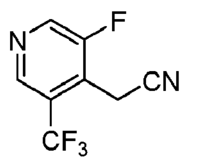 | 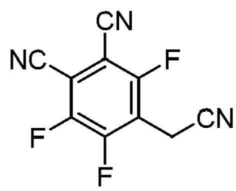 | 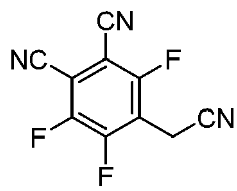 |
| A72 | 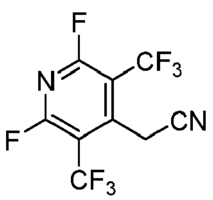 | 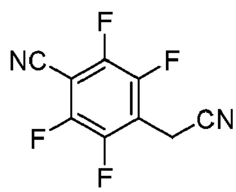 | 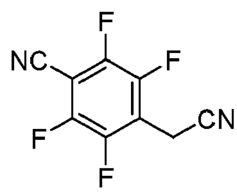 |

(continued)

| | $A^1$ | $A^2$ | $A^3$ |
|---|---|---|---|
| A77 | 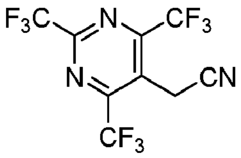 | 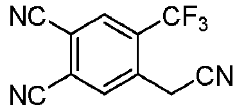 | 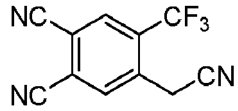 |
| A78 | 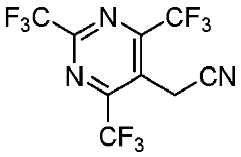 | 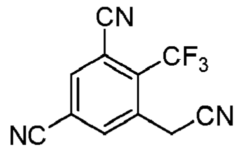 | 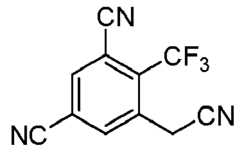 |

According to one embodiment of the present invention, the compound of formula (I) is selected from the compounds A1 to A18, A57, A59, A60, A61, A64, A77 and A78, wherein $A^1$, $A^2$ and $A^3$ of the compound of formula (I) are selected according to the following formulae:

| | $A^1$ | $A^2$ | $A^3$ |
|---|---|---|---|
| A1 | 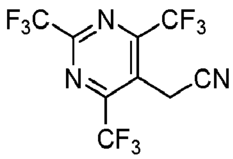 | 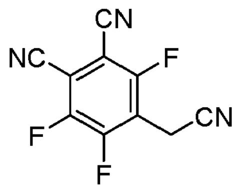 | 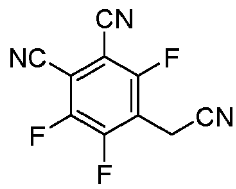 |
| A2 | 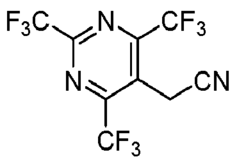 | 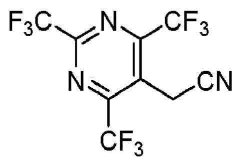 | 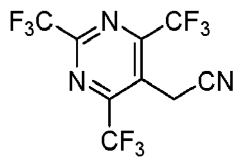 |
| A3 | 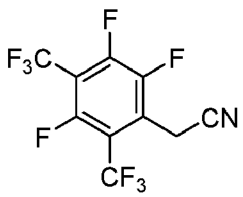 | 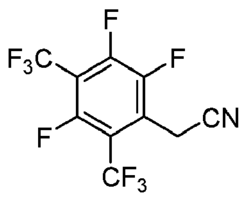 | 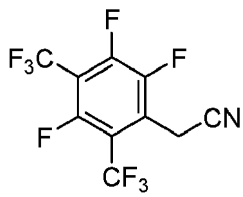 |
| A4 | 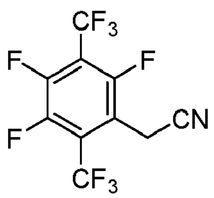 | 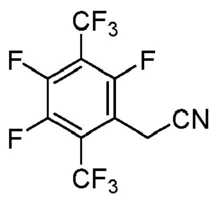 | 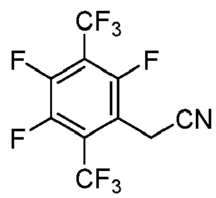 |
| A5 | 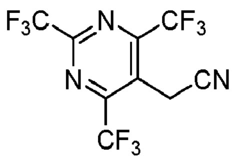 | 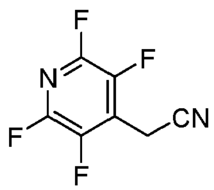 | 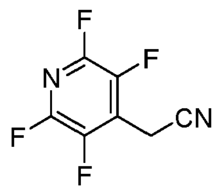 |

(continued)

| | $A^1$ | $A^2$ | $A^3$ |
|---|---|---|---|
| A6 | 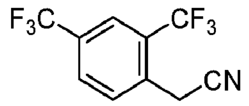 | 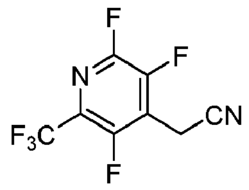 | 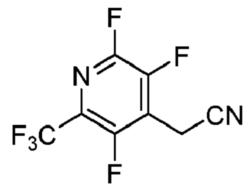 |
| A7 | 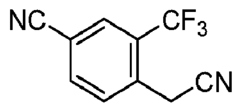 | 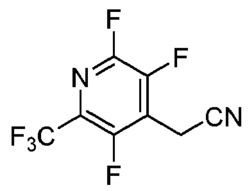 | 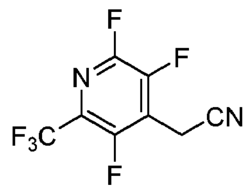 |
| A8 | 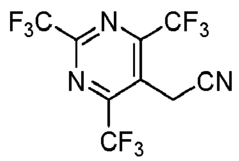 | 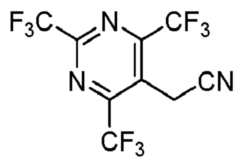 | 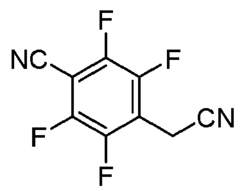 |
| A9 | 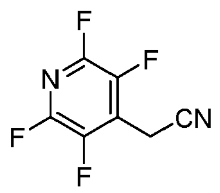 | 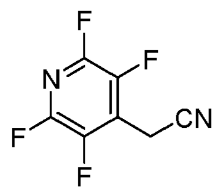 | 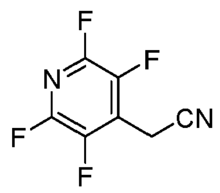 |
| A10 | 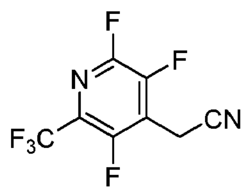 | 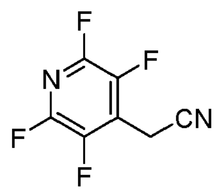 | 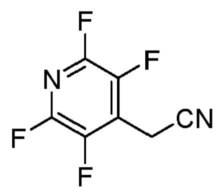 |
| A11 | 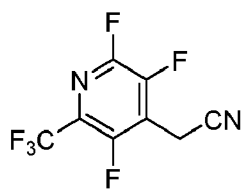 | 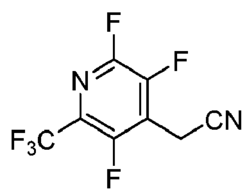 | 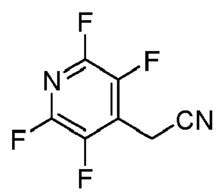 |
| A12 | 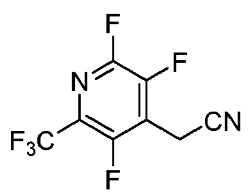 | 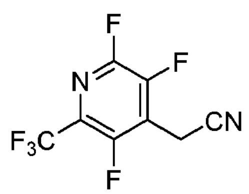 | 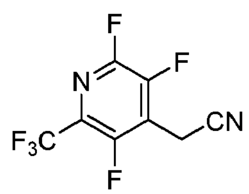 |
| A13 | 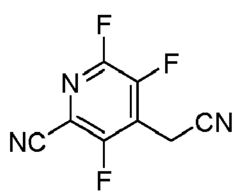 | 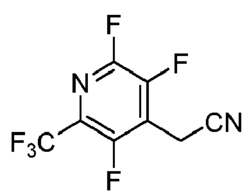 | 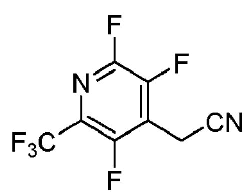 |

(continued)

| | A[1] | A[2] | A[3] |
|---|---|---|---|
| A14 | 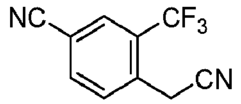 | 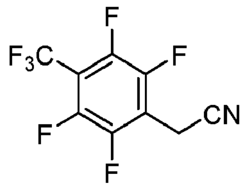 | 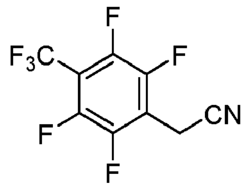 |
| A15 | 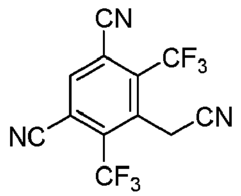 | 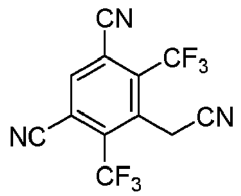 | 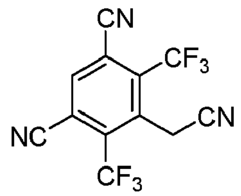 |
| A16 | 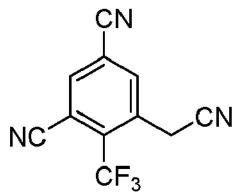 | 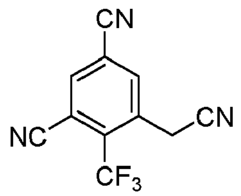 | 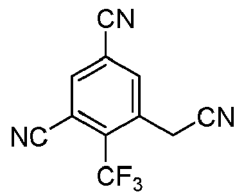 |
| A17 | 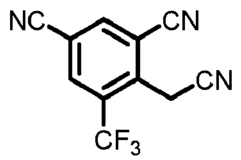 | 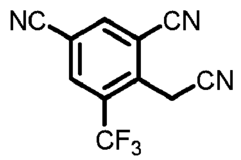 | 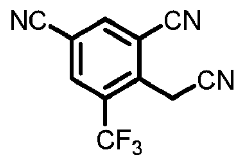 |
| A18 | 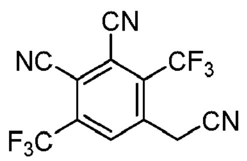 | 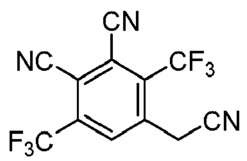 | 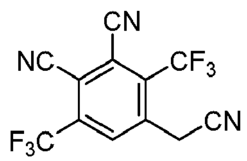 |
| A57 | 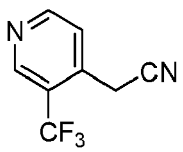 | 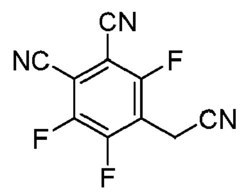 | 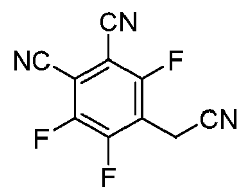 |
| A59 | 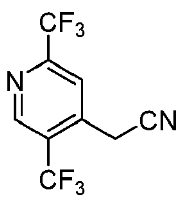 | 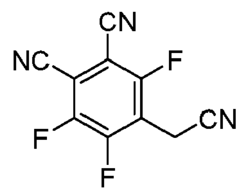 | 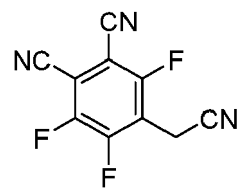 |
| A60 | 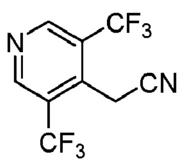 | 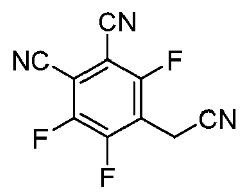 | 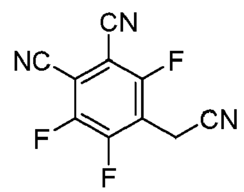 |

(continued)

| | $A^1$ | $A^2$ | $A^3$ |
|---|---|---|---|
| A61 | 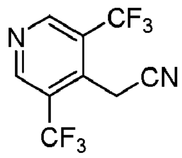 | 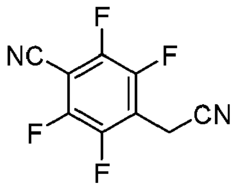 | 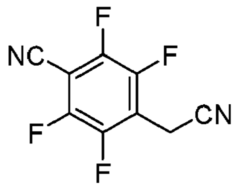 |
| A64 | 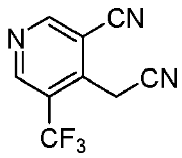 | 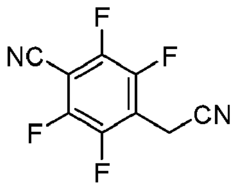 | 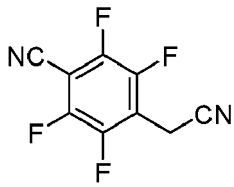 |
| A77 | 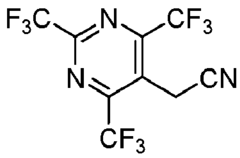 | 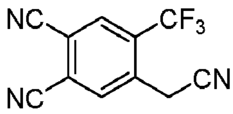 | 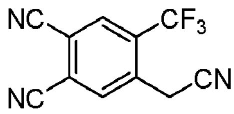 |
| A78 | 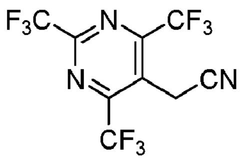 | 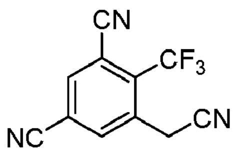 | 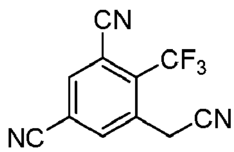 |

According to one embodiment of the present invention, the compound of formula (I) is selected from the compounds B1 to B79:

| | | |
|---|---|---|
| 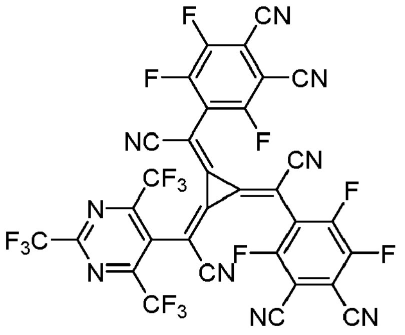 | 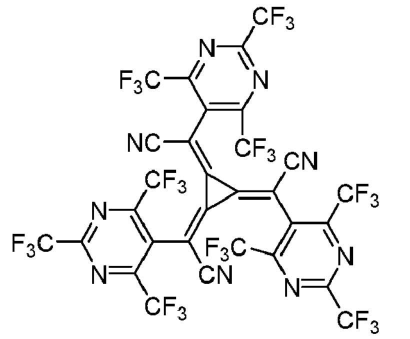 | 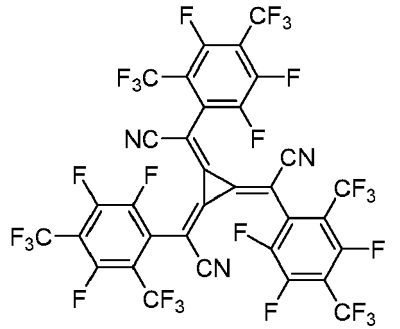 |
| B1 | B2 | B3 |
| 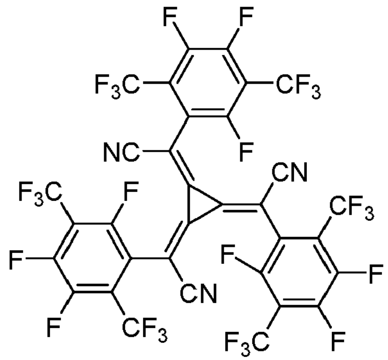 | 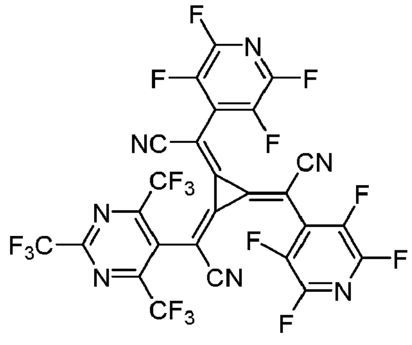 | 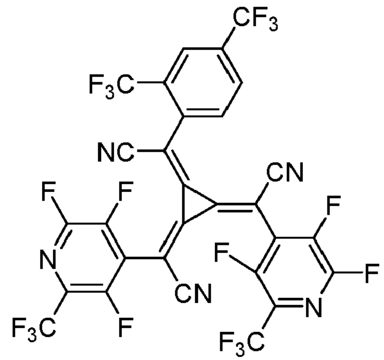 |
| B4 | B5 | B6 |
| 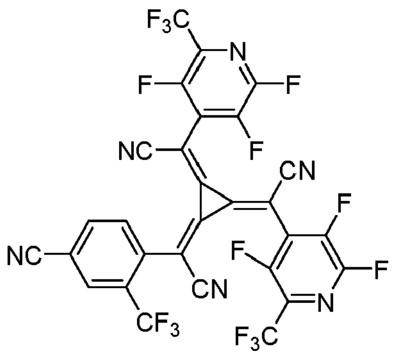 | 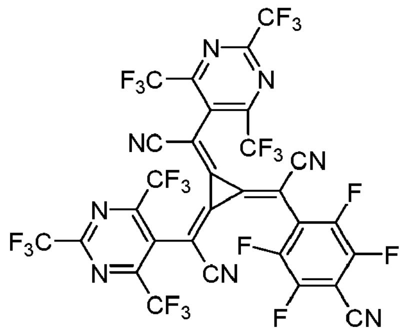 | 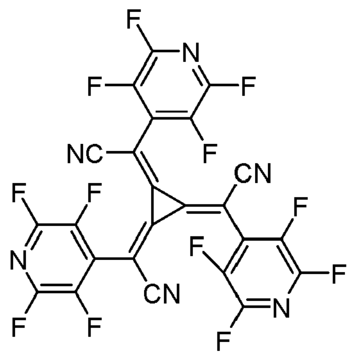 |

(continued)

| B7 | B8 | B9 |
|---|---|---|
| 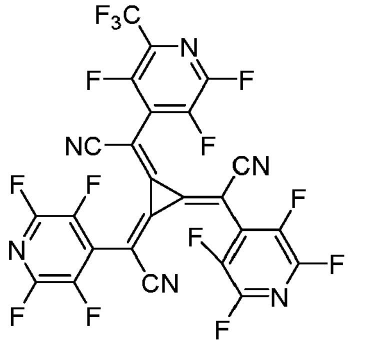 | 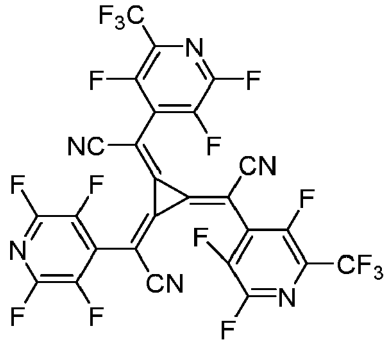 | 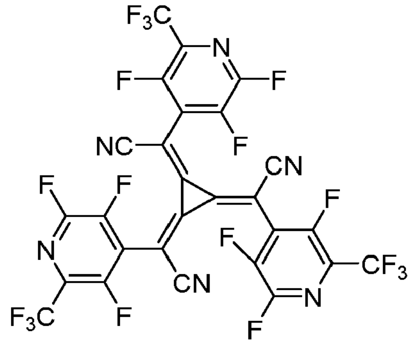 |
| B10 | B11 | B12 |
| 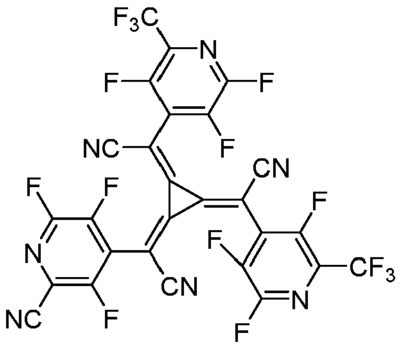 | 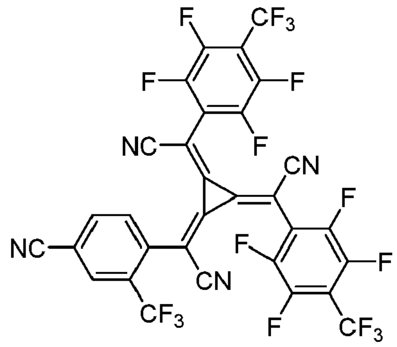 | 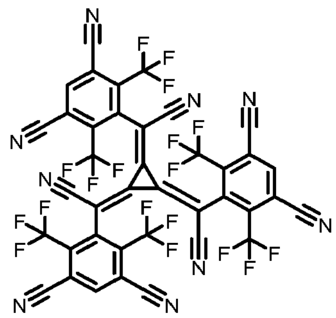 |
| B13 | B14 | B15 |
| 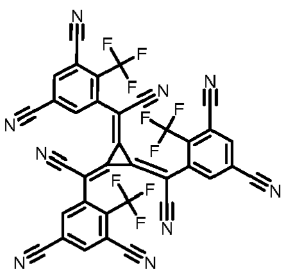 | 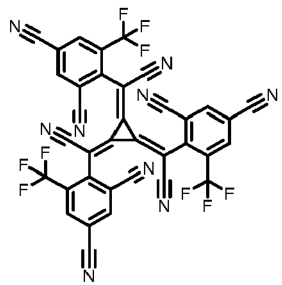 | 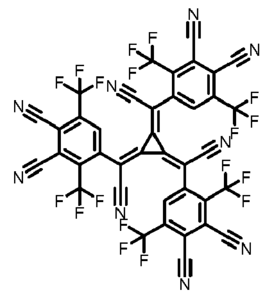 |

(continued)

| B16 | B17 | B18 |
|---|---|---|
| 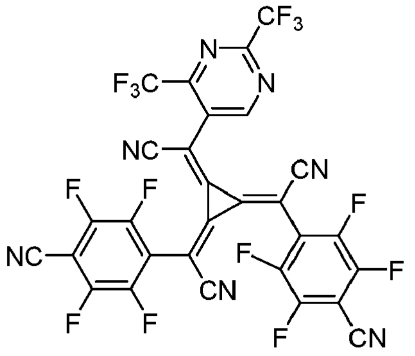 | 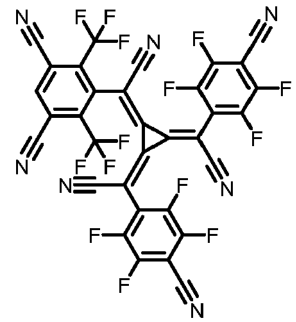 | 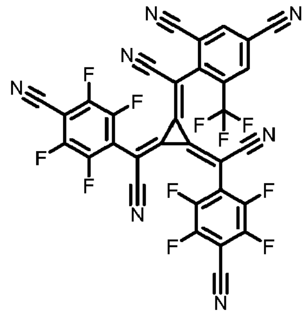 |
| B19 | B20 | B21 |
| 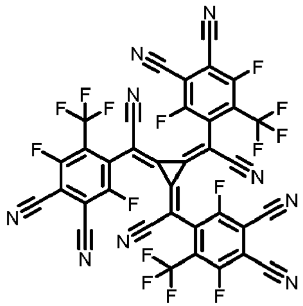 | 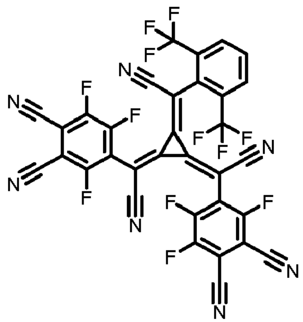 | 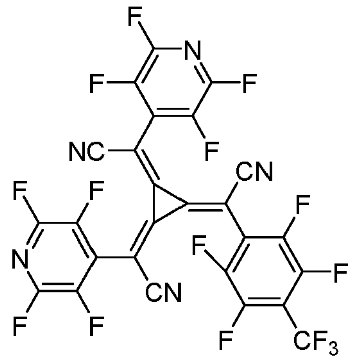 |
| B22 | B23 | B24 |

(continued)

| | | |
|---|---|---|
| 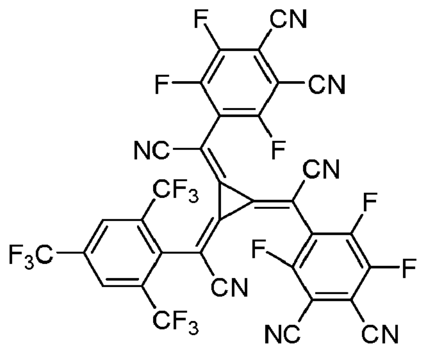 | 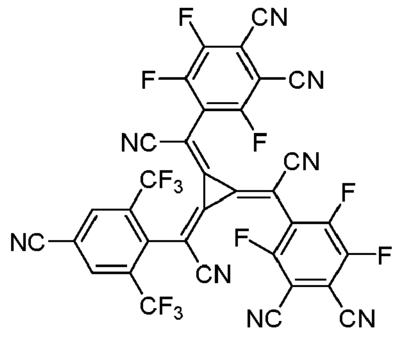 | 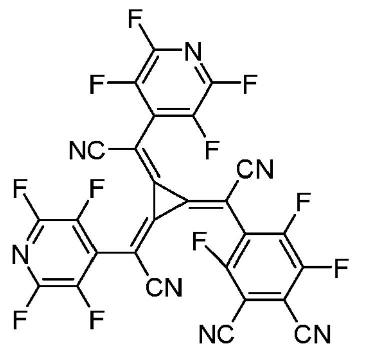 |
| B25 | B26 | B27 |
| 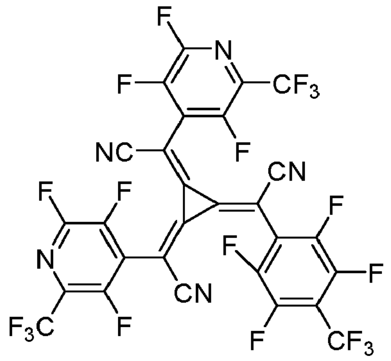 | 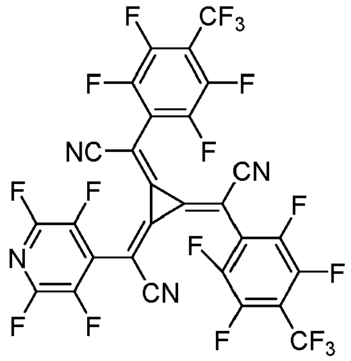 | |
| B28 | B29 | |

(continued)

| | | |
|---|---|---|
| 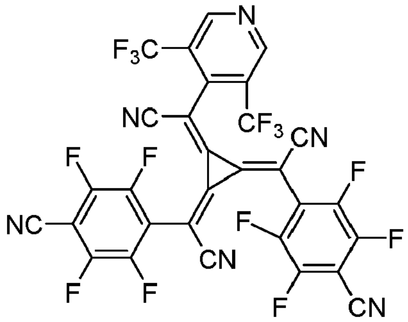 | 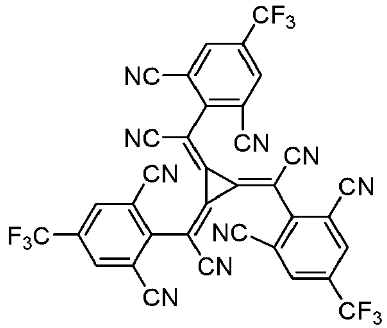 | 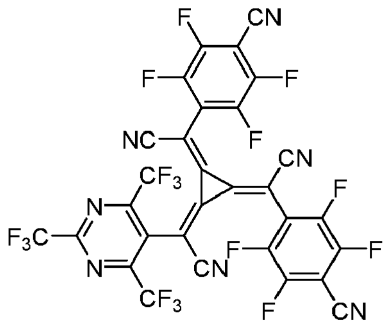 |
| B30 | B31 | B32 |
| 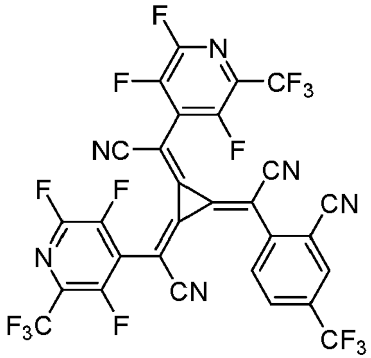 | 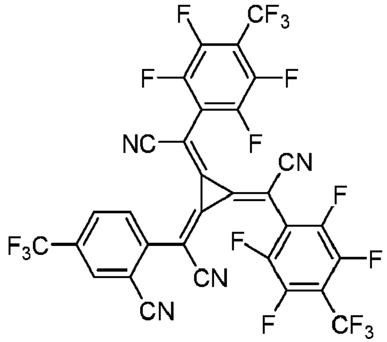 | 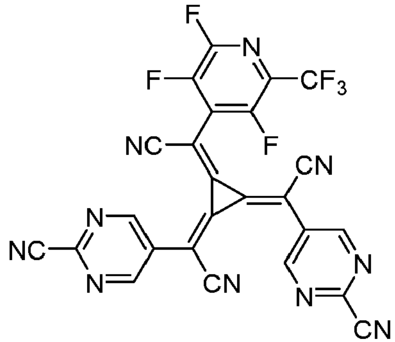 |
| B33 | B34 | B35 |

(continued)

| | | |
|---|---|---|
| 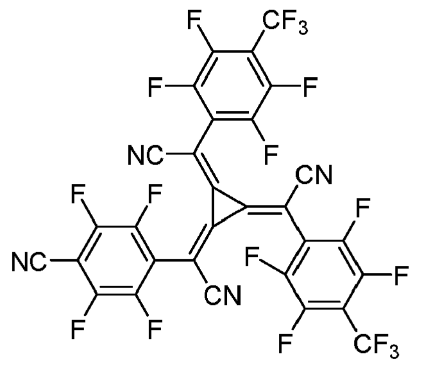 | 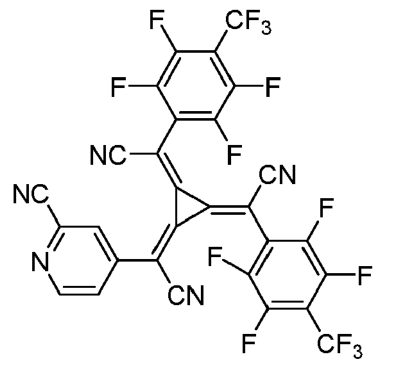 | 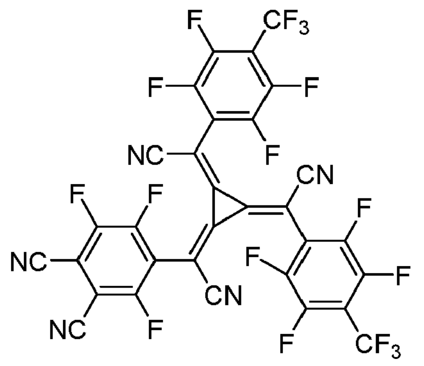 |
| B36 | B37 | B38 |
| 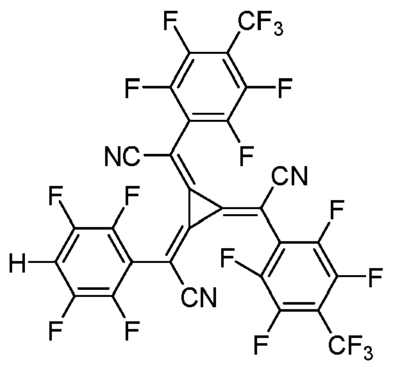 | 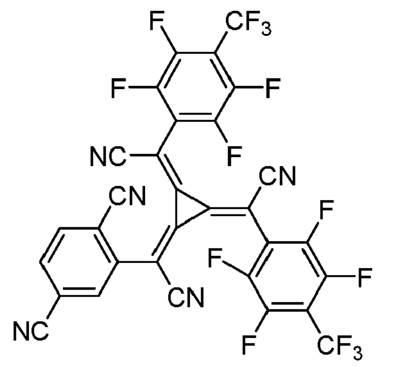 | 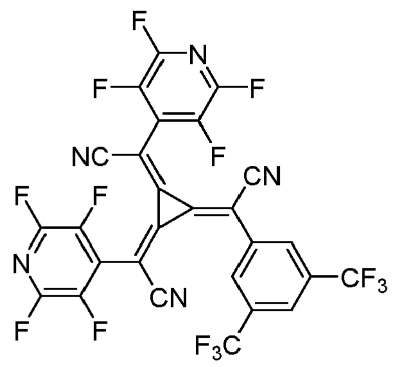 |
| B39 | B40 | B41 |

(continued)

| | | |
|---|---|---|
| 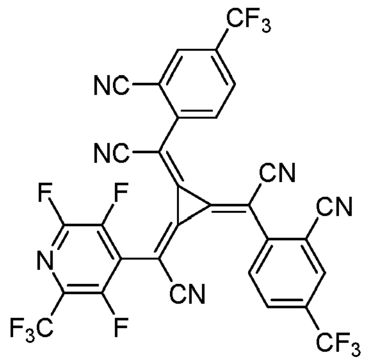 | 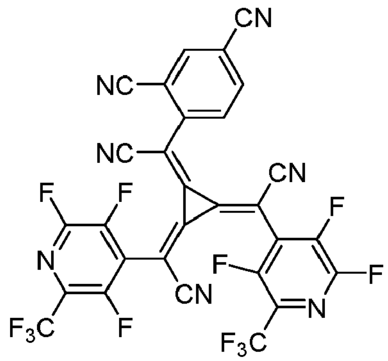 | 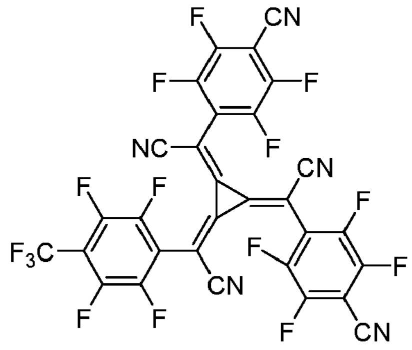 |
| B42 | B43 | B44 |
| 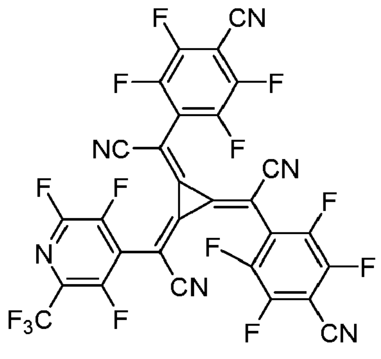 | 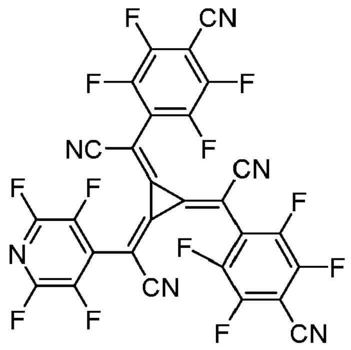 | 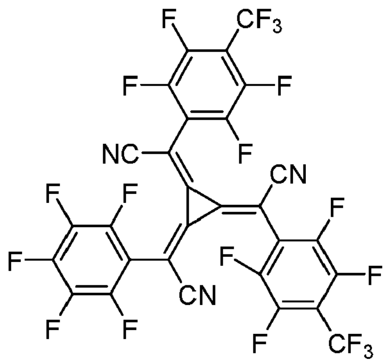 |
| B45 | B46 | B47 |

(continued)

<table>
<tr><td colspan="2">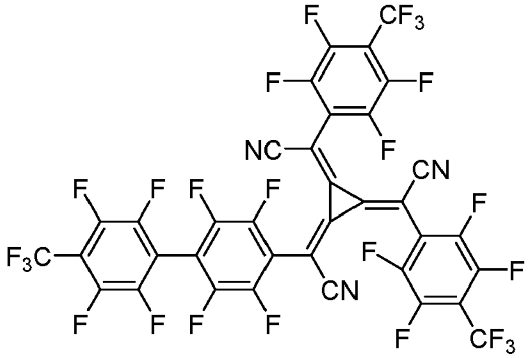</td><td>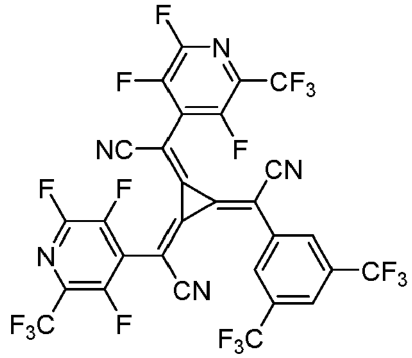</td></tr>
<tr><td colspan="2">B48</td><td>B49</td></tr>
<tr><td>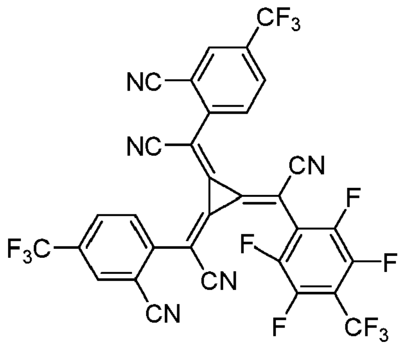</td><td>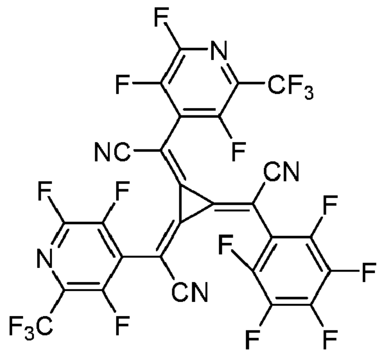</td><td>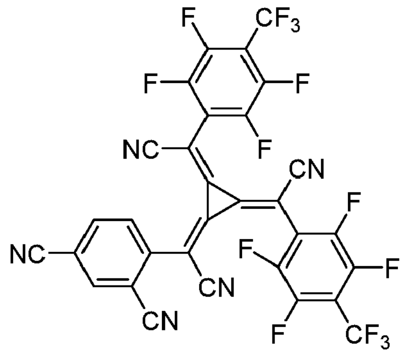</td></tr>
<tr><td>B50</td><td>B51</td><td>B52</td></tr>
</table>

(continued)

| | | |
|---|---|---|
| 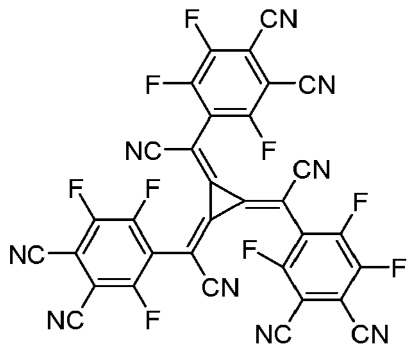 | 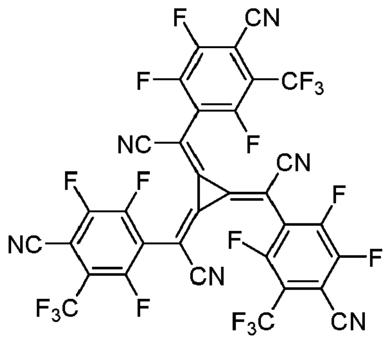 | |
| B53 | B54 | |
| 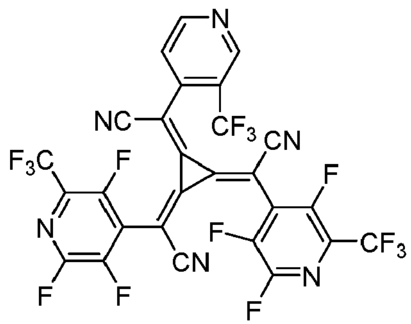 | 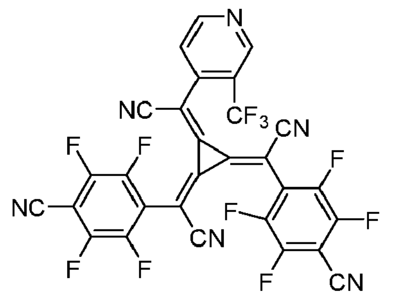 | 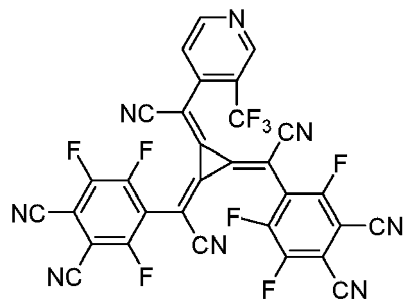 |
| B55 | B56 | B57 |
| 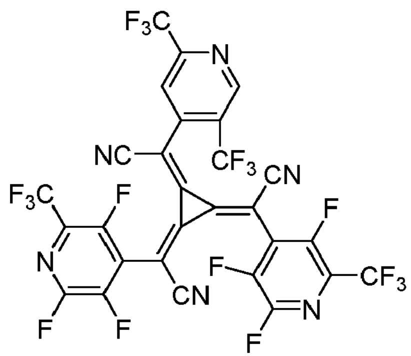 | 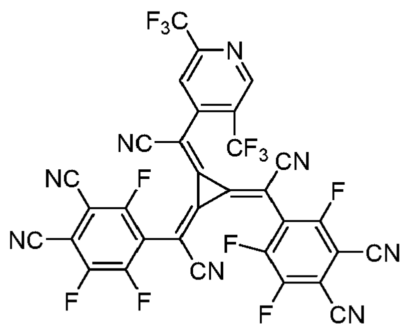 | 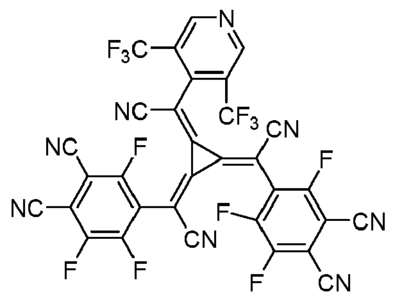 |

(continued)

| | | |
|---|---|---|
| B58 | B59 | B60 |
| 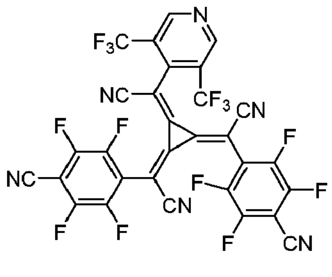 | 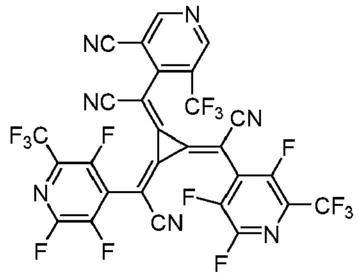 | 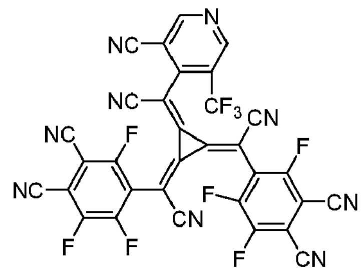 |
| B61 | B62 | B63 |
| 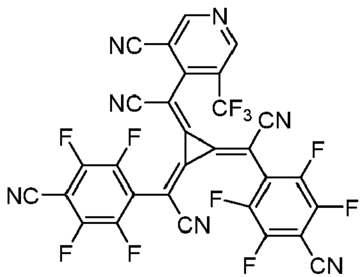 | 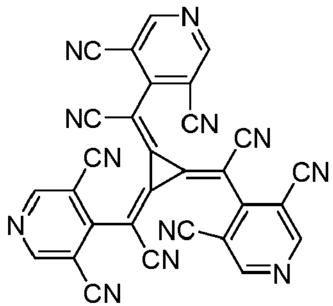 | 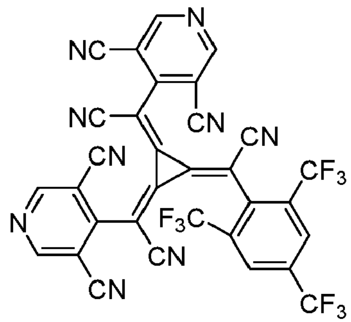 |
| B64 | B65 | B66 |
| 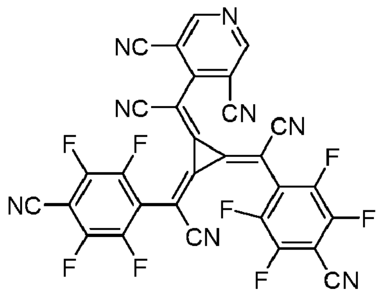 | 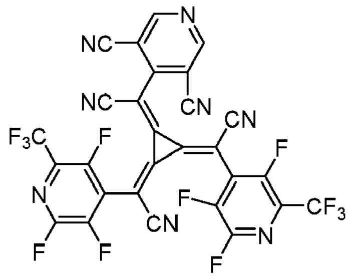 | 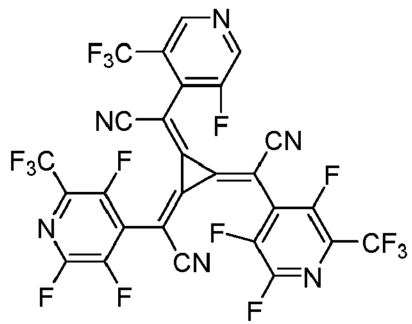 |
| B67 | B68 | B69 |

(continued)

| | | |
|---|---|---|
| 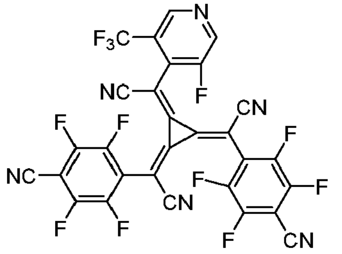 | 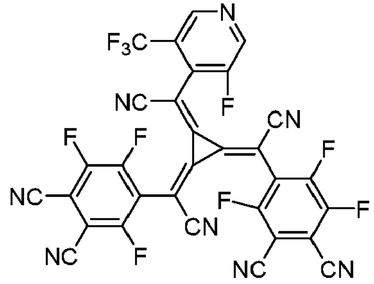 | 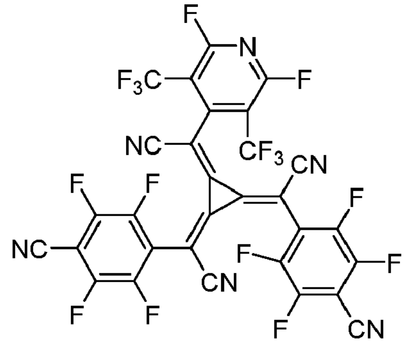 |
| B70 | B71 | B72 |
| 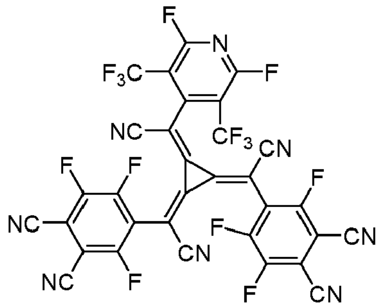 | 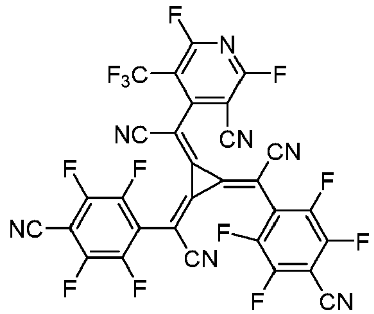 | 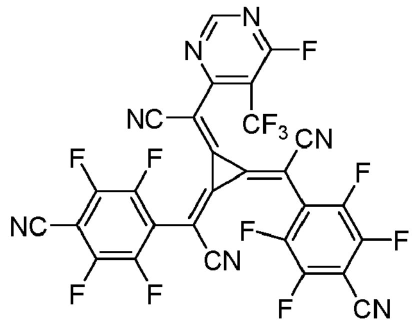 |
| B73 | B74 | B75 |
| 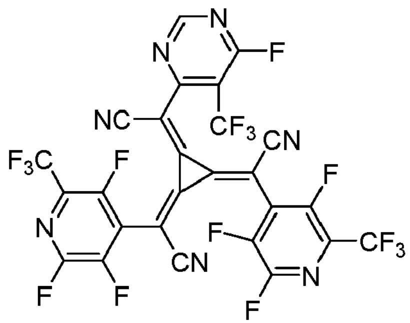 | 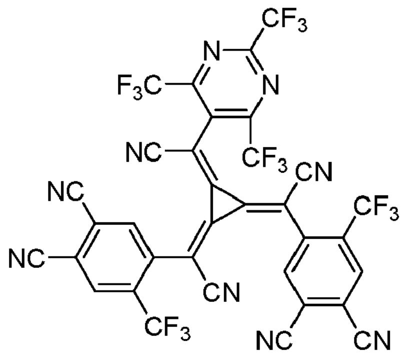 | 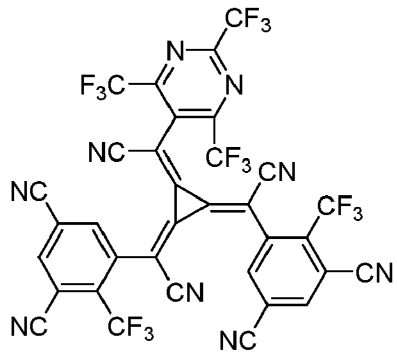 |

(continued)

| B76 | B77 | B78 |
| --- | --- | --- |
| 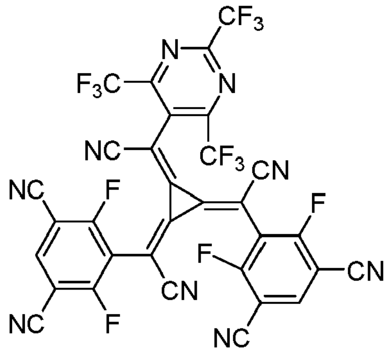 | | |
| B79 | | |

According to one embodiment of the present invention, the compound of formula (I) is selected from the compounds B1 to B29, B56, B57, B59, B60, B61, B64, B67, B70 to B73, B77 and B78:

| | | | |
|---|---|---|---|
| 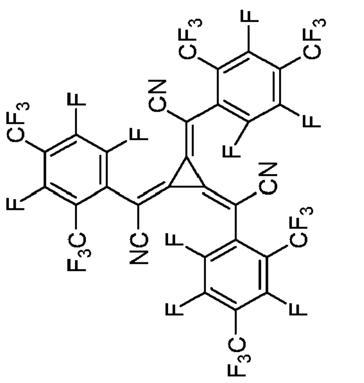 | B3 | 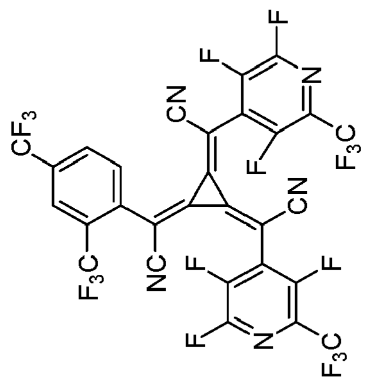 | B6 |
| 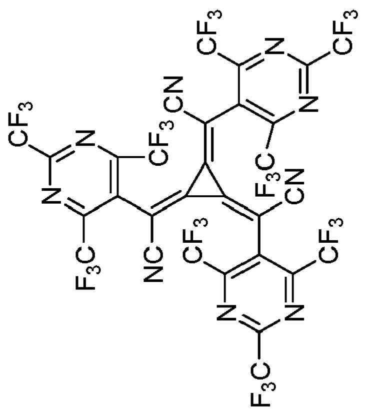 | B2 | 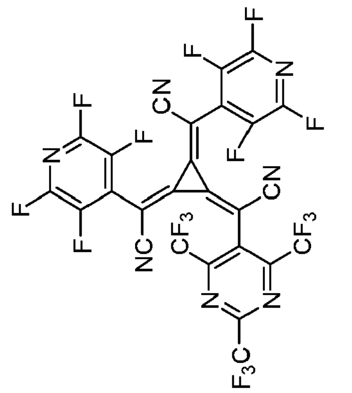 | B5 |
| 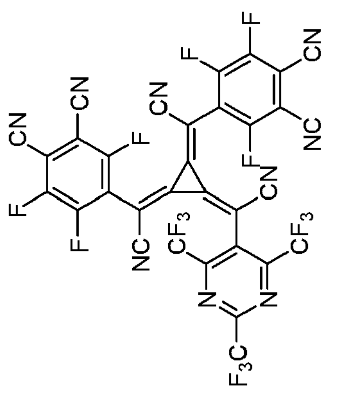 | B1 | 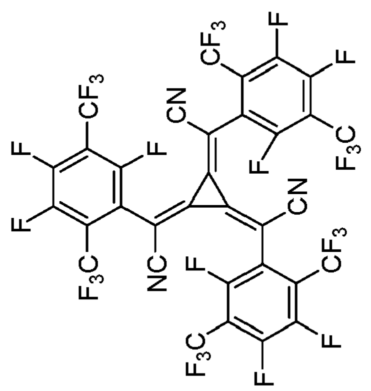 | B4 |

(continued)

| | | |
|---|---|---|
| 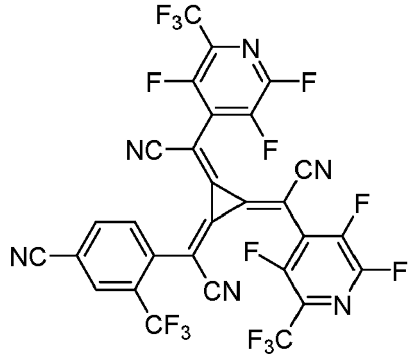 | 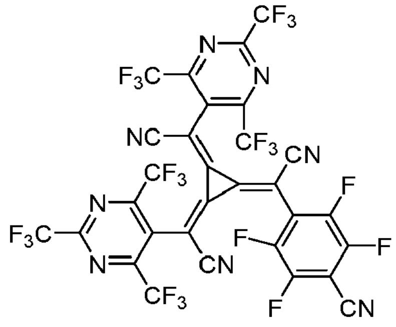 | 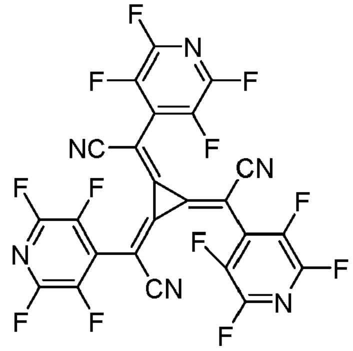 |
| B7 | B8 | B9 |
| 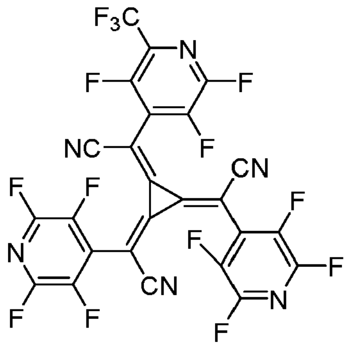 | 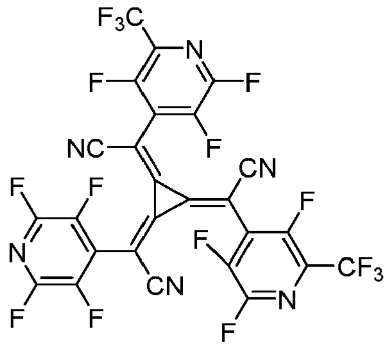 | 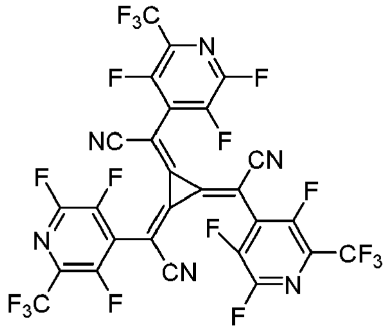 |
| B10 | B11 | B12 |

(continued)

| | | |
|---|---|---|
| 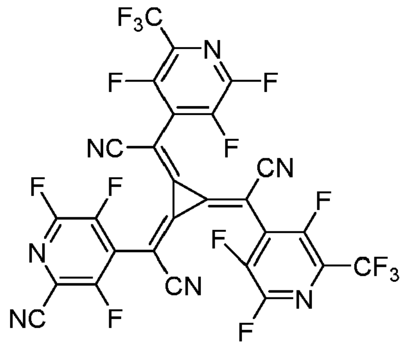 | 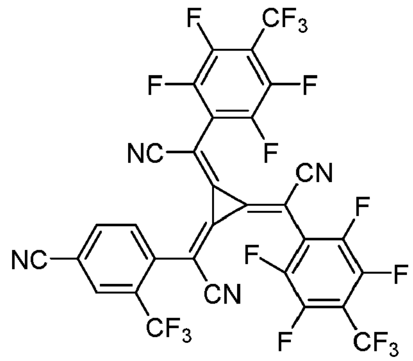 | 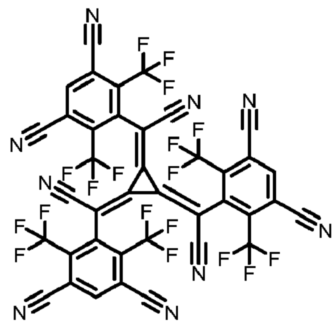 |
| B13 | B14 | B15 |
| 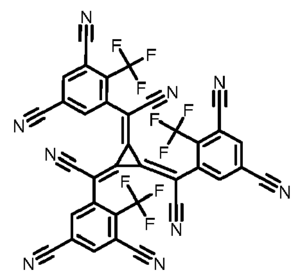 | 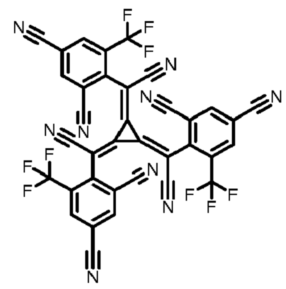 | 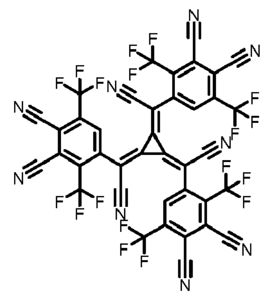 |
| B16 | B17 | B18 |
| 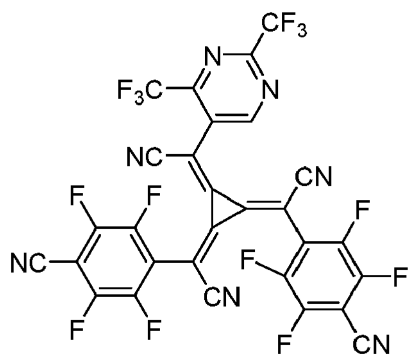 | 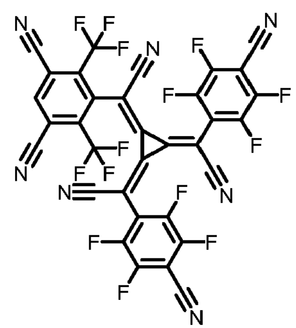 | 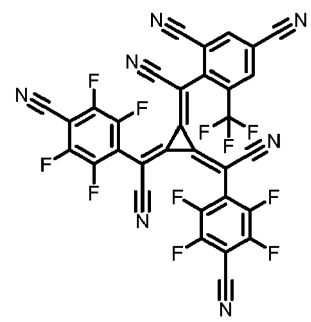 |

(continued)

| B19 | B20 | B21 |
|---|---|---|
| 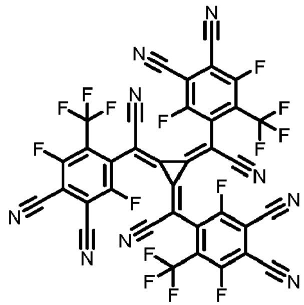 | 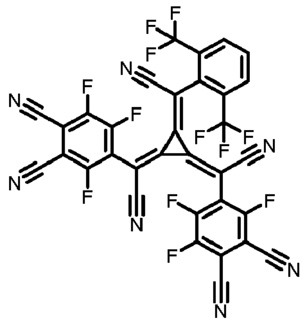 | 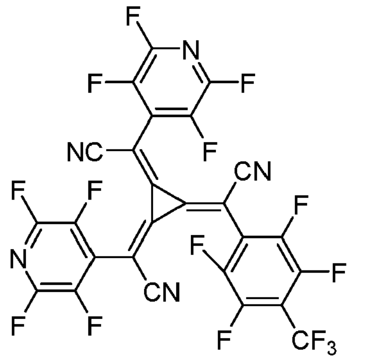 |
| B22 | B23 | B24 |
| 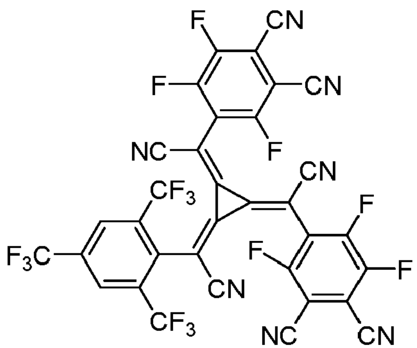 | 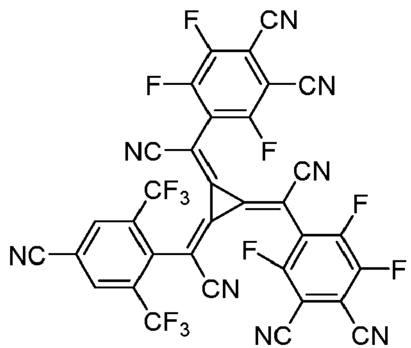 | 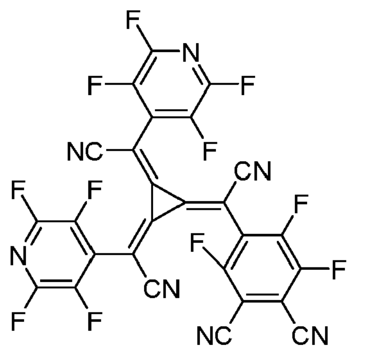 |
| B25 | B26 | B27 |

(continued)

| | | |
|---|---|---|
| 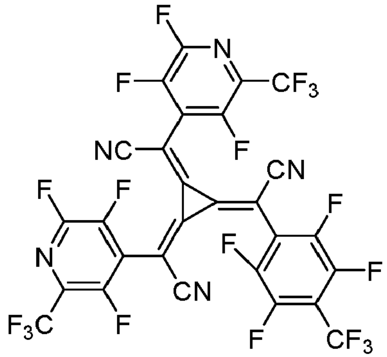 | 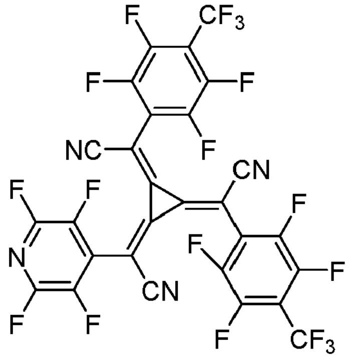 | |
| B28 | B29 | |
| 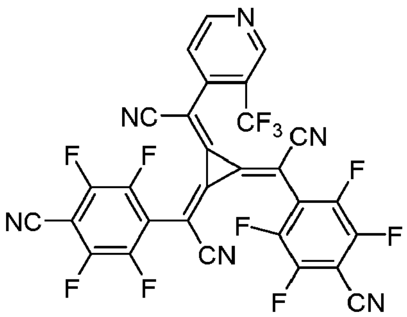 | 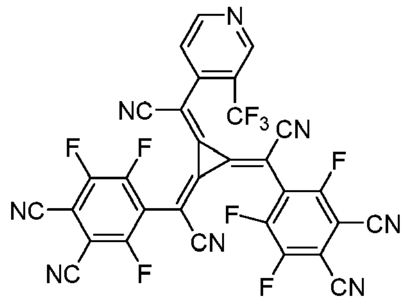 | 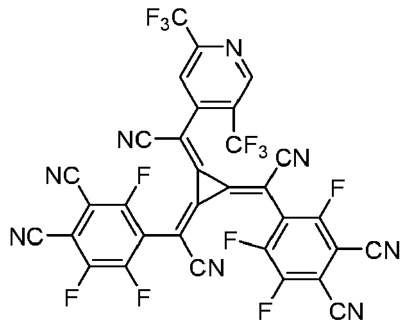 |
| B56 | B57 | B59 |
| 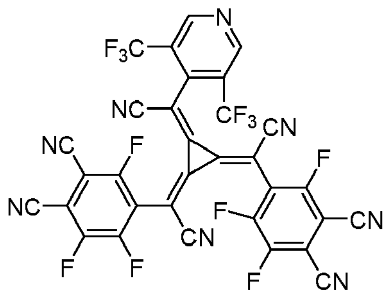 | 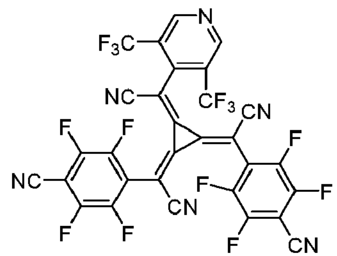 | 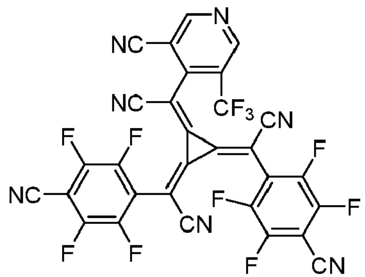 |
| B60 | B61 | B64 |

(continued)

| | | |
|---|---|---|
| 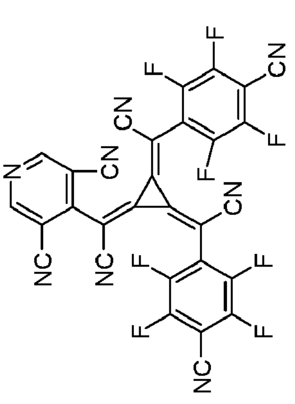 | 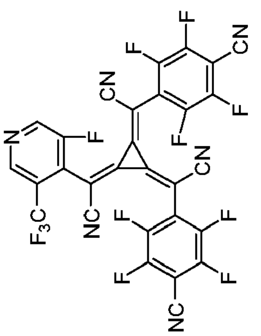 | 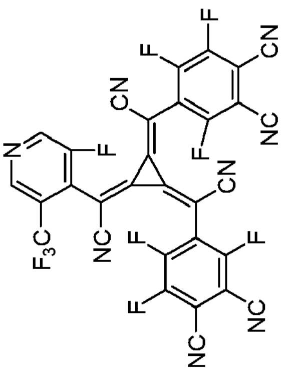 |
| B67 | B70 | B71 |
| 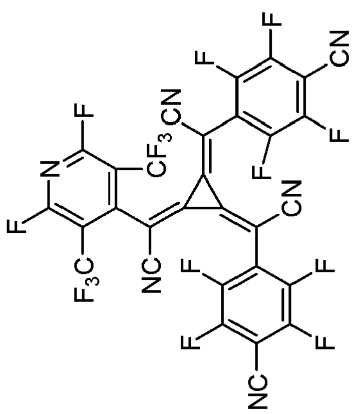 | 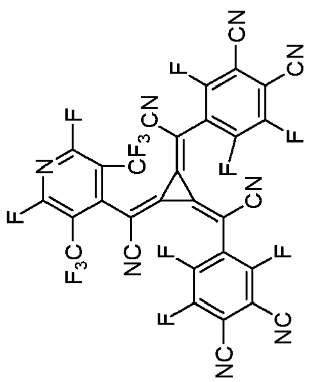 | 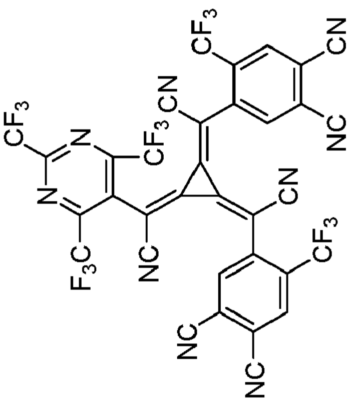 |
| B72 | B73 | B77 |

(continued)

| | |
|---|---|
| 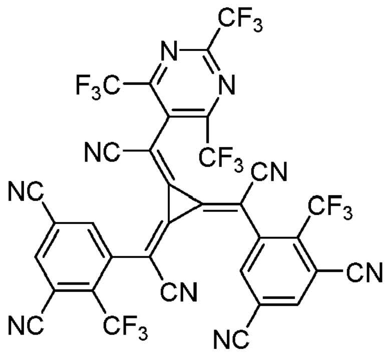 | |
| B78 | |

According to one embodiment of the present invention, the compound of formula (I) is selected from the compounds B1 to B18, B56, B57, B59, B60, B61, B64, B67, B70 to B73, B77 and B78:

| | | | | |
|---|---|---|---|---|
| 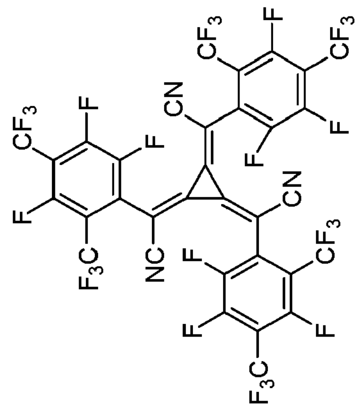 | B3 | 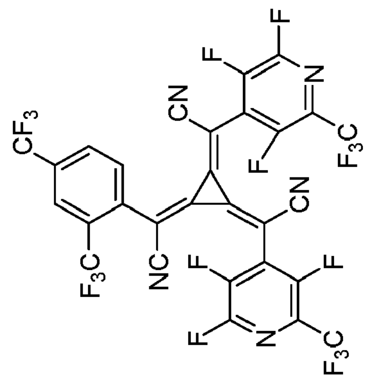 | B6 | 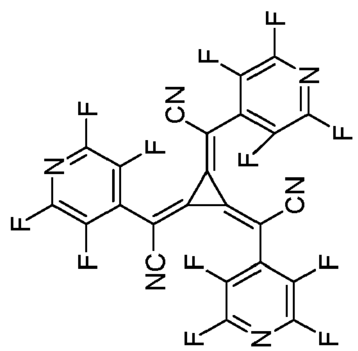 |
| 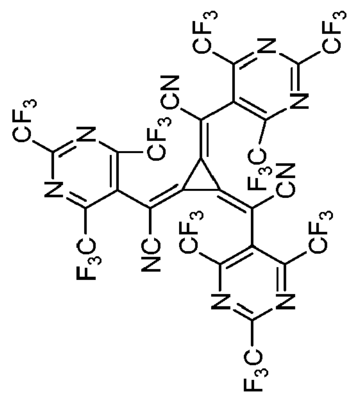 | B2 | 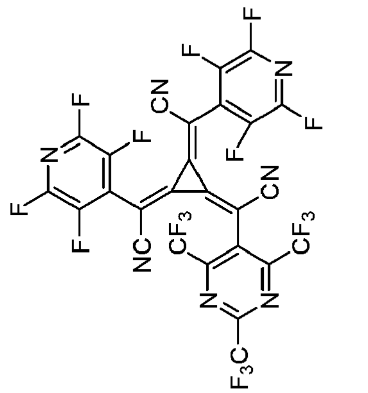 | B5 | 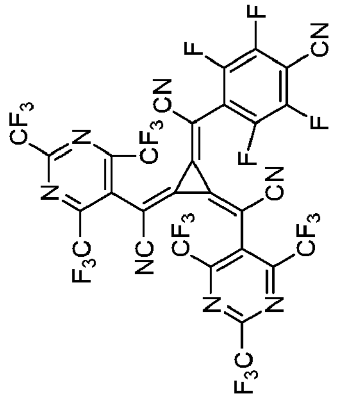 |
| 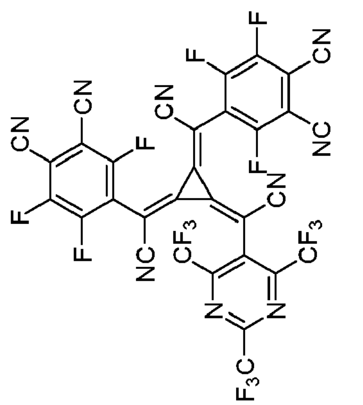 | B1 | 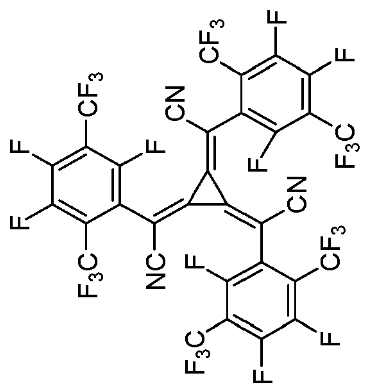 | B4 | 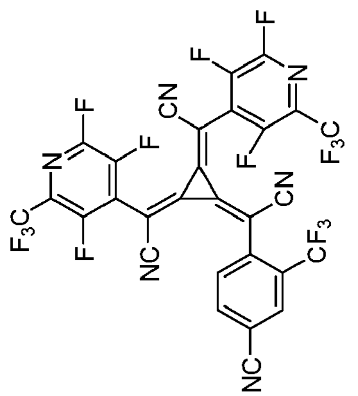 |

(continued)

| | | |
|---|---|---|
| B7 | B8 | B9 |
| 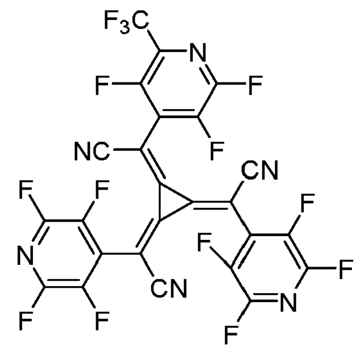 | 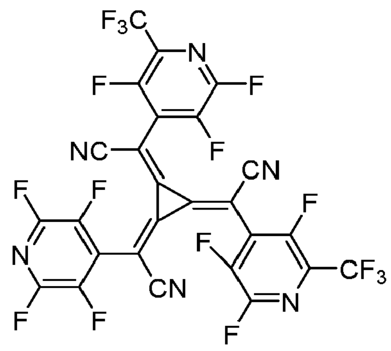 | 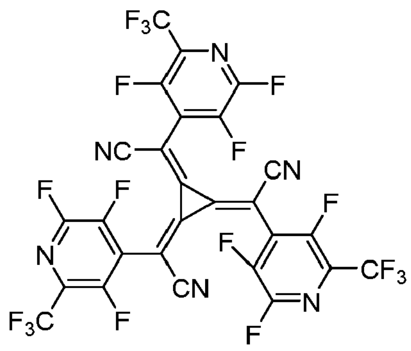 |
| B10 | B11 | B12 |
| 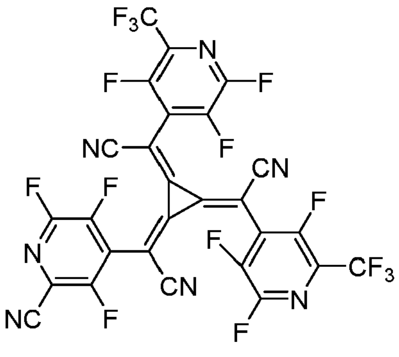 | 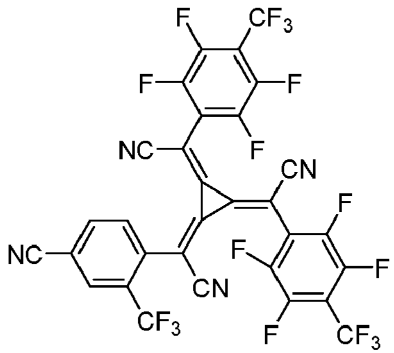 | 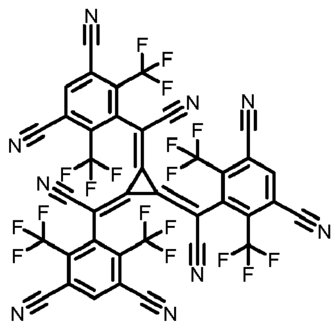 |
| B13 | B14 | B15 |

(continued)

| | | | | | |
|---|---|---|---|---|---|
| 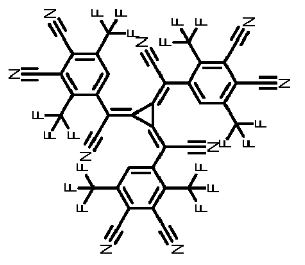 | B18 | 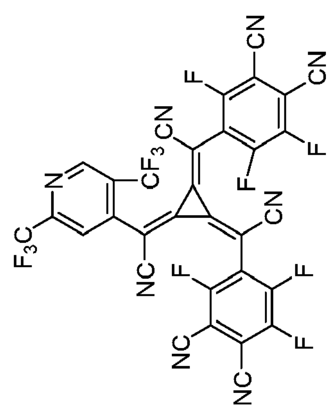 | B59 | 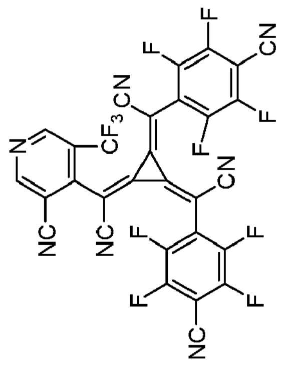 | B64 |
| 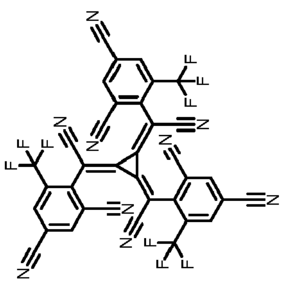 | B17 | 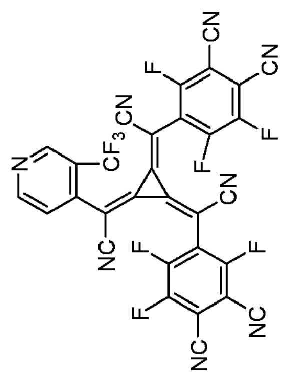 | B57 | 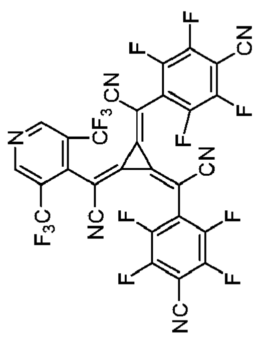 | B61 |
| 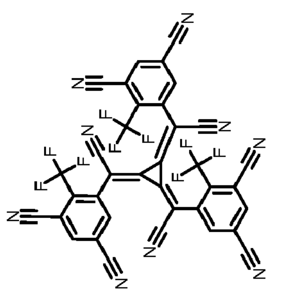 | B16 | 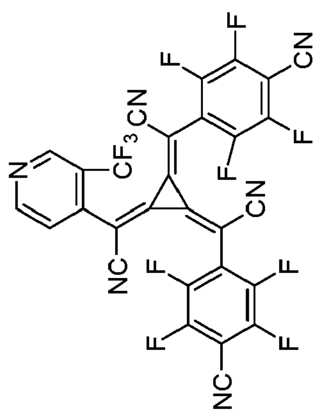 | B56 | 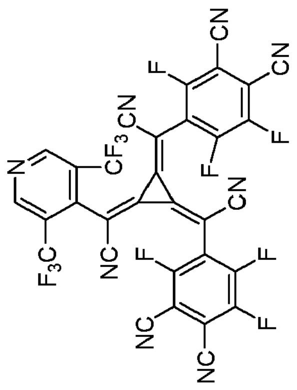 | B60 |

(continued)

| | | |
|---|---|---|
| 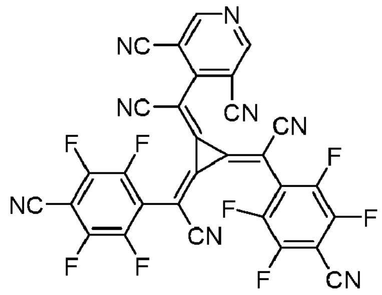 | 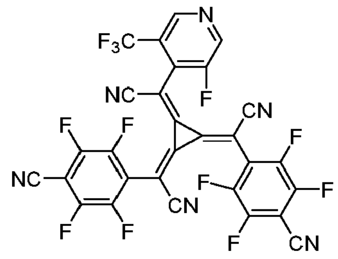 | 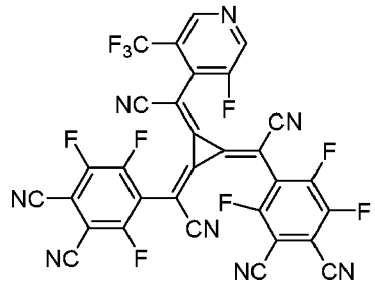 |
| B67 | B70 | B71 |
| 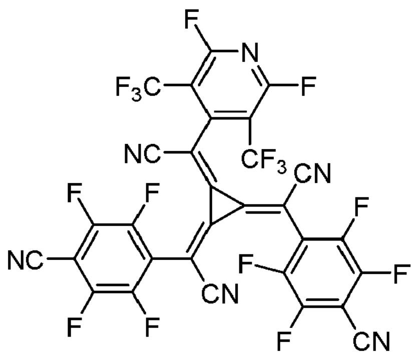 | 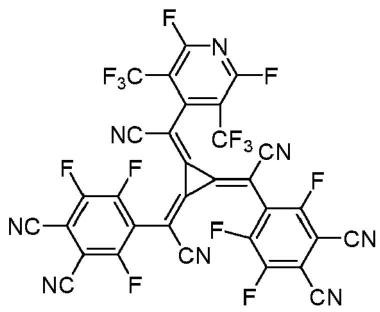 | 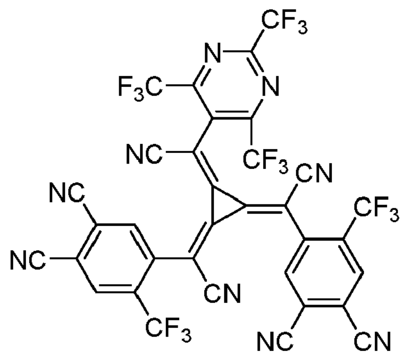 |
| B72 | B73 | B77 |

(continued)

| | |
|---|---|
| 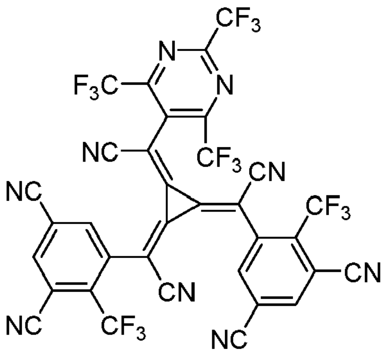 | |
| B78 | |

CGL Properties

According to one embodiment of the present invention, the first charge generation layer has a thickness of ≤ 30 nm, preferably ≤ 25 nm, more preferably ≤ 20 nm, more preferably ≤ 15 nm, and most preferably ≤10 nm.

According to one embodiment of the present invention, the first charge generation layer has a thickness of ≥ 1 nm, preferably ≥ 2 nm.

According to one embodiment of the present invention, the second charge generation layer has a thickness of ≤ 30 nm, preferably ≤ 25 nm, more preferably ≤ 20 nm, more preferably ≤ 15 nm, and most preferably ≤10 nm.

According to one embodiment of the present invention, the second charge generation layer has a thickness of ≥ 1 nm, preferably ≥ 2 nm.

According to one embodiment of the invention, the first charge generation layer is arranged closer to a cathode layer than the second charge generation layer.

According to one embodiment of the present invention, the first charge generation layer is in direct contact to the second charge generation layer.

According to one embodiment of the present invention, the charge generation layer has an overall thickness of ≤ 60 nm, preferably ≤ 55 nm, more preferably ≤ 50 nm, more preferably ≤ 45 nm, more preferably ≤ 40 nm, more preferably ≤ 35 nm, more preferably ≤ 30 nm, more preferably ≤ 25 nm, and most preferably ≤ 20 nm.

According to one embodiment of the present invention, the charge generation layer has a thickness of ≥ 2 nm, preferably ≥ 4 nm.

According to one embodiment of the present invention the first charge generation layer and/or second charge generation layer and/or the compound of formula (I) are non-emissive.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

Organic Electronic Device

The present invention furthermore relates to an organic electronic device comprising a charge generation layer according to the present invention.

According to one embodiment of the present invention, the organic electronic device is a electroluminescent device; preferably an organic light-emitting diode.

The present invention furthermore relates to an organic electronic device comprising at least two vertically stacked electroluminescent units and a charge generation layer according to the present invention, wherein each electroluminescent unit comprises at least one light-emitting layer.

According to the present invention, the term "vertically stacked" particularly means that the electroluminescent units are stacked in an essentially perpendicular direction to the charge generation layer.

According to one embodiment of the present invention, the electroluminescent device according to the present invention is an organic light emitting diode, in particular a stacked organic light emitting diode.

According to one embodiment of the present invention, the charge generation layer according to the present invention is arranged between two of the at least two vertically stacked electroluminescent units.

According to one embodiment of the present invention, the organic electronic device is a part of a display device.

According to one embodiment of the present invention, the electroluminescent device is a pixel, particularly a pixel of a display device.

According to one embodiment of the present invention, the organic electronic device comprises at least three or at least four vertically stacked electroluminescent units, wherein each electroluminescent unit comprises at least one light-emitting layer.

According to one embodiment of the present invention, the organic electronic device comprises at least three or at least four vertically stacked electroluminescent units, wherein each electroluminescent unit comprises at least one light-emitting layer, a hole transport layer, and an electron transport layer.

Display Device

The present invention furthermore relates to a display device comprising a plurality of organic electronic devices according to the present invention, wherein at least two of the plurality of organic electronic devices shares as charge generation layer a common charge generation layer, wherein the common charge generation layer is a charge generation layer according to the present invention.

The present invention furthermore relates to a display device comprising a plurality of organic electronic devices

according to the present invention, wherein at least two of the plurality of organic electronic devices shares as charge generation layer a common charge generation layer, wherein the common charge generation layer is a charge generation layer according to the present invention.

The present invention furthermore relates to a display device comprising a plurality of organic electronic devices according to the present invention, wherein at least two of the plurality of organic electronic devices shares as charge generation layer a common charge generation layer, extending over the at least two of the plurality of organic electronic devices,
wherein the common charge generation layer is a charge generation layer according to the present invention.

The present invention furthermore relates to a display device comprising a plurality of organic electronic devices according to the present invention, wherein at least two of the plurality of organic electronic devices shares as charge generation layer a common charge generation layer, extending over the at least two of the plurality of organic electronic devices, wherein the common charge generation layer is a charge generation layer according to the present invention.

The present invention furthermore relates to a display device comprising a plurality of organic electroluminescent devices according to the present invention, wherein each of the plurality of electroluminescent devices shares as charge generation layer a common charge generation layer extending over all of the plurality of organic electroluminescent devices, wherein the common charge generation layer is a charge generation layer according to the present invention.

The present invention furthermore relates to a display device comprising a plurality of organic electroluminescent devices according to the present invention, wherein each of the plurality of organic electroluminescent devices shares as charge generation layer a common charge generation layer extending over all of the plurality of organic electroluminescent devices, wherein the common charge generation layer is a charge generation layer according to the present invention.

In other words, the invention relates to a display device comprising a charge generation layer according to the present invention, wherein a plurality of at least two vertically stacked electroluminescent units are arranged horizontally with the charge generation layer. Thereby each of the at least two vertically stacked electroluminescent units forms an organic electroluminescent device according to the invention with the common charge generation layer according to the present invention.

According to one embodiment of the present invention, the first charge generation layer of the common charge generation layer has a thickness of ≤ 30 nm, preferably ≤ 25 nm, more preferably ≤ 20 nm, more preferably ≤ 15 nm, and most preferably ≤10 nm.

According to one embodiment of the present invention, the first charge generation layer of the common charge generation layer has a thickness of ≥ 1 nm, preferably ≥ 2 nm.

According to one embodiment of the present invention, the second charge generation layer of the common charge generation layer has a thickness of ≤ 30 nm, preferably ≤ 25 nm, more preferably ≤ 20 nm, more preferably ≤ 15 nm, and most preferably ≤10 nm.

According to one embodiment of the present invention, the second charge generation layer of the common charge generation layer has a thickness of ≥ 1 nm, preferably ≥ 2 nm.

According to one embodiment of the invention, the first charge generation layer is arranged closer to a cathode layer than the second charge generation layer in the common charge generation layer.

According to one embodiment of the present invention, the first charge generation layer is in direct contact to the second charge generation layer in the common charge generation layer.

According to one embodiment of the present invention, the common charge generation layer has an overall thickness of ≤ 60 nm, preferably ≤ 55 nm, more preferably ≤ 50 nm, more preferably ≤ 45 nm, more preferably ≤ 40 nm, more preferably ≤ 35 nm, more preferably ≤ 30 nm, more preferably ≤ 25 nm, and most preferably ≤ 20 nm.

According to one embodiment of the present invention, the common charge generation layer has a thickness of ≥ 2 nm, preferably ≥ 4 nm.

According to one embodiment of the present invention, each electroluminescent device comprises at least three or at least four vertically stacked electroluminescent units, wherein each electroluminescent unit comprises at least one light-emitting layer.

According to an embodiment of the invention, the display device is an active matrix display.

According to an embodiment of the invention, the display device is an OLED display.

According to an embodiment of the invention, the display device comprises a driving circuit configured to separately driving the pixels of the plurality of pixels.

Further layers

In accordance with the invention, the organic electroluminescent device or the display device, further referred to as organic electronic device, may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

*Anode layer*

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

*Hole injection layer*

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane (F4TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = -5.2 eV) doped with F4TCNQ; $\alpha$-NPD (N,N'-Bis(naphthalen-1-yl)-N,N'-bis(phenyl)-benzidine) doped with F4TCNQ. $\alpha$-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

According to a preferred embodiment of the present invention, however, the HIL comprises a compound of formula (I) as described above.

According to a preferred embodiment of the present invention, the HIL may comprises the same compound of formula (I) as the p-type charge generation layer.

According to a preferred embodiment of the present invention, the HIL may comprises a substantially covalent matrix compound as described above.

According to a preferred embodiment of the present invention, the HIL may comprises a compound of formula (I), as described above, and a compound of formula (IV) or (V), as described above.

According to a preferred embodiment of the present invention, the p-type charge generation layer and the hole injection layer may comprise an identical substantially covalent matrix compound.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise a substantially covalent matrix compound as described above.

According to one embodiment of the present invention, the hole transport layer may comprise a compound of formula (VI) or (VII) as described above.

According to a preferred embodiment of the present invention, the hole injection layer and the hole transport layer may comprise an identical a compound of formula (VI) or (VII) as described above.

According to a preferred embodiment of the present invention, the p-type charge generation layer, the hole injection layer and the hole transport layer may comprise an identical substantially covalent matrix compound.

According to a preferred embodiment of the present invention, the p-type charge generation layer, the hole injection layer and the hole transport layer may comprise an identical an identical a compound of formula (IV) or (V) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Photoactive layer (PAL)*

According to an embodiment of the present invention, the organic electronic device may further comprise a photoactive layer, wherein the photoactive layer is arranged between the anode layer and the cathode layer.

The photoactive layer converts an electrical current into photons or photons into an electrical current.

The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL.

According to one embodiment of the present invention, the photoactive layer does not comprise the compound of formula (I).

The photoactive layer may be a light-emitting layer or a light-absorbing layer.

*Emission layer (EML)*

According to an embodiment of the present invention, the organic electronic device may further comprise an emission layer, wherein the emission layer is arranged between the anode layer and the cathode layer.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to one embodiment of the present invention, the emission layer does not comprise the compound of formula (I).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

*Electron transport layer (ETL)*

The organic electronic device according to the present invention may further comprise an electron transport layer (ETL).

According to another embodiment of the present invention, the electron transport layer may further comprise an azine compound, preferably a triazine compound or a pyrimidine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer

comprise an azine compound. Preferably, the azine compound is a triazine compound.

According to an embodiment of the present invention, the n-type charge generation layer is contacting sandwiched between the electron transport layer and the p-type charge generation layer.

According to an embodiment of the present invention, the n-type charge generation layer is contacting sandwiched between the electron transport layer and the p-type charge generation layer; wherein the n-type charge generation layer and/or the electron transport layer comprise an azine compound. Particularly improved performance may be obtained.

According to an embodiment of the present invention, the n-type charge generation layer is contacting sandwiched between the electron transport layer and the p-type charge generation layer; and the electron transport layer is contacting sandwiched between the first emission layer and the n-type charge generation layer; wherein the n-type charge generation layer and/or the electron transport layer comprise an azine compound. Particularly improved performance may be obtained.

According to an embodiment of the present invention, the n-type charge generation layer is contacting sandwiched between the electron transport layer and the p-type charge generation layer; and the electron transport layer is contacting sandwiched between the first emission layer and the n-type charge generation layer; wherein the n-type charge generation layer comprises a phenanthroline compound and the electron transport layer comprise an azine compound, preferably a triazine or a pyrimidine compound. Particularly improved performance may be obtained.

*Electron injection layer (EIL)*

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

*Cathode layer*

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

It is to be understood that the cathode layer is not part of an electron injection layer or the electron transport layer.

*Organic light-emitting diode (OLED)*

The organic electronic device according to the invention may be an organic light-emitting device.

According to one aspect of the present invention, there is provided an organic light-emitting diode (OLED) comprising: an anode layer formed on a substrate; a charge generation layer according to the invention, at least one emission layer and a cathode layer.

According to one aspect of the present invention, there is provided an organic light-emitting diode (OLED) comprising: a substrate; an anode layer formed on the substrate; a charge generation layer according to invention, at least one emission layer and a cathode layer.

According to one aspect of the present invention, there is provided an organic light-emitting diode (OLED) comprising: an anode layer formed on a substrate; a charge generation layer according to invention, at least a first and a second emission layer and a cathode layer, wherein the charge generation layer is arranged between the first and the second emission layer.

According to one aspect of the present invention, there is provided an organic light-emitting diode (OLED) comprising: a substrate; an anode layer formed on the substrate; a charge generation layer according to invention, at least a first and a second emission layer and a cathode layer, wherein the charge generation layer is arranged between the first and the second emission layer.

According to one aspect of the present invention, there is provided an organic light-emitting diode (OLED) comprising an anode layer formed on a substrate; a charge generation layer according to the invention, a hole transport layer, an emission layer, an electron transport layer and a cathode layer.

According to one aspect of the present invention, there is provided an organic light-emitting diode (OLED) comprising: a substrate; an anode layer formed on the substrate; a charge generation layer, a charge generation layer according to the invention, a hole transport layer, an emission layer, an electron transport layer and a cathode layer.

According to another aspect of the present invention, there is provided an OLED comprising: an anode layer formed on a substrate; a charge generation layer according to the invention, a hole transport layer, an electron blocking layer, an emission layer, a hole blocking layer, an electron transport layer and a cathode layer.

According to another aspect of the present invention, there is provided an OLED comprising: a substrate; an anode layer formed on the substrate; a charge generation layer according to the invention, a hole transport layer, an electron blocking layer, an emission layer, a hole blocking layer, an electron transport layer and a cathode layer.

According to another aspect of the present invention, there is provided an OLED comprising: an anode electrode formed on the substrate; a charge generation layer according to the invention, a hole transport layer, an electron blocking layer, an emission layer, a hole blocking layer, an electron transport layer, an electron injection layer, and a cathode electrode.

According to another aspect of the present invention, there is provided an OLED comprising: a substrate; an anode electrode formed on the substrate; a charge generation layer according to the invention, a hole transport layer, an electron blocking layer, an emission layer, a hole blocking layer, an electron transport layer, an electron injection layer, and a cathode electrode.

According to various embodiments of the present invention, there may be provided OLEDs layers arranged between the above mentioned layers, on the substrate or on the top electrode.

According to one aspect, the OLED may comprise a layer structure of a substrate that is adjacent arranged to an anode layer, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to a second charge generation layer of the charge generation according to the invention, the second charge generation layer is adjacent arranged to a first charge generation layer of the charge generation layer according to the invention, the first charge generating layer of the charge generation layer according to the invention is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The present invention furthermore relates to a compound of formula (XI)

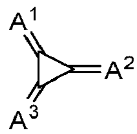

(XI),

wherein in formula (XI) $A^1$ is selected from a group of formula (XIIa)

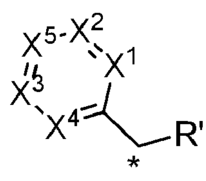

(XIIa),

wherein

$X^1$ is selected from $CR^1$ or N;
$X^2$ is selected from $CR^2$ or N;

$X^3$ is selected from $CR^3$ or N;
$X^4$ is selected from $CR^4$;
$X^5$ is selected from $CR^5$ or N;
$R^1$ (if present) is selected from electron-withdrawing group, CN, partially fluorinated or perfluorinated $C_1$ to $C_8$ alkyl, $-NO_2$, halogen, Cl, F, D or H,
$R^2$, $R^3$ and $R^5$ (if present) are independently selected from electron-withdrawing group, CN, partially fluorinated or perfluorinated $C_1$ to $C_8$ alkyl, $-NO_2$, halogen, Cl, F, D or H,
$R^4$ is selected from CN, and partially fluorinated or perfluorinated $C_1$ to $C_8$ alkyl,
whereby when any of $R^1$, $R^2$, $R^3$ and $R^5$ is present, then the corresponding $X^1$, $X^2$, $X^3$, and $X^5$ is not N;
and wherein in formula (XI) $A^2$ and $A^3$ are independently selected from formula (XIII)

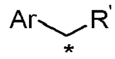

(XIII)

wherein Ar is independently selected from substituted or unsubstituted $C_6$ to $C_{18}$ aryl and substituted or unsubstituted $C_2$ to $C_{18}$ heteroaryl, wherein the substituents on Ar are independently selected from electron-withdrawing group, CN, partially or perfluorinated $C_1$ to $C_6$ alkyl, $-NO_2$, halogen, Cl, F, D;
and R' is selected from substituted or unsubstituted $C_6$ to $C_{18}$ aryl or $C_3$ to $C_{18}$ heteroaryl, partially fluorinated or perfluorinated $C_1$ to $C_8$ alkyl, halogen, F or CN.

According to one embodiment of the present invention, the charge generation layer, the organic electroluminescent device, and/or the display device according to the present invention comprise as compound of formula (I) the compound according to formula (XI).

According to one embodiment of the present invention, the compound of formula (XI) is selected from a compound of formula (XI)

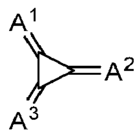

(XI)

whereby $A^1$ is selected from formula (XIIb)

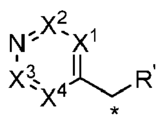

(XIIb)

wherein

$X^1$ is selected from $CR^1$ or N;
$X^2$ is selected from $CR^2$ or N;
$X^3$ is selected from $CR^3$ or N;
$X^4$ is selected from $CR^4$;
$R^1$ (if present) is selected from electron-withdrawing group, CN, partially fluorinated or perfluorinated $C_1$ to $C_8$ alkyl, halogen, $-NO_2$, Cl, F, D or H,
$R^2$, and $R^3$ (if present) are independently selected from electron-withdrawing group, CN, partially fluorinated or perfluorinated $C_1$ to $C_8$ alkyl, $-NO_2$, halogen, Cl, F, D or H,
$R^4$ is selected from CN, and partially fluorinated or perfluorinated $C_1$ to $C_8$ alkyl,

whereby when any of $R^1$, $R^2$, and $R^3$ and is present, then the corresponding $X^1$, $X^2$, and $X^3$ is not N;
and wherein in formula (XI) $A^2$ and $A^3$ are independently selected from formula (XIII)

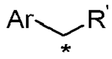

(XIII)

wherein Ar is independently selected from substituted or unsubstituted $C_6$ to $C_{18}$ aryl and substituted or unsubstituted $C_2$ to $C_{18}$ heteroaryl, wherein the substituents on Ar are independently selected from electron-withdrawing group, CN, partially or perfluorinated $C_1$ to $C_6$ alkyl, $-NO_2$, halogen, Cl, F, D; and
R' is selected from substituted or unsubstituted $C_6$ to $C_{18}$ aryl or $C_3$ to $C_{18}$ heteroaryl, partially fluorinated or perfluorinated $C_1$ to $C_8$ alkyl, halogen, F or CN.

According to one embodiment of the present invention, the compound of formula (XI) is selected from a compound of formula (XI)

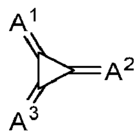

(XI)

whereby $A^1$ is selected from formula (XIIb)

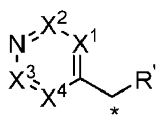

(XIIb)

wherein

$X^1$ is selected from $CR^1$ or N;
$X^2$ is selected from $CR^2$ or N;
$X^3$ is selected from $CR^3$ or N;
$X^4$ is selected from $CR^4$;
$R^1$ (if present) is selected from electron-withdrawing group, CN, partially fluorinated or perfluorinated $C_1$ to $C_8$ alkyl, $-NO_2$, halogen, Cl, F, D or H,
$R^2$, and $R^3$ (if present) are independently selected from electron-withdrawing group, CN, partially fluorinated or perfluorinated $C_1$ to $C_8$ alkyl, $-NO_2$, halogen, Cl, F, D or H,
$R^4$ is selected from CN, and partially fluorinated or perfluorinated $C_1$ to $C_8$ alkyl,
whereby when any of $R^1$, $R^2$, and $R^3$ and is present, then the corresponding $X^1$, $X^2$, and $X^3$ is not N;
with the proviso that when $R^1$ and $R^4$ are present and only $R^1$ or $R^4$ is selected from CN, then $R^2$, $R^3$ and the remaining $R^1$ or $R^4$ are independently selected from CN, and partially fluorinated or perfluorinated $C_1$ to $C_8$ alkyl, D, or $R^2$ and $R^3$ are selected from CN, partially fluorinated or perfluorinated $C_2$ to $C_8$ alkyl, halogen, Cl, F. D, or H, or $R^2$, $R^3$ and the remaining $R^1$ or $R^4$ are independently selected from CN, partially fluorinated or perfluorinated $C_1$ to $C_8$ alkyl, halogen, Cl, F, D;
or with the proviso that when $R^1$ and $R^4$ are present and only $R^1$ or $R^4$ is selected from perfluorinated $C_1$, then $R^2$ and $R^3$ are independently selected from partially fluorinated or perfluorinated $C_2$ to $C_8$ alkyl, halogen, Cl, F, D, or H; or $R^2$, $R^3$ and the remaining $R^1$ or $R^4$ is selected from CN, partially fluorinated or perfluorinated $C_1$ to $C_8$ alkyl, halogen, Cl, F, D;
or with the proviso that when $X^1$ is N and $R^4$ is selected from CN then $R^2$, $R^3$, are selected from (if present) H or D,

or $R^2$ and $R^3$ are independently selected from CN, partially fluorinated or perfluorinated $C_1$ to $C_8$ alkyl, halogen, Cl, F, D, but $R^2$ and $R^3$ cannot be both CN, or $R^2$ is selected from partially fluorinated or perfluorinated $C_2$ to $C_8$ alkyl, halogen, Cl, F, D or H;

or with the proviso that when $X^1$ is N and $R^4$ is selected from perfluorinated $C_1$ alkyl, then $R^2$ is selected from partially fluorinated or perfluorinated $C_2$ to $C_8$ alkyl, halogen, Cl, F, D or $R^3$ is selected from CN, partially fluorinated or perfluorinated $C_1$ to $C_8$ alkyl, halogen, Cl, F, D, or $R^2$ and $R^3$, are independently selected from CN, partially fluorinated or perfluorinated $C_1$ to $C_8$ alkyl, halogen, Cl, F, D, or $R^2$ and $R^3$ are independently selected from (if present) H or D;

and wherein in formula (XI) $A^2$ and $A^3$ are independently selected from formula (XIII)

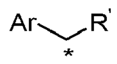

(XIII)

wherein Ar is independently selected from substituted or unsubstituted $C_6$ to $C_{18}$ aryl and substituted or unsubstituted $C_2$ to $C_{18}$ heteroaryl, wherein the substituents on Ar are independently selected from CN, partially or perfluorinated $C_1$ to $C_6$ alkyl, halogen, Cl, F, D; and

R' is selected from substituted or unsubstituted $C_6$ to $C_{18}$ aryl or $C_3$ to $C_{18}$ heteroaryl, partially fluorinated or perfluorinated $C_1$ to $C_8$ alkyl, halogen, F or CN.

According to one embodiment of the present invention, the compound of formula (XI) is selected from a compound of formula (XI)

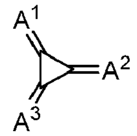

(XI)

whereby $A^1$ is selected from formula (XIIb)

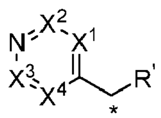

(XIIb)

wherein

$X^1$ is selected from $CR^1$ or N;

$X^2$ is selected from $CR^2$ or N;

$X^3$ is selected from $CR^3$ or N;

$X^4$ is selected from $CR^4$;

$R^1$ (if present) is selected from electron-withdrawing group, CN, partially fluorinated or perfluorinated $C_1$ to $C_8$ alkyl, halogen, $-NO_2$, Cl, F, D or H,

$R^2$, and $R^3$ (if present) are independently selected from electron-withdrawing group, CN, partially fluorinated or perfluorinated $C_1$ to $C_8$ alkyl, $-NO_2$, halogen, Cl, F, D or H,

$R^4$ is selected from CN, and partially fluorinated or perfluorinated $C_1$ to $C_8$ alkyl,

whereby when any of $R^1$, $R^2$, and $R^3$ and is present, then the corresponding $X^1$, $X^2$, and $X^3$ is not N;

and wherein in formula (XI) $A^2$ and $A^3$ are independently selected from formula (XIII)

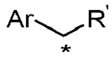

(XIII)

wherein Ar is independently selected from substituted or unsubstituted $C_6$ to $C_{18}$ aryl and substituted or unsubstituted $C_2$ to $C_{18}$ heteroaryl, wherein the substituents on Ar are independently selected from electron-withdrawing group, CN, partially or perfluorinated $C_1$ to $C_6$ alkyl, $-NO_2$, halogen, Cl, F, D; and
R' is selected from substituted or unsubstituted $C_6$ to $C_{18}$ aryl or $C_3$ to $C_{18}$ heteroaryl, partially fluorinated or perfluorinated $C_1$ to $C_8$ alkyl, halogen, F or CN;
wherein the following formulae (XIIb) are excluded:

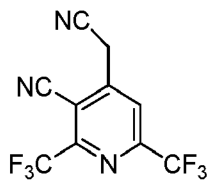, 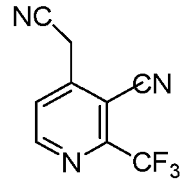, 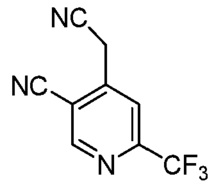, 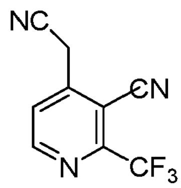,

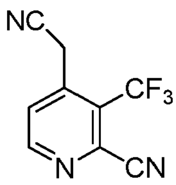, 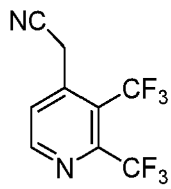, 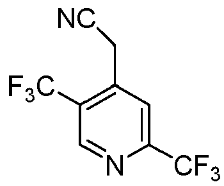, 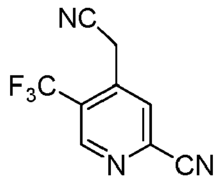,

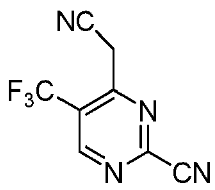, 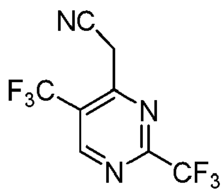, and 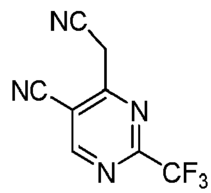,

and wherein the compound of formula (XI) is not a compound according to the following formula:

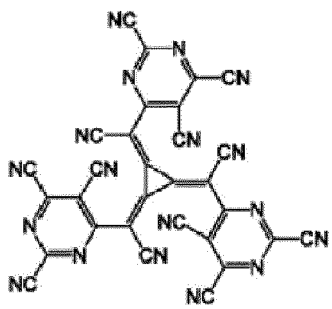.

According to one embodiment of the present invention, the compound of formula (XI) is selected from a compound of formula (XIV)

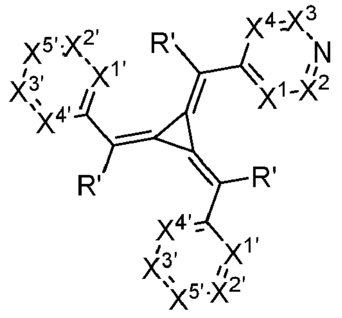

(XIV)

wherein

$X^1$ is selected from $CR^1$ or N;
$X^2$ is selected from $CR^2$ or N;
$X^3$ is selected from $CR^3$ or N;
$X^4$ is selected from $CR^4$;
$R^1$ (if present) is selected from electron-withdrawing group, CN, partially fluorinated or perfluorinated $C_1$ to $C_8$ alkyl, $-NO_2$, halogen, Cl, F, D or H,
$R^2$, and $R^3$ (if present) are independently selected from electron-withdrawing group, CN, partially fluorinated or perfluorinated $C_1$ to $C_8$ alkyl, $-NO_2$, halogen, Cl, F, D or H,
$R^4$ is selected from CN, and partially fluorinated or perfluorinated $C_1$ to $C_8$ alkyl,
whereby when any of $R^1$, $R^2$, and $R^3$ is present, then the corresponding $X^1$, $X^2$, and $X^3$ is not N;
wherein R' is selected from substituted or unsubstituted $C_6$ to $C_{18}$ aryl or $C_3$ to $C_{18}$ heteroaryl, partially flurorinated or perfluorinated $C_1$ to $C_8$ alkyl, halogen, F or CN;
and wherein
each $X^{1'}$ is selected from $CR^{1'}$ or N;
each $X^{2'}$ is selected from $CR^{2'}$ or N;
each $X^{3'}$ is selected from $CR^{3'}$ or N;
each $X^{4'}$ is selected from $CR^{4'}$ or N;
each $X^{5'}$ is selected from $CR^{5'}$ or N;grl
each $R^{1'}$, $R^{2'}$, $R^{3'}$, $R^{4'}$ and $R^{5'}$ (if present) are independently selected from electron-withdrawing group, F, CN, partially fluorinated or perfluorinated $C_1$ to $C_8$ alkyl, halogen, Cl, F, D or H, whereby when any of $R^{1'}$, $R^{2'}$, $R^{3'}$, $R^{4'}$ and $R^{5'}$ is present, then the corresponding $X^{1'}$, $X^{2'}$, $X^{3'}$, $X^{4'}$ and $X^{5'}$ is not N.

According to one embodiment of the present invention, when $X^1$ is selected from $CR^1$ then $R^1$ is selected from electron-withdrawing group, F. CN, and partially fluorinated or perfluorinated $C_1$ to $C_8$ alkyl,

According to one embodiment of the present invention, when $X^1$ is selected from $CR^1$ then $R^1$ is selected from F. CN, and partially fluorinated or perfluorinated $C_1$ to $C_8$ alkyl,

According to one embodiment of the present invention, when $X^1$ is selected from $CR^1$ then $R^1$ is selected from CN, and partially fluorinated or perfluorinated $C_1$ to $C_8$ alkyl.

According to one embodiment of the present invention, $R^4$ is F, CN, and partially fluorinated or perfluorinated $C_1$ to $C_8$ alkyl.

According to one embodiment of the present invention, $R^4$ is CN, and partially fluorinated or perfluorinated $C_1$ to $C_8$ alkyl.

According to one embodiment of the present invention, $X^{4'}$ is selected from $CR^{4'}$.

According to one embodiment of the present invention, $X^{5'}$ is selected from N.

According to one embodiment of the present invention, the substituents on Ar are independently selected from CN, partially or perfluorinated $C_1$ to $C_6$ alkyl, $-NO_2$, F.

According to one embodiment of the present invention, R' is selected from CN.

According to one embodiment of the present invention, $A^1$ in the compound according to formula (XI) is selected from one of the following formulae:

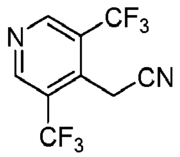 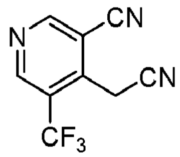 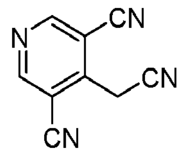 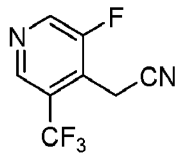

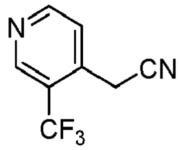 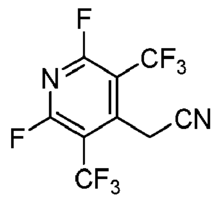 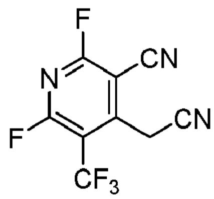 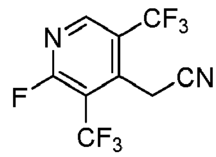

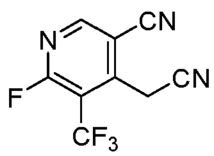 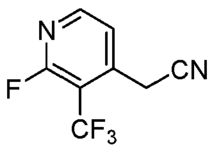 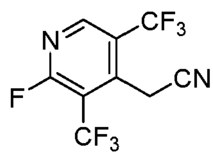 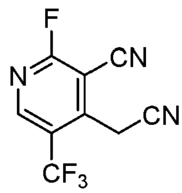

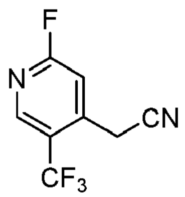 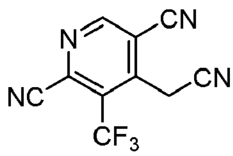 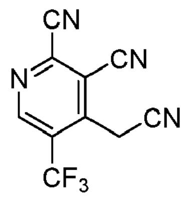 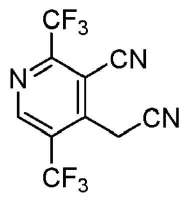

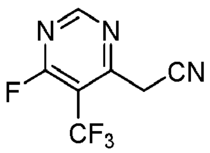 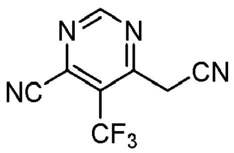 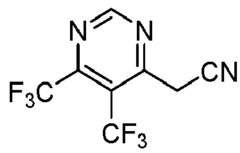 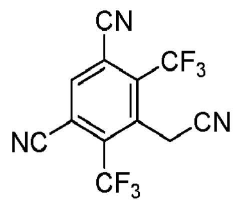

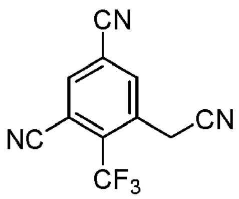 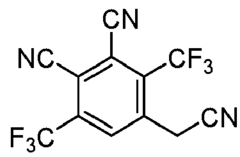 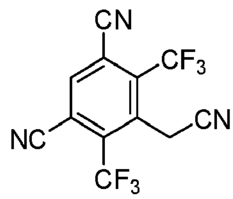 .

According to one embodiment of the present invention, $A^1$ in the compound according to formula (XI) is selected from one of the following formulae:

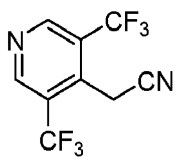 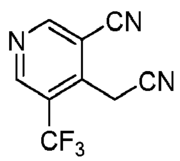 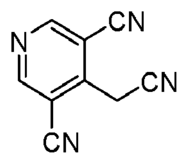 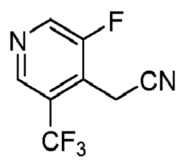

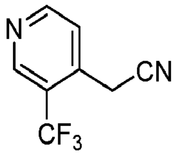 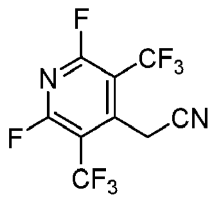 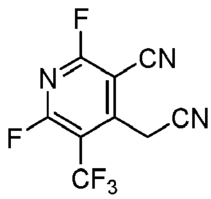 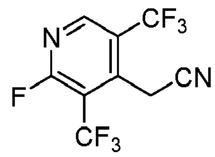

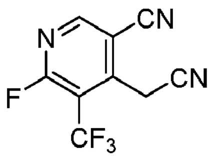 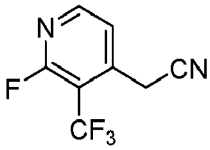 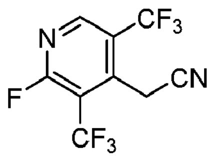 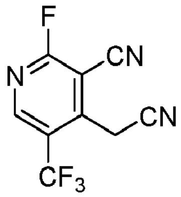

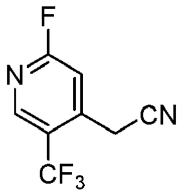 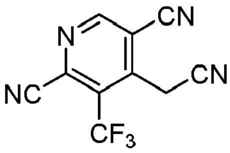 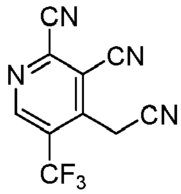 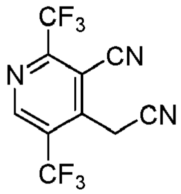

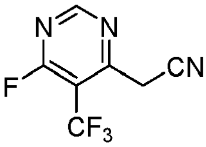 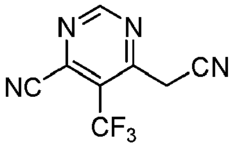 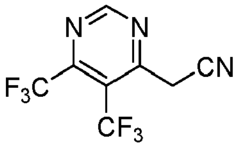

According to one embodiment of the present invention, wherein $A^2$ and $A^3$ in the compound according to formula (XI) are independently selected from one of the following formulae:

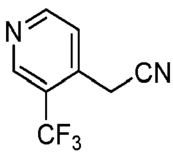 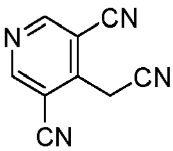 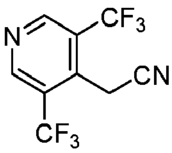 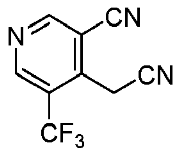

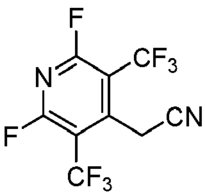 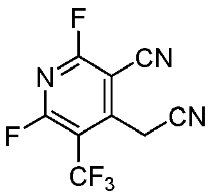 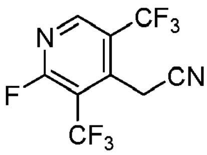 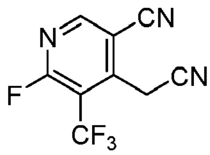

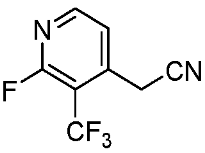 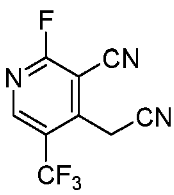 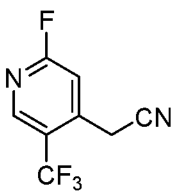 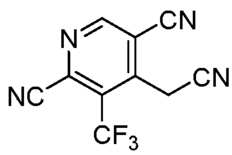

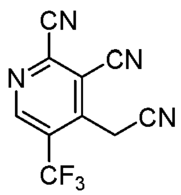
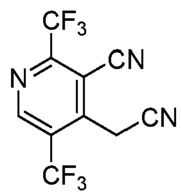
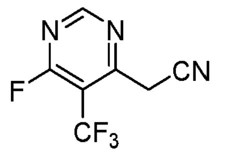
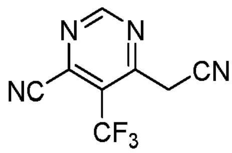
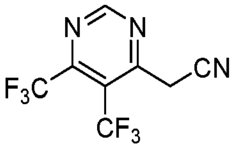
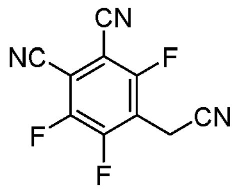
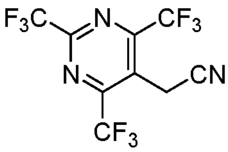
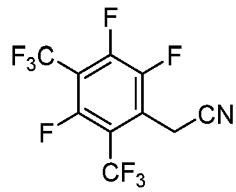
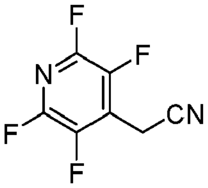
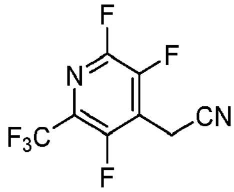
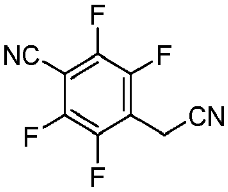
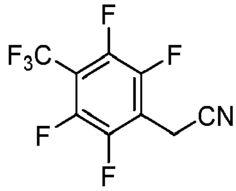
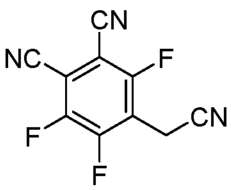
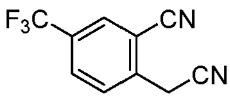
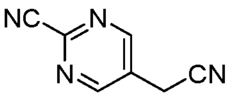
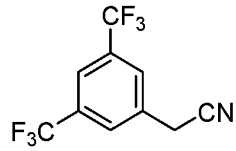
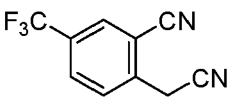
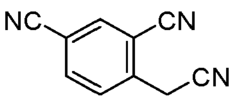
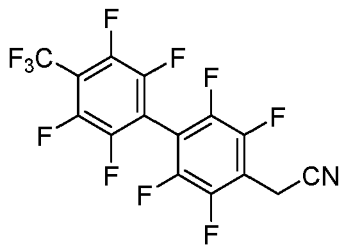
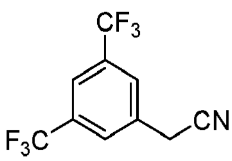
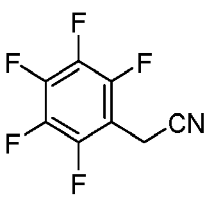
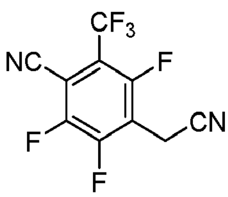
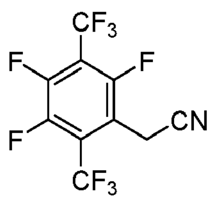
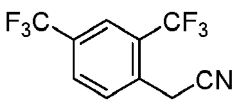
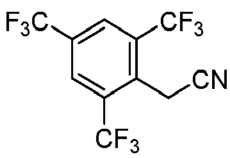
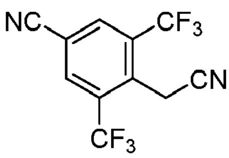
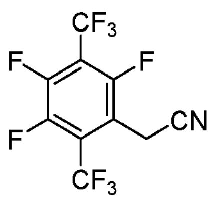

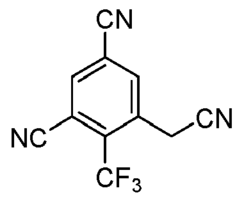 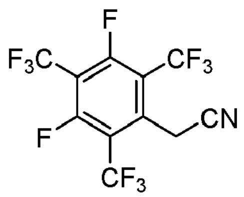 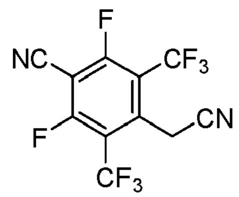 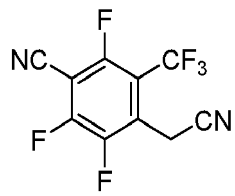

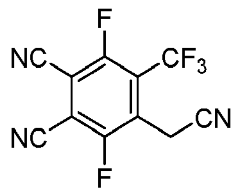 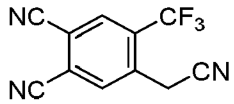 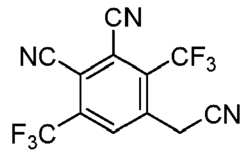 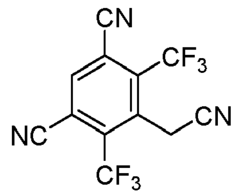

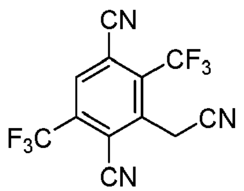 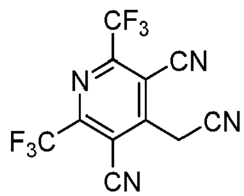 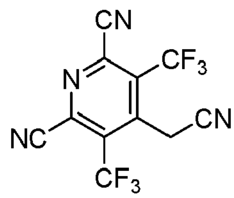 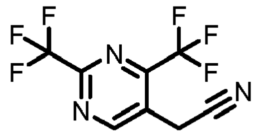

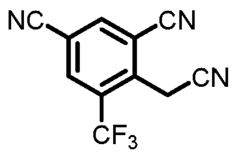 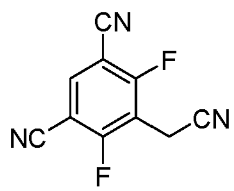 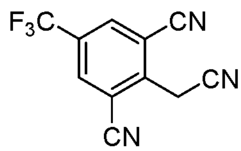 .

According to one embodiment of the present invention, the compound of formula (XI) is selected from the compounds C1 to C23, and C25 to C34, wherein $A^1$, $A^2$ and $A^3$ of the compound of formula (XI) are selected according to the following formulae:

| | $A^1$ | $A^2$ | $A^3$ |
|---|---|---|---|
| C1 | 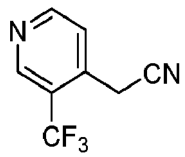 | 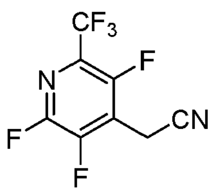 | 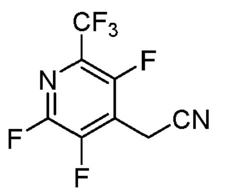 |
| C2 | 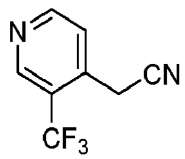 | 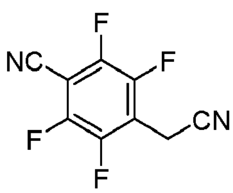 | 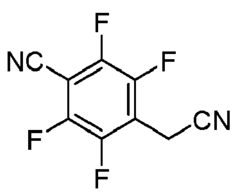 |
| C3 | 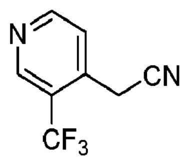 | 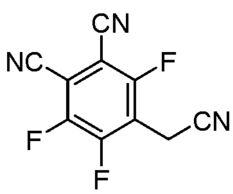 | 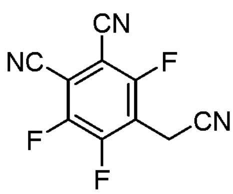 |

(continued)

| | $A^1$ | $A^2$ | $A^3$ |
|---|---|---|---|
| C4 | 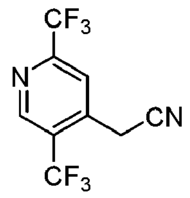 | 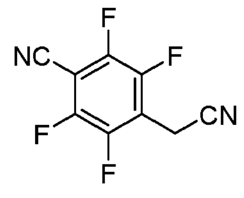 | 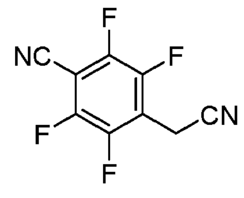 |
| C5 | 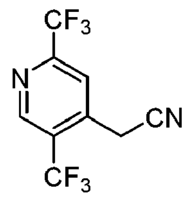 | 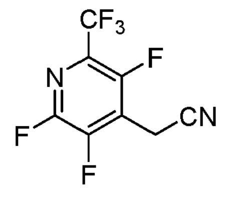 | 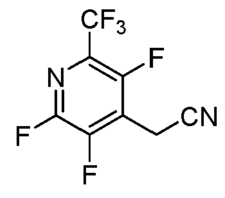 |
| C6 | 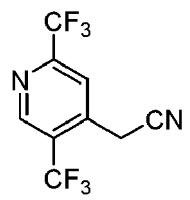 | 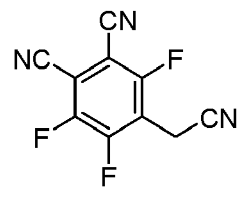 | 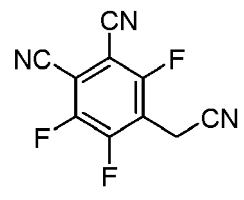 |
| C7 | 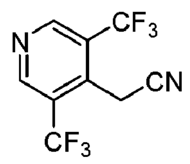 | 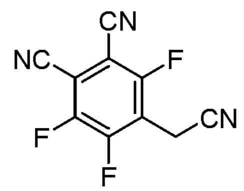 | 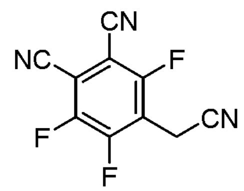 |
| C8 | 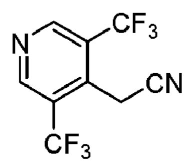 | 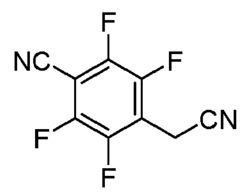 | 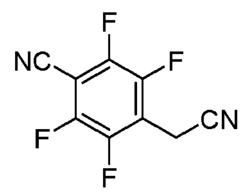 |
| C9 | 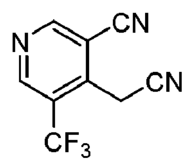 | 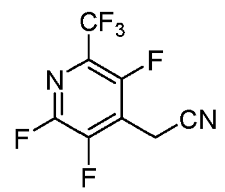 | 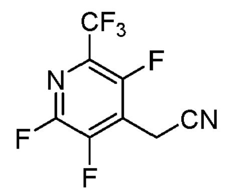 |
| C10 | 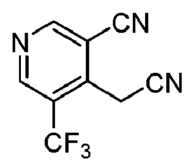 | 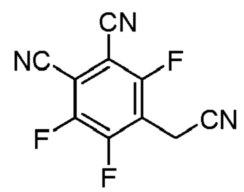 | 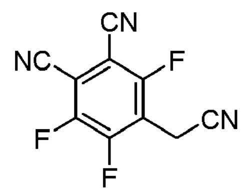 |
| C11 | 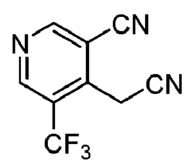 | 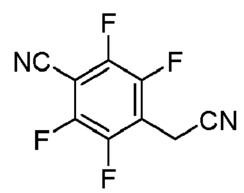 | 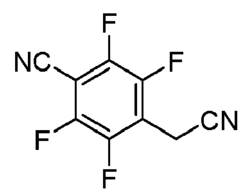 |

(continued)

| | $A^1$ | $A^2$ | $A^3$ |
|---|---|---|---|
| C12 | 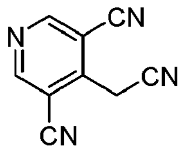 | 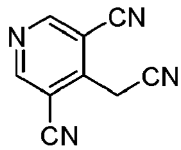 | 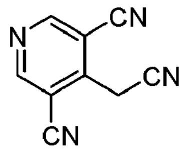 |
| C13 | 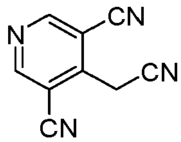 | 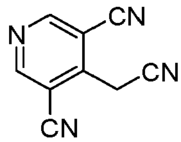 | 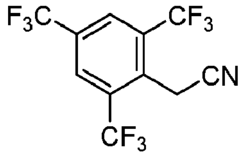 |
| C14 | 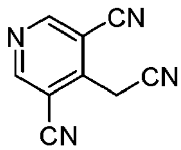 | 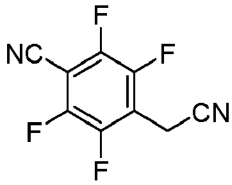 | 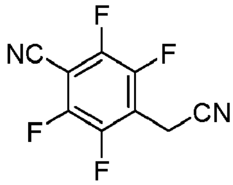 |
| C15 | 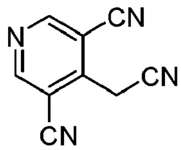 | 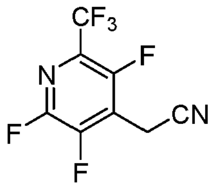 | 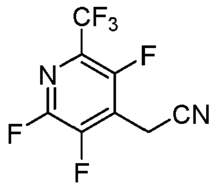 |
| C16 | 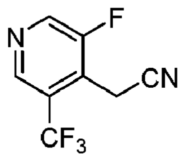 | 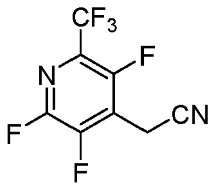 | 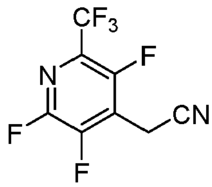 |
| C17 | 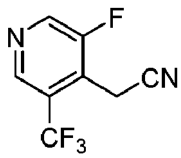 | 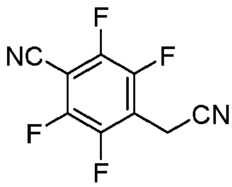 | 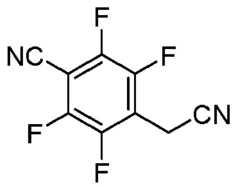 |
| C18 | 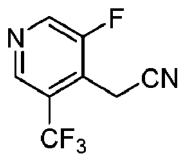 | 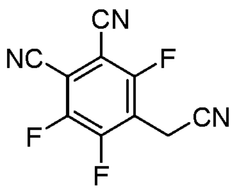 | 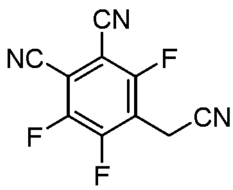 |
| C19 | 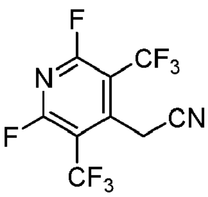 | 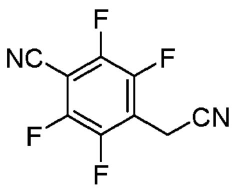 | 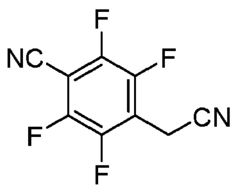 |

(continued)

| | $A^1$ | $A^2$ | $A^3$ |
|---|---|---|---|
| C20 | 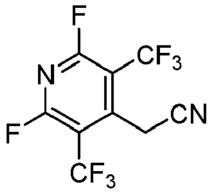 | 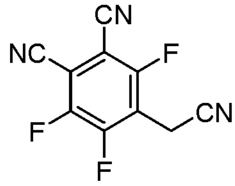 | 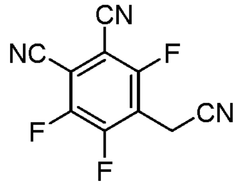 |
| C21 | 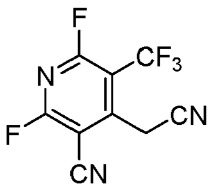 | 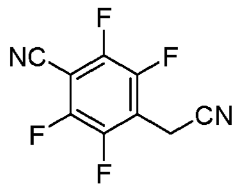 | 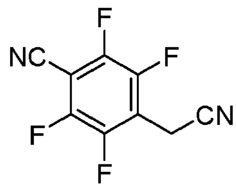 |
| C22 | 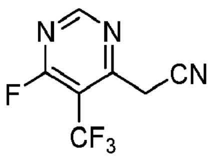 | 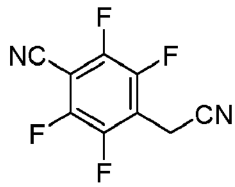 | 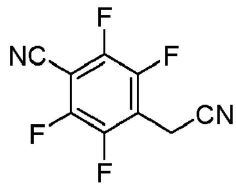 |
| C23 | 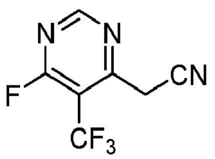 | 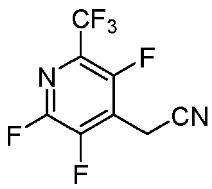 | 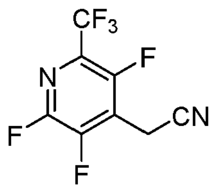 |
| C25 | 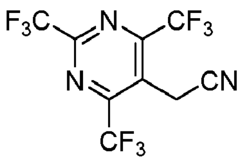 | 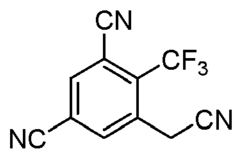 | 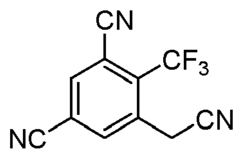 |
| C26 | 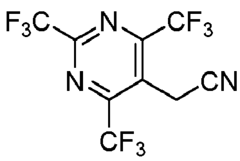 | 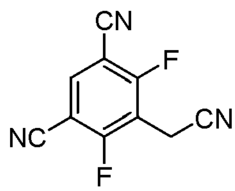 | 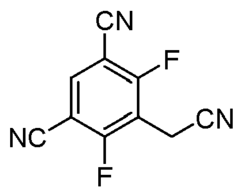 |
| C27 | 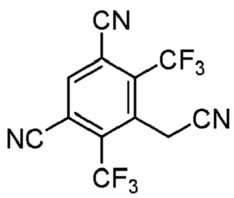 | 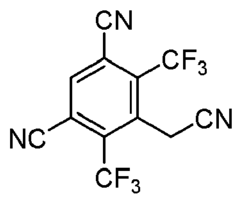 | 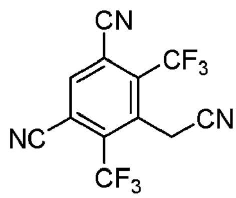 |
| C28 | 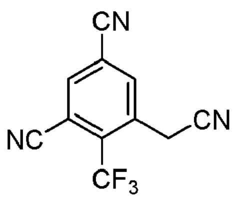 | 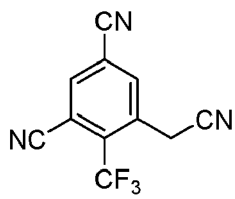 | 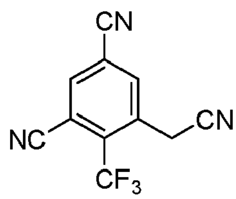 |

(continued)

| | A$^1$ | A$^2$ | A$^3$ |
|---|---|---|---|
| C29 | 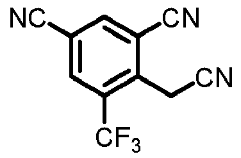 | 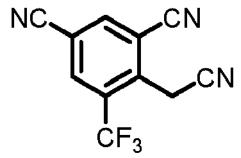 | 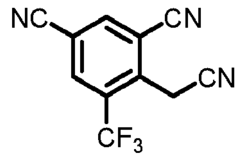 |
| C30 | 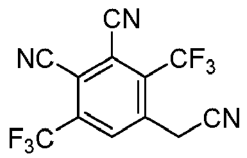 | 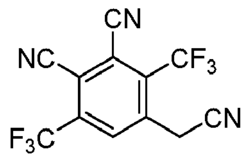 | 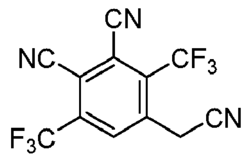 |
| C31 | 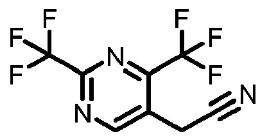 | 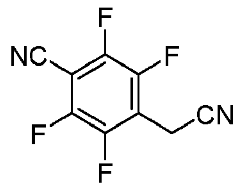 | 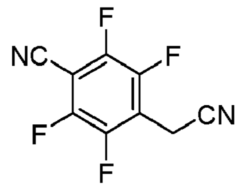 |
| C32 | 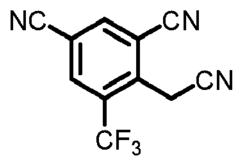 | 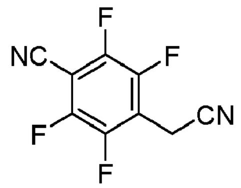 | 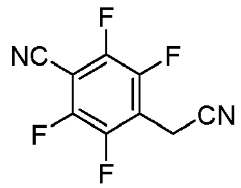 |
| C33 | 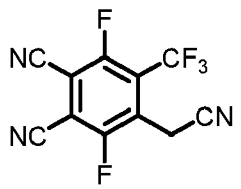 | 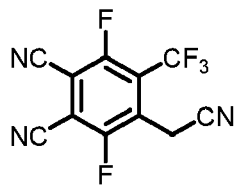 | 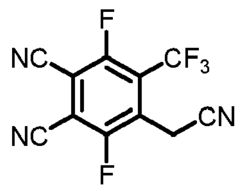 |
| C34 | 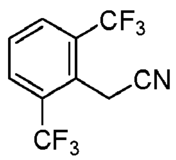 | 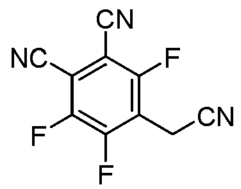 | 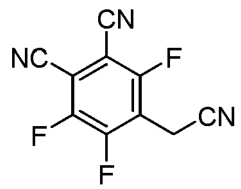 |

According to one embodiment of the present invention, the compound of formula (XI) is selected from E1 to E34:

| | | |
|---|---|---|
| 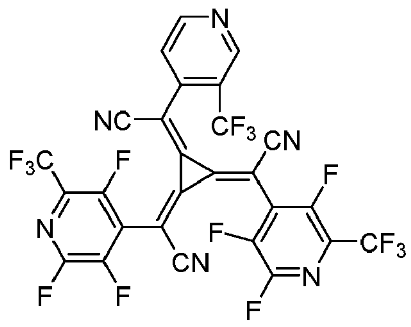 | 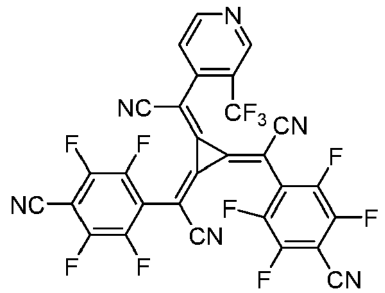 | 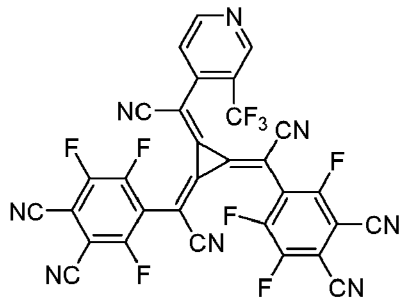 |
| E1 | E2 | E3 |
| 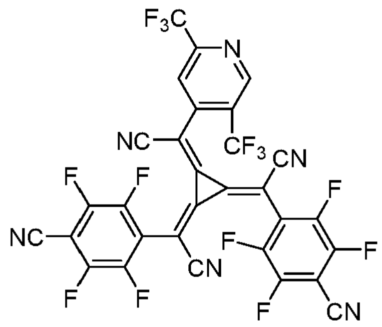 | 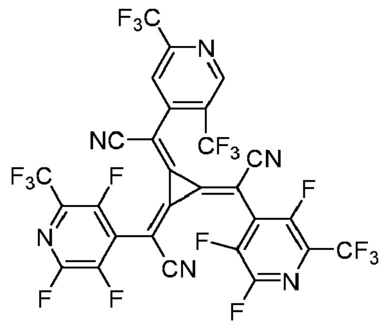 | 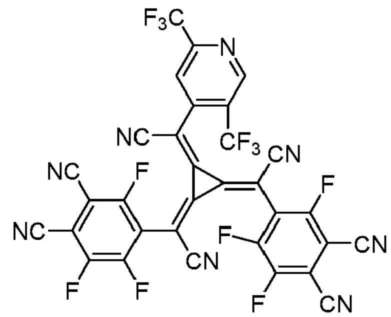 |
| E4 | E5 | E6 |
| 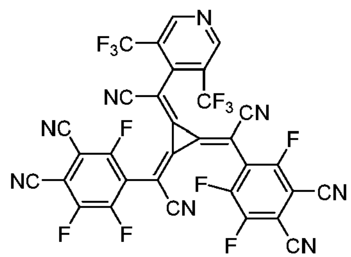 | 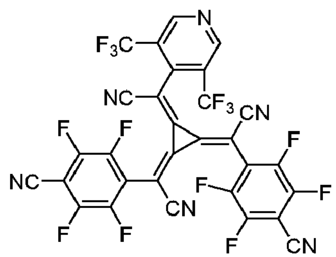 | 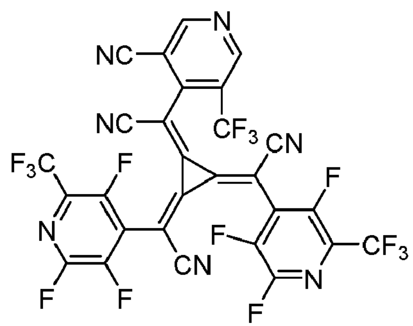 |
| E7 | E8 | E9 |

(continued)

| | | |
|---|---|---|
| 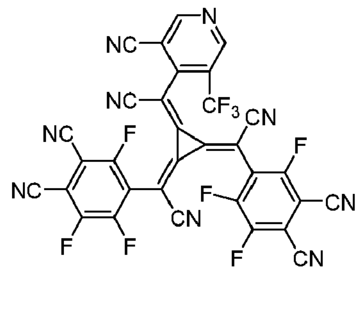 | 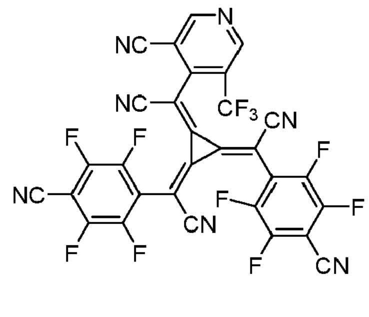 | 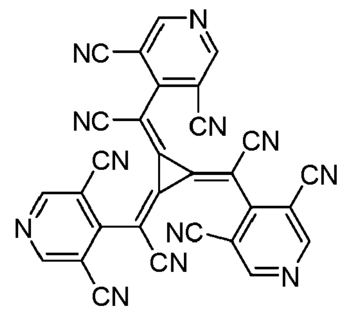 |
| E10 | E11 | E12 |
| 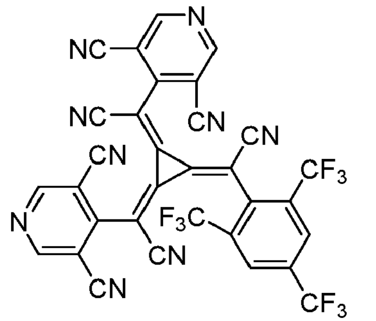 | 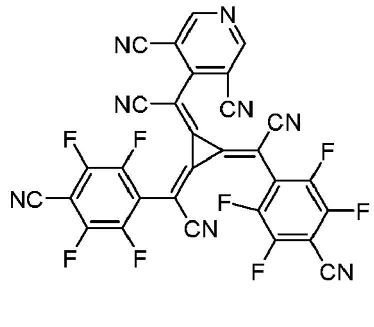 | 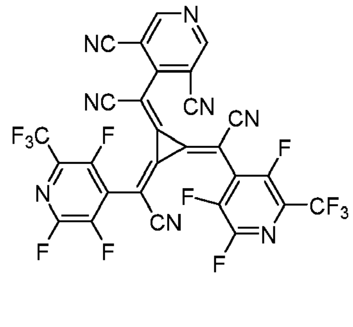 |
| E13 | E14 | E15 |
| 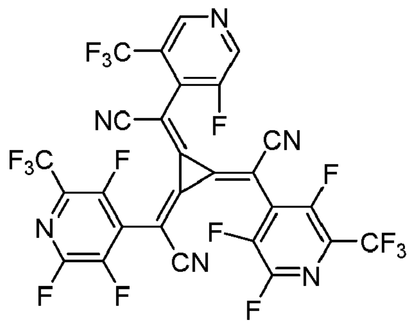 | 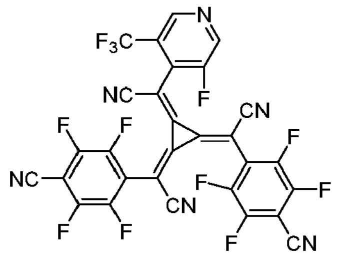 | 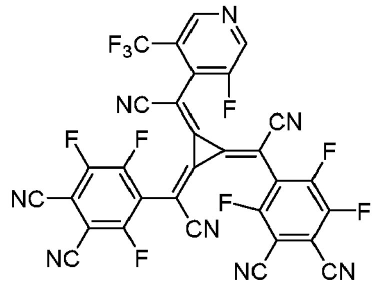 |
| E16 | E17 | E18 |

(continued)

| | | |
|---|---|---|
| 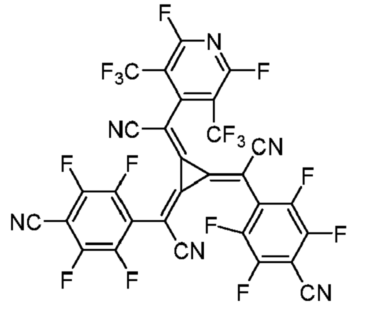 | 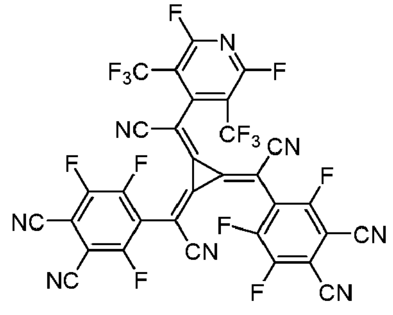 | 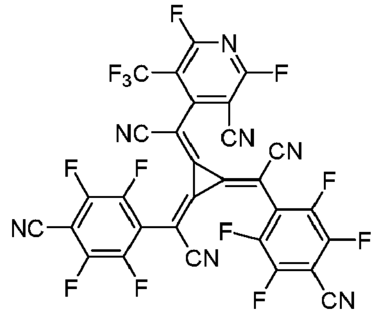 |
| E19 | E20 | E21 |
| 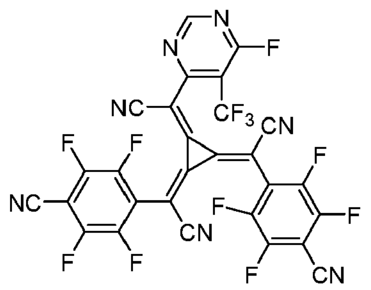 | 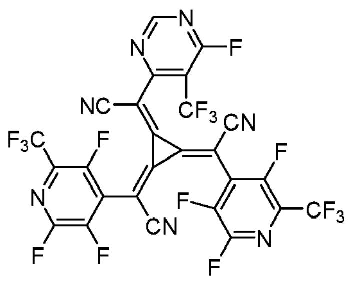 | 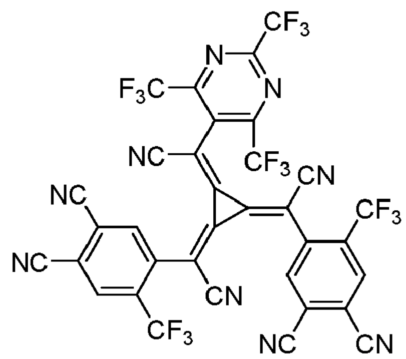 |
| E22 | E23 | E24 |
| 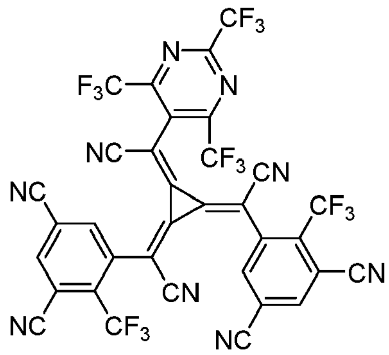 | 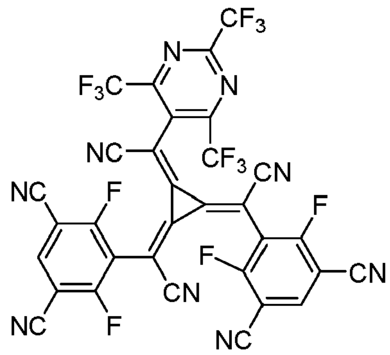 | 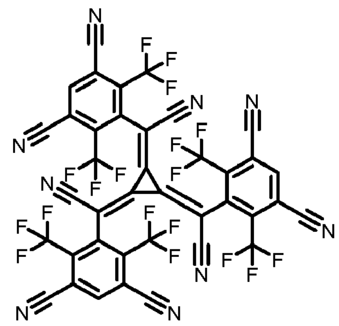 |

(continued)

| | | |
|---|---|---|
| E25 | E26 | E27 |
| 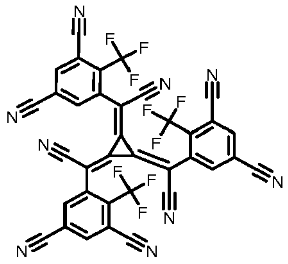 | 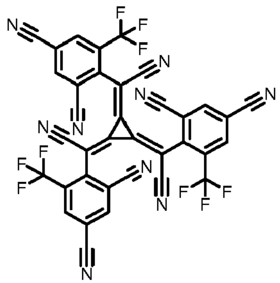 | 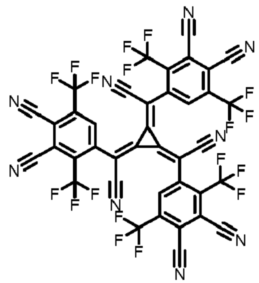 |
| E28 | E29 | E30 |
| 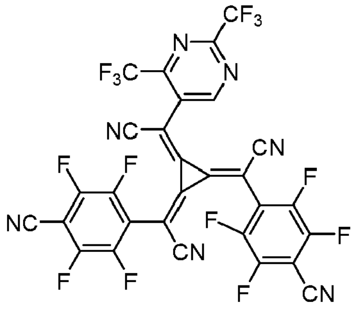 | 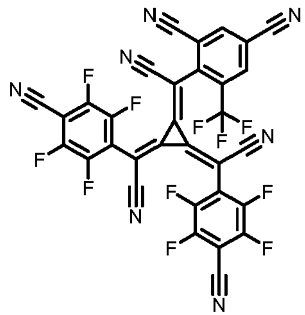 | 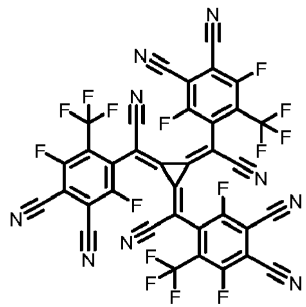 |
| E31 | E32 | E33 |
| 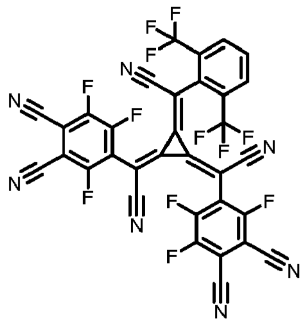 | | |
| E34 | | |

Hereinafter, the embodiments are illustrated in more detail with reference to examples. However, the present disclosure is not limited to the following examples. Reference will now be made in detail to the exemplary aspects.

**Description of the Drawings**

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an OLED comprising a charge generation layer, according to an exemplary embodiment of the present invention.

FIG. 2 is a schematic sectional view of a stacked OLED comprising a charge generation layer, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Fig. 1 is a schematic sectional view of an OLED 100, according to one exemplary embodiment of the present invention.

Referring to Fig. 1 the OLED 100 includes a substrate 110, an anode layer 120, a hole injection layer (HIL) 130, a first hole transport layer (HTL1) 140, an electron blocking layer (EBL) 145, an emission layer (EML) 150, a hole blocking layer (HBL) 155, an electron transport layer (ETL) 160, an n-type charge generation layer (n-CGL) 185, a p-type charge generation layer (p-GCL) 135 which may comprise a compound of formula (I), a second hole transport layer (HTL2) 141, and electron injection layer (EIL) 180 and a cathode layer 190. The HIL may comprise a compound of Formula (I).

Fig. 2 is a schematic sectional view of a stacked OLED 100, according to another exemplary embodiment of the present invention. Fig. 2 differs from Fig. 1 in that the OLED 100 of Fig. 1 further comprises a second emission layer.

Referring to Fig. 2 the OLED 100 includes a substrate 110, an anode layer 120, a hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-CGL) 185, a p-type charge generation layer (p-GCL) 135 which may comprise compound of Formula (I), a second hole transport layer (HTL) 141, a second electron blocking layer (EBL) 146, a second emission layer (EML) 151, a second hole blocking layer (EBL) 156, a second electron transport layer (ETL) 161, an electron injection layer (EIL) 180 and a cathode layer 190. The HIL may comprise a compound of Formula (I).

In the description above the method of manufacture an OLED 100 of the present invention is started with a substrate 110 onto which an anode layer 120 is formed, on the anode layer 120, a hole injection layer 130, a first hole transport layer 140, optional a first electron blocking layer 145, a first emission layer 150, optional a first hole blocking layer 155, optional at least one first electron transport layer 160, an n-CGL 185, a p-CGL 135, a second hole transport layer 141, optional a second electron blocking layer 146, a second emission layer 151, an optional second hole blocking layer 156, an optional at least one second electron transport layer 161, an optional electron injection layer (EIL) 180 and a cathode layer 190 are formed, in that order or the other way around.

While not shown in Fig. 1 and 2, a sealing and/or capping layer may further be formed on the cathode layer 190, in order to seal the organic electronic device 100. In addition, various other modifications may be applied thereto.

Hereinafter, one or more exemplary embodiments of the present invention will be described in detail with, reference to the following examples. However, these examples are not intended to limit the purpose and scope of the one or more exemplary embodiments of the present invention.

## Detailed description

The invention is furthermore illustrated by the following examples which are illustrative only and non-binding.

Compounds of formula (I) may be prepared as described in EP2180029A1 and WO2016097017A1.

UV-VIS absorption measurement in solution

Experimental absorption spectra were recorded on a Shimadzu UV-2401 PC Series Spectrophotometer. For sample preparation the material is weighed into an aluminum crucible, which is then inserted into a 25 mL measuring flask. The related micro balance has a mass change readability in the 1-2 μg range. The flask is then filled up to the mark with dichloromethane (Spectroscopy grade, transmission ≥90% for λ ≥ 248 nm according to manufacturer) and shaken until the material is completely dissolved, yielding a solution with a concentration of 10-4 - 10-5 mol/L. For measurement the solution is put into a standard cuvette (Hellma 110-QS: quartz, d=10 mm, with PTFE stopper). The spectrum is recorded at a slit width of 1 nm at a sampling interval of 0.5 nm at an ambient temperature of 20 °C. From all spectra the background absorption of the pure solvent is subtracted which was measured immediately prior to the measurement using the same measurement conditions. The results are shown in Table 1.

Optical absorptance measurement of p-type charge generation layer

Mixed films of N-([1,1'-biphenyl]-2-yl)-N-(9,9-dimethyl-9H-fluoren-2-yl)-9,9'-spirobi[fluoren]-2-amine and a p-dopant according to Table 2 with a thickness of 35 nm on quartz substrates (EN08, ≥ 99.98% SiO2, GVB GmbH) are prepared by thermal evaporation in a vacuum system (Cluster Tool, Sunic System Ltd.) at a deposition rate of 1 A/s and a pressure of approximately 3e-7 mbar. The samples are stored in glovebox with pure nitrogen atmosphere until the measurement takes place (maximum 1 hour of air exposure). Reflectance and transmittance are measured using a Filmetrics F10-RT Spectrometer with a spectral range of 380 nm to 1050 nm. An empty quartz substrate is used for reflectance standard. Absorptance is automatically calculated by subtracting reflectance and transmittance values from 100%. The results are shown in Table 2.

Calculated HOMO and LUMO

The HOMO and LUMO are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

Calculated absorption area or maximal absorption

Calculations were carried out with the program package TURBOMOLE V6.5 (TURBOMOLE GmbH, Litzenhardtstrasse 19, 76135 Karlsruhe, Germany).

LUMO and HOMO energies and the resulting HOMO-LUMO-gap were calculated using the hybrid functional B3LYP with a 6-31G* basis set in the gas phase. The thus obtained optimized geometries were used to run TDDFT calculations applying the hybrid functional PBE0 with a def2-SVP basis set in the gas phase and including the first 30 singlet transitions. The calculated singlet transitions were used to calculate the absorption spectra by applying a Gaussian fit (λ = 215-850 nm, SD=20, 200 sampling points) from which transitions below 350 nm were excluded.

To calculate the general absorption in a relevant wavelength area (λ = 400-650 nm, blue and green emission) the integral below the calculated UV TDDFT spectrum was determined.

General procedure for fabrication of OLEDs

For bottom emission devices, see Table 2, a 15Ω /cm$^2$ glass substrate with 90 nm ITO (available from Corning Co.) was cut to a size of 50 mm x 50 mm x 0.7 mm, ultrasonically washed with isopropyl alcohol for 5 minutes and then with pure water for 5 minutes, and washed again with UV ozone for 30 minutes, to prepare the anode.

Then N-([1,1'-biphenyl]-2-yl)-N-(9,9-dimethyl-9H-fluoren-2-yl)-9,9'-spirobi[fluoren]-2-aminewas vacuum deposited with 12 vol% of compound according to formula (I) or a comparative compound according to Table 2 to form a hole injection layer having a thickness 10 nm.

Then N-([1,1'-biphenyl]-2-yl)-N-(9,9-dimethyl-9H-fluoren-2-yl)-9,9'-spirobi[fluoren]-2-amine was vacuum deposited, to form a first hole transport layer having a thickness of 130 nm

Then N,N-bis(4-(dibenzo[b,d]furan-4-yl)phenyl)-[1,1':4',1''-terphenyl]-4-amine was vacuum deposited on the

HTL, to form an electron blocking layer (EBL) having a thickness of 5 nm.

Then 97 vol.-% H09 (Sun Fine Chemicals, Korea) as EML host and 3 vol.-% BD200 (Sun Fine Chemicals, Korea) as fluorescent blue dopant were deposited on the EBL, to form a first blue-emitting EML with a thickness of 20 nm.

Then 2-(3'-(9,9-dimethyl-9H-fluoren-2-yl)-[1,1'-biphenyl]-3-yl)-4,6-diphenyl-1,3,5-triazine was vacuum deposited to form a first hole blocking layer having a thickness of 25 nm.

Then an-type CGL having a thickness of 15 nm is formed on the ETL1 by co-depositing 99 vol.-% (3 -(10-(3 -(2,6-diphenylpyrimidin-4-yl)phenyl)anthracen-9-yl)phenyl)dimethylphosphine oxide] having energy level of the LUMO of -1.80 eV, expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase and 1 vol.-% Yb.

Then a p-type CGL having a thickness of 20 nm is formed on the first n-type CGL by co-depositing N-([1,1'-biphenyl]-2-yl)-N-(9,9-dimethyl-9H-fluoren-2-yl)-9,9'-spirobi[fluoren]-2-amine with 20 vol% compound according to formula (I) or a comparative example according to table 3.

Then a second hole transport layer having a thickness of 11 nm is formed on the first p-type CGL by depositing N-([1,1'-biphenyl]-2-yl)-N-(9,9-dimethyl-9H-fluoren-2-yl)-9,9'-spirobi[fluoren]-2-amine.

Then a second electron blocking layer having a thickness of 5 nm is formed on the second hole transport layer by depositing N,N-bis(4-(dibenzo[b,d]furan-4-yl)phenyl)-[1,1':4',1"-terphenyl]-4-amine,

Then 97 vol.-% H09 (Sun Fine Chemicals, Korea) as EML host and 3 vol.-% BD200 (Sun Fine Chemicals, Korea) as fluorescent blue dopant were deposited on the second EBL, to form a second blue-emitting EML with a thickness of 20 nm.

Then 2-(3'-(9,9-dimethyl-9H-fluoren-2-yl)-[1,1'-biphenyl]-3-yl)-4,6-diphenyl-1,3,5-triazine was vacuum deposited to form a second hole blocking layer having a thickness of 10 nm is formed on the second blue-emitting EML.

Then, 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% LiQ were vacuum deposited on the second hole blocking layer to form a second electron transport layer having a thickness of 25nm.

Al is evaporated at a rate of 0.01 to 1 A/s at $10^{-7}$ mbar to form a cathode with a thickness of 100 nm.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m$^2$ using an Instrument Systems CAS-140CT array spectrometer (calibrated by Deutsche Akkreditierungsstelle (DAkkS)) for each of the voltage values. The cd/A efficiency at 10 mA/cm2 is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 10 mA/cm$^2$.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm$^2$.

Lifetime LT of the device is measured at ambient conditions (20°C) and 30 mA/cm$^2$, using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U=[U100\ h)-\ U(1h)]$$

or the operating voltage after 1 hour after the start of operation of the device from the operating voltage after 400 hours.

$$\Delta U=[U400\ h)-\ U(1h)]$$

The smaller the value of ΔU the better is the operating voltage stability.

Luminous flux

The samples were placed individually into an integrating sphere and the luminous flux has been measured at a current density of 10 mA/cm$^2$ using an Instrument Systems CAS-140CT array spectrometer (calibrated by Deutsche Akkreditierungsstelle (DAkkS)). As a constant current source a Keithley 2635 source measure unit has been used.

Technical effect of the invention

**Table 1: Overview of physical parameters of radialenes**

| | A1 | A2 | A3 | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| Comp | 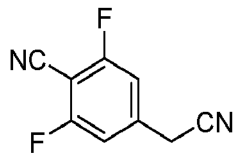 | 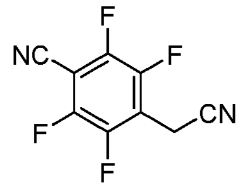 | 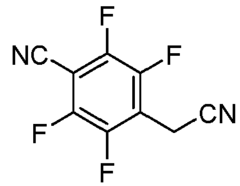 | 475 | 507 | 54.84 | -5.19 |
| A1 | 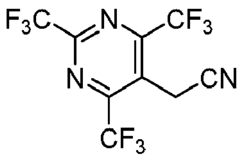 | 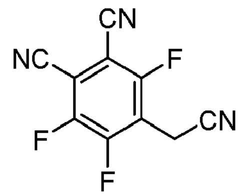 | 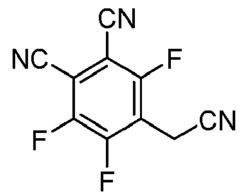 | 448 | 479 | 41.69 | -5.44 |
| A2 | 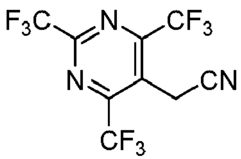 | 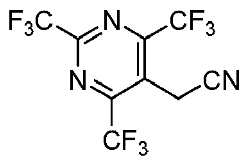 | 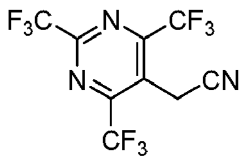 | 395 | 415 | 21.62 | -5.15 |
| A3 | 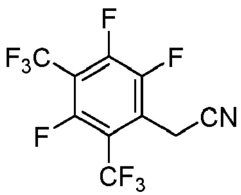 | 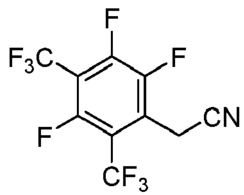 | 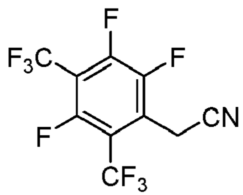 | 409 | 409 | 34.72 | -4.86 |

(continued)

| | A1 | A2 | A3 | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A4 | 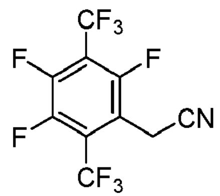 | 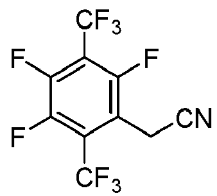 | 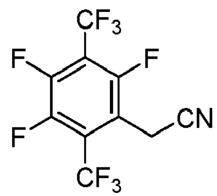 | 420 | 472 | 25.80 | -4.74 |
| A5 | 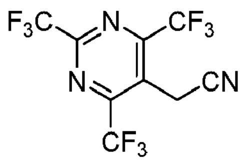 | 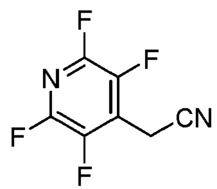 | 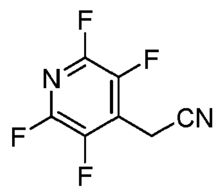 | 426 | 434 | 37,39 | -5.13 |
| A6 | 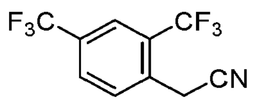 | 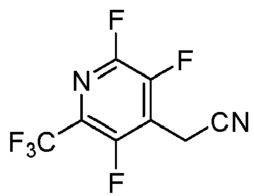 | 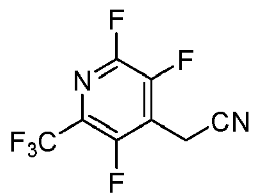 | 428 | 428 | 40.80--- | -5.15 |
| A7 | 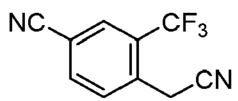 | 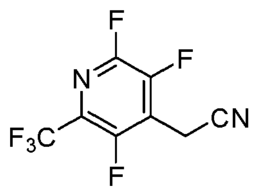 | 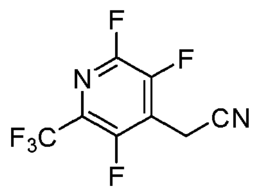 | 430 | 428 | 39.87 | -4.99 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A8 | 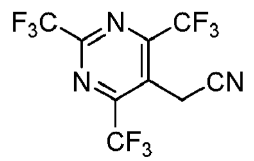 | 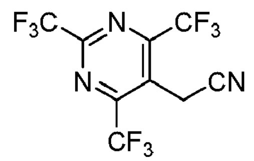 | 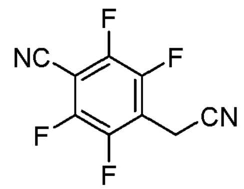 | 434 | 456 | 35.17 | -5.18 |
| A9 | 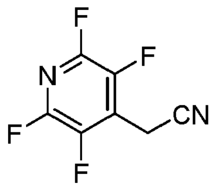 | 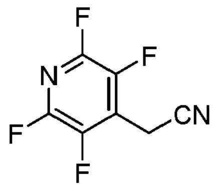 | 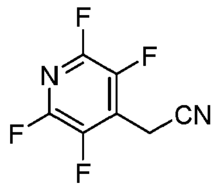 | 435 | 428 | 39.05 | -5.09 |
| A10 | 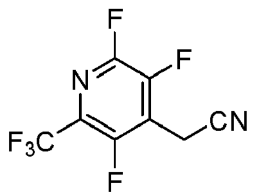 | 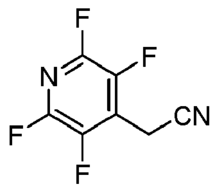 | 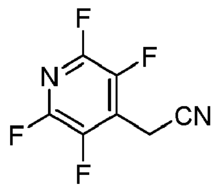 | 435 | 434 | 41,36 | -5.15 |
| A11 | 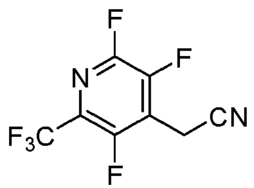 | 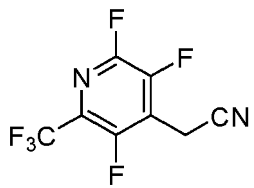 | 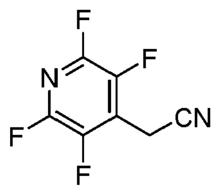 | 436 | 444 | 43,28 | -5.22 |
| A12 | 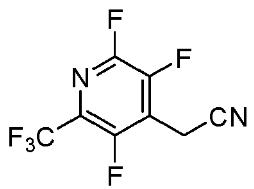 | 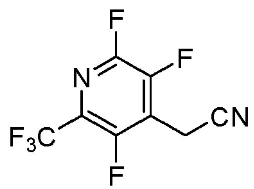 | 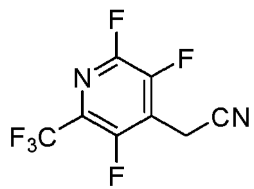 | 436 | 444 | 42.67 | -5.29 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A13 | 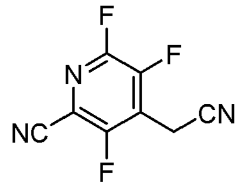 | 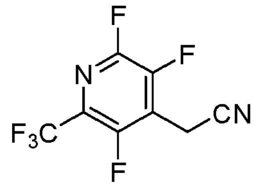 | 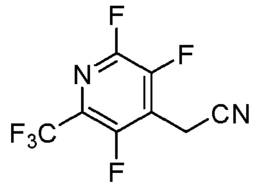 | 438 | 437 | 43.11 | -5.31 |
| A14 | 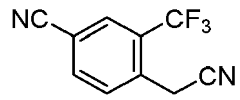 | 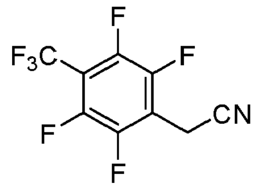 | 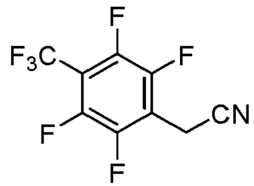 | 439 | 456 | 41.83 | -4.83 |
| A15 | 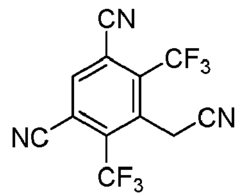 | 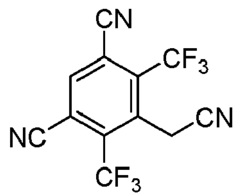 | 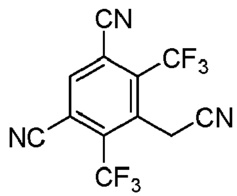 | -- | 364 | 2,00 | -5.16 |
| A55 | 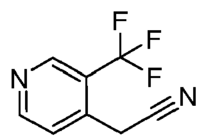 | 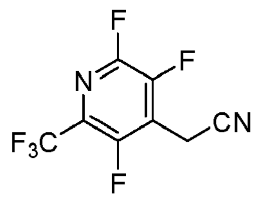 | 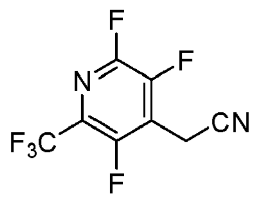 | -- | 418 | 31.95 | -5.02 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A65 | 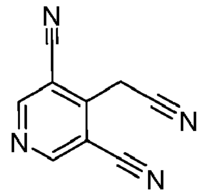 | 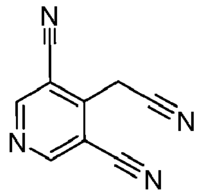 | 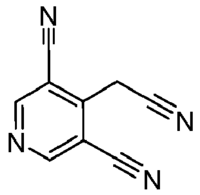 | -- | 430 | 33.33 | -5.25 |
| A66 | 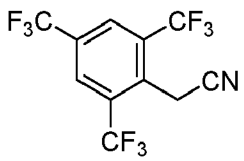 | 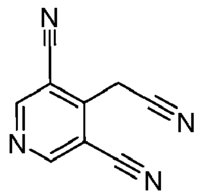 | 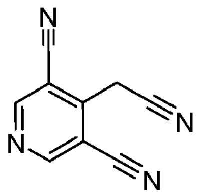 | -- | 409 | 23.00 | -5.03 |
| A16 | 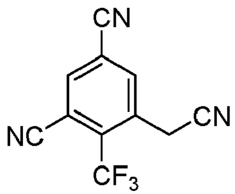 | 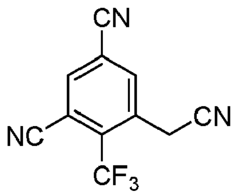 | 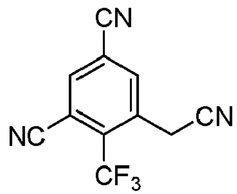 | -- | 412 | 22.41 | -5.17 |
| A17 | 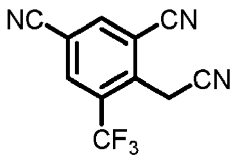 | 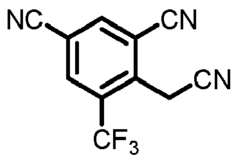 | 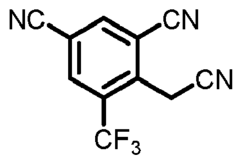 | -- | 444 | 29.55 | -5.06 |
| A18 | 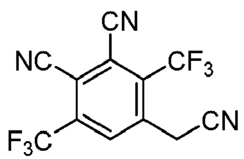 | 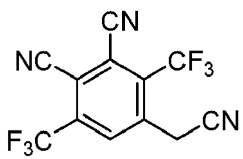 | 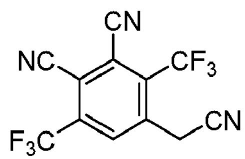 | -- | 431 | 26.84 | -5.45 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A72 | 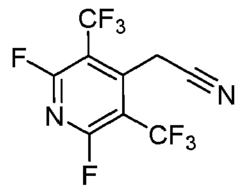 | 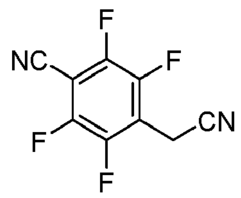 | 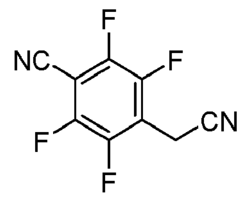 | -- | 466 | 39.16 | -5.38 |
| A62 | 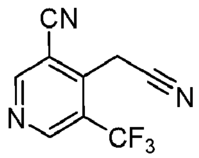 | 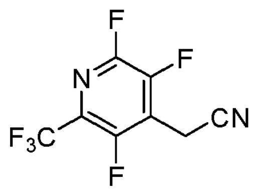 | 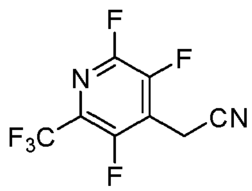 | -- | 425 | 35.20 | -5.11 |
| A31 | 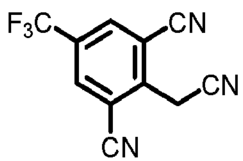 | 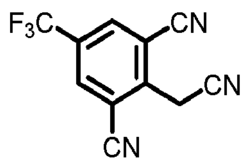 | 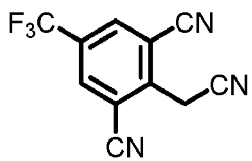 | -- | 450 | 35.14 | -5.08 |
| A59 | 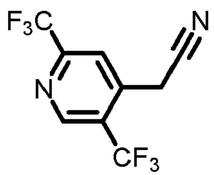 | 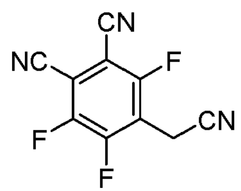 | 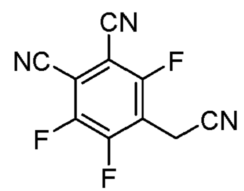 | -- | 465 | 46.77 | -5.32 |
| A79 | 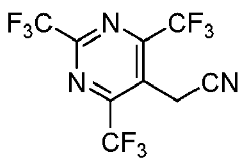 | 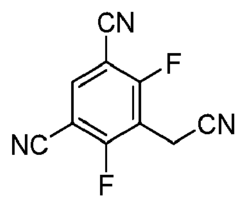 | 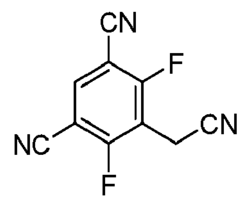 | -- | 453 | 41.51 | -5.26 |

(continued)

| | A¹ | A² | A³ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A77 | 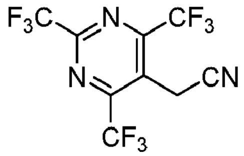 | 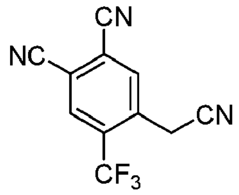 | 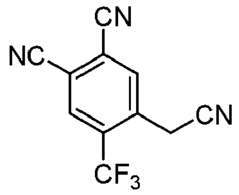 | -- | 447 | 35.62 | -5.26 |
| A57 | 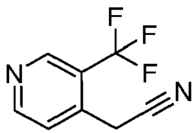 | 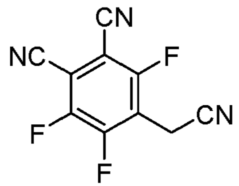 | 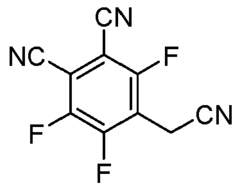 | -- | 460 | 46.51 | -5.17 |
| A58 | 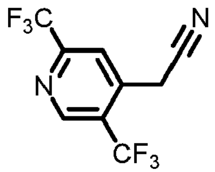 | 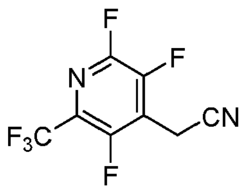 | 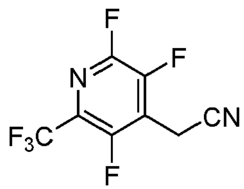 | -- | 431 | 39.95 | -5.17 |
| A68 | 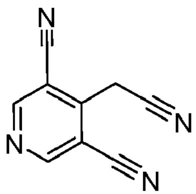 | 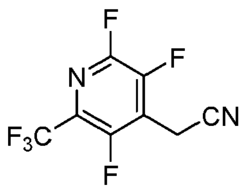 | 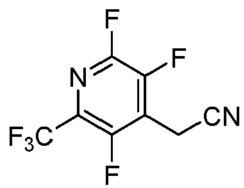 | -- | 440 | 39.97 | -5.25 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A70 | 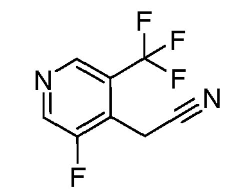 | 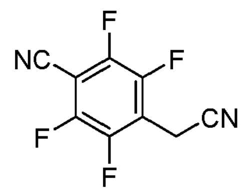 | 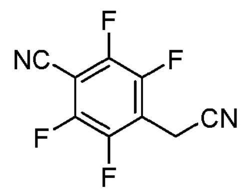 | -- | 479 | 46.68 | -4.96 |
| A74 | 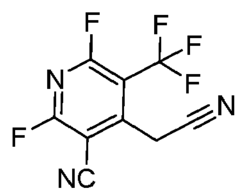 | 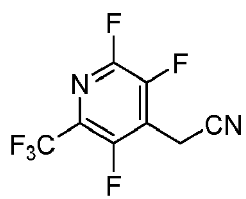 | 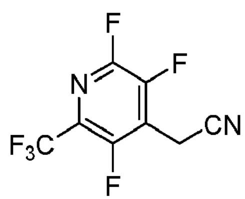 | -- | 421 | 34.47 | -5.12 |
| A76 | 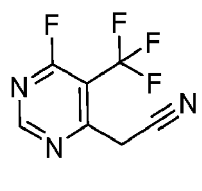 | 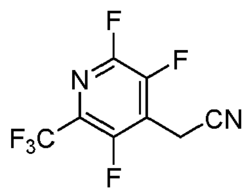 | 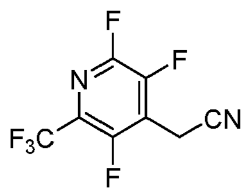 | -- | 437 | 41.87 | -5.21 |
| A19 | 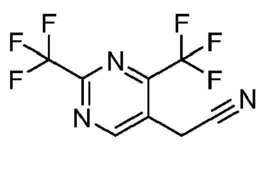 | 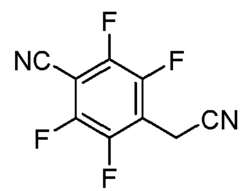 | 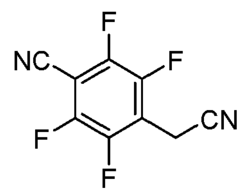 | -- | 475 | 43.25 | -5.16 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A69 | 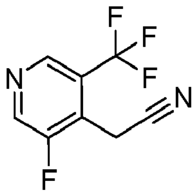 | 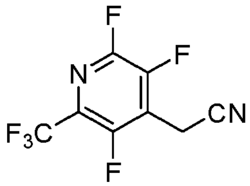 | 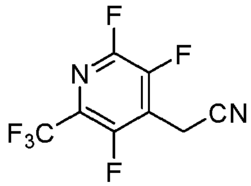 | -- | 418 | 32.90 | -5.07 |
| A71 | 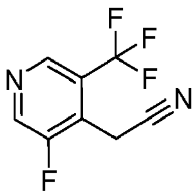 | 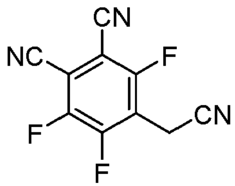 | 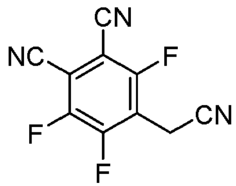 | -- | 472 | 45.97 | -5.29 |
| A78 | 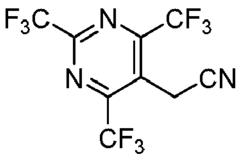 | 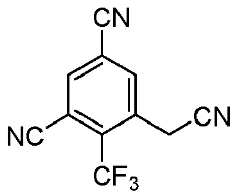 | 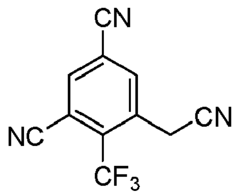 | -- | 425 | 33.42 | -5.21 |
| A73 | 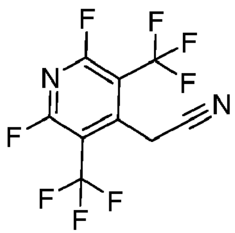 | 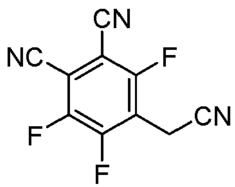 | 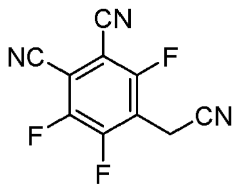 | -- | 463 | 42.45 | -5.32 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A75 | 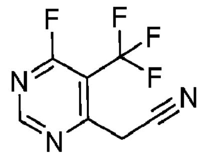 | 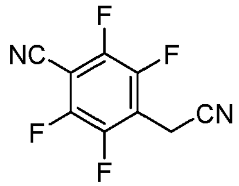 | 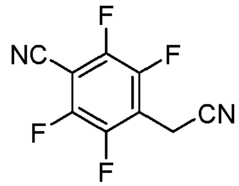 | -- | 479 | 44.93 | -5.13 |
| A56 | 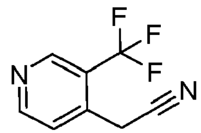 | 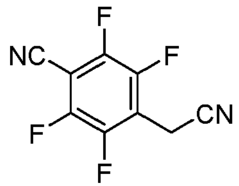 | 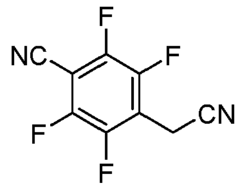 | -- | 469 | 46.58 | -5.04 |
| A20 | 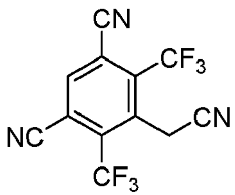 | 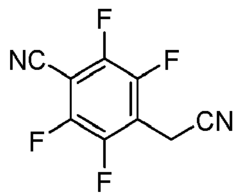 | 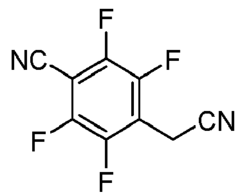 | -- | 491 | 53.13 | -5.19 |
| A21 | 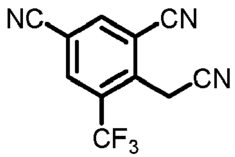 | 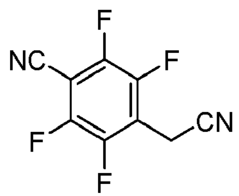 | 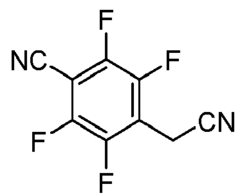 | -- | 479 | 44.58 | -5.06 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A22 | 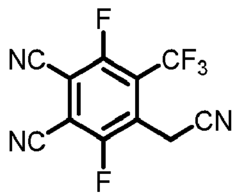 | 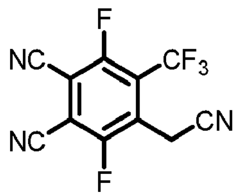 | 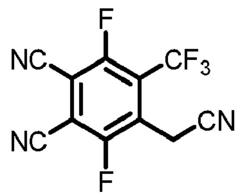 | -- | 466 | 35.52 | -5.38 |
| A23 | 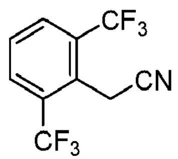 | 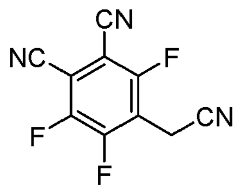 | 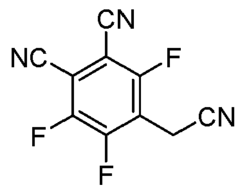 | -- | 456 | 44.09 | -5.02 |
| A24 | 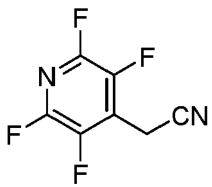 | 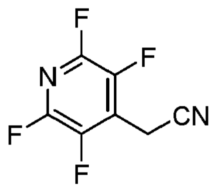 | 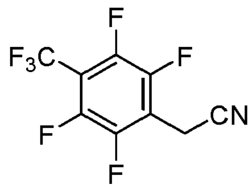 | 441 | 428 | 41,93 | -5.03 |
| A25 | 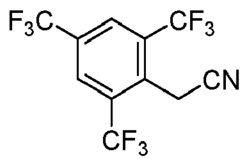 | 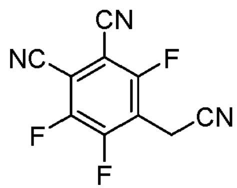 | 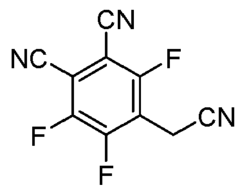 | 441 | 463 | 44.65 | -5.22 |
| A26 | 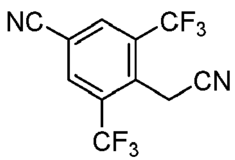 | 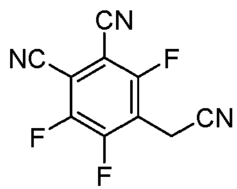 | 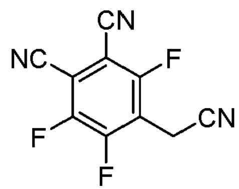 | 442 | 466 | 45.18 | -5.32 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A27 | 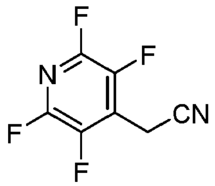 | 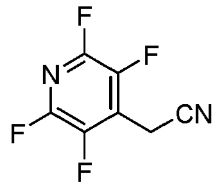 | 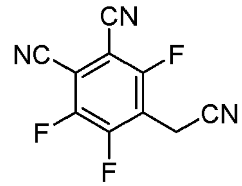 | 443 | 453 | 46,44 | -5.24 |
| A28 | 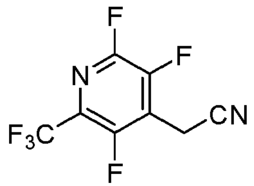 | 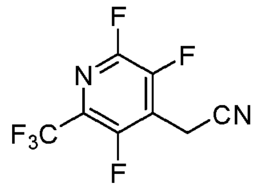 | 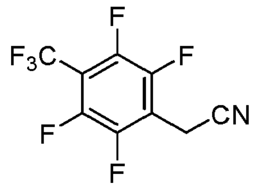 | 443 | 447 | 43.38 | -5.14 |
| A29 | 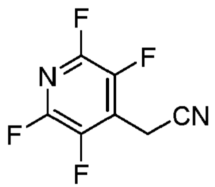 | 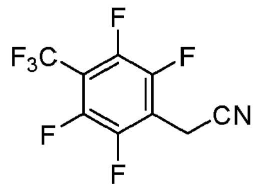 | 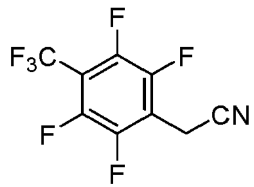 | 446 | 463 | 45.38 | -4.97 |
| A61 | 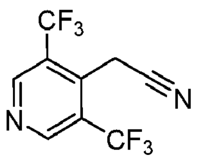 | 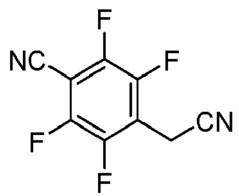 | 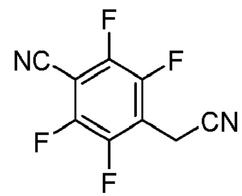 | -- | 472 | 43.75 | -5.02 |
| A60 | 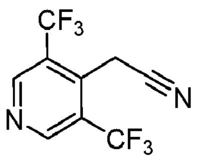 | 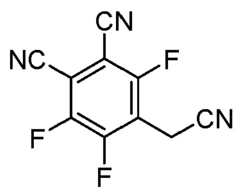 | 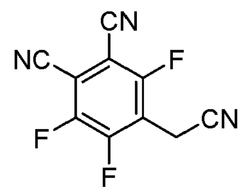 | -- | 469 | 44.37 | -5.27 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A64 | 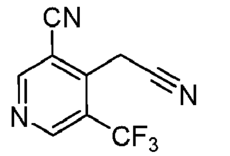 | 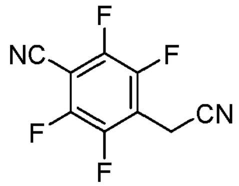 | 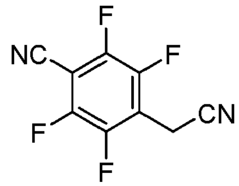 | -- | 482 | 43.98 | -5.11 |
| A63 | 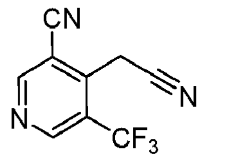 | 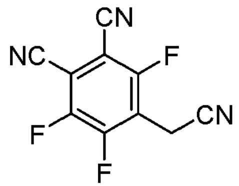 | 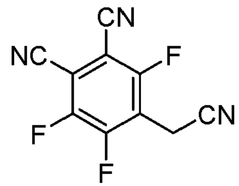 | -- | 479 | 46.36 | -5.37 |
| A67 | 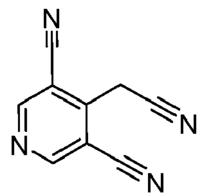 | 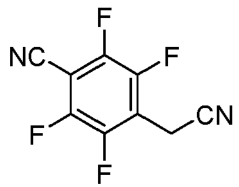 | 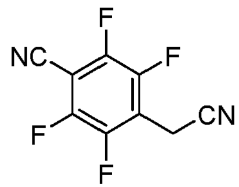 | -- | 494 | 46.79 | -5.23 |
| A32 | 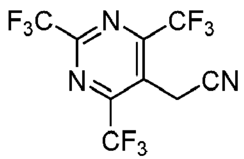 | 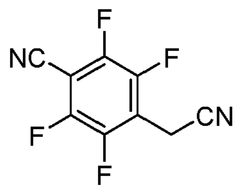 | 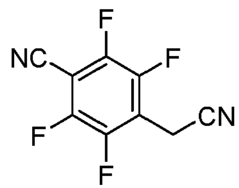 | 451 | 467 | 42.43 | -5.19 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A33 | 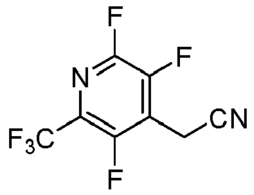 | 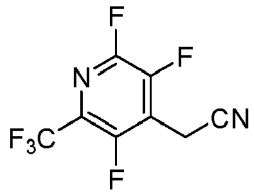 | 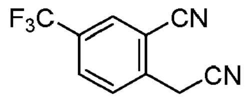 | 451 | 447 | 43.57 | -5.38 |
| A34 | 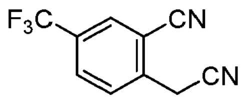 | 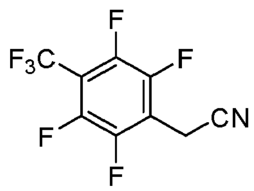 | 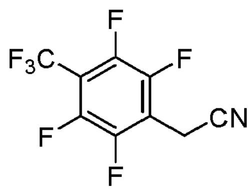 | 453 | 475 | 45.84 | -4.82 |
| A35 | 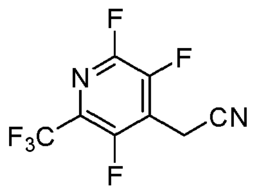 | 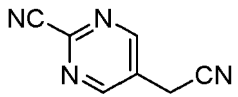 | 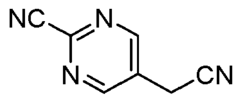 | 453 | 453 | 48,05 | -5.30 |
| A36 | 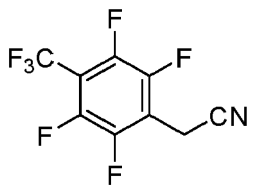 | 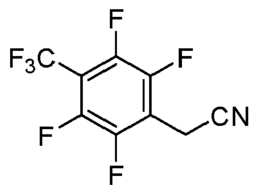 | 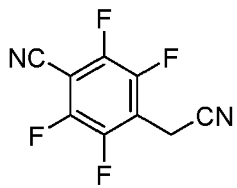 | 454 | 469 | 45.16 | -5.00 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A37 | 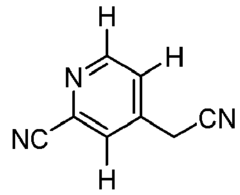 | 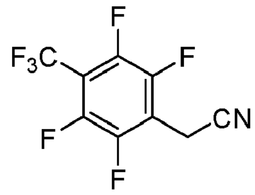 | 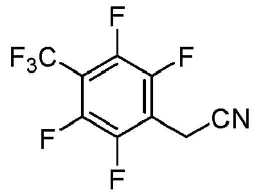 | 454 | 466 | 47.05 | -5.00 |
| A38 | 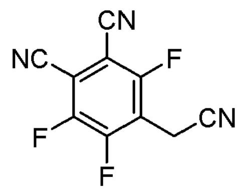 | 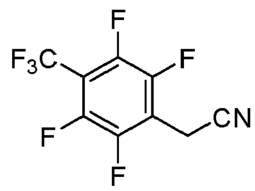 | 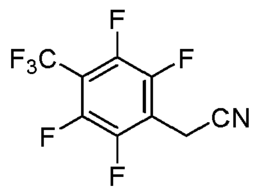 | 454 | 475 | 49.05 | -5.12 |
| A39 | 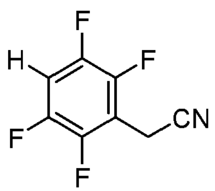 | 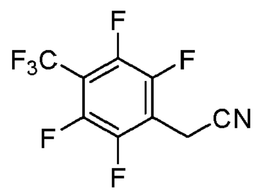 | 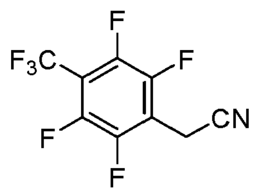 | 454 | 453 | 42.44 | -4.75 |
| A40 | 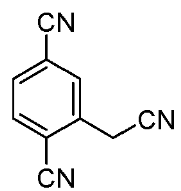 | 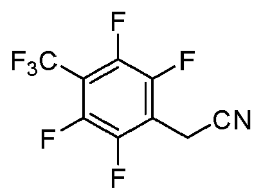 | 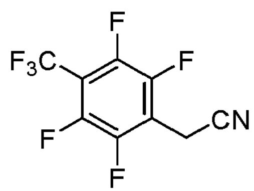 | 455 | 463 | 43.79 | -4.93 |
| A41 | 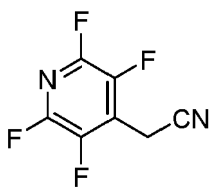 | 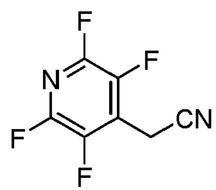 | 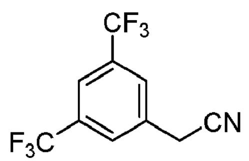 | 456 | 456 | 44.17 | -4.93 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A42 | 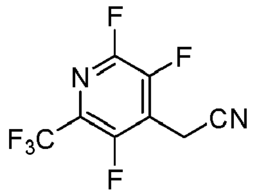 | 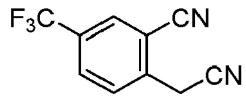 | 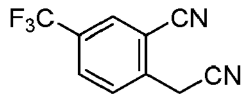 | 456 | 466 | 43.40 | -4.91 |
| A43 | 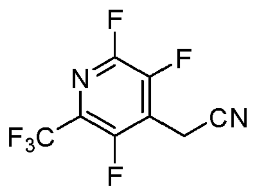 | 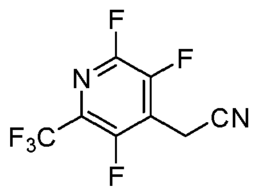 | 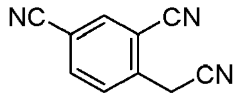 | 456 | 472 | 44.34 | -5.16 |
| A44 | 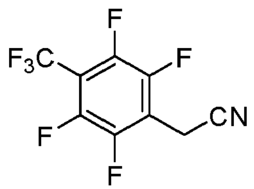 | 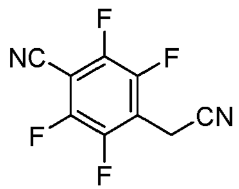 | 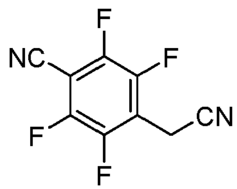 | 457 | 479 | 47.13 | -5.10 |
| A45 | 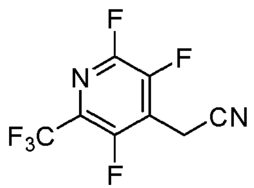 | 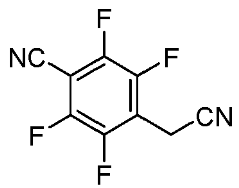 | 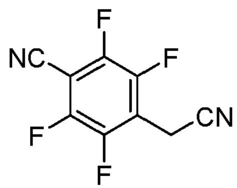 | 457 | 485 | 48.37 | -5.23 |
| A46 | 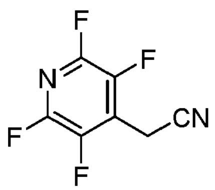 | 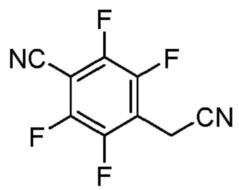 | 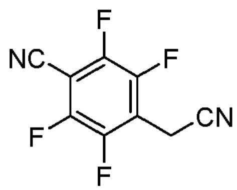 | 457 | 479 | 47.51 | -5.16 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A47 | 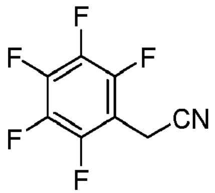 | 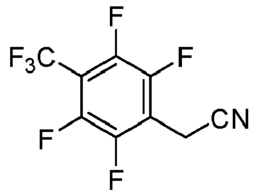 | 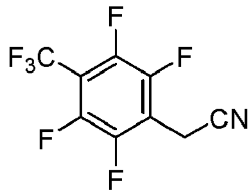 | 457 | 472 | 44.53 | -4.79 |
| A48 | 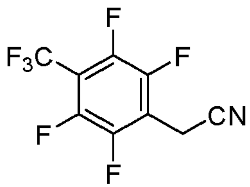 | 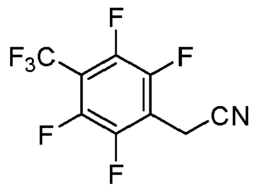 | 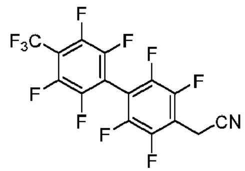 | 458 | 479 | 50.75 | -4.85 |
| A49 | 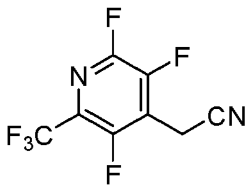 | 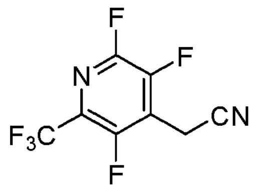 | 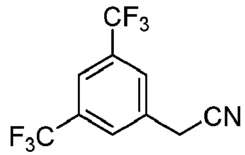 | 458 | 479 | 46.77 | -5.07 |
| A50 | 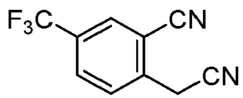 | 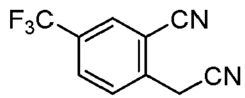 | 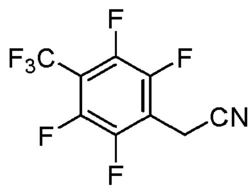 | 458 | 479 | 44.92 | -4.73 |
| A51 | 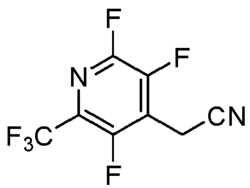 | 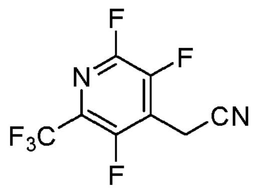 | 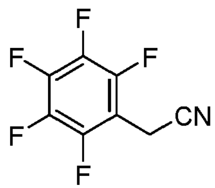 | 458 | 491 | 42.93 | -5.04 |

(continued)

| | $A^1$ | $A^2$ | $A^3$ | λabs(max) of organic p-dopant in solution | λabs(max) 300-650 nm TDDFT of organic p-dopant | Absorption Area 400-650 nm TDDFT [a.u. x nm] of organic p-dopant | LUMO DFT [eV] |
|---|---|---|---|---|---|---|---|
| A52 | 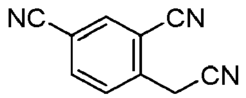 | 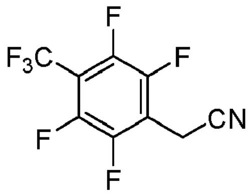 | 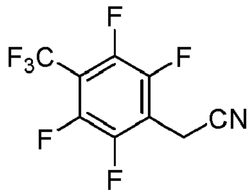 | 459 | 475 | 45,68 | -4.92 |
| A53 | 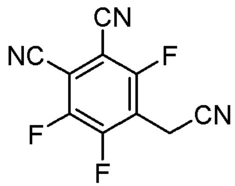 | 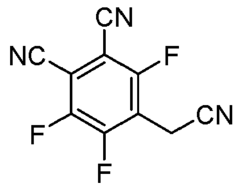 | 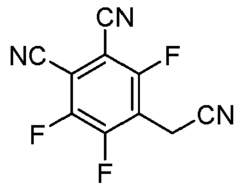 | 459 | 479 | 51.36 | -5.51 |
| A54 | 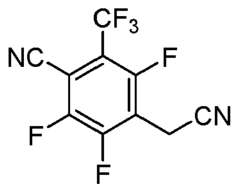 | 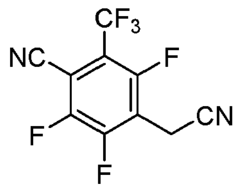 | 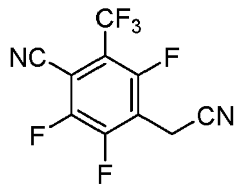 | 459 | 491 | 51.09 | -5.32 |

The compounds in particular the inventive compounds exhibits a low absorption in the range of 300 to 650 nm.

Thus, the compounds may be beneficial for providing an organic electronic device or a display device with increased brightness of a display or when a lower current density is used, the lifetime of the display can be increased.

**Table 2: Optical absorptance of p-type charge generation layer (solid film)**

| | p-Dopant* | λabs (max) of organic p-dopant in solution | Absorption Area 300-650 nm TDDFT [a.u. x nm] of organic p-dopant | Cone. (vol%) | Abs. Integral visible 380-780nm [a.u. x nm] of solid film | Abs. Integral blue 450-500nm [a.u. x nm] of solid film | Abs. Integral green 500-600nm [a.u. x nm] of solid film |
|---|---|---|---|---|---|---|---|
| Comp. 1 | Comparative | 475 | 54.84245 | 10 | 3509 | 604 | 818 |
| Inv. 1 | A9 | 435 | 39.05 | 10 | 3283 | 486 | 594 |
| Inv. 2 | A12 | 436 | 42.66625 | 10 | 3418 | 524 | 592 |
| Inv. 3 | A32 | 451 | 42.43 | 10 | 3258 | 522 | 648 |
| Inv. 4 | A1 | 448 | 41.69 | 10 | 3433 | 436 | 769 |
| Inv. 5 | A25 | 441 | 44.65 | 10 | 3103 | 459 | 603 |

It can be seen from Table 2 that a layer containing a radialene having a λabs(max) below 459 nm and an organic hole transport compound exhibits a lower absorption of visible light in particular of the green and blue part of the visible light.

This may be beneficial for increasing the brightness of a display or when a lower current density is used, the lifetime of the display can be increased.

**Table 3: Performance of the OLED containing the inventive charge generation layer**

| | Org. p-dopant | λabs (max) of organic p-dopant in solution | λabs(max) 300-650 nm TDDFT [a.u. x nm] of organic p-dopant | Absorption Area [a.u. x nm] calculated by TDDFT of organic p-dopant | Voltage at 15 $mA/cm^2$ [V] | EQE at 15 $mA/cm^2$ [%] | Ceff at 15 $mA/cm^2$ [cd/A] | luminous flux at 10 $mA/cm^2$ [lm] | relative luminous flux at 10 $mA/cm^2$ [%] |
|---|---|---|---|---|---|---|---|---|---|
| Comp. Ex. 2 | Comparative | 475 | 507 | 54.84 | 7.32 | 13.25 | 130.3 | 0,0194 | 100% |
| Ex. 1 | A25 | 441 | 463 | 44.65 | 7.30 | 13.92 | 135.8 | 0,0218 | 112% |
| Ex. 2 | A12 | 436 | 444 | 42.67 | 7.34 | 13.46 | 130.7 | 0,0211 | 109% |

According to Table 3, a higher luminous flux for the charge generation layer according to the invention could be measured.

This may be beneficial for increasing the brightness of a display or when a lower current density is used, the lifetime of the display can be increased.

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

**Claims**

**1.** A charge generation layer comprising a first charge generation layer and a second charge generation layer, wherein the first charge generation layer comprises a compound of formula (I)

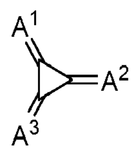

(I),

wherein in formula (I)

- $A^1$ is independently selected from a group of formula (II)

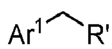

(II),

wherein $Ar^1$ is independently selected from substituted or unsubstituted $C_6$ to $C_{36}$ aryl and substituted or unsubstituted $C_2$ to $C_{36}$ heteroaryl;
wherein for the case that $Ar^1$ is substituted, one or more of the substituents are independently selected from the group consisting of an electron-withdrawing group, F, CN, partially fluorinated alkyl, perfluorinated alkyl, and $-NO_2$;
- $A^2$ and $A^3$ are independently selected from a group of formula (III)

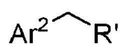

(III),

wherein $Ar^2$ is independently selected from substituted or unsubstituted $C_6$ to $C_{36}$ aryl and substituted or unsubstituted $C_2$ to $C_{36}$ heteroaryl;
wherein for the case that $Ar^2$ is substituted, one or more of the substituents are independently selected from the group consisting of an electron-withdrawing group, F, CN, partially fluorinated alkyl, perfluorinated alkyl, and $-NO_2$;
- and wherein each R' is independently selected from substituted or unsubstituted $C_6$ to $C_{18}$ aryl, $C_3$ to $C_{18}$ heteroaryl, electron-withdrawing group, partially fluorinated $C_1$ to $C_8$ alkyl, perfluorinated $C_1$ to $C_8$ alkyl, halogen, F or CN;

wherein the compound of formula (I) has an absorption maximum $\lambda_{max}$ at ≤ 459 nm when measured in DCM at a concentration of $10^{-5}$ to $10^{-4}$ mol/L at 20 °C, an absorption maximum $\lambda_{max}$ at ≤ 494 nm when calculated with the program package TURBOMOLE V6.5 (TURBOMOLE GmbH, Litzenhardtstrasse 19, 76135 Karlsruhe, Germany) by TDDFT using the hybrid functional PBE0 with a def2-SVP basis set in the gas phase and including the first 30 singlet transitions from optimized geometry using the hybrid functional B3LYP with a 6-31G* basis set in the gas phase,

and/or an integral of ≤ 50 a.u. × nm in an UV-Vis Spectrum in the range of 400 to 650 nm, when calculated with the program package TURBOMOLE V6.5 (TURBOMOLE GmbH, Litzenhardtstrasse 19, 76135 Karlsruhe, Germany) by TDDFT using the hybrid functional PBE0 with a def2-SVP basis set in the gas phase and including the first 30 singlet transitions from optimized geometry using the hybrid functional B3LYP with a 6-31G* basis set in the gas phase;
wherein the first charge generation layer comprises an organic hole transport compound and wherein the second charge generation layer comprises an organic electron transport compound and a metal dopant.

**2.** Charge generation layer according to claim 1, wherein the charge generation layer is not a charge generation layer selected from the group consisting of:

a) a charge generation layer, wherein the first charge generation layer comprises 10.1 vol% of a compound of formula (I) wherein $A^1$, $A^2$ and $A^3$ are selected according to the following:

$A^1$

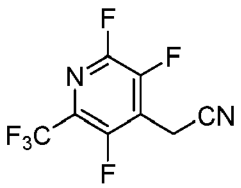

$A^2$

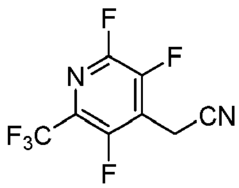

$A^3$

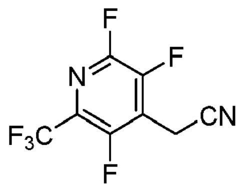

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm, and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;
b) a charge generation layer, wherein the first charge generation layer comprises 9.8 vol% of a compound of formula (I) wherein $A^1$, $A^2$ and $A^3$ are selected according to the following:

$A^1$

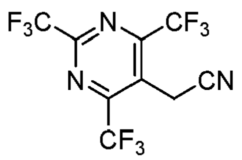

$A^2$

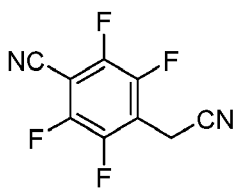

$A^3$

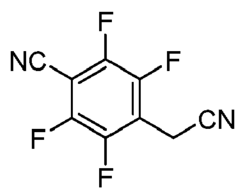

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm, and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;
c) a charge generation layer, wherein the first charge generation layer comprises 12 vol% of a compound of formula (I) wherein $A^1$, $A^2$ and $A^3$ are selected according to the following:

$A^1$ 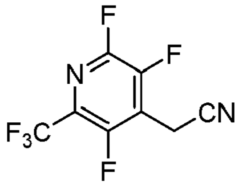 $A^2$ 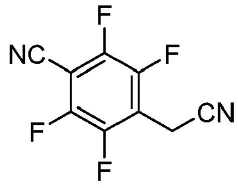 $A^3$ 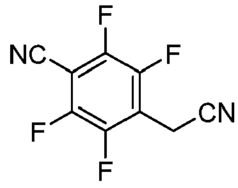

and N-([1,1'-biphenyl]-2-yl)-N-(9,9-dimethyl-9H-fluoren-2-yl)-9,9-diphenyl-9H-fluoren-2-amine, wherein the first charge generation layer has a thickness of 86 nm, and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

d) a charge generation layer, wherein the first charge generation layer comprises 9.6 vol% of a compound of formula (I) wherein $A^1$, $A^2$ and $A^3$ are selected according to the following:

$A^1$ 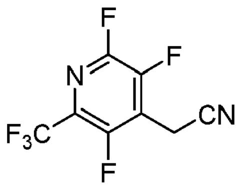 $A^2$ 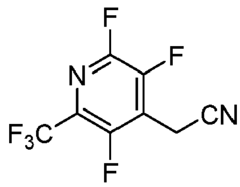 $A^3$ 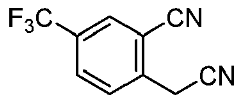

and N-([1,1'-biphenyl]-2-yl)-N-(9,9-dimethyl-9H-fluoren-2-yl)-9,9'-spirobi[fluoren]-2-amine, wherein the first charge generation layer has a thickness of 81 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

e) a charge generation layer, wherein the first charge generation layer comprises 10.1 vol% of a compound of formula (I) wherein $A^1$, $A^2$ and $A^3$ are selected according to the following:

$A^1$ 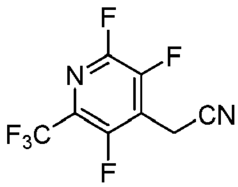 $A^2$ 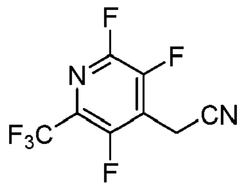 $A^3$ 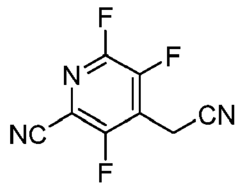

and N-([1,1'-biphenyl]-2-yl)-N-(9,9-dimethyl-9H-fluoren-2-yl)-9,9'-spirobi[fluoren]-2-amine, wherein the first charge generation layer has a thickness of 81 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

f) a charge generation layer, wherein the first charge generation layer comprises 9.9 vol% of a compound of formula (I) wherein $A^1$, $A^2$ and $A^3$ are selected according to the following:

$A^1$ 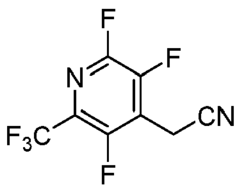 $A^2$ 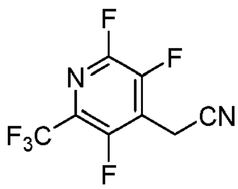 $A^3$ 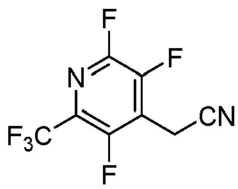

and N-([1,1'-biphenyl]-2-yl)-N-(9,9-dimethyl-9H-fluoren-2-yl)-9,9'-spirobi[fluoren]-2-amine, wherein the first

charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;
g) a charge generation layer, wherein the first charge generation layer comprises 10.8 vol% of a compound of formula (I) wherein $A^1$, $A^2$ and $A^3$ are selected according to the following:

$A^1$
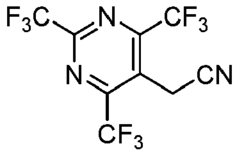
$A^2$
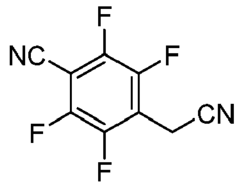
$A^3$
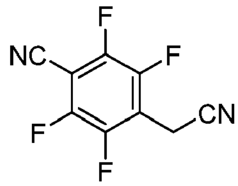

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;
h) a charge generation layer, wherein the first charge generation layer comprises 11.8 vol% of a compound of formula (I) wherein $A^1$, $A^2$ and $A^3$ are selected according to the following:

$A^1$
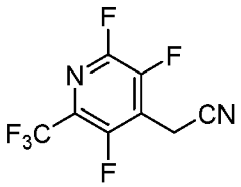
$A^2$
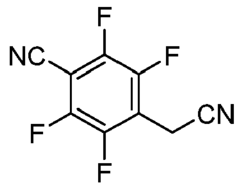
$A^3$
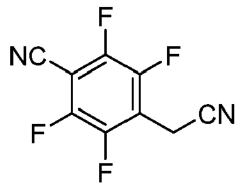

and N-([1,1'-biphenyl]-2-yl)-N-(9,9-dimethyl-9H-fluoren-2-yl)-9,9'-spirobi[fluoren]-2-amine, wherein the first charge generation layer has a thickness of 86 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;
i) a charge generation layer, wherein the first charge generation layer comprises 9.9 vol% of a compound of formula (I) wherein $A^1$, $A^2$ and $A^3$ are selected according to the following:

$A^1$
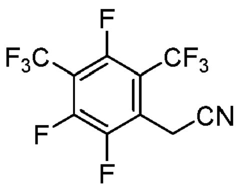
$A^2$
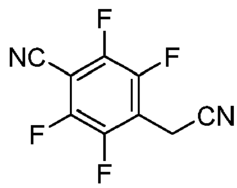
$A^3$
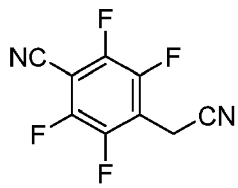

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;
j) a charge generation layer, wherein the first charge generation layer comprises 10.3 vol% of a compound of formula (I) wherein $A^1$, $A^2$ and $A^3$ are selected according to the following:

$A^1$ 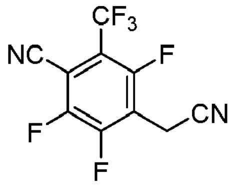 $A^2$ 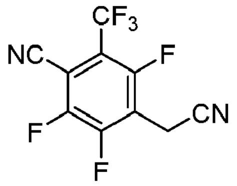 $A^3$ 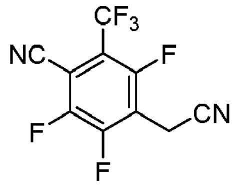

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

k) a charge generation layer, wherein the first charge generation layer comprises 10.3 vol% of a compound of formula (I) wherein $A^1$, $A^2$ and $A^3$ are selected according to the following:

$A^1$ 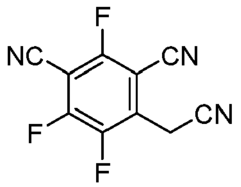 $A^2$ 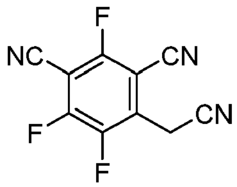 $A^3$ 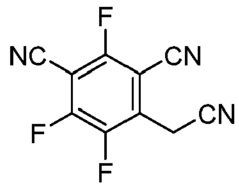

and N-([1,1'-biphenyl]-4-yl)-9,9-dimethyl-N-(4-(9-phenyl-9H-carbazol-3-yl)phenyl)-9H-fluoren-2-amine, wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

l) a charge generation layer, wherein the first charge generation layer comprises 5 vol% of a compound of formula (I) wherein $A^1$, $A^2$ and $A^3$ are selected according to the following:

$A^1$ 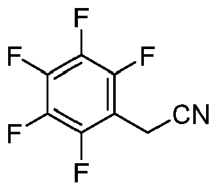 $A^2$ 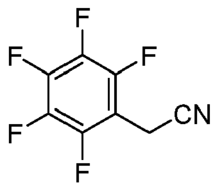 $A^3$ 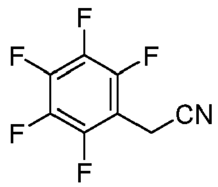

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;

m) a charge generation layer, wherein the first charge generation layer comprises 5 vol% of a compound of formula (I) wherein $A^1$, $A^2$ and $A^3$ are selected according to the following:

$A^1$ 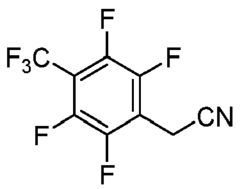 $A^2$ 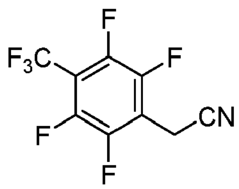 $A^3$ 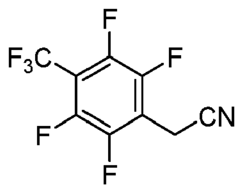

and N-([1,1'-biphenyl]-2-yl)-N-(9,9-dimethyl-9H-fluoren-2-yl)-9,9'-spirobi[fluoren]-4-amine, wherein the first

charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;
n) a charge generation layer, wherein the first charge generation layer comprises 5 vol% or 10 vol% of a compound of formula (I) wherein $A^1$, $A^2$ and $A^3$ are selected according to the following:

$A^1$

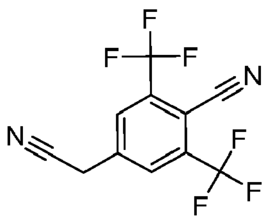

$A^2$

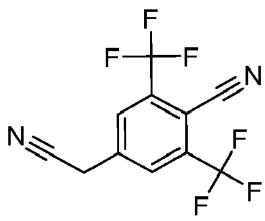

$A^3$

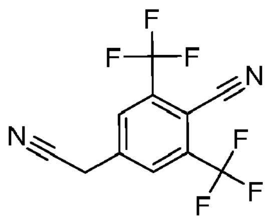

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;
o) a charge generation layer, wherein the first charge generation layer comprises 5 vol% or 10 vol% of a compound of formula (I) wherein $A^1$, $A^2$ and $A^3$ are selected according to the following:

$A^1$

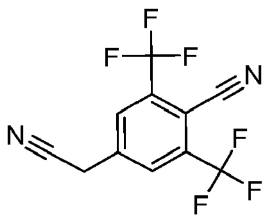

$A^2$

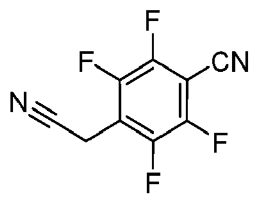

$A^3$

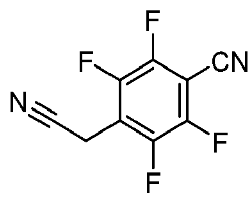

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;
p) a charge generation layer, wherein the first charge generation layer comprises 10 vol% of a compound of formula (I) wherein $A^1$, $A^2$ and $A^3$ are selected according to the following:

$A^1$

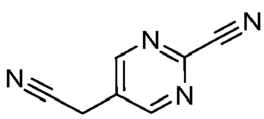

$A^2$

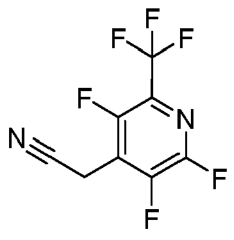

$A^3$

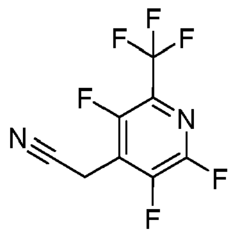

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;
q) a charge generation layer, wherein the first charge generation layer comprises 10 vol% of a compound of formula (I) wherein $A^1$, $A^2$ and $A^3$ are selected according to the following:

A1 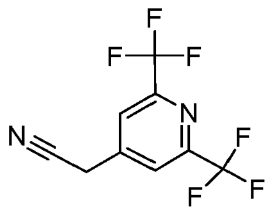 A2 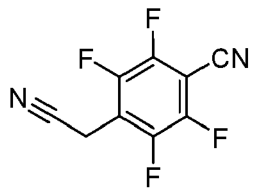 A3 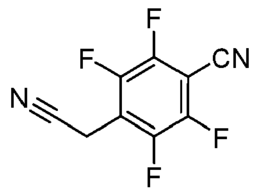

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;
r) a charge generation layer, wherein the first charge generation layer comprises 10 vol% of a compound of formula (I) wherein $A^1$, $A^2$ and $A^3$ are selected according to the following:

A1 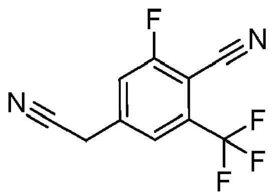 A2 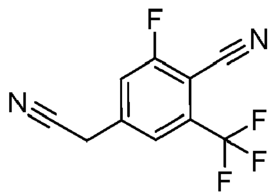 A3 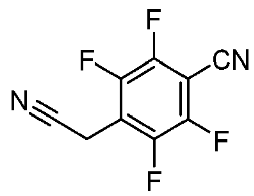

and N-([1,1'-biphenyl]-2-yl)-N-(9,9-dimethyl-9H-fluoren-2-yl)-9,9'-spirobi[fluoren]-4-amine, wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% or 3 vol.-% Li, wherein the second charge generation layer has a thickness of 10 nm;
s) a charge generation layer, wherein the first charge generation layer comprises 10 wt% of a compound of formula (I) wherein $A^1$, $A^2$ and $A^3$ are selected according to the following:

A1 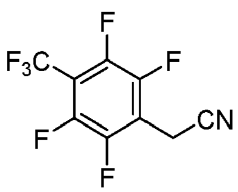 A2 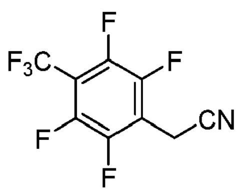 A3 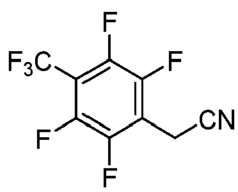

wherein the first charge generation layer has a thickness of 10 nm,
and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;
t) a charge generation layer, wherein the first charge generation layer comprises 10 wt% of a compound of formula (I) wherein $A^1$, $A^2$ and $A^3$ are selected according to the following:

A1 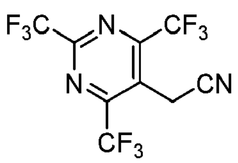 A2 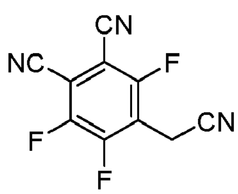 A3 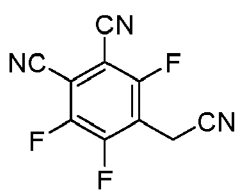

wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

u) a charge generation layer, wherein the first charge generation layer comprises 10 wt% of a compound of formula (I) wherein $A^1$, $A^2$ and $A^3$ are selected according to the following:

$A^1$

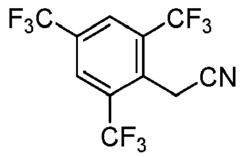

$A^2$

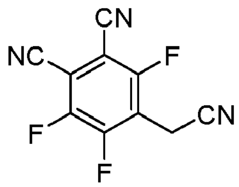

$A^3$

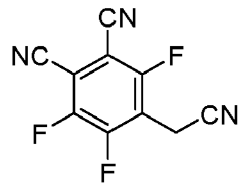

wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 10 nm;

v) a charge generation layer, wherein the first charge generation layer comprises 10 vol% or 10 wt% of a compound of formula (I) wherein $A^1$, $A^2$ and $A^3$ are selected according to the following:

$A^1$

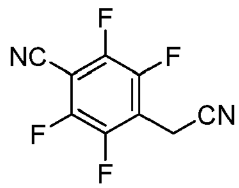

$A^2$

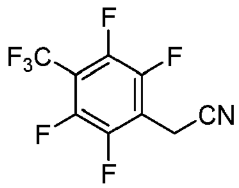

$A^3$

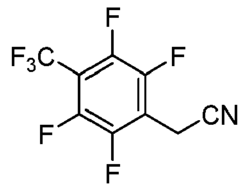

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 15 nm;

w) a charge generation layer, wherein the first charge generation layer comprises 10 vol% or 10 wt% of a compound of formula (I) wherein $A^1$, $A^2$ and $A^3$ are selected according to the following:

$A^1$

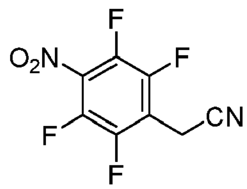

$A^2$

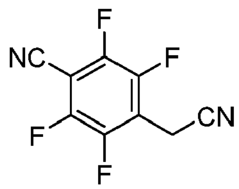

$A^3$

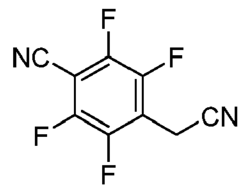

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 15 nm; and

x) a charge generation layer, wherein the first charge generation layer comprises 10 vol% or 10 wt% of a compound of formula (I) wherein $A^1$, $A^2$ and $A^3$ are selected according to the following:

$A^1$ $A^2$ $A^3$

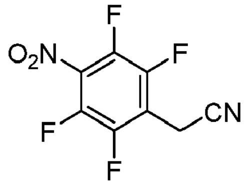 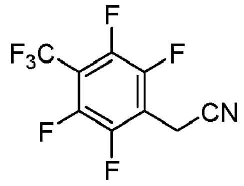 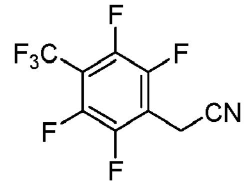

and N-([1,1'-biphenyl]-2-yl)-N-(9.9-dimethyl-9H-fluoren-2-yl)-9,9'spirobi[fluoren]-2-amine, wherein the first charge generation layer has a thickness of 10 nm,

and the second charge generation layer contains 99 vol.-% 2,2'-(1,3-Phenylene)bis[9-phenyl-1,10-phenanthroline] and 1 vol.-% Li, wherein the second charge generation layer has a thickness of 15 nm.

**3.** Charge generation layer according to any one of the claims 1 or 2, wherein the organic electron transport compound comprises 15 covalently bound atoms.

**4.** Charge generation layer according to any one of claims 1 to 3, wherein the metal dopant is Yb or a metal alloy comprising a metal selected from the group consisting of Li and Yb.

**5.** Charge generation layer according to any one of claims 1 to 4, wherein the organic electron transport compound has a LUMO when calculated by DFT using B3LYP/6-31G* of < -1.75 eV.

**6.** Charge generation layer according to any one of claims 1 to 5, wherein the compound of formula (I) has an absorption maximum $\lambda_{max}$ at ≤ 455 nm when measured in DCM at a concentration of $10^{-5}$ to $10^{-4}$ mol/L at 20 °C, preferably ≤ 450 nm, more preferably ≤ 445, more preferably ≤ 441 nm, and most preferably ≤ 440 nm.

**7.** Charge generation layer according to any one of claims 1 to 5, wherein the compound of formula (I) has an absorption maximum $\lambda_{max}$ at ≤ 475 nm, preferably at ≤ 455 nm.

**8.** Charge generation layer according to any one of claims 1 to 7, wherein the compound of formula (I) has a LUMO expressed in the absolute scale referring to vacuum energy level being zero when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase in the range from ≥ -5.7 eV to ≤ -4.7 eV, preferably ≥ -5.6 eV to ≤ -4.7 eV, more preferably ≥ -5.55 eV to ≤ -4.75 eV, more preferably ≥ -5.50 eV to ≤ -4.80 eV, and most preferably ≥- 5.45 eV to ≤ -4.85 eV.

**9.** Organic electronic device comprising a charge generation according to any one of claims 1 to 8.

**10.** Organic electronic device comprising at least two vertically stacked electroluminescent units and a charge generation layer according to any one of claims 1 to 8, wherein each electroluminescent unit comprises at least one light-emitting layer.

**11.** Organic electronic device according to claim 9 or 10, comprising at least three or at least four vertically stacked electroluminescent units, wherein each electroluminescent unit comprises at least one light-emitting layer.

**12.** Display device comprising a plurality of organic electronic devices according to any one of claim 9 to 11.

**13.** Display device according to claim 12, wherein at least two of the plurality of the organic electronic devices share as charge generation layer a common charge generation layer, wherein the common charge generation layer is a charge generation layer according to any one of claims 1 to 7.

**14.** A compound according to formula (XI)

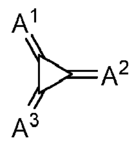

(XI),

wherein in formula (XI) $A^1$ is selected from a group of formula (XIIa)

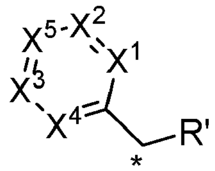

(XIIa),

wherein

$X^1$ is selected from $CR^1$ or N;
$X^2$ is selected from $CR^2$ or N;
$X^3$ is selected from $CR^3$ or N;
$X^4$ is selected from $CR^4$;
$X^5$ is selected from $CR^5$ or N;
$R^1$ (if present) is selected from electron-withdrawing group, CN, partially fluorinated or perfluorinated $C_1$ to $C_8$ alkyl, $-NO_2$, halogen, Cl, F, D or H,
$R^2$, $R^3$ and $R^5$ (if present) are independently selected from electron-withdrawing group, CN, partially fluorinated or perfluorinated $C_1$ to $C_8$ alkyl, $-NO_2$, halogen, Cl, F, D or H,
$R^4$ is selected from CN, and partially fluorinated or perfluorinated $C_1$ to $C_8$ alkyl,
whereby when any of $R^1$, $R^2$, $R^3$ and $R^5$ is present, then the corresponding $X^1$, $X^2$, $X^3$, and $X^5$ is not N;

and wherein in formula (XI) $A^2$ and $A^3$ are independently selected from formula (XIII)

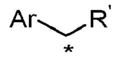

(XIII)

wherein Ar is independently selected from substituted or unsubstituted $C_6$ to $C_{18}$ aryl and substituted or unsubstituted $C_2$ to $C_{18}$ heteroaryl, wherein the substituents on Ar are independently selected from electron-withdrawing group, CN, partially or perfluorinated $C_1$ to $C_6$ alkyl, halogen, $-NO_2$, Cl, F, D;
and R' is selected from substituted or unsubstituted $C_6$ to $C_{18}$ aryl or $C_3$ to $C_{18}$ heteroaryl, partially fluorinated or perfluorinated $C_1$ to $C_8$ alkyl, halogen, F or CN.

**15.** Compound according to claim 14, wherein compound of formula (XI) is selected from a compound of formula (XI)

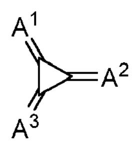

(XI)

whereby $A^1$ is selected from formula (XIIb)

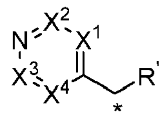

(XIIb)

wherein

$X^1$ is selected from $CR^1$ or N;
$X^2$ is selected from $CR^2$ or N;
$X^3$ is selected from $CR^3$ or N;
$X^4$ is selected from $CR^4$;
$R^1$ (if present) is selected from electron-withdrawing group, CN, partially fluorinated or perfluorinated $C_1$ to $C_8$ alkyl, $-NO_2$, halogen, Cl, F, D or H,
$R^2$, and $R^3$ (if present) are independently selected from electron-withdrawing group, CN, partially fluorinated or perfluorinated $C_1$ to $C_8$ alkyl, $-NO_2$, halogen, Cl, F, D or H,
$R^4$ is selected from CN, and partially fluorinated or perfluorinated $C_1$ to $C_8$ alkyl,
whereby when any of $R^1$, $R^2$, and $R^3$ and is present, then the corresponding $X^1$, $X^2$, and $X^3$ is not N;
with the proviso that when $R^1$ and $R^4$ are present and only $R^1$ or $R^4$ is selected from CN, then $R^2$, $R^3$ and the remaining $R^1$ or $R^4$ are independently selected from CN, and partially fluorinated or perfluorinated $C_1$ to $C_8$ alkyl, D, or $R^2$ and $R^3$ are selected from CN, partially fluorinated or perfluorinated $C_2$ to $C_8$ alkyl, halogen, Cl, F. D, or H, or $R^2$, $R^3$ and the remaining $R^1$ or $R^4$ are independently selected from CN, partially fluorinated or perfluorinated $C_1$ to $C_8$ alkyl, halogen, Cl, F, D;
or with the proviso that when $R^1$ and $R^4$ are present and only $R^1$ or $R^4$ is selected from perfluorinated $C_1$, then $R^2$ and $R^3$ are independently selected from partially fluorinated or perfluorinated $C_2$ to $C_8$ alkyl, halogen, Cl, F, D, or H; or $R^2$, $R^3$ and the remaining $R^1$ or $R^4$ is selected from CN, partially fluorinated or perfluorinated $C_1$ to $C_8$ alkyl, halogen, Cl, F, D;
or with the proviso that when $X^1$ is N and $R^4$ is selected from CN then $R^2$, $R^3$, are selected from (if present) H or D, or $R^2$ and $R^3$ are independently selected from CN, partially fluorinated or perfluorinated $C_1$ to $C_8$ alkyl, halogen, Cl, F, D, but $R^2$ and $R^3$ cannot be both CN, or $R^2$ is selected from partially fluorinated or perfluorinated $C_2$ to $C_8$ alkyl, halogen, Cl, F, D or H;
or with the proviso that when $X^1$ is N and $R^4$ is selected from perfluorinated $C_1$ alkyl, then $R^2$ is selected from partially fluorinated or perfluorinated $C_2$ to $C_8$ alkyl, halogen, Cl, F, D or $R^3$ is selected from CN, partially fluorinated or perfluorinated $C_1$ to $C_8$ alkyl, halogen, Cl, F, D, or $R^2$ and $R^3$, are independently selected from CN, partially fluorinated or perfluorinated $C_1$ to $C_8$ alkyl, halogen, Cl, F, D, or $R^2$ and $R^3$ are independently selected from (if present) H or D;
and wherein in formula (XI) $A^2$ and $A^3$ are independently selected from formula (XIII)

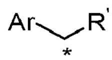

(XIII)

wherein Ar is independently selected from substituted or unsubstituted $C_6$ to $C_{18}$ aryl and substituted or unsubstituted $C_2$ to $C_{18}$ heteroaryl, wherein the substituents on Ar are independently selected from CN, partially or perfluorinated $C_1$ to $C_6$ alkyl, halogen, Cl, F, D; and
R' is selected from substituted or unsubstituted $C_6$ to $C_{18}$ aryl or $C_3$ to $C_{18}$ heteroaryl, partially fluorinated or perfluorinated $C_1$ to $C_8$ alkyl, halogen, F or CN.

**16.** Compound according to claim 14, wherein $A^1$ in the compound according to formula (XI) is selected from one of the following formulae:

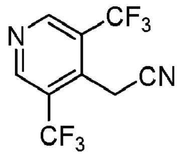 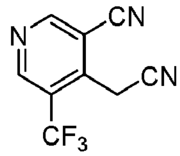 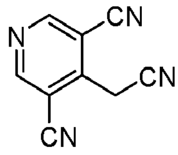 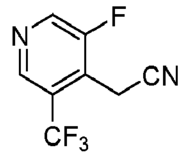

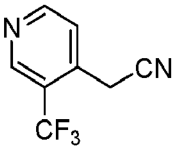 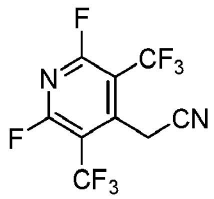 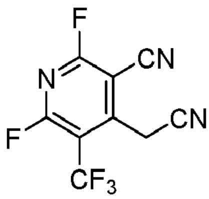 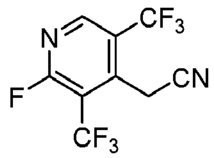

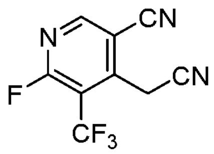 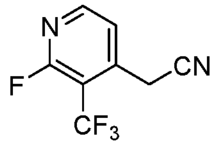 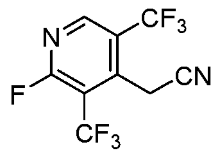 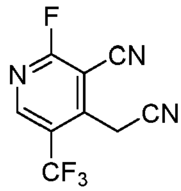

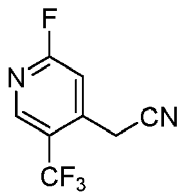 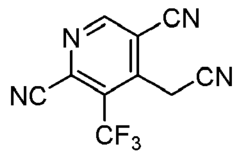 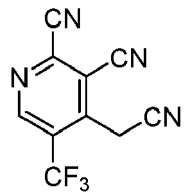 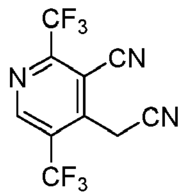

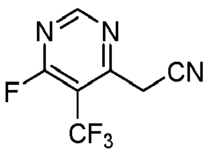 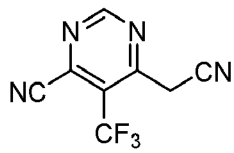 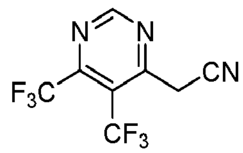 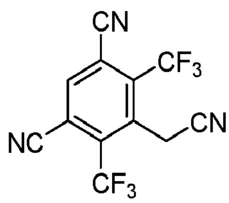

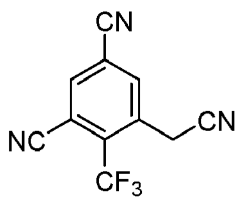 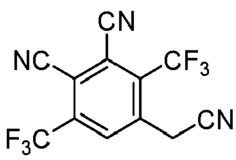 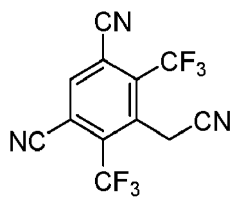 .

**17.** Compound according to any one of claims 15 or 16, wherein $A^2$ and $A^3$ in the compound according to formula (XI) are independently selected from one of the following formulae:

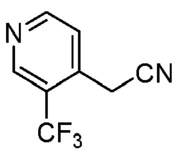 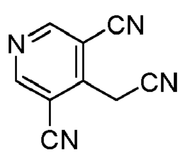 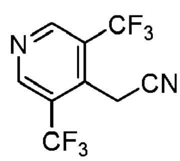 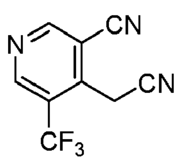

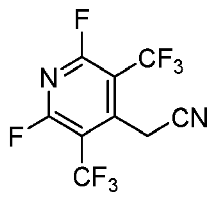
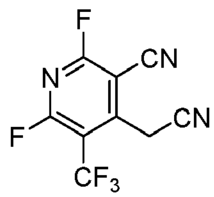
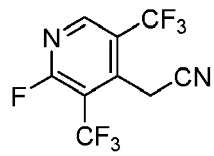
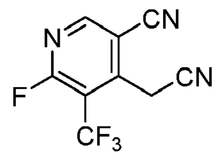

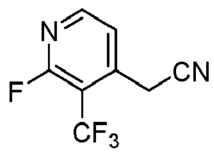
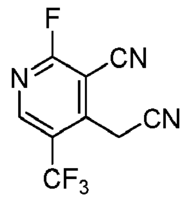
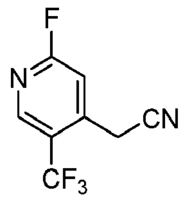
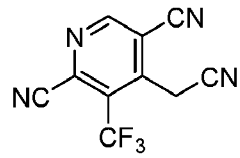

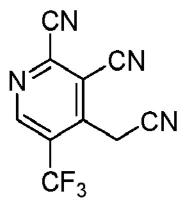
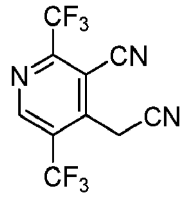
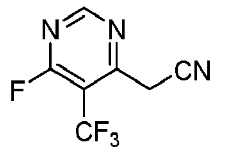
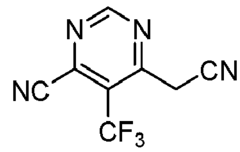

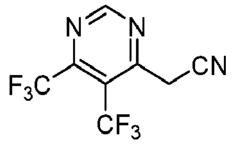
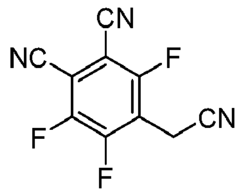
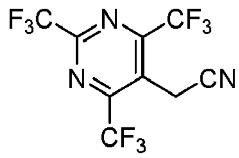
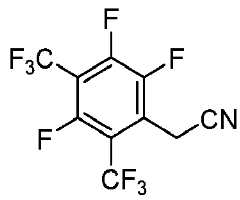

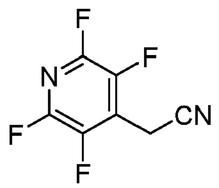
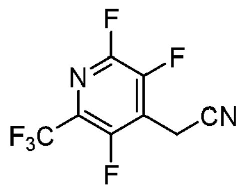
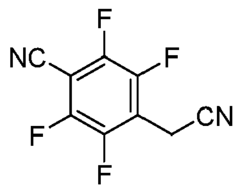
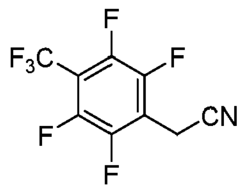

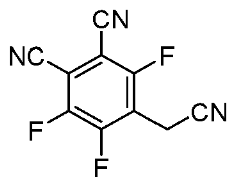
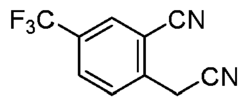
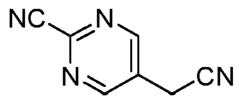
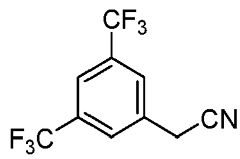

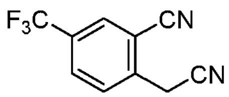
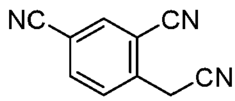
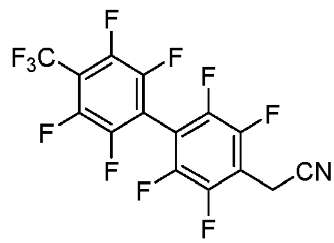

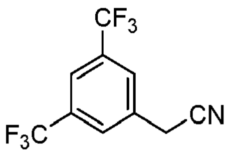
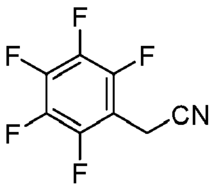
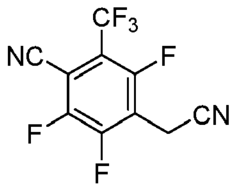
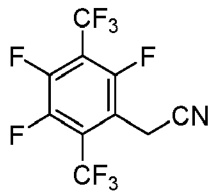

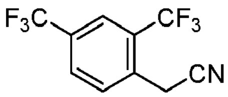
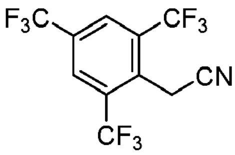
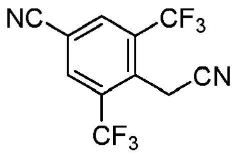
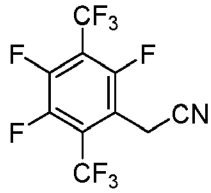

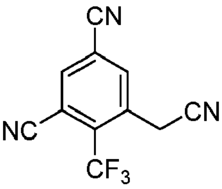
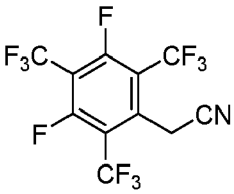
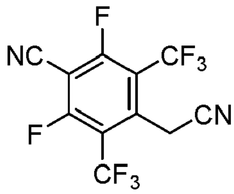
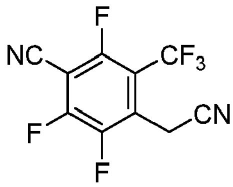

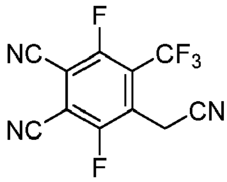
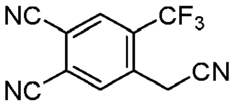
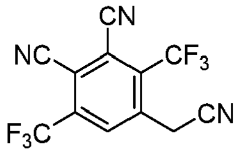
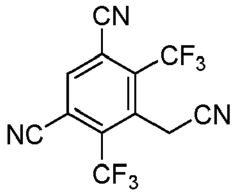

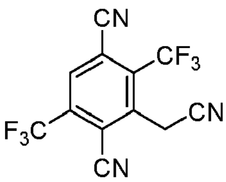
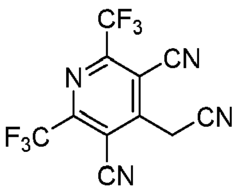
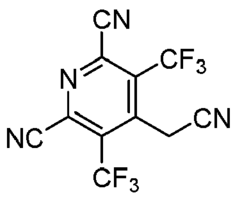
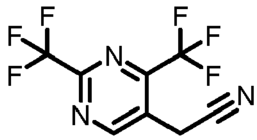

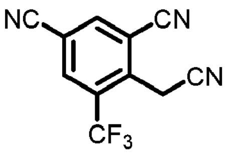
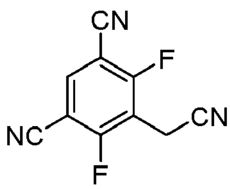
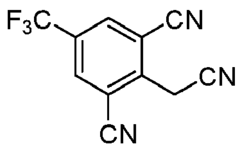
.

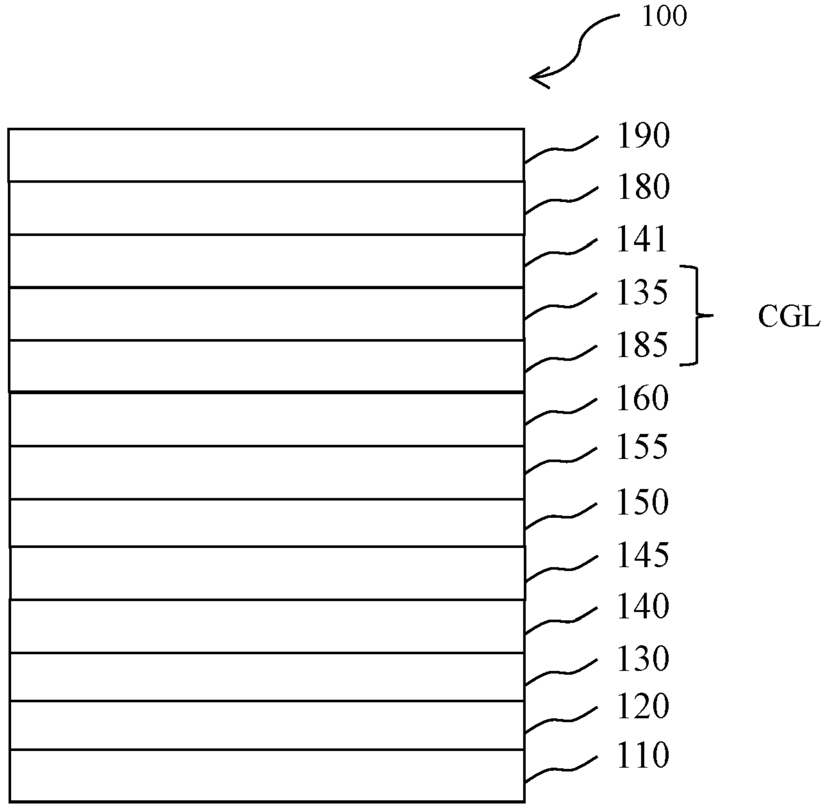


Fig. 1

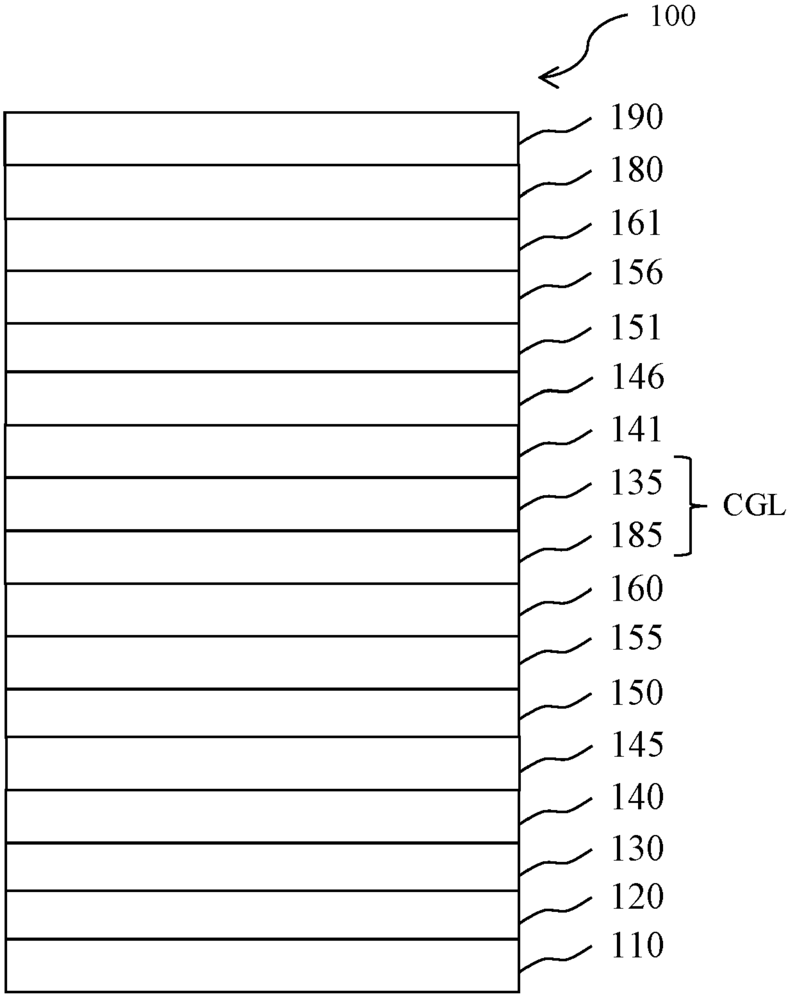
100
190
180
161
156
151
146
141
135
185
CGL
160
155
150
145
140
130
120
110

**Fig. 2**

Europäisches Patentamt
European Patent Office
Office européen des brevets

# EUROPEAN SEARCH REPORT

Application Number
EP 21 21 5929

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 3 799 143 A1 (NOVALED GMBH [DE]) 31 March 2021 (2021-03-31) * examples 5-10; table 4; compound A2 * | 1-13 | INV. H01L51/54 |
| X<br>Y | EP 3 034 489 A1 (NOVALED GMBH [DE]) 22 June 2016 (2016-06-22) * paragraphs [0025] - [0029], [0064]; table 1; compounds A1-A3,B1 * | 14-17<br>1-13 | |
| X | EP 3 382 770 A1 (NOVALED GMBH [DE]) 3 October 2018 (2018-10-03) * page 12; compound P18 * | 14 | |
| X | CN 109 081 791 A (AAC TECH NANJING INC) 25 December 2018 (2018-12-25) * pages 30-32; compounds P-3-P-5, P-7-P-9, P-19-P-23, P29, P-30 * | 14 | |
| A | CN 109 485 576 A (CHANGCHUN HAIPURUNSI TECH CO LTD) 19 March 2019 (2019-03-19) * compounds 43,44 * | 14-17 | |

| TECHNICAL FIELDS SEARCHED (IPC) |
|---|
| H01L |

The present search report has been drawn up for all claims

2

| Place of search | Date of completion of the search | Examiner |
|---|---|---|
| The Hague | 3 June 2022 | Fratiloiu, Silvia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 21 5929

This annex lists the patent family members relating to the patent documents cited in the above-mentioned European search report. The members are as contained in the European Patent Office EDP file on
The European Patent Office is in no way liable for these particulars which are merely given for the purpose of information.

03-06-2022

| Patent document cited in search report | Publication date | Patent family member(s) | Publication date |
|---|---|---|---|
| EP 3799143 A1 | 31-03-2021 | CN 114503297 A | 13-05-2022 |
| | | EP 3799143 A1 | 31-03-2021 |
| | | WO 2021058761 A1 | 01-04-2021 |
| EP 3034489 A1 | 22-06-2016 | CN 107207420 A | 26-09-2017 |
| | | EP 3034489 A1 | 22-06-2016 |
| | | EP 3233787 A1 | 25-10-2017 |
| | | JP 6649952 B2 | 19-02-2020 |
| | | JP 2018506137 A | 01-03-2018 |
| | | KR 20170097707 A | 28-08-2017 |
| | | TW 201638366 A | 01-11-2016 |
| | | US 2017373251 A1 | 28-12-2017 |
| | | WO 2016097017 A1 | 23-06-2016 |
| EP 3382770 A1 | 03-10-2018 | CN 110612614 A | 24-12-2019 |
| | | EP 3382770 A1 | 03-10-2018 |
| | | JP 2020519002 A | 25-06-2020 |
| | | KR 20190134687 A | 04-12-2019 |
| | | US 2020032093 A1 | 30-01-2020 |
| | | WO 2018178273 A1 | 04-10-2018 |
| CN 109081791 A | 25-12-2018 | NONE | |
| CN 109485576 A | 19-03-2019 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2722908 A1
- EP 2180029 A1
- WO 2016097017 A1

### Non-patent literature cited in the description

- **YASUHIKO SHIROTA ; HIROSHI KAGEYAMA.** *Chem. Rev.,* 2007, vol. 107, 953-1010